(19) Europäisches Patentamt / European Patent Office / Office européen des brevets

(11) EP 3 451 403 B1

(12) **EUROPEAN PATENT SPECIFICATION**

(45) Date of publication and mention of the grant of the patent:
**12.02.2020 Bulletin 2020/07**

(51) Int Cl.:
***H01L 51/50*** *(2006.01)*

(21) Application number: **18192792.2**

(22) Date of filing: **05.09.2018**

(54) **ORGANIC LIGHT-EMITTING DEVICE**

ORGANISCHE LICHTEMITTIERENDE VORRICHTUNG

DISPOSITIF ÉLECTROLUMINESCENT ORGANIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.09.2017 KR 20170113561**
**04.09.2018 KR 20180105124**

(43) Date of publication of application:
**06.03.2019 Bulletin 2019/10**

(73) Proprietor: **Samsung Electronics Co., Ltd.**
**Gyeonggi-do, 16677 (KR)**

(72) Inventors:
- **KWAK, Seungyeon**
  **16678 Gyeonggi-do, (KR)**
- **KOO, Hyun**
  **16678 Gyeonggi-do (KR)**
- **KIM, Sangdong**
  **16678 Gyeonggi-do, (KR)**
- **KIM, Jiwhan**
  **16678 Gyeonggi-do, (KR)**
- **LEE, Sunghun**
  **16678 Gyeonggi-do, (KR)**
- **CHOI, Hyeonho**
  **16678 Gyeonggi-do, (KR)**
- **HONG, Seokhwan**
  **16678 Gyeonggi-do, (KR)**
- **HWANG, Kyuyoung**
  **16678 Gyeonggi-do, (KR)**

(74) Representative: **Elkington and Fife LLP**
**Prospect House**
**8 Pembroke Road**
**Sevenoaks, Kent TN13 1XR (GB)**

(56) References cited:
**US-A1- 2017 162 802**

- **BIN WANG ET AL: ") complexes supported by tetradentate benzazole-containing ligands", JOURNAL OF MATERIALS CHEMISTRY C, vol. 3, no. 31, 1 January 2015 (2015-01-01), pages 8212-8218, XP055540969, UK ISSN: 2050-7526, DOI: 10.1039/C5TC01449B**
- **SHIU-LUN LAI ET AL: "High Efficiency White Organic Light-Emitting Devices Incorporating Yellow Phosphorescent Platinum(II) Complex and Composite Blue Host", ADVANCED FUNCTIONAL MATERIALS, WILEY - V C H VERLAG GMBH & CO. KGAA, DE, vol. 23, no. 41, 6 November 2013 (2013-11-06), pages 5168-5176, XP001586999, ISSN: 1616-301X, DOI: 10.1002/ADFM.201300281 [retrieved on 2013-05-02]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 451 403 B1

## Description

FIELD OF THE INVENTION

The present disclosure relates to an organic light-emitting device.

BACKGROUND OF THE INVENTION

Organic light-emitting devices (OLEDs) are self-emission devices which produce full-color images. In addition, OLEDs have wide viewing angles and exhibit excellent driving voltage and response speed characteristics.

OLEDs include an anode, a cathode, and an organic layer between the anode and the cathode and including an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transit from an excited state to a ground state to thereby generate light.

OLEDs are known from such documents as:

J. Mater. Chem. C, 2015, 3, 8212 - 8218; and Adv. Funct. Mater., 2013, 23, 5168 -5176.

Both documents disclose OLEDs having phosphorescent, organometallic platinum complexes as emitters in host matrixes.

SUMMARY OF THE INVENTION

Provided is an organic light-emitting device satisfying certain parameters, thus having long lifespan.

Additional aspects will be set forth in part in the description which follows and, in part, will be apparent from the description, or may be learned by practice of the presented embodiments.

According to an aspect of an embodiment, an organic light-emitting device includes a first electrode; a second electrode facing the first electrode; and an emission layer disposed between the first electrode and the second electrode, the emission layer includes a host and a dopant,

the emission layer may emits a phosphorescent light,

the dopant is an organometallic compound,

a photoluminescent quantum yield (PLQY) of the dopant is 0.8 or greater and 1.0 or less,

a decay time of the dopant is 0.1 microseconds ($\mu$s) or greater and 2.9 $\mu$s or less,

0.1 eV $\leq$ HOMO (dopant) - HOMO (host) $\leq$ about 0.4 eV,

wherein the HOMO (dopant) represents a highest occupied molecular orbital (HOMO) energy level (expressed in electron volts) of the dopant, and

the HOMO (host) represents, in a case where the host included in the emission layer includes one type of host, a HOMO energy level (expressed in electron volts) of the one type of host; or in a case where the host included in the emission layer is a mixture of two or more different types of host, a highest HOMO energy level from among HOMO energy levels (expressed in electron volts) of the two or more different types of host,

the PLQY of the dopant may be a PLQY of Film 1,

the decay time of the dopant may be calculated from a time-resolved photoluminescence (TRPL) spectrum with respect to Film 1,

Film 1 is a film having a thickness of 40 nanometers (nm) obtained by vacuum-deposition of the host and the dopant included in the emission layer in a weight ratio of 90:10 on a quartz substrate at a vacuum degree of $10^{-7}$ torr.

the HOMO (dopant) may be a negative value measured by using a photoelectron spectrometer in an ambient atmosphere with respect to a film having a thickness of 40 nm obtained by vacuum-deposition of 1,4-bis(triphenylsilyl)benzene and the dopant included in the emission layer in a weight ratio of 85:15 on an indium tim oxide (ITO) substrate at a vacuum degree of $10^{-7}$ torr, and

the HOMO (host) may be, i) in a case where the host includes one type of host, a negative value measured by using a photoelectron spectrometer in an ambient atmosphere with respect to a film having a thickness of 40 nm obtained by vacuum-deposition of the one type of host on an ITO substrate at a vacuum degree of $10^{-7}$ torr; or ii) in a case where the host is a mixture of two or more different types of host, a largest negative value from among negative values measured by using a photoelectron spectrometer in an ambient atmosphere with respect to films having a thickness of 40 nm obtained by vacuum-deposition of each of the two or more different types of host on an ITO substrate at a vacuum degree of $10^{-7}$ torr.

According to an aspect of other embodiment, an organic light-emitting device may include:

a first electrode;
a second electrode facing the first electrode;
emission units in the number of m stacked between the first electrode and the second electrode and comprising at least one emission layer; and
charge generating layers in the number of m-1 disposed between each two adjacent emission units from among the m emission units, the each m-1 charge generating layers comprising an n-type charge generating layer and a p-type charge generating layer,
wherein m is an integer of 2 or greater,
a maximum emission wavelength of light emitted from at least one of the emission units in the number of m differs from that of light emitted from at least one of the other emission units,
the emission layer comprises a host and a dopant,
the emission layer emits a phosphorescent light,
the dopant is an organometallic compound,
a photoluminescence quantum yield (PLQY) of the dopant is about 0.8 or greater and about 1.0 or less,
a decay time of the dopant is about 0.1 microseconds or greater and about 2.9 microseconds or less,
0.1 electron volts ≤ HOMO (dopant) - HOMO (host) ≤ about 0.4 electron volts, wherein the HOMO (dopant) represents a highest occupied molecular orbital (HOMO) energy level (expressed in electron volts) of the dopant, and the HOMO (host) represents, in a case where the host comprised in the emission layer comprises one type of host, a HOMO energy level (expressed in electron volts) of the one type of host; or in a case where the host comprised in the emission layer is a mixture of two or more different types of host, a highest HOMO energy level from among HOMO energy levels (expressed in electron volts) of the two or more different types of host,
the PLQY of the dopant is a PLQY of Film 1,
the decay time of the dopant is calculated from a time-resolved photoluminescence (TRPL) spectrum with respect to Film 1,
Film 1 is a film having a thickness of 40 nanometers obtained by vacuum-deposition of the host and the dopant comprised in the emission layer in a weight ratio of 90:10 on a quartz substrate at a vacuum degree of $10^{-7}$ torr,
the HOMO (dopant) is a negative value measured by using a photoelectron spectrometer in an ambient atmosphere with respect to a film having a thickness of 40 nanometers obtained by vacuum-deposition of 1,4-bis(triphenylsilyl)benzene and the dopant comprised in the emission layer in a weight ratio of 85:15 on an ITO substrate at a vacuum degree of $10^{-7}$ torr, and
the HOMO (host) is, i) in a case where the host comprises one type of host, a negative value measured by using a photoelectron spectrometer in an ambient atmosphere with respect to a film having a thickness of 40 nanometers obtained by vacuum-deposition of the one type of host on an ITO substrate at a vacuum degree of $10^{-7}$ torr; or ii) in a case where the host is a mixture of two or more different types of host, a largest negative value from among negative values measured by using a photoelectron spectrometer in an ambient atmosphere with respect to films having a thickness of 40 nanometers obtained by vacuum-deposition of each of the two or more different types of host on an ITO substrate at a vacuum degree of $10^{-7}$ torr.

According to an aspect of other embodiment, an organic light-emitting device may include:

a first electrode;
a second electrode facing the first electrode; and
emission layers in the number of m stacked between the first electrode and the second electrode,
wherein
m is an integer of 2 or greater,
a maximum emission wavelength of light emitted from at least one of the emission layers in the number of m differs from that of light emitted from at least one of the other emission layers,
the emission layer comprises a host and a dopant,
the emission layer emits a phosphorescent light,
the dopant is an organometallic compound,
a photoluminescence quantum yield (PLQY) of the dopant is about 0.8 or greater and about 1.0 or less,
a decay time of the dopant is about 0.1 microseconds or greater and about 2.9 microseconds or less,
0.1 electron volts ≤ HOMO (dopant) - HOMO (host) ≤ about 0.4 electron volts, wherein the HOMO (dopant) represents a highest occupied molecular orbital (HOMO) energy level (expressed in electron volts) of the dopant, and the HOMO (host) represents, in a case where the host comprised in the emission layer comprises one type of host, a HOMO energy level (expressed in electron volts) of the one type of host; or in a case where the host comprised in the emission layer is a mixture of two or more different types of host, a highest HOMO energy level from among HOMO energy levels (expressed in electron volts) of the two or more different types of host,

the PLQY of the dopant is a PLQY of Film 1,
the decay time of the dopant is calculated from a time-resolved photoluminescence (TRPL) spectrum with respect to Film 1,
Film 1 is a film having a thickness of 40 nm obtained by vacuum-deposition of the host and the dopant comprised in the emission layer in a weight ratio of 90:10 on a quartz substrate at a vacuum degree of $10^{-7}$ torr,
the HOMO (dopant) is a negative value measured by using a photoelectron spectrometer in an ambient atmosphere with respect to a film having a thickness of 40 nanometers obtained by vacuum-deposition of 1,4-bis(triphenylsilyl)benzene and the dopant comprised in the emission layer in a weight ratio of 85:15 on an ITO substrate at a vacuum degree of $10^{-7}$ torr, and
the HOMO (host) is, i) in a case where the host comprises one type of host, a negative value measured by using a photoelectron spectrometer in an ambient atmosphere with respect to a film having a thickness of 40 nanometers obtained by vacuum-deposition of the one type of host on an ITO substrate at a vacuum degree of $10^{-7}$ torr; or ii) in a case where the host is a mixture of two or more different types of host, a largest negative value from among negative values measured by using a photoelectron spectrometer in an ambient atmosphere with respect to films having a thickness of 40 nanometers obtained by vacuum-deposition of each of the two or more different types of host on an ITO substrate at a vacuum degree of $10^{-7}$ torr.

BRIEF DESCRIPTION OF THE DRAWINGS

These and/or other aspects will become apparent and more readily appreciated from the following description of the embodiments, taken in conjunction with the accompanying drawings in which:

FIG. 1 illustrates a schematic view of an organic light-emitting device 10 according to an embodiment;
FIG. 2 is a diagram showing an organic light-emitting device according to an embodiment in terms of HOMO (dopant) and HOMO (host);
FIG. 3 is a schematic view of an organic light-emitting device 100 according to another embodiment; and
FIG. 4 is a schematic view of an organic light-emitting device 200 according to still another embodiment.

DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.
In FIG. 1, an organic light-emitting device 10 includes a first electrode 11, a second electrode 19 facing the first electrode 11, and an organic layer 10A between the first electrode 11 and the second electrode 19.
In FIG. 1, the organic layer 10A includes an emission layer 15, a hole transport region 12 is disposed between the first electrode 11 and an emission layer 15, and an electron transport region 17 is disposed between the emission layer 15 and the second electrode 19.
In FIG. 1, a substrate may be additionally placed under the first electrode 11 or above the second electrode 19. The substrate may be a glass substrate or a plastic substrate, each having excellent mechanical strength, thermal stability, transparency, surface smoothness, ease of handling, and water resistance.

**First electrode 11**

The first electrode 11 may be formed by depositing or sputtering, onto the substrate, a material for forming the first electrode 11. When the first electrode 11 is an anode, the material for forming the first electrode 11 may be selected from materials with a high work function that facilitate hole injection.
The first electrode 11 may be a reflective electrode, a semi-transmissive electrode, or a transmissive electrode. When the first electrode 11 is a transmissive electrode, a material for forming the first electrode 11 may be selected from indium tin oxide (ITO), indium zinc oxide (IZO), tin oxide ($SnO_2$), zinc oxide (ZnO), and any combinations thereof, but embodiments are not limited thereto. In some embodiments, when the first electrode 11 is a semi-transmissive electrode or a reflective electrode, as a material for forming the first electrode 11, at least one of magnesium (Mg), silver (Ag), aluminum (Al), aluminum-lithium (Al-Li), calcium (Ca), magnesium-indium (Mg-In), magnesium-silver (Mg-Ag), and any combination thereof may be used, but embodiments are not limited thereto.

The first electrode 11 may have a single-layered structure, or a multi-layered structure including two or more layers.

**Emission layer 15**

The emission layer 15 includes a host and a dopant.

The emission layer 15 emits a phosphorescent light. That is, the dopant emits a phosphorescent light. The emission layer 15 emitting a phosphorescent light is distinct from an emission layer emitting a fluorescent light by including a general fluorescent dopant and/or a thermal activated delayed fluorescence (TADF) dopant.

The dopant is an organometallic compound.

An emission energy of a maximum emission wavelength of an emission spectrum of the dopant may be about 2.31 electron volts (eV) or greater and about 2.48 eV or less. In some embodiments, an emission energy of a maximum emission wavelength of an emission spectrum of the dopant may be about 2.31 eV or greater and about 2.48 eV or less, about 2.31 eV or greater and about 2.40 eV or less, about 2.31 eV or greater and about 2.38 eV or less, about 2.31 eV or greater and about 2.36 eV or less, about 2.32 eV or greater and about 2.36 eV or less, or about 2.33 eV or greater and about 2.35 eV or less, but embodiments are not limited thereto. The term "maximum emission wavelength" refers to a wavelength at which the emission intensity is the maximum and can also be referred to as "peak emission wavelength".

A photoluminescence quantum yield (PLQY) of the dopant is 0.8 or greater and 1.0 or less. In some embodiments, a PLQY of the dopant may be about 0.9 or greater and about 1.0 or less, about 0.92 or greater and about 1.0 or less, about 0.94 or greater and about 1.0 or less, about 0.95 or greater and about 1.0 or less, about 0.96 or greater and about 1.0 or less, about 0.972 or greater and about 0.995 or less, about 0.974 or greater and about 0.995 or less, about 0.975 or greater and about 1.0 or less, about 0.975 or greater and about 0.995 or less, about 0.975 or greater and about 0.990 or less, about 0.978 or greater and about 0.985 or less, or about 0.978 or greater and about 0.980 or less, but embodiments are not limited thereto.

A decay time of the dopant is 0.1 microseconds ($\mu s$) or greater and 2.9 $\mu s$ or less. In some embodiments, a decay time of the dopant may be about 1.0 $\mu s$ or greater and about 2.9 $\mu s$ or less, about 1.5 $\mu s$ or greater and about 2.9 $\mu s$ or less, about 1.6 $\mu s$ or greater and about 2.7 $\mu s$ or less, about 1.5 $\mu s$ or greater and about 2.6 $\mu s$ or less, about 1.7 $\mu s$ or greater and about 2.5 $\mu s$ or less, about 1.8 $\mu s$ or greater and about 2.5 $\mu s$ or less, or about 2.0 $\mu s$ or greater and about 2.5 $\mu s$ or less, but embodiments are not limited thereto.

The host and the dopant included in the emission layer satisfy 0.1 eV $\leq$ HOMO (dopant) - HOMO (host) $\leq$ 0.4 eV. The HOMO (dopant) represents a highest occupied molecular orbital (HOMO) energy level (expressed in electron volts) of the dopant. The HOMO (host) represents, in a case where the host included in the emission layer includes one type of host (for example, the host included in the emission layer consists of one type of host), a HOMO energy level (expressed in electron volts) of the one type of host; or in a case where the host included in the emission layer is a mixture of two or more different types of host, a highest HOMO energy level from among HOMO energy levels (expressed in electron volts) of the two or more different types of host. FIG. 2 is a diagram showing the relationship between the HOMO (dopant) and the HOMO (host).

In some embodiments, the host and the dopant included in the emission layer may satisfy about 0.1 eV $\leq$ HOMO (dopant) - HOMO (host) $\leq$ about 0.3 eV, about 0.1 eV $\leq$ HOMO (dopant) - HOMO (host) $\leq$ about 0.25 eV, or about 0.15 eV $\leq$ HOMO (dopant) - HOMO (host) $\leq$ about 0.25 eV, but embodiments are not limited thereto.

In an embodiment, in the emission layer 15,
a PLQY of the dopant may be about 0.975 or greater and about 1.0 or less,
a decay time of the dopant may be about 2.0 $\mu s$ or greater and about 2.5 $\mu s$ or less, and
the host and the dopant may satisfy that about 0.15 eV $\leq$ HOMO (dopant)-HOMO (host) $\leq$ about 0.25 eV, but embodiments are not limited thereto.

In an embodiment, in the emission layer 15,
an emission energy of a maximum emission wavelength of an emission spectrum of the dopant may be about 2.31 eV or greater and about 2.36 eV or less,
a PLQY of the dopant may be about 0.975 or greater and about 1.0 or less,
a decay time of the dopant may be about 2.0 $\mu s$ or greater and about 2.5 $\mu s$ or less, and
the host and the dopant may satisfy that about 0.15 eV $\leq$ HOMO (dopant)-HOMO (host) $\leq$ about 0.25 eV, but embodiments are not limited thereto.

The emission energy of a maximum emission wavelength of an emission spectrum of the dopant may be calculated from a maximum emission wavelength of an emission spectrum with respect to Film 1.

The PLQY of the dopant may be a PLQY of Film 1.

The decay time of the dopant may be calculated from a TRPL spectrum with respect to Film 1.

Film 1 is a film having a thickness of 40 nanometers (nm) obtained by vacuum-deposition of the host and the dopant included in the emission layer in a weight ratio of 90:10 on a quartz substrate at a vacuum degree of $10^{-7}$ torr.

The HOMO (dopant) may be a negative value measured by using a photoelectron spectrometer (for example, AC3 available from Riken Keiki Co., Ltd.) in an ambient atmosphere with respect to a film having a thickness of 40 nm obtained by vacuum-deposition of 1,4-bis(triphenylsilyl)benzene and the dopant included in the emission layer in a weight ratio of 85:15 on an ITO substrate at a vacuum degree of $10^{-7}$ torr.

The HOMO (host) may be, i) in a case where the host includes one type of host (for example, the host included in the emission layer consists of one type of host), a negative value measured by using a photoelectron spectrometer in an ambient atmosphere with respect to a film having a thickness of 40 nm obtained by vacuum-deposition of the one type of host on an ITO substrate at a vacuum degree of $10^{-7}$ torr; or ii) in a case where the host is a mixture of two or more different types of host, a largest negative value from among negative values measured by using a photoelectron spectrometer in an ambient atmosphere with respect to films having a thickness of 40 nm obtained by vacuum-deposition of each of the two or more different types of host on an ITO substrate at a vacuum degree of $10^{-7}$ torr.

Evaluation methods of an emission energy of a maximum emission wavelength energy of an emission spectrum of the dopant, a PLQY of the dopant, a decay time of the dopant, HOMO (dopant), and HOMO (host) may be understood by referring to the descriptions for those provided herein with reference to Examples.

When the host and the dopant in the emission layer 15 satisfy "all" of the above described the PLQY range of the dopant, the decay time range of the dopant, and the HOMO (dopant) - HOMO (host) range "at the same time", the organic light-emitting device 10 may have long lifespan characteristics. Furthermore, while not wishing to be bound by theory, it is understood that when the host and the dopant in the emission layer 15 additionlly satisfy the above described emission energy range of maximum emission wavelength of an emission spectrum of the dopant, the organic light-emitting device 10 may have longer lifespan characteristics.

"t (5%)" refers to time required for the luminance of the organic light-emitting device 10 under given driving conditions to reduce from the initial luminance (100%) to 95% thereof, i.e., time taken for 5% of lifespan change. "R (5%)" refers to a rate required for the luminance of the organic light-emitting device 10 under given driving conditions to reduce from the initial luminance (100%) to 95%, i.e., a rate required for 5% of lifespan change. In this case, R (5%) = 1/t (5%).

R (5%) may increase as an emission energy of excitons produced by a dopant included in the emission layer 15 increases, a density of the excitons increases, and a diffusion length for excitons to collide with polarons increases.

When an emission energy of a maximum emission wavelength of the dopant, i.e., excitons, included in the emission layer 15 excessively increases, polarons may be transitioned to a high energy level by exciton-polaron quenching. By this, various chemical bonds included in the host and/or the dopant molecules included in the emission layer 15 may be broken to thereby increase the possibility of decomposition of the host and/or the dopant molecules included in the emission layer 15. Therefore, a relationship between an emission energy (E) of a maximum emission wavelength of the dopant, i.e., excitons, included in the emission layer 15 and R(5%) may be shown as follows: $R(5\%) \propto \exp[-(E_d-E)/kT]$. Here, $E_d$ indicates carbon-nitrogen binding energy which is relatively weak bond among chemical bonds between atoms, 3.16 eV. kT indicates Boltzmann constant (e.g., kT is 25.7 millielectron volts (meV) at a temperature of 25 °C (298 Kelvins (K))).

Next, PLQY (Φ) is a property that is directly related to luminescence ability of a dopant included in the emission layer 15. When PLQY (Φ) of the dopant included in the emission layer 15 is low, luminescence efficiency of the organic light-emitting device10 may be deteriorated. Thus, the organic light-emitting device 10 needs to be driven with a high current to achieve the predetermined luminance, which may result in deterioration of lifespan of the organic light-emitting device 10. Thus, a relationship between PLQY of the dopant included in the emission layer 15 and R(5%) may be shown as follows: $R(5\%) \propto \Phi^{-1}$.

A diffusion length of excitons in the emission layer 15 is proportional to a square root of decay time (τ) of excitons i.e., the dopant in the emission layer 15.

Thus, a relationship between decay time of the dopant in the emission layer 15 and R(5%) may be shown as follows: $R(5\%) \propto T^{0.5}$.

A density of excitons in the emission layer 15 may be determined by a HOMO energy level difference (ΔH) between the host and the dopant included in the emission layer 15. When the HOMO energy level difference (ΔH) between the host and the dopant is relatively high, holes provided to the emission layer 15 may be trapped thereinto, and excitons may be greatly produced in a region near to the hole transport region 12 in the emission layer 15, thereby increasing the density of excitons in the emission layer 15. When the HOMO energy level difference (ΔH) between the host and the dopant is relatively small, most holes provided to the emission layer 15 may be stacked in a region near to the electron transport region 17, and excitons may be greatly produced in the region, thereby increasing the density of excitons in the emission layer 15. Therefore, a relationship between a density of excitons and R(5%) may be shown as follows: $R(5\%) \propto \exp(|\Delta H-\Delta H_{opt}|/kT)$. Here, $AH_{opt}$ indicates a HOMO energy level difference of that can reduce the density of excitons, and kT indicates Boltzmann constant.

That is,

a) when a dopant in the emission layer 15 satisfies a PLQY range described herein, relatively low current driving conditions may be selected to achieve a high luminance of the organic light-emitting device 10,

b) when a dopant in the emission layer 15 satisfies a decay time range described herein, a diffusion length of excitons in the emission layer 15 may be decreased, and

c) when a host and a dopant in the emission layer 15 satisfies the HOMO (dopant) - HOMO (host) range described herein, excitons produced in the emission layer 15 are not concentrated either in a region near the hole transport region 12 or a region near the electron transport region 17 in the emission layer 15, and a density of excitons in the emission layer 15 may be decreased.

Thus, when the host and the dopant in the emission layer 15 satisfy "all" of the PLQY range of the dopant, the decay time range of the dopant, and the HOMO (dopant) - HOMO (host) range described herein "at the same time", the organic light-emitting device 10 may have significantly improved lifespan characteristics.

Furthermore, when a dopant in the emission layer 15 satisfies the emission energy range of a maximum emission wavelength of an emission spectrum described herein, the possibility of decomposition of the host and/or the dopant molecules included in the emission layer 15, through breaking of various chemical bonds included in the host and/or the dopant molecules included in the emission layer 15 by polarons transitioned to a high energy level by exciton-polaron quenching, may be decreased. Thus, when the host and the dopant in the emission layer 15 additionally satisfy the emission energy range of the maximum emission wavelength of an emission spectrum of the dopant, the organic light-emitting device 10 may have significantly improved lifespan characteristics.

**Dopant in emission layer 15**

The dopant in the emission layer 15 may be a phosphorescent compound. Thus, the organic light-emitting device 10 is quite different from an organic light-emitting device that emits a fluorescent light through a fluorescence mechanism.

The dopant may be an organometallic compound.

In one or more embodiments, the dopant may be an organometallic compound including a transition metal, thallium (Tl), lead (Pb), bismuth (Bi), indium(In), tin(Sn), antimony(Sb), or tellurium (Te).

In some embodiments, the dopant may be an organometallic compound including a Group 1 (the first row) transition metal, a Group 2 (the second row) transition metal, or a Group 3 (the third row) transition metal of periodic table of elements.

In an embodiment, the dopant may be an iridium-free organometallic compound.

In one or more embodiments, the dopant may be an organometallic compound including platinum (Pt), osmium (Os), titanium (Ti), zirconium (Zr), hafnium (Hf), europium (Eu), terbium (Tb), thulium (Tm), rhodium (Rh), ruthenium (Ru), rhenium (Re), beryllium (Be), magnesium (Mg), aluminum (Al), calcium (Ca), manganese (Mn), cobalt (Co), copper (Cu), zinc (Zn), gallium (Ga), germanium (Ge), palladium (Pd), silver (Ag), or gold (Au). In some embodiments, the dopant may be an organometallic compound including platinum (Pt) or palladium (Pd), but embodiments are not limited thereto.

In one or more embodiments, the dopant may be a platinum (Pt)-containing organometallic compound.

In one or more embodiments, a dopant in the emission layer 15 may be an organometallic compound having a square-planar coordination.

In one or more embodiments, a dopant in the emission layer 15 may satisfy T1 (dopant) $\leq$ Egap (dopant) $\leq$ T1 (dopant) + 0.5 eV, and in some embodiments, T1 (dopant) $\leq$ Egap (dopant) $\leq$ T1 (dopant) + 0.36 eV, but embodiments are not limited thereto.

Egap (dopant) represents a difference between a HOMO energy level and a LUMO energy level of a dopant included in the emission layer 15, and HOMO (dopant) represents a HOMO energy level of a dopant included in the emission layer 15. The method of measuring HOMO (dopant) is as described herein.

When Egap (dopant) is within any of these ranges, a dopant in the emission layer 15, e.g., an organometallic compound having a square-planar coordination, may have a high radiative decay rate despite weak spin-orbital coupling (SOC) with a singlet energy level which is close to a triplet energy level.

In one or more embodiments, the dopant may include a metal M and an organic ligand, and the metal M and the organic ligand may form one, two, or three cyclometalated rings. The metal M may be platinum (Pt), osmium (Os), titanium (Ti), zirconium (Zr), hafnium (Hf), europium (Eu), terbium (Tb), thulium (Tm), rhodium (Rh), ruthenium (Ru), rhenium (Re), beryllium (Be), magnesium (Mg), aluminum (Al), calcium (Ca), manganese (Mn), cobalt (Co), copper (Cu), zinc (Zn), gallium (Ga), germanium (Ge), palladium (Pd), silver (Ag), or gold (Au). In some embodiments, the dopant may include a metal M, and the metal M may be Pt, Pd, or Au, but embodiments are not limited thereto.

In one or more embodiments, the dopant may include a metal M and a tetradentate organic ligand, and the metal M and the tetradentate organic ligand are capable of together forming three or four (e.g., three) cyclometalated

rings. The metal M may be defined the same as described herein. The tetradentate organic ligand may include, for example, a benzimidazole group and a pyridine group, but embodiments are not limited thereto.

In one or more embodiments, the dopant may include a metal M and at least one of ligands represented by Formulae 1-1 to 1-4:

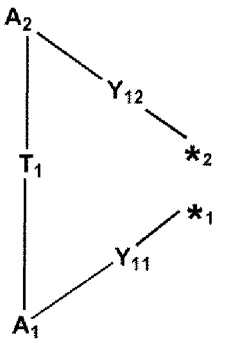

Formula 1-1

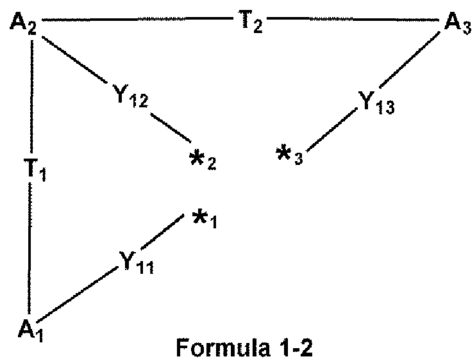

Formula 1-2

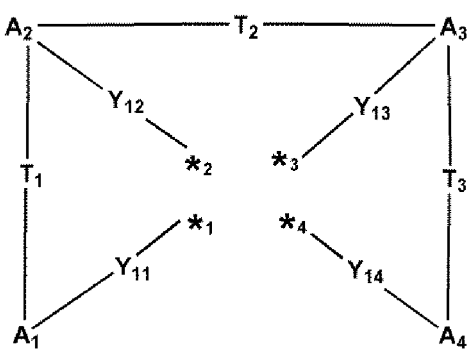

Formula 1-3

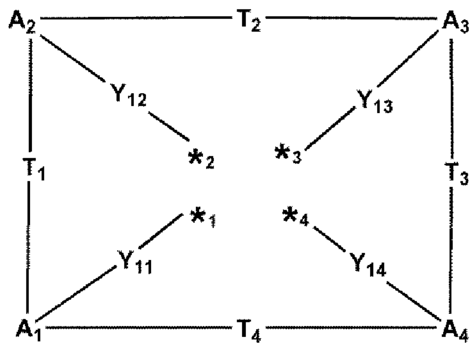

Formula 1-4

wherein, in Formulae 1-1 to 1-4,

$A_1$ to $A_4$ may each independently be selected from a substituted or unsubstituted $C_5$-$C_{30}$ carbocyclic group, a substituted or unsubstituted $C_1$-$C_{30}$ heterocyclic group, and a non-cyclic group,

$Y_{11}$ to $Y_{14}$ may each independently be a chemical bond, O, S, $N(R_{91})$, $B(R_{91})$, $P(R_{91})$, or $C(R_{91})(R_{92})$,

$T_1$ to $T_4$ may each independently be selected from a single bond, a double bond, *-N($R_{93}$)-*', *-B($R_{93}$)-*', *-P($R_{93}$)-*', *-C($R_{93}$)($R_{94}$)-*', *-Si($R_{93}$)($R_{94}$)-*', *-Ge($R_{93}$)($R_{94}$)-*', *-S-*', *-Se-*', *-O-*', *-C(=O)-*', *-S(=O)-*', *-S(=O)$_2$-*', *-C($R_{93}$)=*', *=C($R_{93}$)-*', *-C($R_{93}$)=C($R_{94}$)-*', *-C(=S)-*', and *-C=C-*',

a substituent of the substituted $C_5$-$C_{30}$ carbocyclic group, a substituent of the substituted $C_1$-$C_{30}$ heterocyclic group, and $R_{91}$ to $R_{94}$ may each independently be selected from hydrogen, deuterium, -F, -Cl, -Br, -I, -$SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, -N($Q_1$)($Q_2$), -Si($Q_3$)($Q_4$)($Q_5$),-B($Q_6$)($Q_7$), and -P(=O)($Q_8$)($Q_9$), provided that the substituent of the substituted $C_5$-$C_{30}$ carbocyclic group and the substituent of the substituted $C_1$-$C_{30}$ heterocyclic group are not a hydrogen,

$*_1$, $*_2$, $*_3$ and $*_4$ each indicate a binding site to the metal M of the dopant and

wherein $Q_1$ to $Q_9$ are the same as defined below.

In some embodiments, in Formulae 1-1 to 1-4, $A_1$ to $A_4$ may each independently be selected from a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene 5,5-dioxide group, an azaindole group, an azabenzoborole group, an azabenzophosphole group, an azaindene group, an azabenzosilole group, a azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an iso-oxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, and a 5,6,7,8-tetrahydroquinoline group, each unsubstituted or substituted with at least one selected from deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-B(Q_6)(Q_7)$, and $-P(=O)(Q_3)(Q_9)$, but embodiments are not limited thereto. Here, the substituents of $A_1$ to $A_4$ will be described in detail with regard to $R_1$ in Formula 1A.

For example, the dopant may include a ligand represented by Formula 1-3, and two of $A_1$ to $A_4$ in Formula 1-3 may each be a substituted or unsubstituted benzimidazole group and a substituted or unsubstituted pyridine group, but embodiments are not limited thereto.

In one or more embodiments, the dopant may be an organometallic compound represented by Formula 1A:

Formula 1A

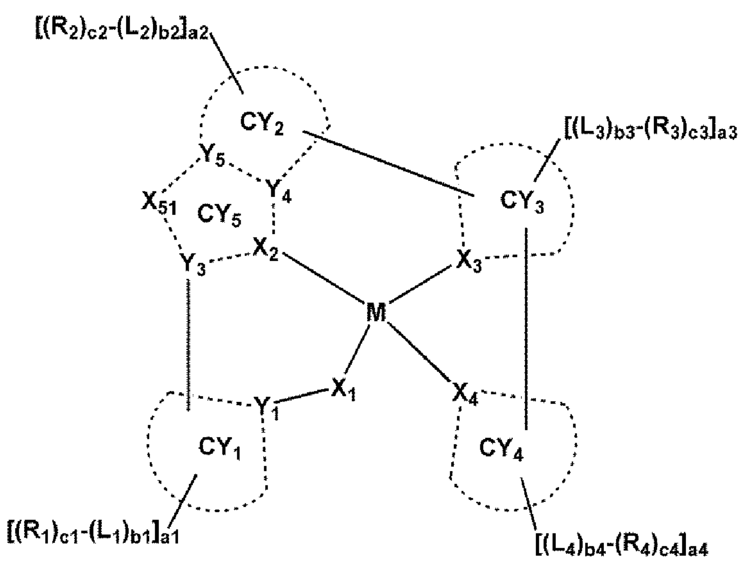

wherein, in Formula 1A,

M may be selected from beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), and gold (Au),
$X_1$ may be O or S, a bond between $X_1$ and M may be a covalent bond,
$X_2$ to $X_4$ may each independently be selected from carbon (C) and nitrogen (N),
one bond selected from a bond between $X_2$ and M, a bond between $X_3$ and M, and a bond between $X_4$ and M may be a covalent bond, while the remaining bonds are each a coordinate bond,
$Y_1$ and $Y_3$ to $Y_5$ may each independently be C or N,
a bond between $X_2$ and $Y_3$, a bond between $X_2$ and $Y_4$, a bond between $Y_4$ and $Y_5$, a bond between $Y_5$ and $X_{51}$, and a bond between $X_{51}$ and $Y_3$ may each be a chemical bond,
$CY_1$ to $CY_5$ may each independently be selected from a $C_5$-$C_{30}$ carbocyclic group and a $C_1$-$C_{30}$ heterocyclic group,
$CY_4$ may not be a benzimidazole group,
a cyclometalated ring formed by $CY_5$, $CY_2$, $CY_3$, and M may be a 6-membered ring,
$X_{51}$ may be selected from O, S, N-$[(L_7)_{b7}$-$(R_7)_{c7}]$, $C(R_7)(R_8)$, $Si(R_7)(R_8)$, $Ge(R_7)(R_8)$, C(=O), N, $C(R_7)$, $Si(R_7)$, and $Ge(R_7)$,
$R_7$ and $R_8$ may optionally be bound via a first linking group to form a substituted or unsubstituted $C_5$-$C_{30}$ carbocyclic group or a substituted or unsubstituted $C_1$-$C_{30}$ heterocyclic group,
$L_1$ to $L_4$ and $L_7$ may each independently be selected from a substituted or unsubstituted $C_5$-$C_{30}$ carbocyclic group and a substituted or unsubstituted $C_1$-$C_{30}$ heterocyclic group,
b1 to b4 and b7 may each independently be an integer from 0 to 5,
$R_1$ to $R_4$, $R_7$, and $R_8$ may each independently be selected from hydrogen, deuterium, -F, -Cl, -Br, -I, $-SF_5$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-B(Q_6)(Q_7)$, and-$P(=O)(Q_3)(Q_9)$,
c1 to c4 may each independently be an integer from 1 to 5,
a1 to a4 may each independently be 0, 1, 2, 3, 4 or 5,
at least two adjacent $R_1$(s) selected from a plurality of $R_1$(s) may optionally be bound to form a substituted or unsubstituted $C_5$-$C_{30}$ carbocyclic group or a substituted or unsubstituted $C_1$-$C_{30}$ heterocyclic group,
at least two adjacent $R_2$(s) selected from a plurality of $R_2$(s) may optionally be bound to form a substituted or unsubstituted $C_5$-$C_{30}$ carbocyclic group or a substituted or unsubstituted $C_1$-$C_{30}$ heterocyclic group,
at least two adjacent $R_3$(s) selected from a plurality of $R_3$(s) may optionally be bound to form a substituted or unsubstituted $C_5$-$C_{30}$ carbocyclic group or a substituted or unsubstituted $C_1$-$C_{30}$ heterocyclic group,
at least two adjacent $R_4$(s) selected from a plurality of $R_4$(s) may optionally be bound to form a substituted or unsubstituted $C_5$-$C_{30}$ carbocyclic group or a substituted or unsubstituted $C_1$-$C_{30}$ heterocyclic group, and
at least two adjacent groups selected from $R_1$ to $R_4$ may optionally be bound to form a substituted or unsubstituted $C_5$-$C_{30}$ carbocyclic group or a substituted or unsubstituted $C_1$-$C_{30}$ heterocyclic group.

In Formulae 1-1 to 1-4 and 1A, a $C_5$-$C_{30}$ carbocyclic group, a $C_1$-$C_{30}$ heterocyclic group, and a $CY_1$ to $CY_4$ may each independently be selected from a) a first ring, b) a condensed ring in which at least two first rings are condensed, or c) a condensed ring in which at least one first ring and at least one second ring are condensed, wherein the first ring may be selected from a cyclohexane group, a cyclohexene group, an adamantane group, a norbonane group, a norbonene group, a benzene group, a pyridine group, a pyrimidine group, a pyrazine group, a pyridazine group, and a triazine group, and the second ring may be selected from a cyclopentane group, a cyclopentene group, a cyclopentadiene group, a furan group, a thiophene group, a silole group, a pyrrole group, a pyrazole group, an imidazole group, a triazole group, an oxazole group, an iso-oxazole group, a thiazole group, an isothiazole group, an oxadiazole group, and a thiadiazole group.

The non-cyclic group in Formulae 1-1 to 1-4 may each be *-C(=O)-*', *-O-C(=O)-*', *-S-C(=O)-*', *-O-C(=S)-*', or *-S-C(=S)-*', but embodiments are not limited thereto.

In Formulae 1-1 to 1-4 and 1A, a substituent of the substituted $C_5$-$C_{30}$ carbocyclic group, a substituent of the substituted $C_1$-$C_{30}$ heterocyclic group, $R_{91}$ to $R_{94}$, $R_1$ to $R_4$, $R_7$, and $R_8$ may each independently be selected from:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, and a $C_1$-$C_{20}$ alkoxy group;

a $C_1$-$C_{20}$ alkyl group and a $C_1$-$C_{20}$ alkoxy group, each substituted with at least one selected from deuterium, -F, -Cl, -Br, -I, $-CD_3$, $-CD_2H$, $-CDH_2$, $-CF_3$, $-CF_2H$,$-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, and a pyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group;

a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, and an imidazopyrimidinyl group, each substituted with at least one selected from deuterium, -F, -Cl, -Br, -I,$-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a dibenzosilolyl group, a benzocarbazolyl group, a dibenzocarbazolyl group, an imidazopyridinyl group, an imidazopyrimidinyl group, and $-Si(Q_{33})(Q_{34})(Q_{35})$; and

$-N(Q_1)(Q_2)$, $-Si(Q_3)(Q_4)(Q_5)$, $-B(Q_6)(Q_7)$, and $-P(=O)(Q_8)(Q_9)$,

wherein $Q_1$ to $Q_9$ and $Q_{33}$ to $Q_{35}$ may each independently be selected from

$-CH_3$, $-CD_3$, $-CD_2H$, $-CDH_2$, $-CH_2CH_3$, $-CH_2CD_3$, $-CH_2CD_2H$, $-CH_2CDH_2$,$-CHDCH_3$, $-CHDCD_2H$, $-CHDCDH_2$, $-CHDCD_3$, $-CD_2CD_3$, $-CD_2CD_2H$, and $-CD_2CDH_2$;

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group; and

an n-propyl group, an iso-propyl group, an n-butyl group, an iso-butyl group, a sec-butyl group, a tert-butyl group, an n-pentyl group, an iso-pentyl group, a sec-pentyl group, a tert-pentyl group, a phenyl group, and a naphthyl group,

each substituted with at least one selected from deuterium, a $C_1$-$C_{10}$ alkyl group, and a phenyl group, but embodiments are not limited thereto.

In one or more embodiments, $X_{51}$ may be N-[$(L_7)_{b7}$-$(R_7)_{c7}$], but embodiments are not limited thereto.

In one or more embodiments, the dopant may be an organometallic compound represented by Formula 1A, wherein in Formula 1A,
$X_2$ and $X_3$ may each independently be C or N,
$X_4$ may be N, and
in cases where i) M is Pt, ii) $X_1$ is O, iii) $X_2$ and $X_4$ are each N, $X_3$ is C, a bond between $X_2$ and M and a bond between $X_4$ and M are each a coordinate bond, and a bond between $X_3$ and M is a covalent bond, iv) $Y_1$ to $Y_5$ are each C, v) a bond between $Y_5$ and $X_{51}$ and a bond between $Y_3$ and $X_{51}$ are each a single bond, vi) $CY_1$, $CY_2$, and $CY_3$ are each a benzene group, and $CY_4$ is a pyridine group, vii) $X_{51}$ is O, S, or N-[$(L_7)_{b7}$-$(R_7)_{c7}$], and viii) b7 is 0, c7 is 1, and $R_7$ is a substituted or unsubstituted $C_1$-$C_{60}$ alkyl group, a1 to a4 may each independently be 1, 2, 3, 4, or 5, and at least one selected from $R_1$ to $R_4$ may each independently be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, and a substituted or unsubstituted monovalent non-aromatic condensed heteropolycyclic group.

In one or more embodiments, the dopant may be represented by Formula 1A-1:

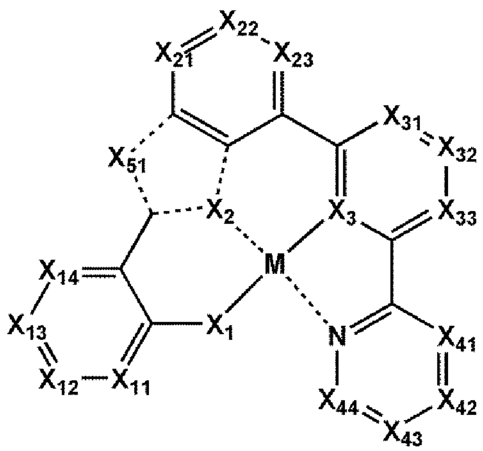

**Formula 1A-1**

wherein, in Formula 1A-1,

M, $X_1$ to $X_3$, and $X_{51}$ may be defined the same as those described herein,
$X_{11}$ may be N or C-[$(L_{11})_{b11}$-$(R_{11})_{c11}$], $X_{12}$ may be N or C-[$(L_{12})_{b12}$-$(R_{12})_{c12}$], $X_{13}$ may be N or C-[$(L_{13})_{b13}$-$(R_{13})_{c13}$], $X_{14}$ may be N or C-[$(L_{14})_{b14}$-$(R_{14})_{c14}$],
$L_{11}$ to $L_{14}$, b11 to b14, $R_{11}$ to $R_{14}$, and c11 to c14 may each be defined the same as $L_1$, b1, $R_1$, and c1 described herein, respectively,
$X_{21}$ may be N or C-[$(L_{21})_{b21}$-$(R_{21})_{c21}$], $X_{22}$ may be N or C-[$(L_{22})_{b22}$-$(R_{22})_{c22}$], $X_{23}$ may be N or C-[$(L_{23})_{b23}$-$(R_{23})_{c23}$], $L_{21}$ to $L_{23}$, b21 to b23, $R_{21}$ to $R_{23}$, and c21 to c23 may each be defined the same as $L_2$, b2, $R_2$, and c2 described herein, respectively,
$X_{31}$ may be N or C-[$(L_{31})_{b31}$-$(R_{31})_{c31}$], $X_{32}$ may be N or C-[$(L_{32})_{b32}$-$(R_{32})_{c32}$], $X_{33}$ may be N or C-[$(L_{33})_{b33}$-$(R_{33})_{c33}$], $L_{31}$ to $L_{33}$, b31 to b33, $R_{31}$ to $R_{33}$, and c31 to c33 may each be defined the same as $L_3$, b3, $R_3$, and c3 described herein, respectively,
$X_{41}$ may be N or C-[$(L_{41})_{b41}$-$(R_{41})_{c41}$], $X_{42}$ may be N or C-[$(L_{42})_{b42}$-$(R_{42})_{c42}$], $X_{43}$ may be N or C-[$(L_{43})_{b43}$-$(R_{43})_{c43}$], $X_{44}$ may be N or C-[$(L_{44})_{b44}$-$(R_{44})_{c44}$],
$L_{41}$ to $L_{44}$, b41 to b44, $R_{41}$ to $R_{44}$, and c41 to c44 may each be defined the same as $L_4$, b4, $R_4$, and c4 described herein, respectively,
two selected from $R_{11}$ to $R_{14}$ may optionally be bound to form a substituted or unsubstituted $C_5$-$C_{30}$ carbocyclic group or a substituted or unsubstituted $C_1$-$C_{30}$ heterocyclic group,
two selected from $R_{21}$ to $R_{23}$ may optionally be bound to form a substituted or unsubstituted $C_5$-$C_{30}$ carbocyclic group or a substituted or unsubstituted $C_1$-$C_{30}$ heterocyclic group,

two selected from $R_{31}$ to $R_{33}$ may optionally be bound to form a substituted or unsubstituted $C_5$-$C_{30}$ carbocyclic group or a substituted or unsubstituted $C_1$-$C_{30}$ heterocyclic group, and
two selected from $R_{41}$ to $R_{44}$ may optionally be bound to form a substituted or unsubstituted $C_5$-$C_{30}$ carbocyclic group or a substituted or unsubstituted $C_1$-$C_{30}$ heterocyclic group.

In some embodiments, the dopant may be selected from Compounds 1-1 to 1-91, 2-1 to 2-47, and 3-1 to 3-582, but embodiments are not limited thereto:

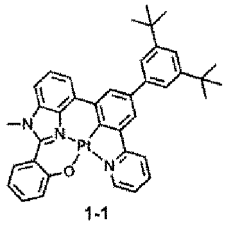
1-1

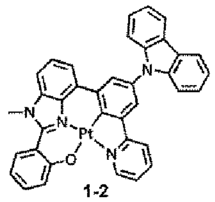
1-2

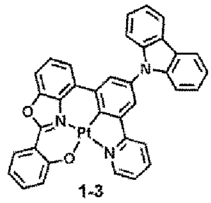
1-3

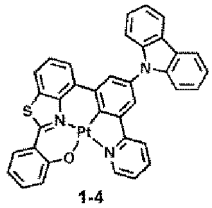
1-4

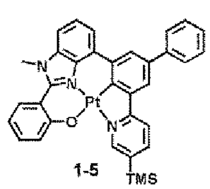
1-5

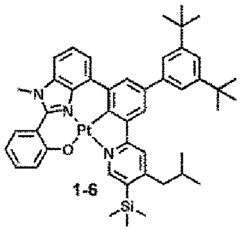
1-6

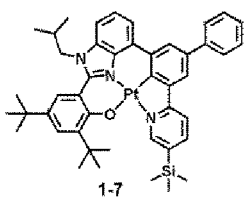
1-7

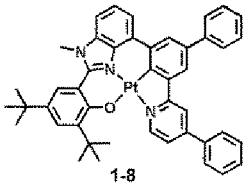
1-8

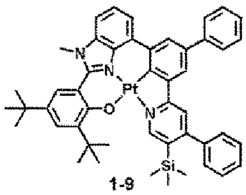
1-9

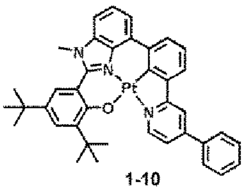
1-10

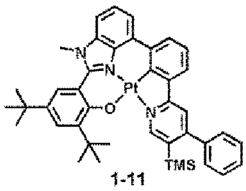
1-11

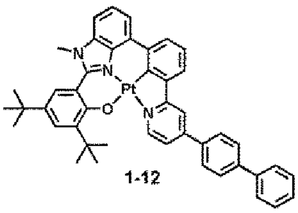
1-12

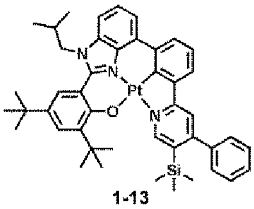
1-13

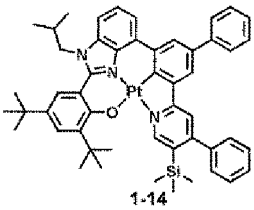
1-14

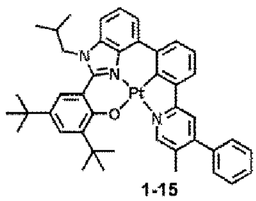
1-15

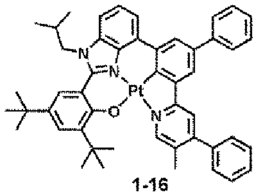
1-16

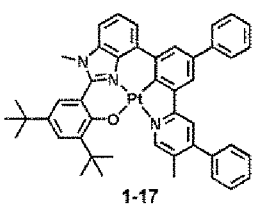
1-17

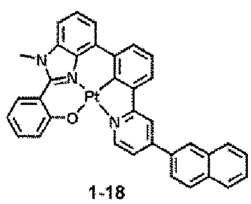
1-18

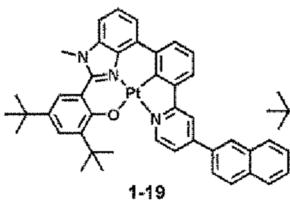
1-19

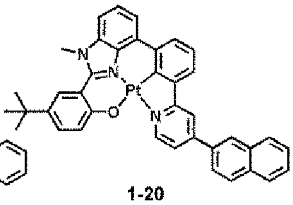
1-20

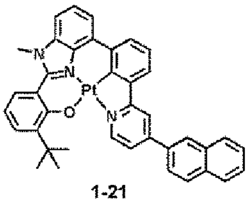
1-21
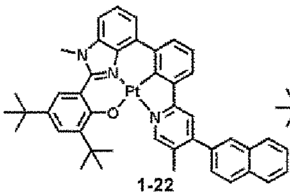
1-22
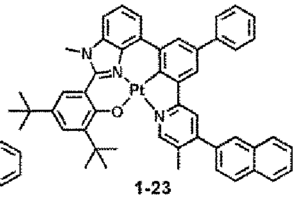
1-23
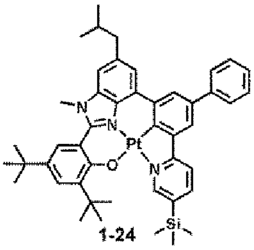
1-24

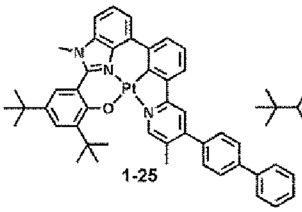
1-25
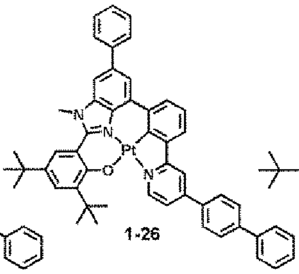
1-26
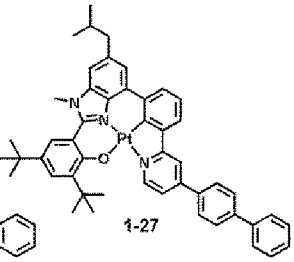
1-27
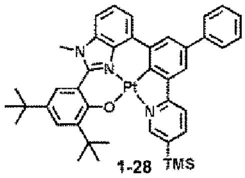
1-28

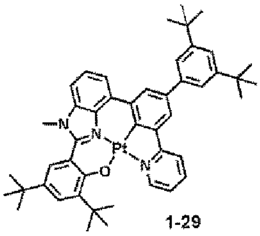
1-29
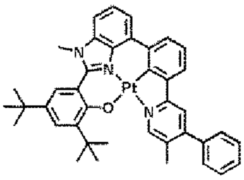
1-30
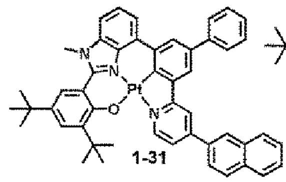
1-31
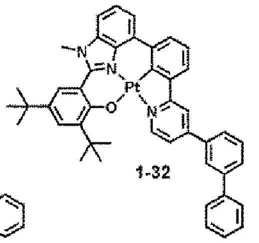
1-32

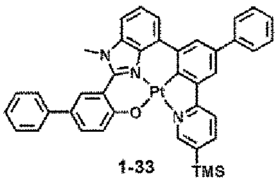
1-33
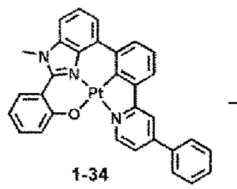
1-34
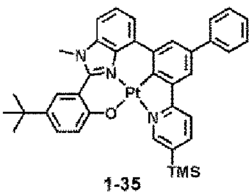
1-35
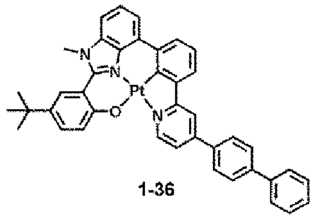
1-36

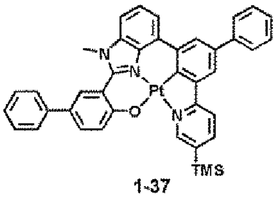
1-37
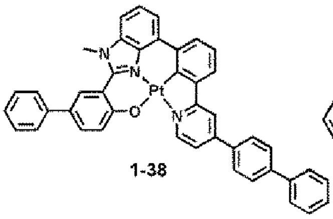
1-38
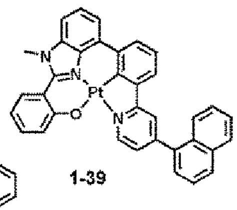
1-39
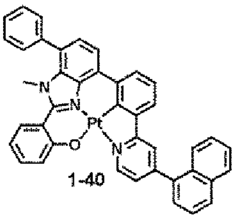
1-40

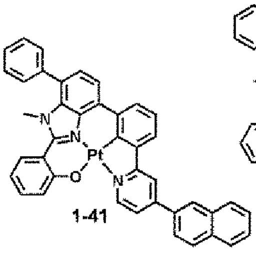
1-41
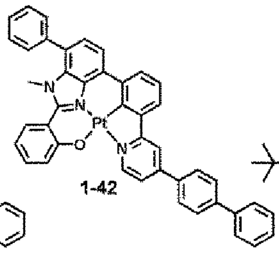
1-42
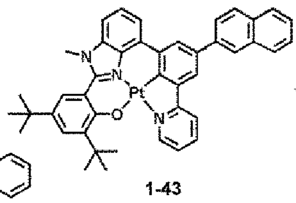
1-43
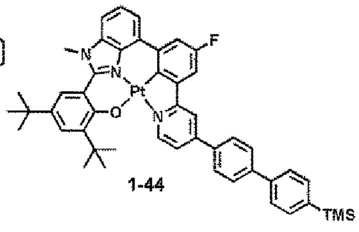
1-44

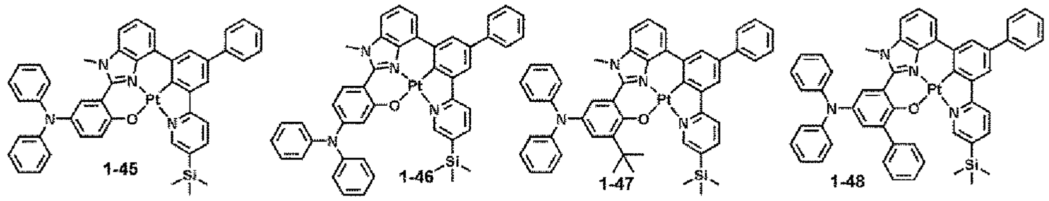

1-45 1-46 1-47 1-48

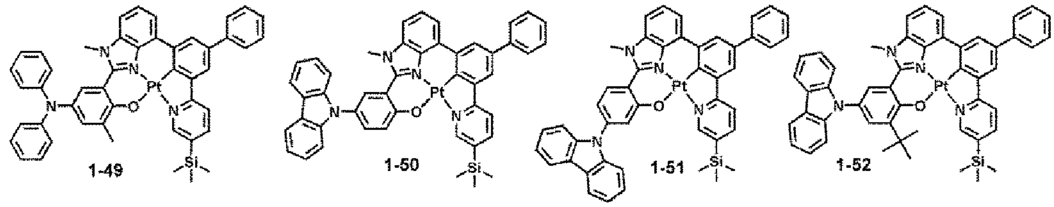

1-49 1-50 1-51 1-52

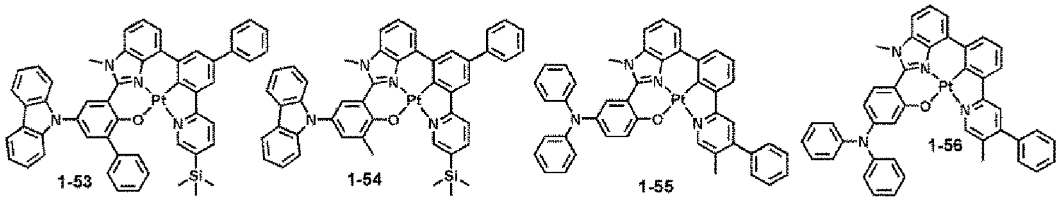

1-53 1-54 1-55 1-56

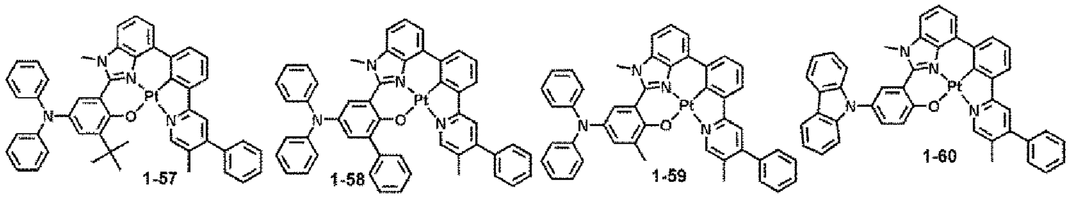

1-57 1-58 1-59 1-60

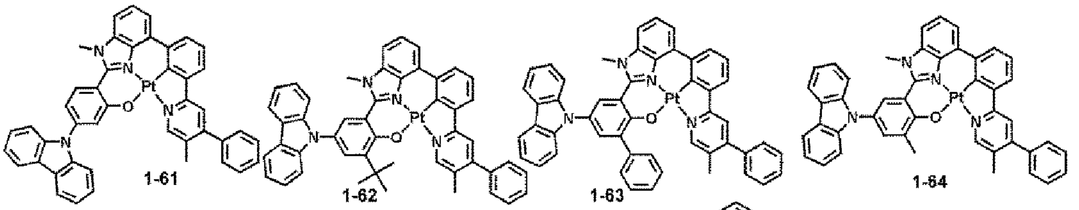

1-61 1-62 1-63 1-64

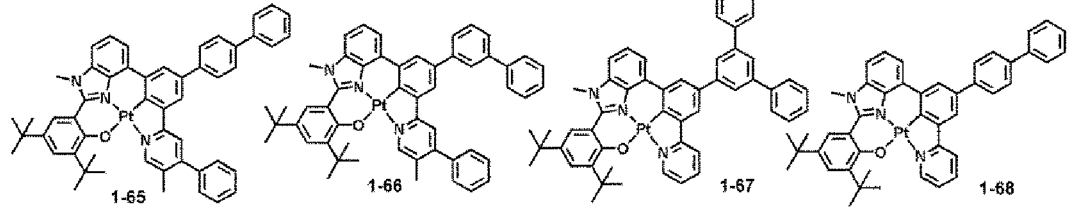

1-65 1-66 1-67 1-68

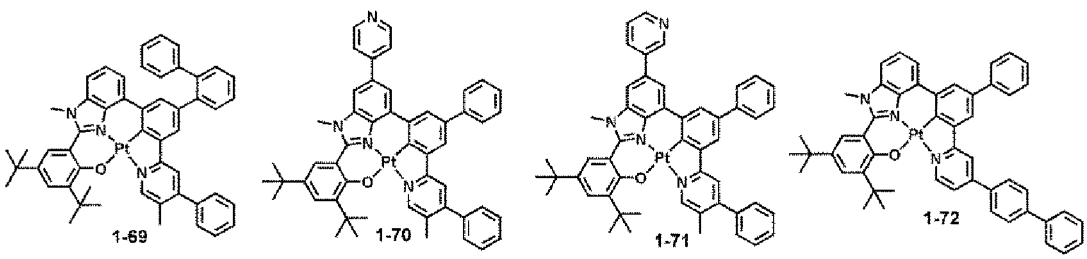

1-69 1-70 1-71 1-72

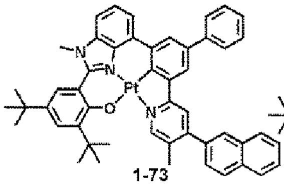
1-73

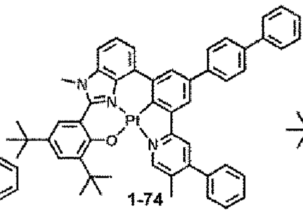
1-74

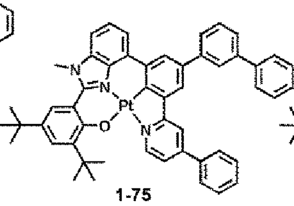
1-75

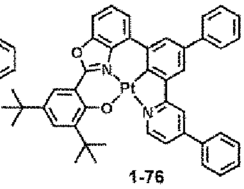
1-76

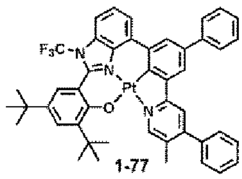
1-77

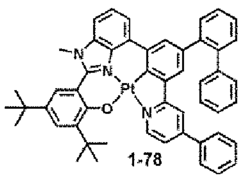
1-78

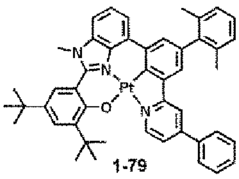
1-79

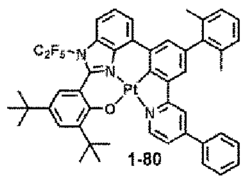
1-80

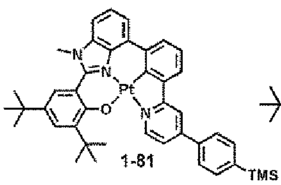
1-81

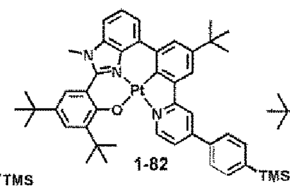
1-82

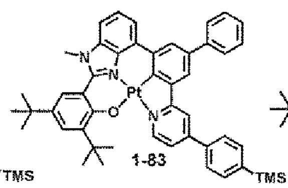
1-83

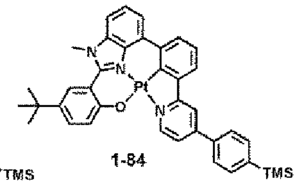
1-84

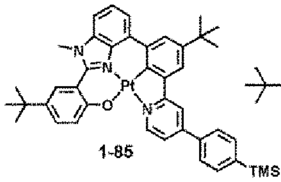
1-85

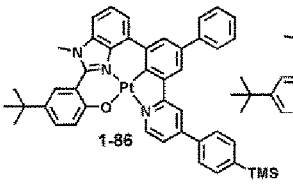
1-86

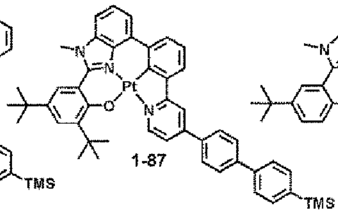
1-87

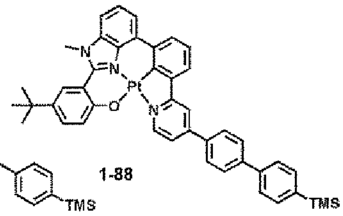
1-88

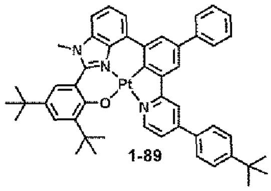
1-89

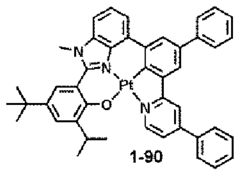
1-90

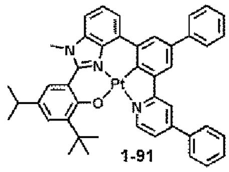
1-91

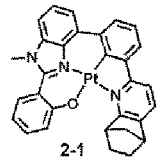
2-1

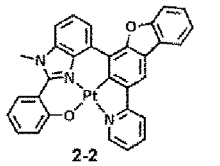
2-2

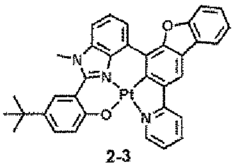
2-3

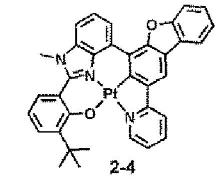
2-4

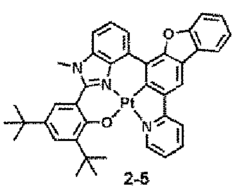
2-5

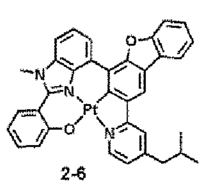
2-6

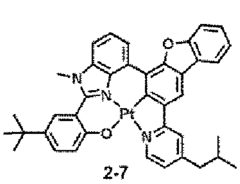
2-7

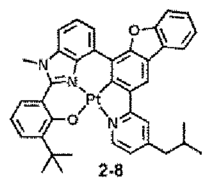
2-8

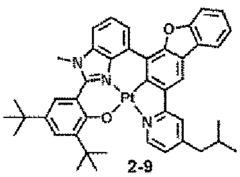
2-9

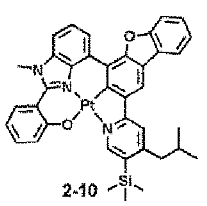
2-10

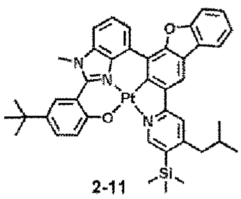
2-11

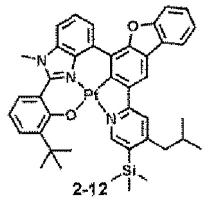
2-12

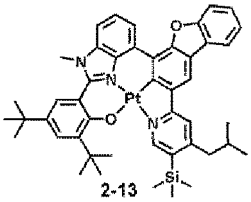
2-13

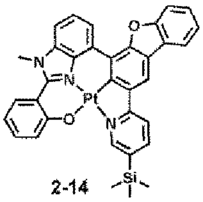
2-14

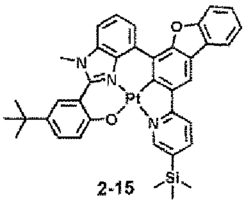
2-15

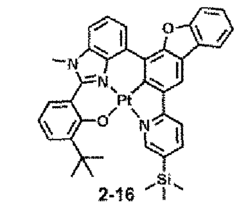
2-16

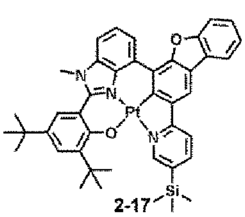
2-17

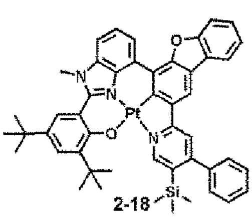
2-18

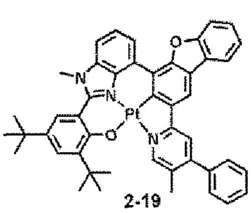
2-19

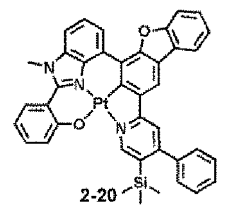
2-20

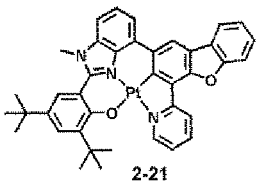
2-21

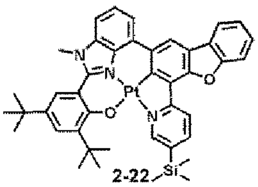
2-22

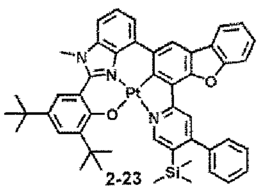
2-23

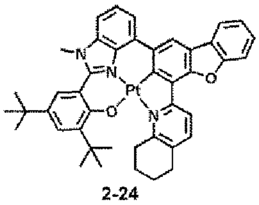
2-24

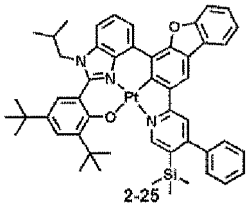
2-25

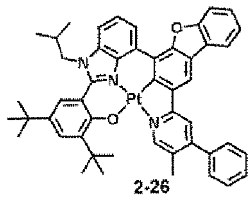
2-26

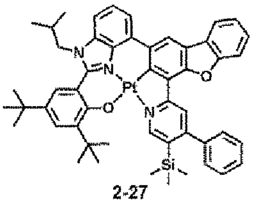
2-27

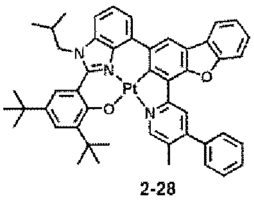
2-28

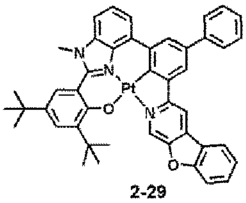
2-29

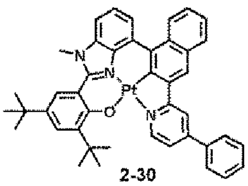
2-30

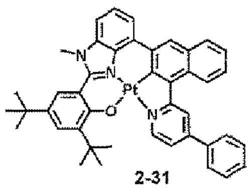
2-31

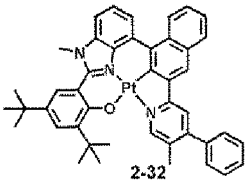
2-32

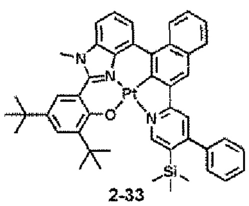
2-33

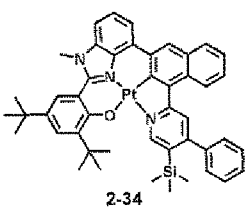
2-34

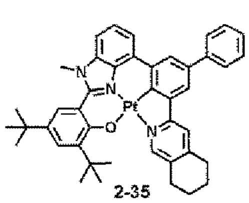
2-35

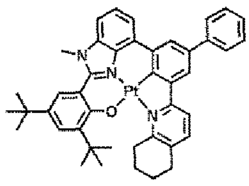
2-36

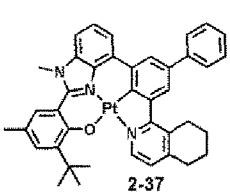
2-37

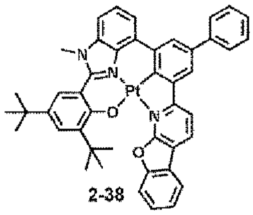
2-38

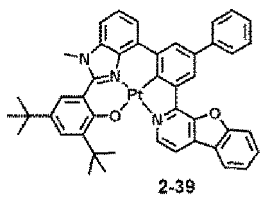
2-39

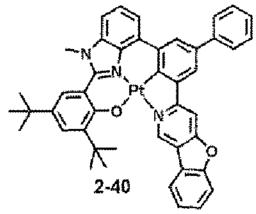
2-40

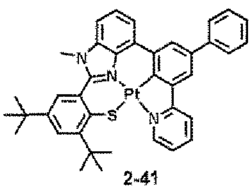
2-41

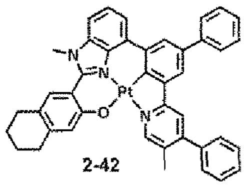
2-42

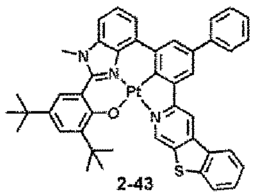
2-43

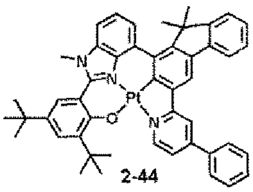
2-44

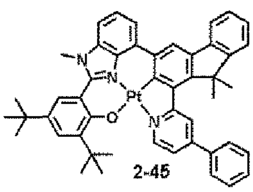
2-45

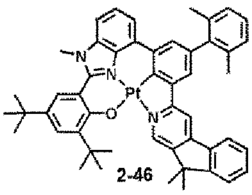
2-46

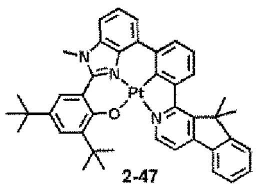
2-47

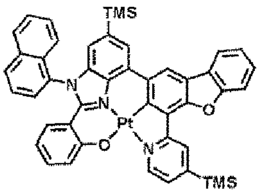
3-1

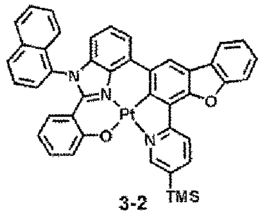
3-2

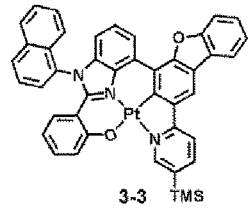
3-3

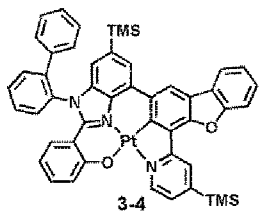
3-4

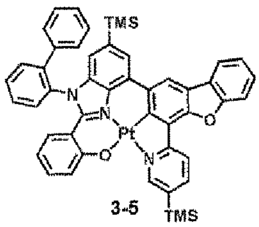
3-5

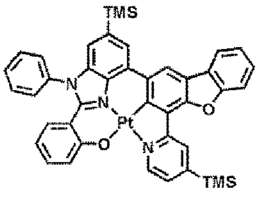
3-6

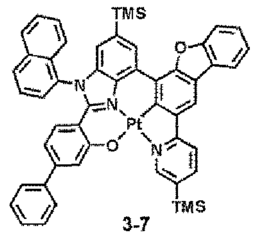
3-7

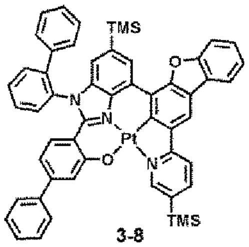
3-8

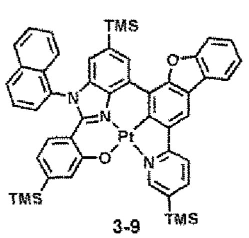
3-9

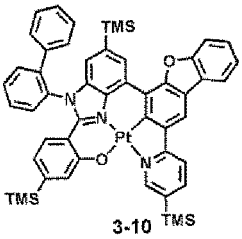
3-10

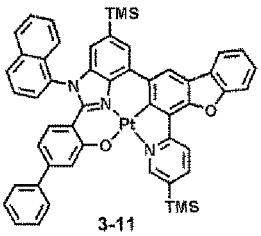
3-11

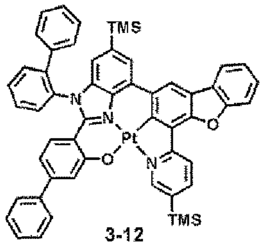
3-12

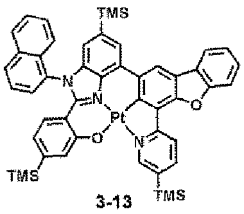
3-13

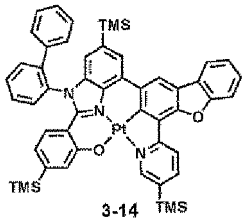
3-14

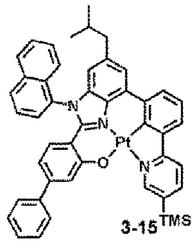
3-15

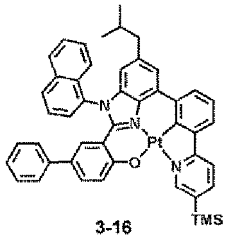
3-16

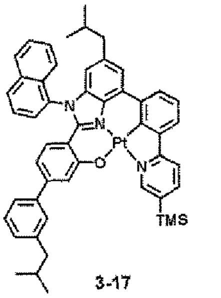
3-17

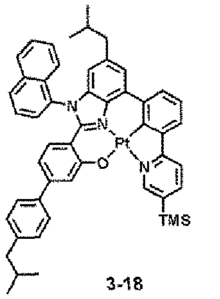
3-18

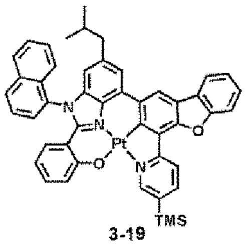
3-19

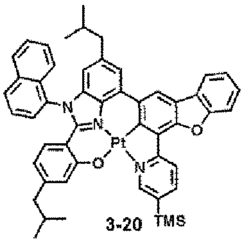
3-20

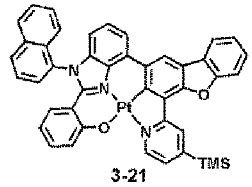
3-21

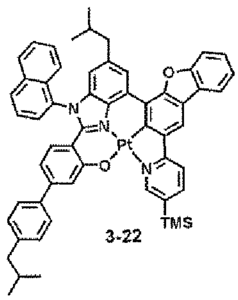
3-22

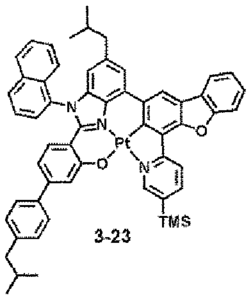
3-23

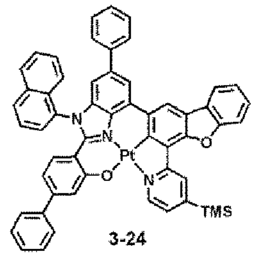
3-24

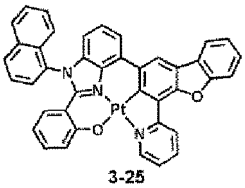
3-25

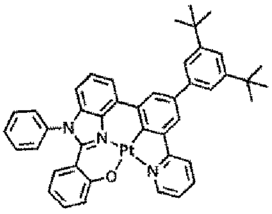
3-26

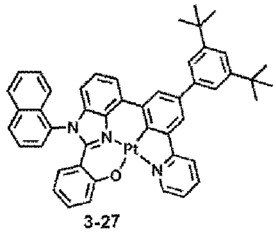
3-27

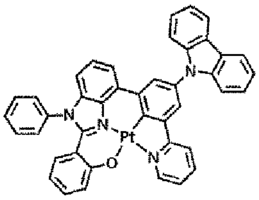
3-28

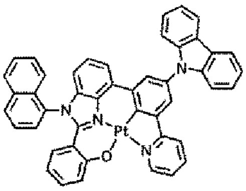
3-29

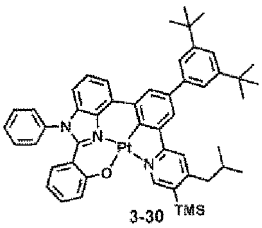
3-30

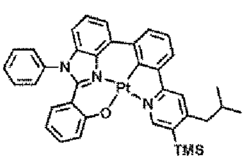
3-31

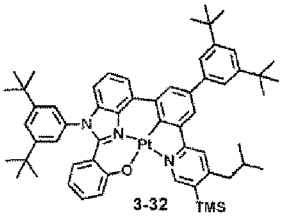
3-32

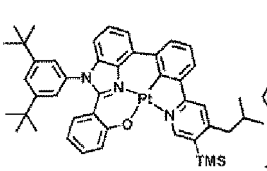
3-33

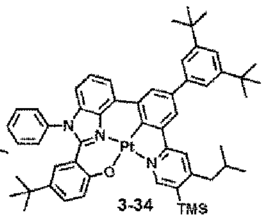
3-34

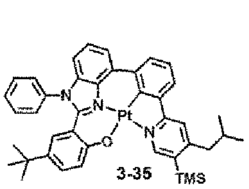
3-35

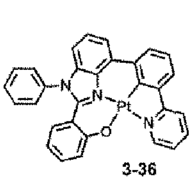
3-36

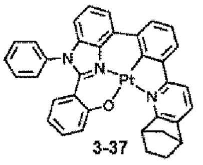
3-37

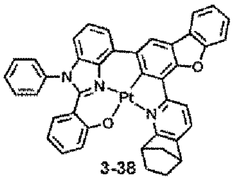
3-38

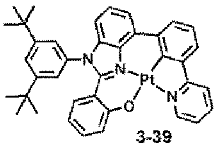
3-39

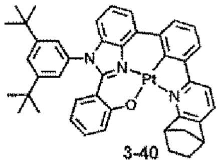
3-40

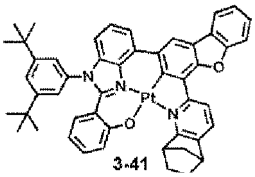
3-41

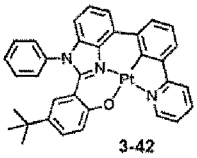
3-42

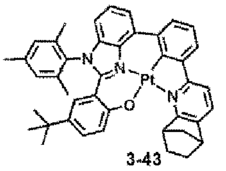
3-43

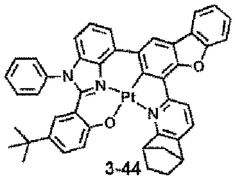
3-44

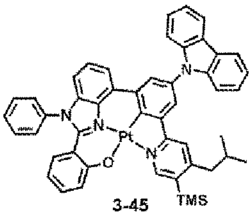
3-45

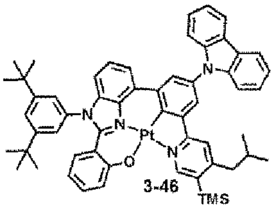
3-46

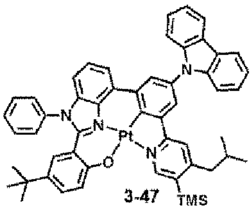
3-47

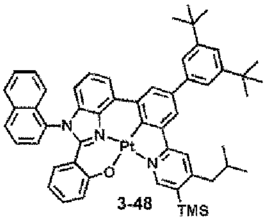
3-48

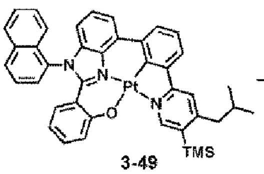
3-49

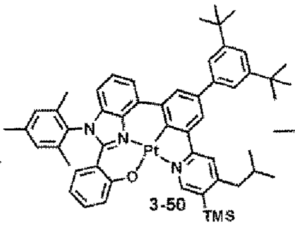
3-50

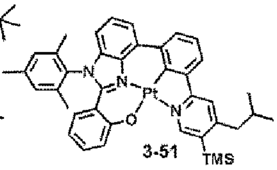
3-51

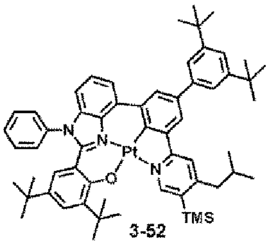
3-52

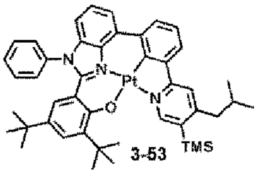
3-53

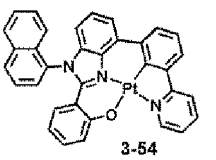
3-54

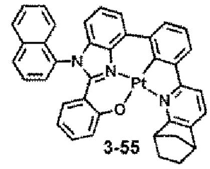
3-55

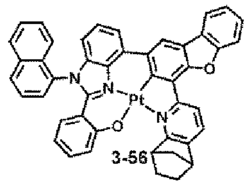
3-56

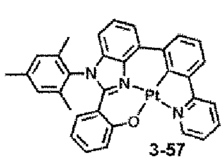
3-57

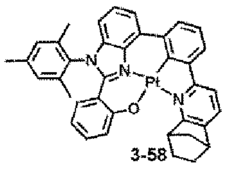
3-58

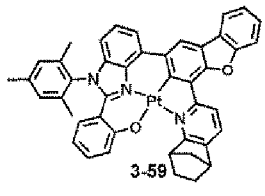
3-59

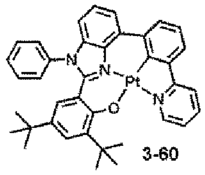
3-60

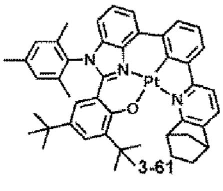
3-61

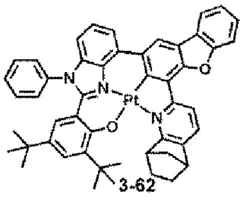
3-62

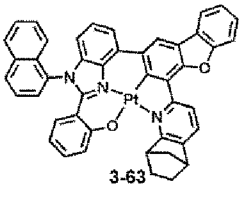
3-63

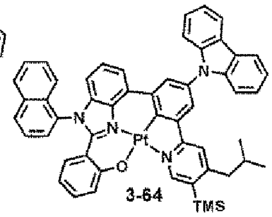
3-64

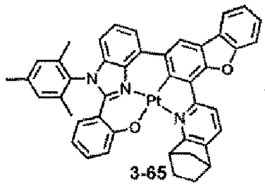
3-65

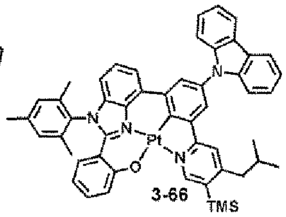
3-66

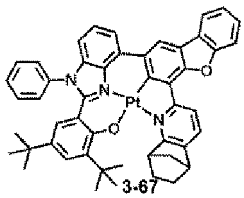
3-67

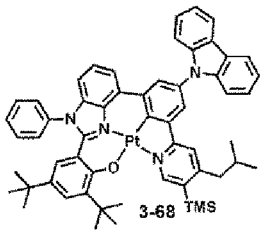
3-68

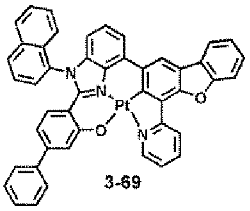
3-69

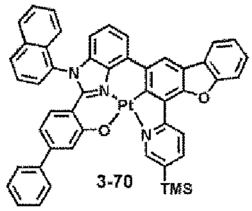
3-70

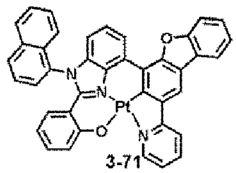
3-71

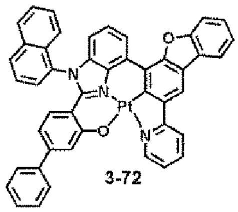
3-72

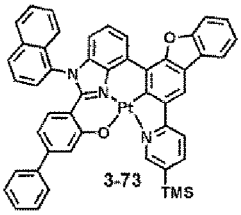
3-73

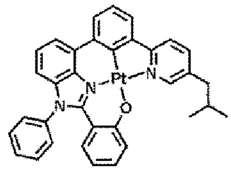
3-74

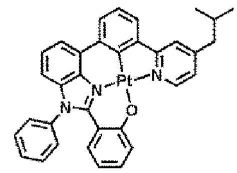
3-75

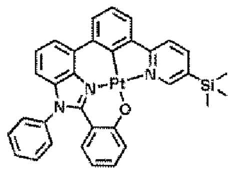
3-76

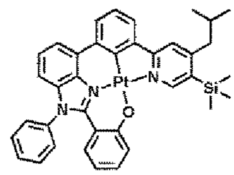
3-77

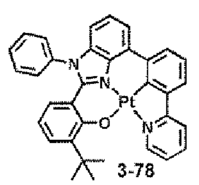
3-78

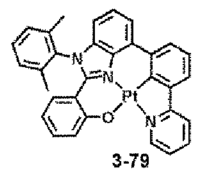
3-79

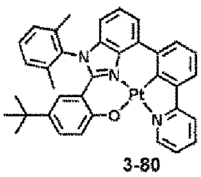
3-80

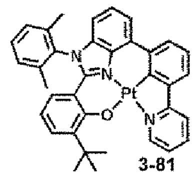
3-81

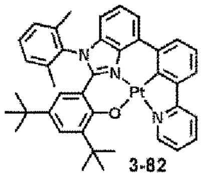
3-82

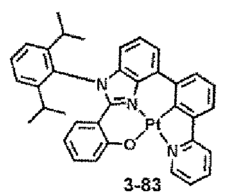
3-83

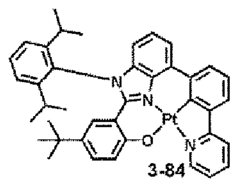
3-84

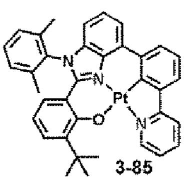
3-85

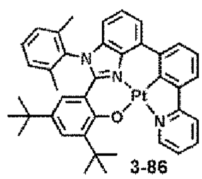
3-86

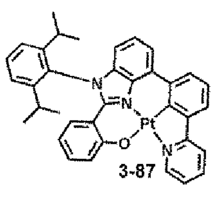
3-87

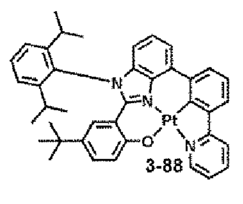
3-88

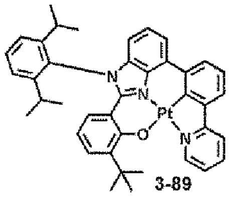
3-89

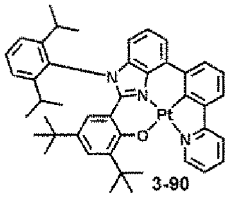
3-90

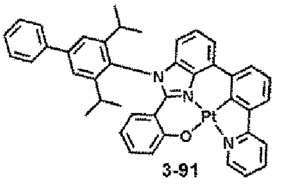
3-91

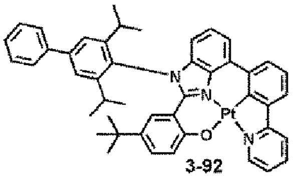
3-92

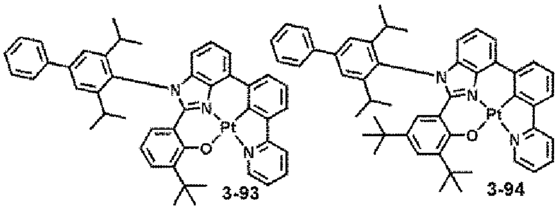

3-93 3-94

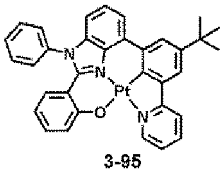

3-95

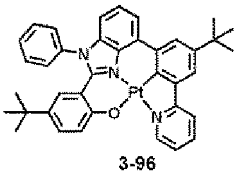

3-96

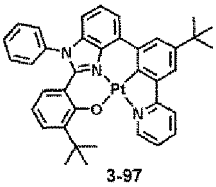

3-97

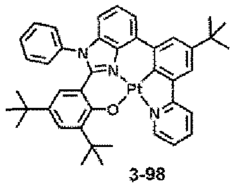

3-98

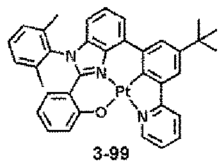

3-99

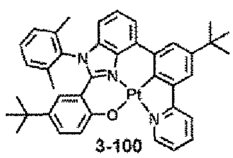

3-100

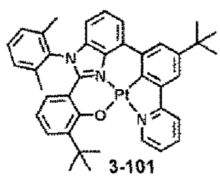

3-101

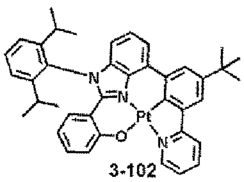

3-102

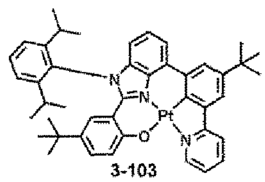

3-103

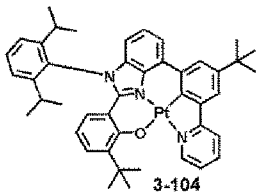

3-104

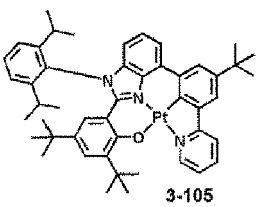

3-105

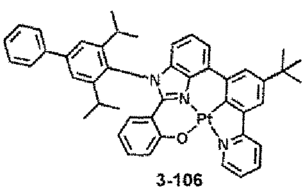

3-106

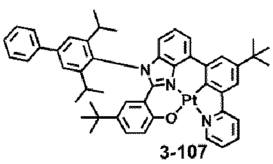

3-107

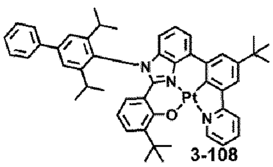

3-108

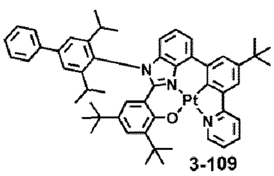

3-109

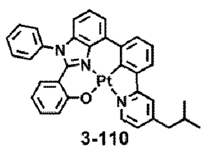

3-110

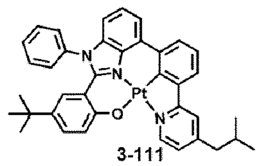

3-111

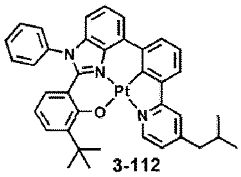

3-112

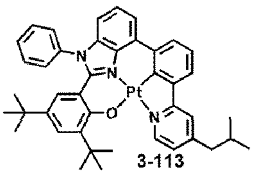

3-113

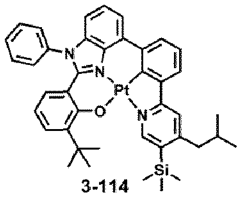

3-114

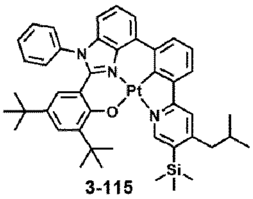

3-115

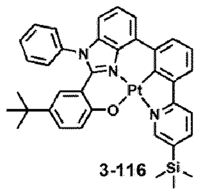
3-116

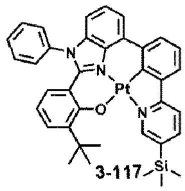
3-117

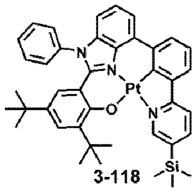
3-118

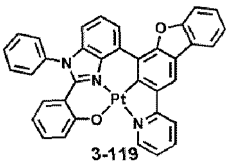
3-119

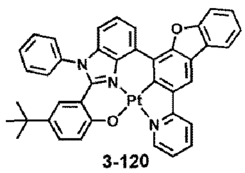
3-120

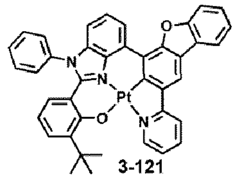
3-121

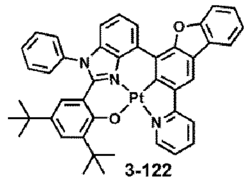
3-122

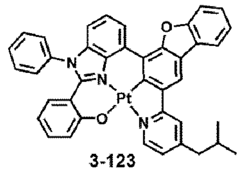
3-123

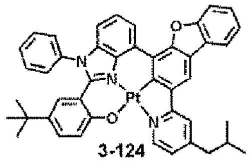
3-124

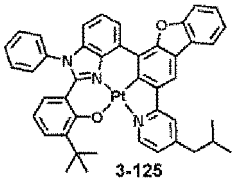
3-125

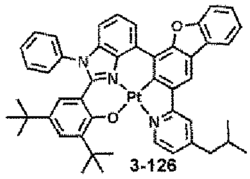
3-126

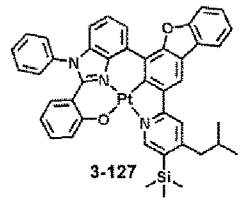
3-127

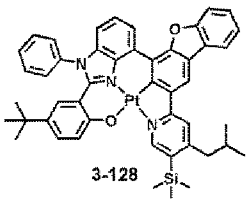
3-128

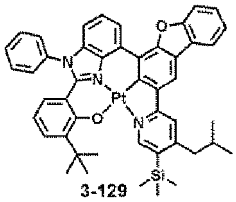
3-129

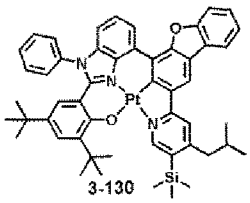
3-130

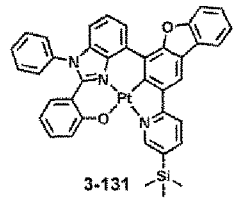
3-131

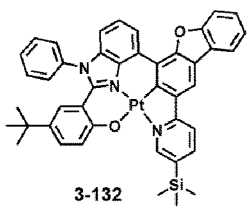
3-132

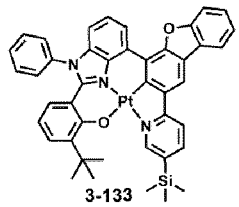
3-133

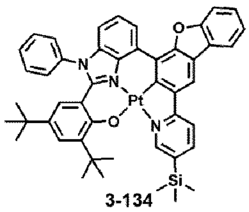
3-134

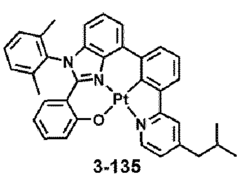
3-135

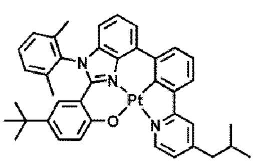
3-136

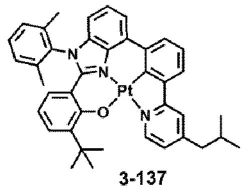
3-137

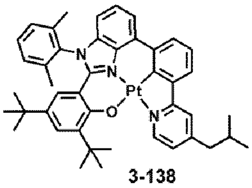
3-138

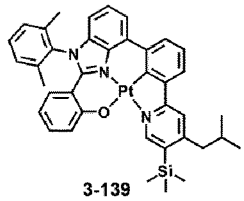
3-139

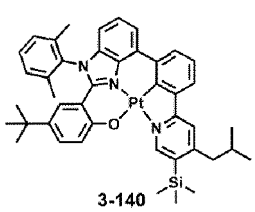
3-140

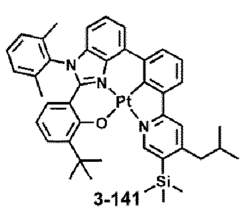
3-141

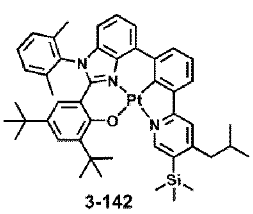
3-142

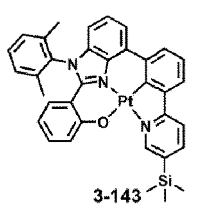
3-143

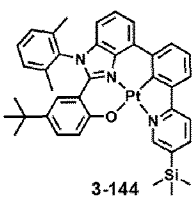
3-144

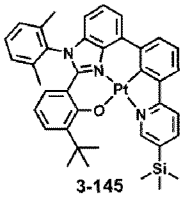
3-145

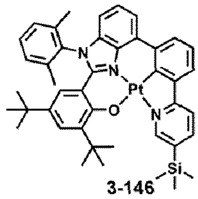
3-146

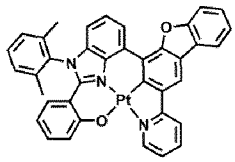
3-147

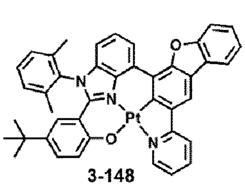
3-148

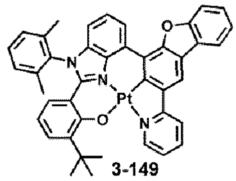
3-149

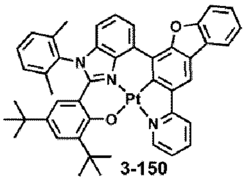
3-150

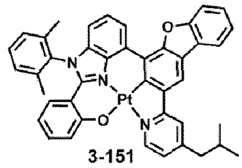
3-151

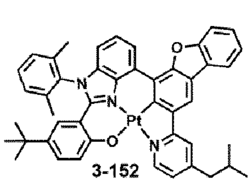
3-152

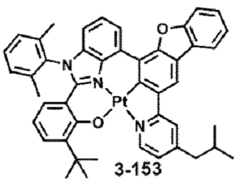
3-153

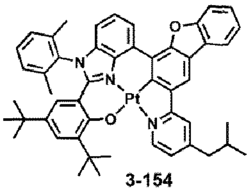
3-154

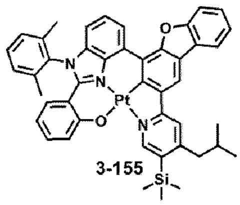
3-155

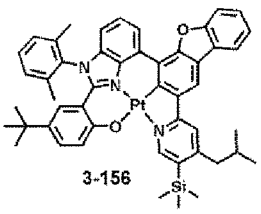
3-156

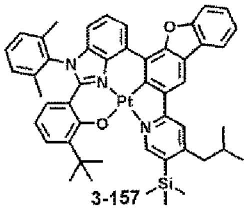
3-157

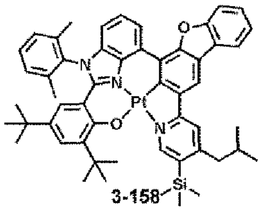
3-158

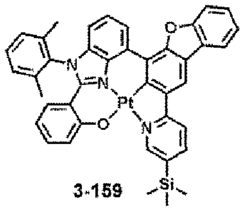
3-159

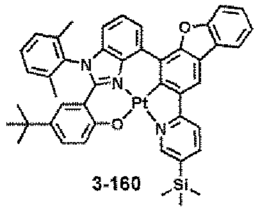
3-160

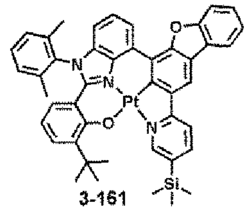
3-161

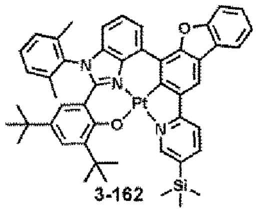
3-162

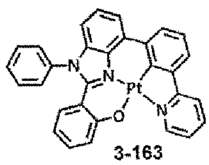
3-163

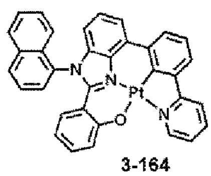
3-164

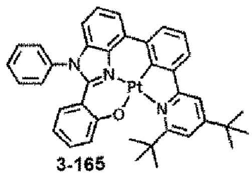
3-165

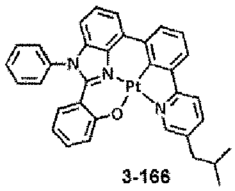
3-166

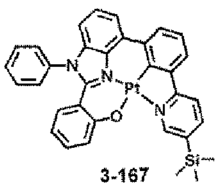
3-167

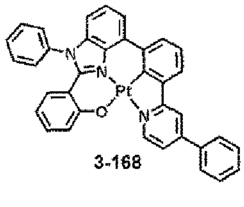
3-168

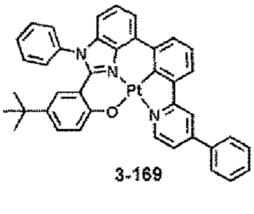
3-169

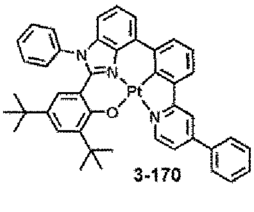
3-170

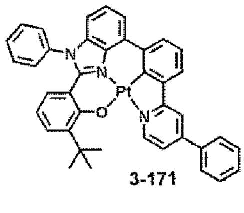
3-171

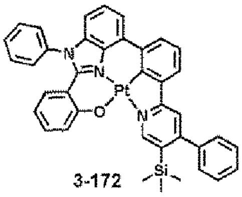
3-172

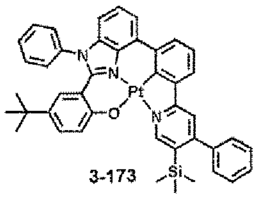
3-173

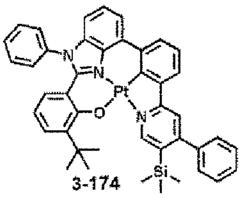
3-174

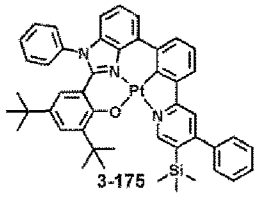
3-175

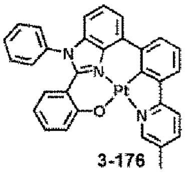
3-176

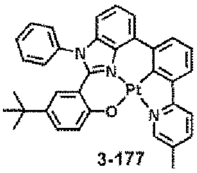
3-177

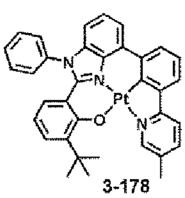
3-178

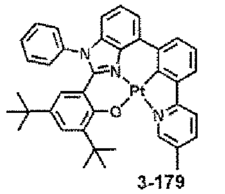
3-179

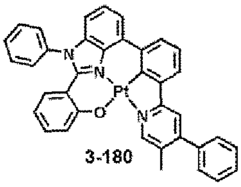
3-180

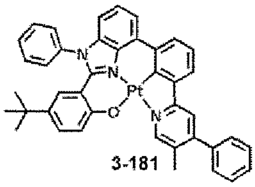
3-181

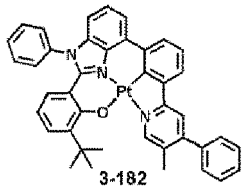
3-182

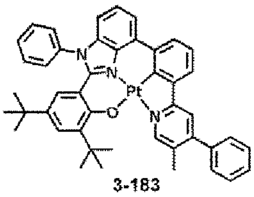
3-183

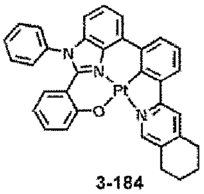
3-184

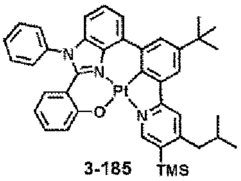
3-185

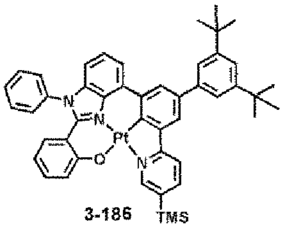
3-186

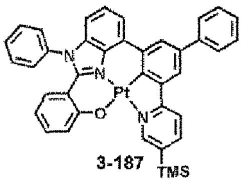
3-187

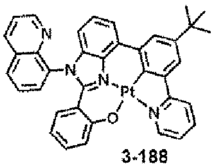
3-188

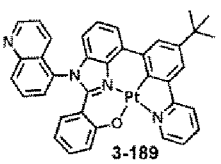
3-189

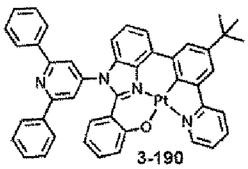
3-190

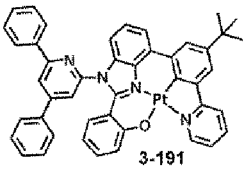
3-191

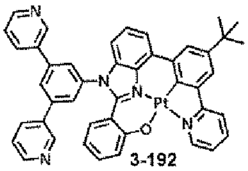
3-192

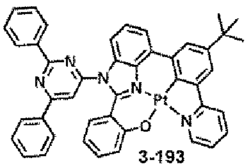
3-193

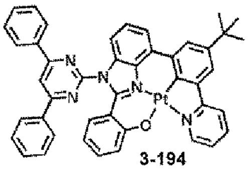
3-194

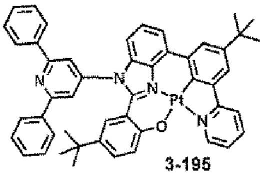
3-195

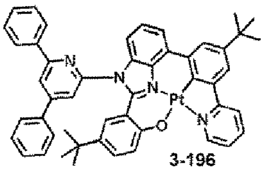
3-196

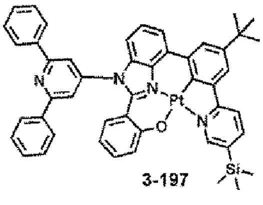
3-197

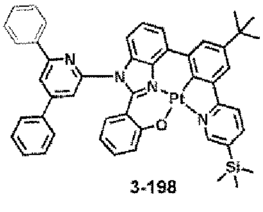
3-198

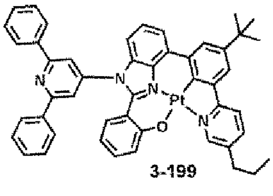
3-199

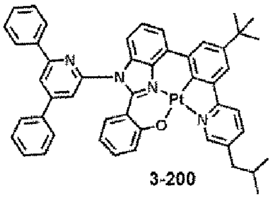

3-200

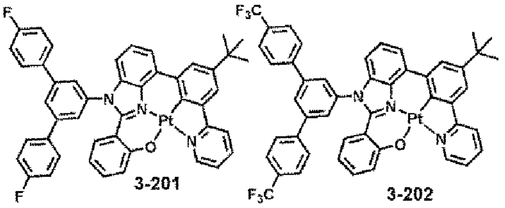

3-201

3-202

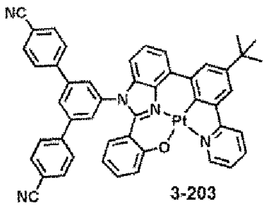

3-203

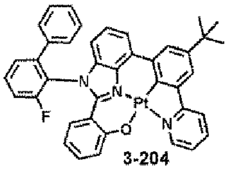

3-204

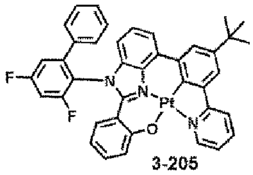

3-205

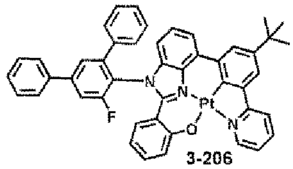

3-206

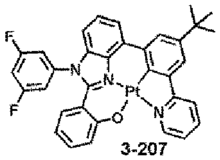

3-207

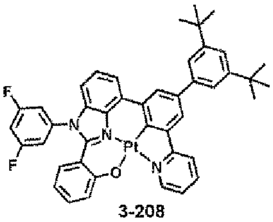

3-208

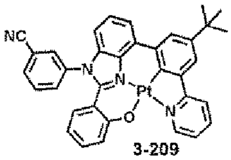

3-209

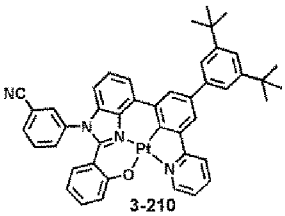

3-210

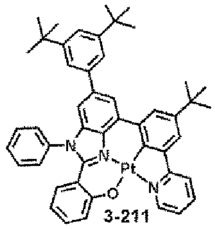

3-211

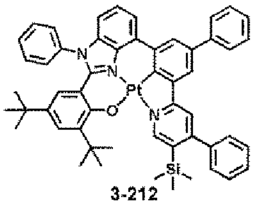

3-212

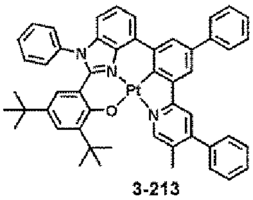

3-213

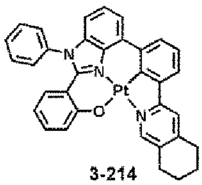

3-214

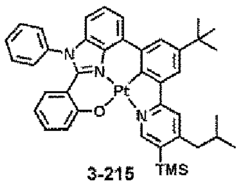

3-215

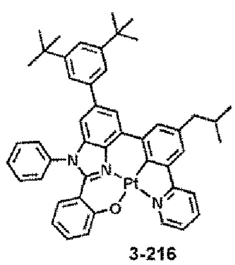

3-216

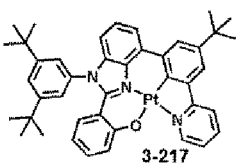

3-217

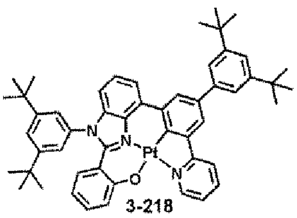

3-218

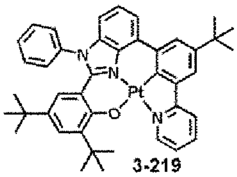

3-219

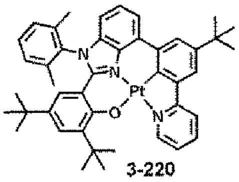

3-220

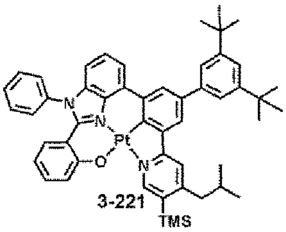

3-221

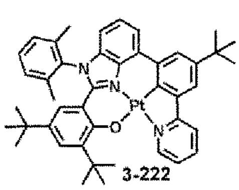

3-222

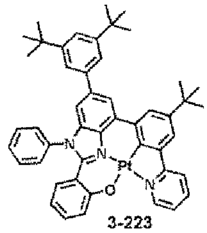
3-223

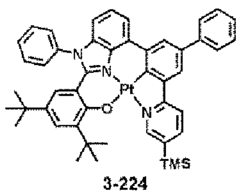
3-224

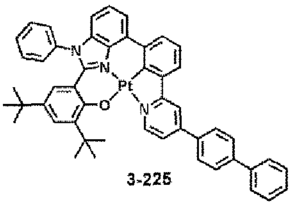
3-225

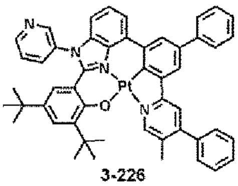
3-226

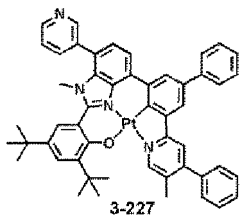
3-227

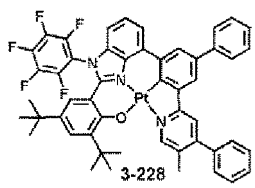
3-228

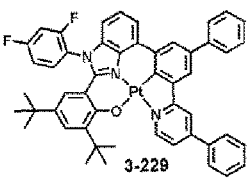
3-229

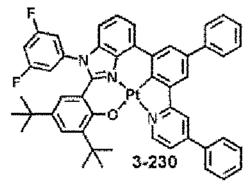
3-230

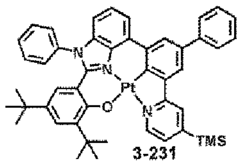
3-231

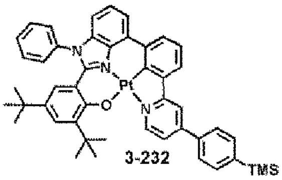
3-232

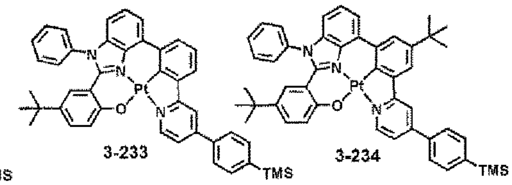
3-233

3-234

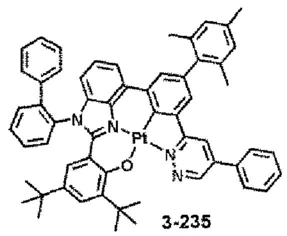
3-235

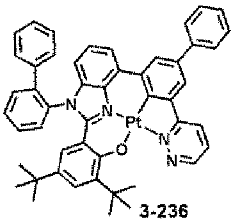
3-236

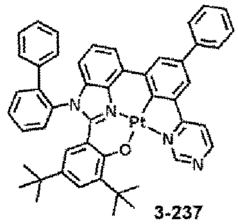
3-237

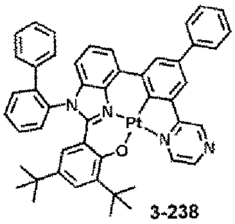
3-238

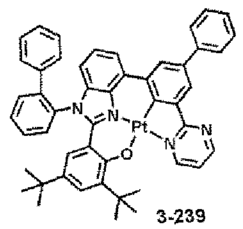
3-239

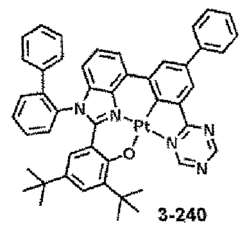
3-240

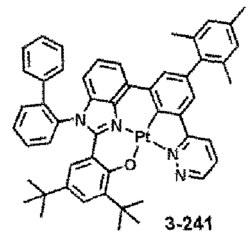
3-241

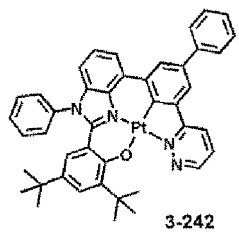
3-242

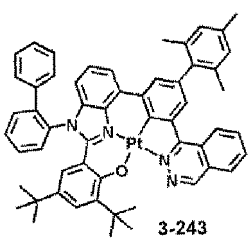
3-243

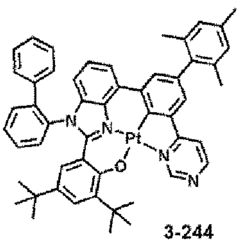
3-244

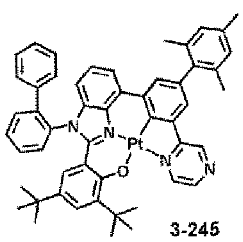
3-245

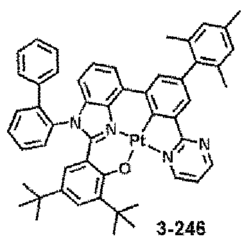
3-246

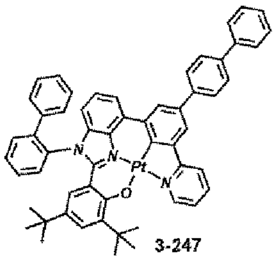
3-247

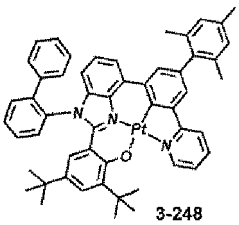
3-248

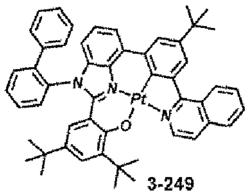
3-249

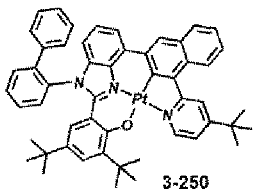
3-250

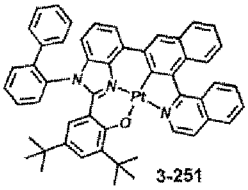
3-251

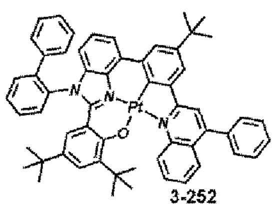
3-252

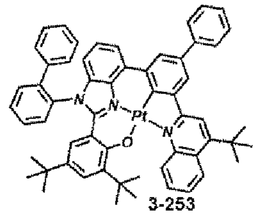
3-253

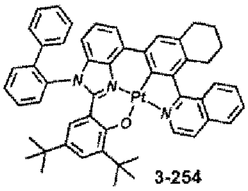
3-254

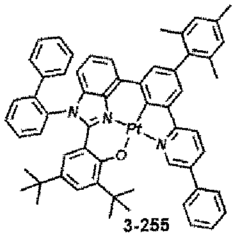
3-255

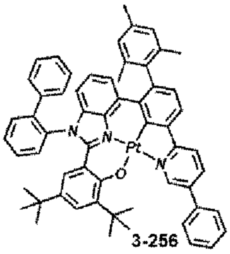
3-256

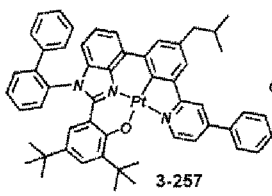
3-257

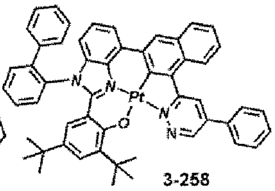
3-258

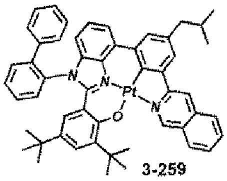
3-259

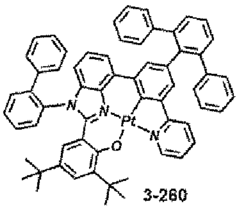
3-260

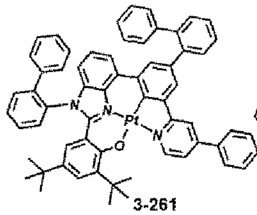
3-261

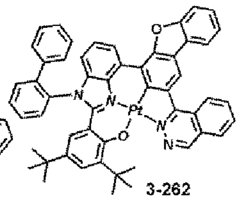
3-262

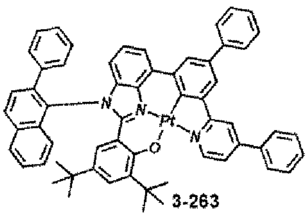
3-263

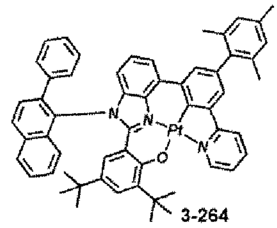
3-264

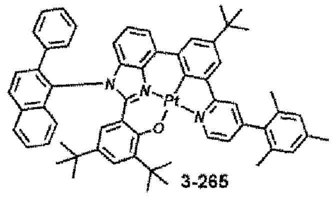
3-265

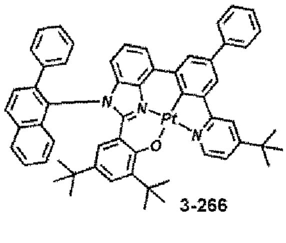
3-266

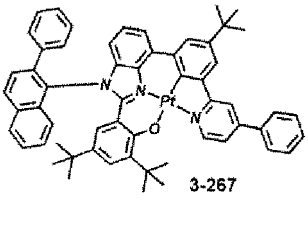
3-267

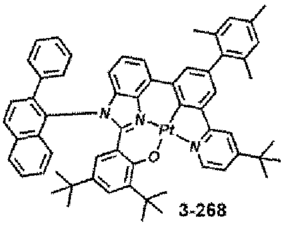
3-268

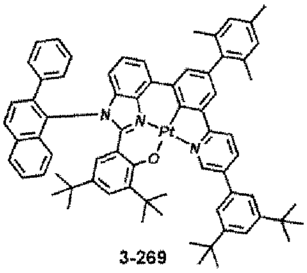
3-269

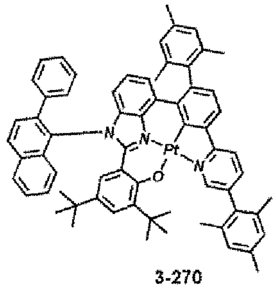
3-270

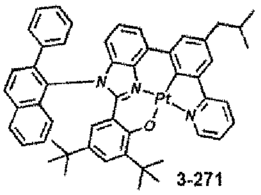
3-271

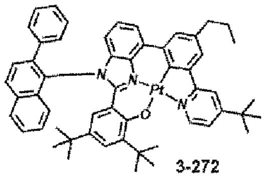
3-272

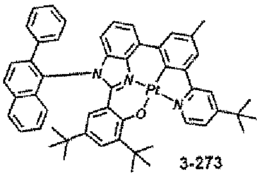
3-273

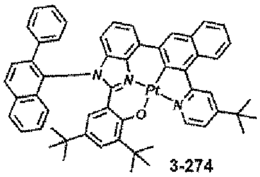
3-274

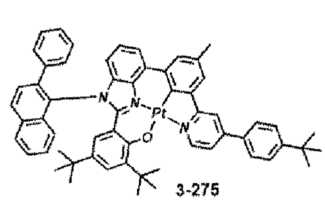
3-275

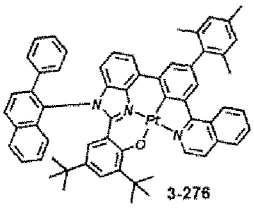
3-276

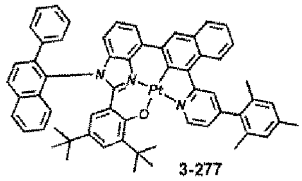
3-277

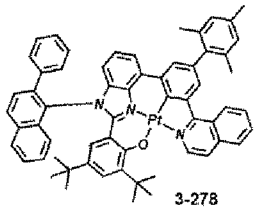
3-278

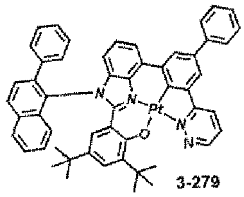
3-279

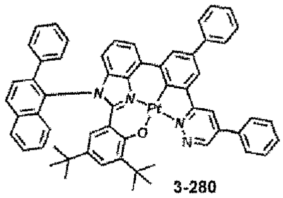
3-280

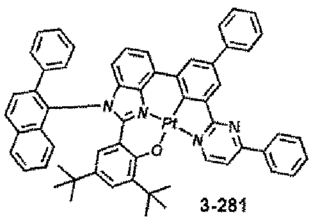
3-281

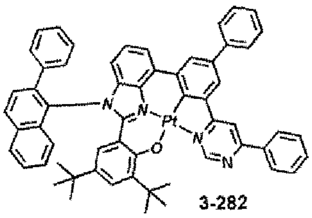
3-282

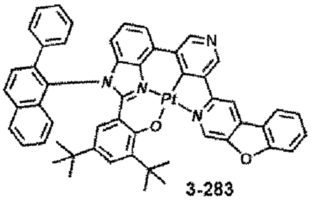
3-283

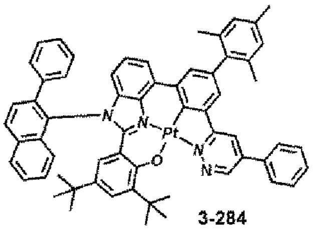
3-284

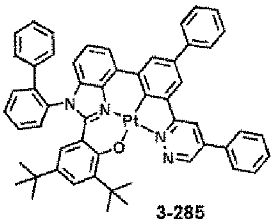
3-285

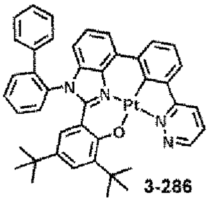
3-286

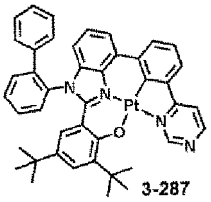
3-287

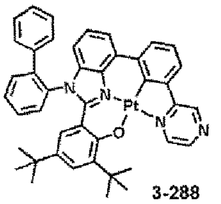
3-288

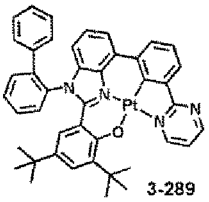
3-289

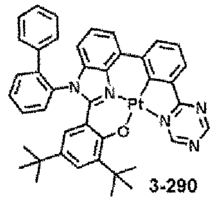
3-290

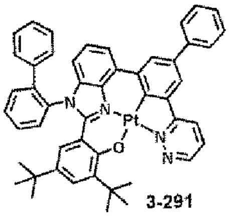
3-291

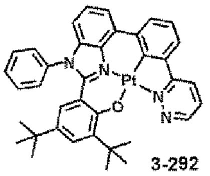
3-292

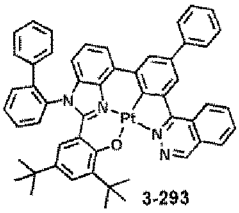
3-293

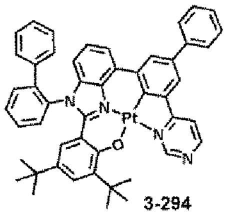
3-294

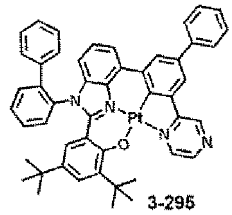
3-295

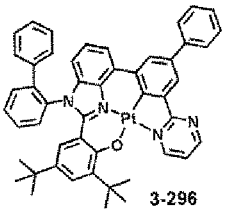
3-296

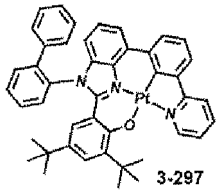
3-297

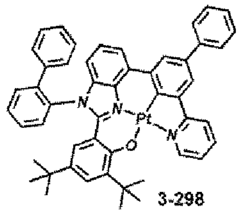
3-298

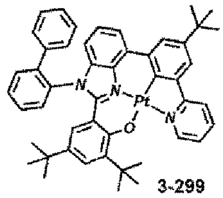
3-299

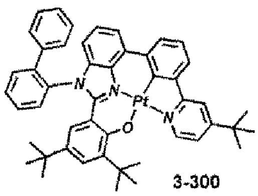
3-300

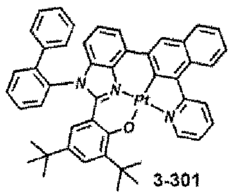
3-301

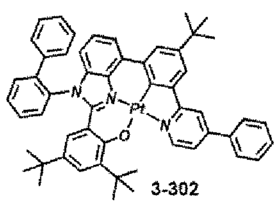
3-302

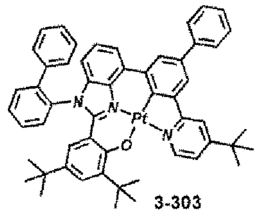
3-303

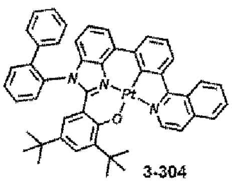
3-304

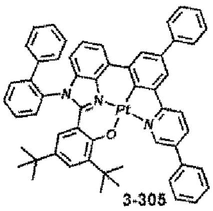
3-305

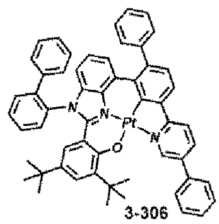
3-306

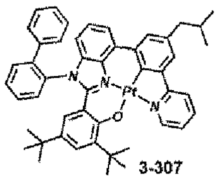
3-307

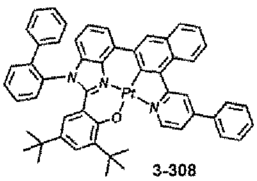
3-308

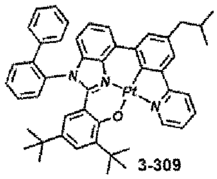
3-309

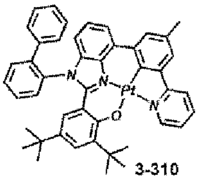
3-310

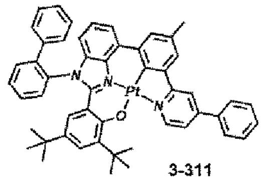
3-311

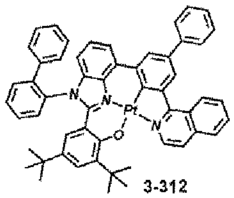
3-312

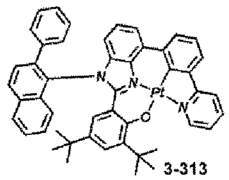
3-313

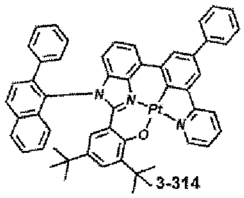
3-314

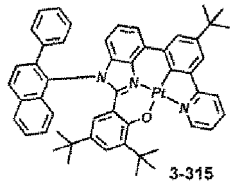
3-315

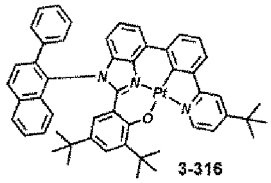
3-316

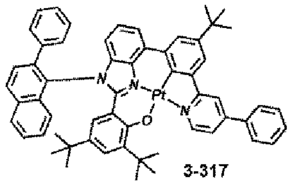
3-317

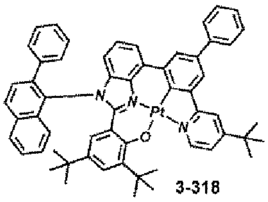
3-318

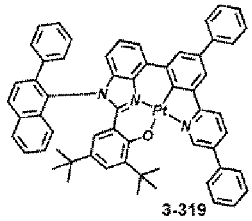
3-319

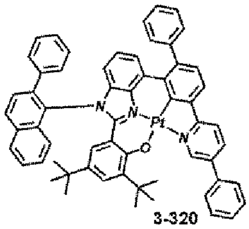
3-320

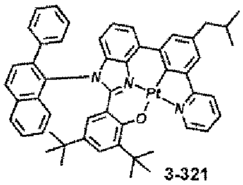
3-321

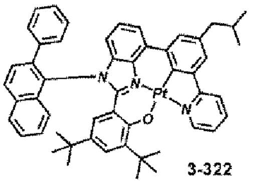
3-322

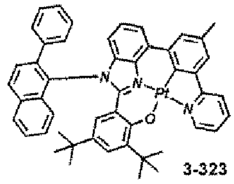
3-323

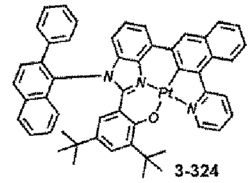
3-324

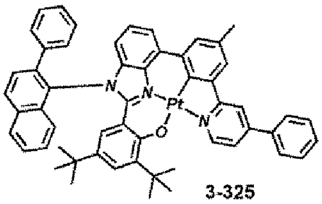
3-325

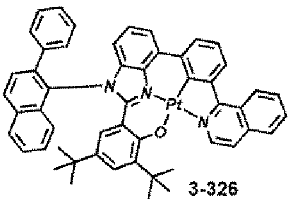
3-326

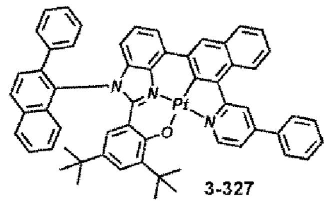
3-327

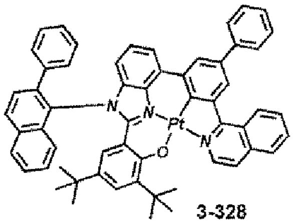
3-328

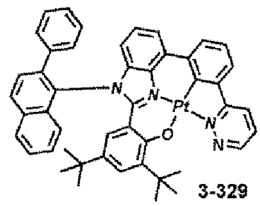
3-329

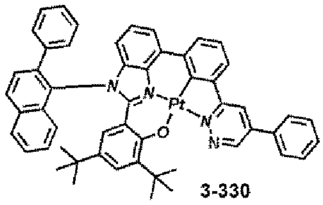
3-330

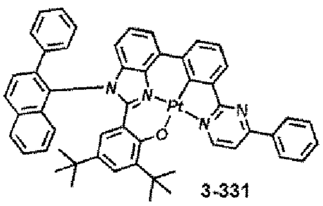
3-331

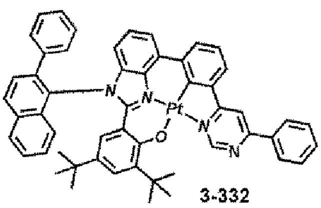
3-332

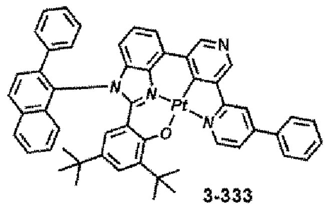
3-333

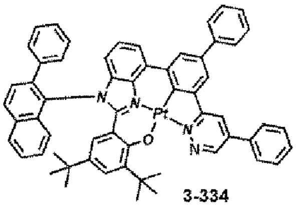
3-334

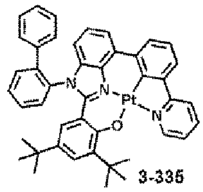
3-335

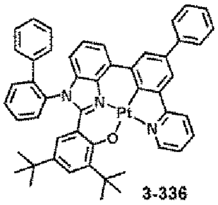
3-336

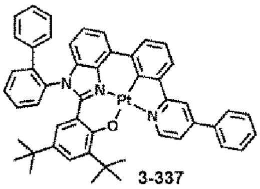
3-337

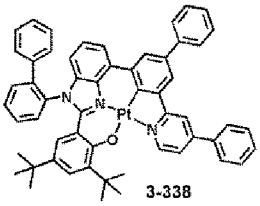
3-338

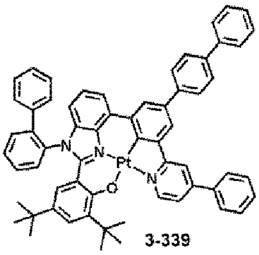
3-339

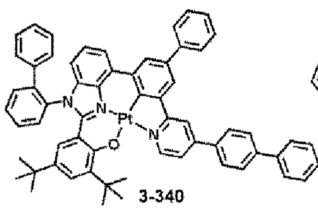
3-340

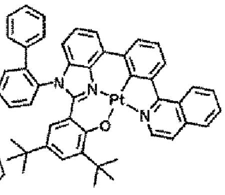
3-341

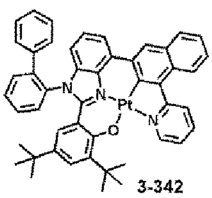
3-342

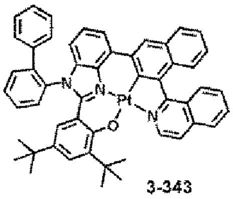
3-343

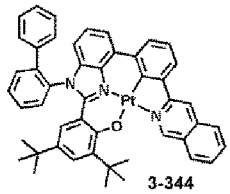
3-344

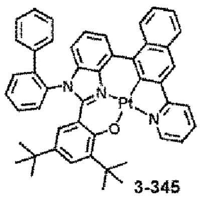
3-345

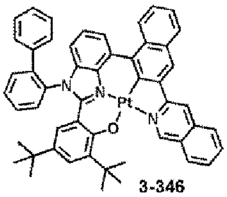
3-346

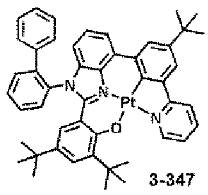
3-347

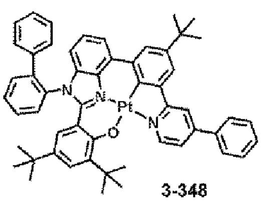
3-348

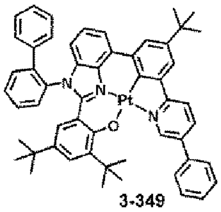
3-349

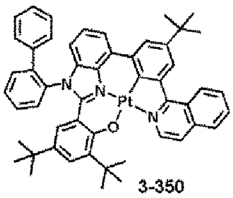
3-350

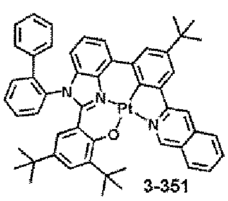
3-351

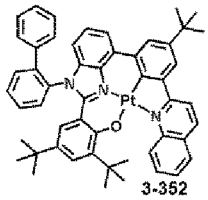
3-352

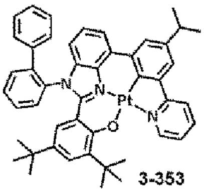
3-353

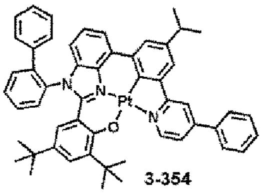
3-354

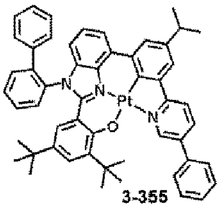
3-355

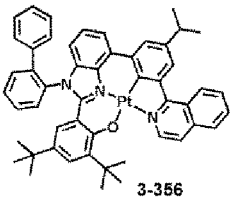
3-356

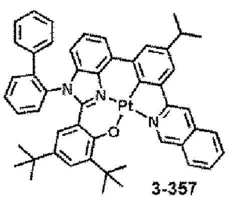
3-357

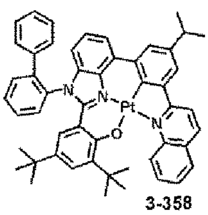
3-358

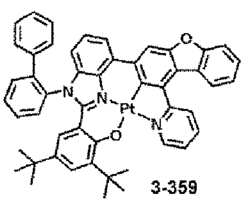
3-359

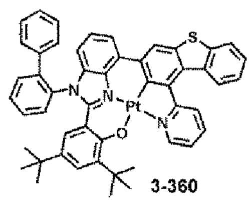
3-360

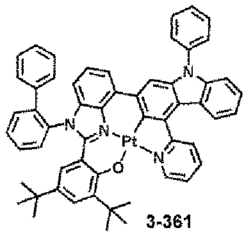
3-361

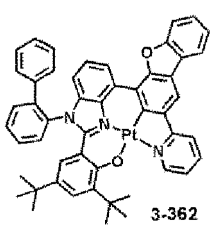
3-362

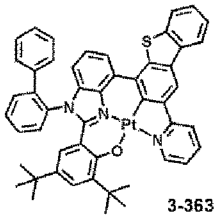
3-363

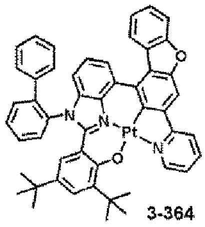
3-364

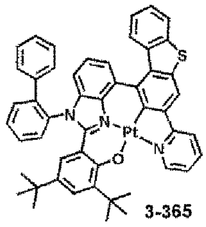
3-365

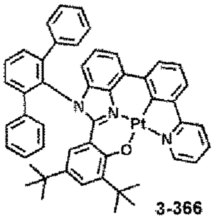
3-366

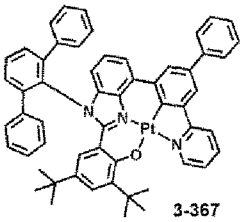
3-367

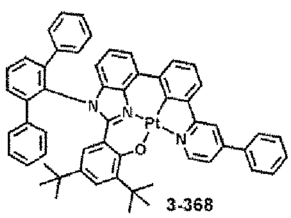
3-368

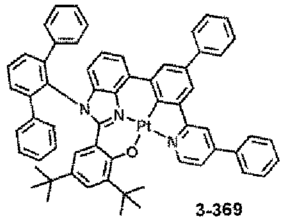
3-369

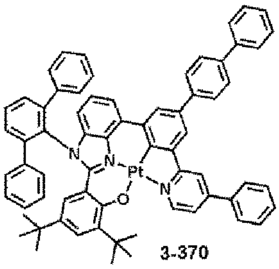
3-370

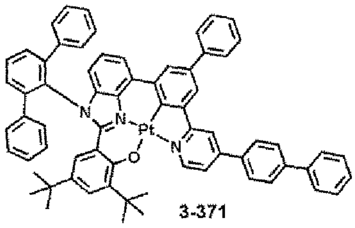
3-371

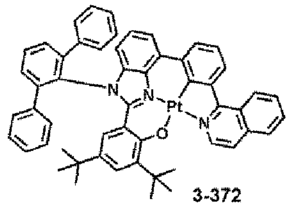
3-372

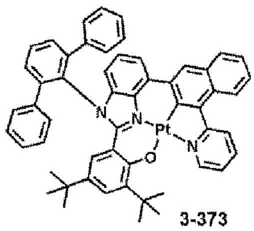
3-373

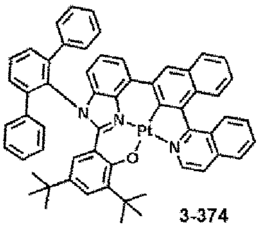
3-374

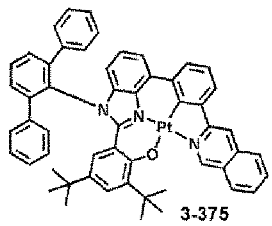
3-375

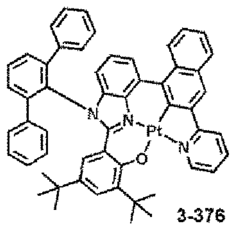
3-376

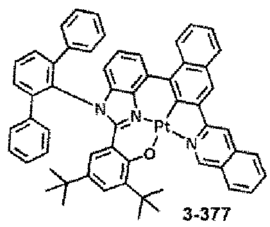
3-377

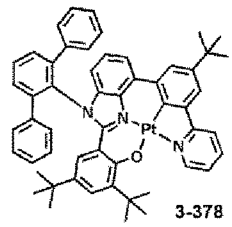
3-378

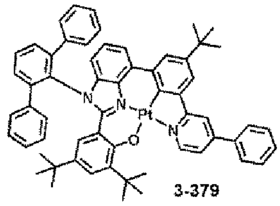
3-379

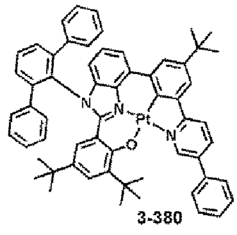
3-380

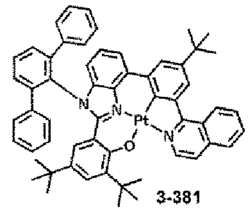
3-381

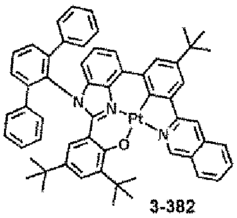
3-382

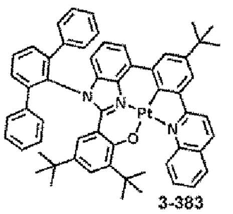
3-383

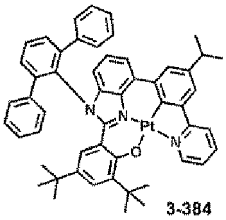
3-384

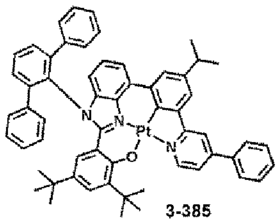
3-385

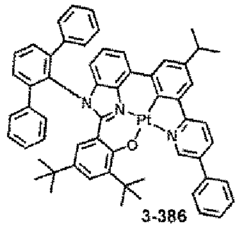
3-386

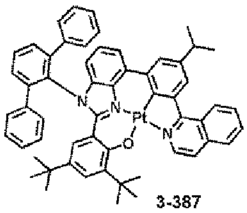
3-387

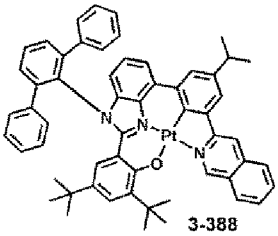
3-388

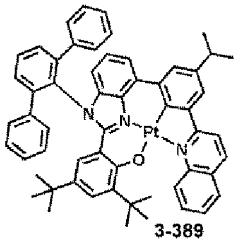
3-389

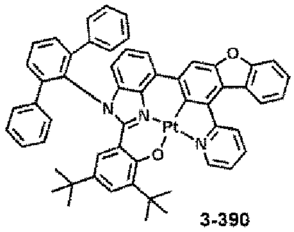
3-390

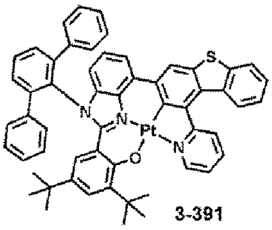
3-391

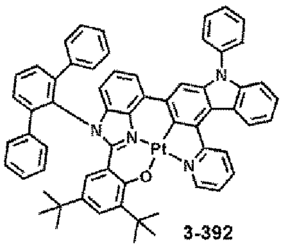
3-392

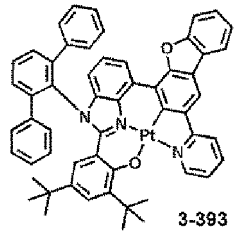
3-393

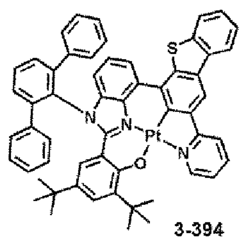
3-394

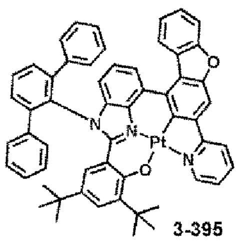
3-395

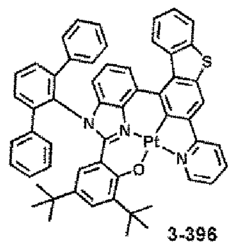
3-396

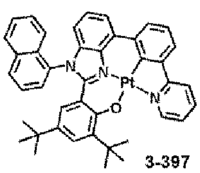
3-397

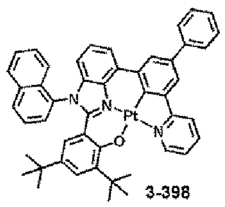
3-398

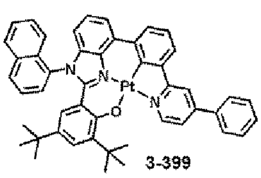
3-399

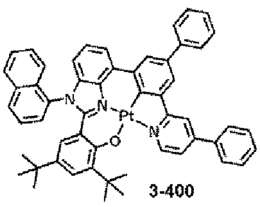
3-400

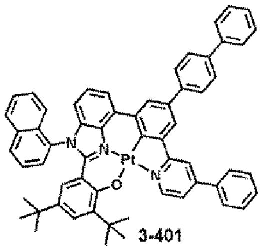
3-401

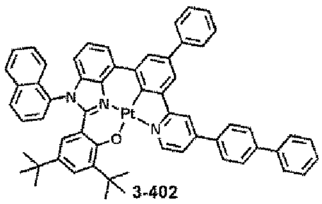
3-402

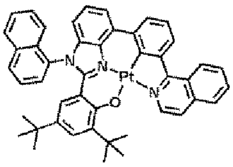
3-403

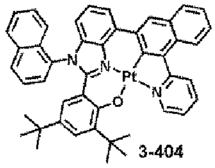
3-404

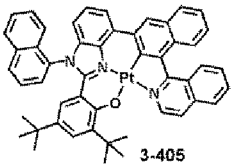
3-405

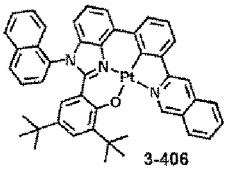
3-406

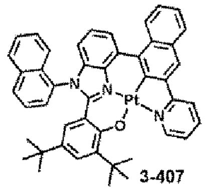
3-407

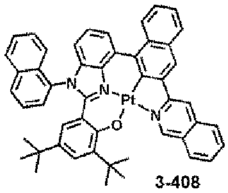
3-408

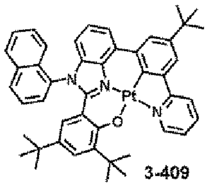
3-409

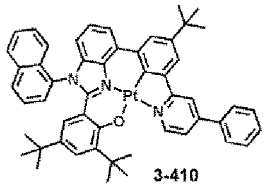
3-410

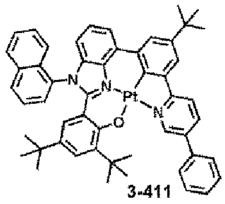
3-411

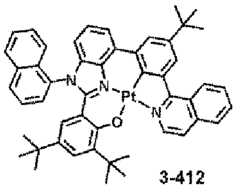
3-412

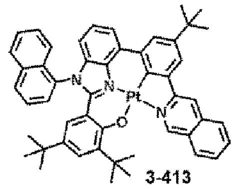
3-413

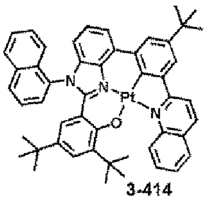
3-414

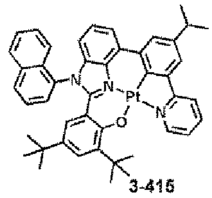
3-415

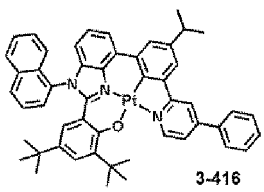
3-416

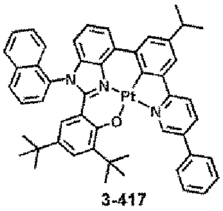
3-417

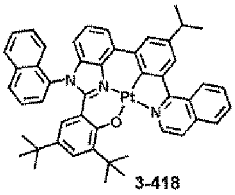
3-418

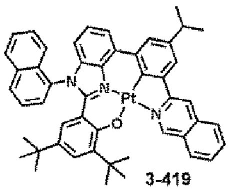
3-419

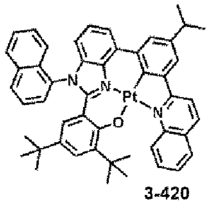
3-420

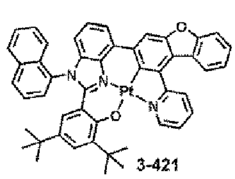
3-421

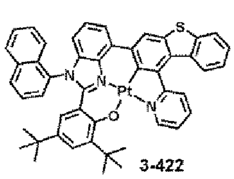
3-422

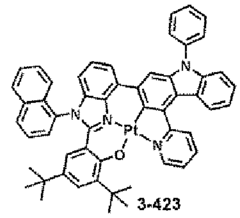
3-423

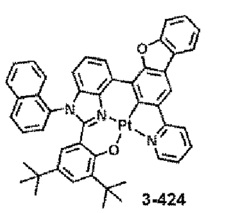
3-424

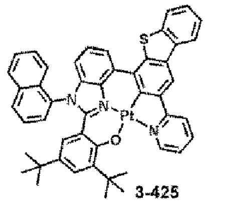
3-425

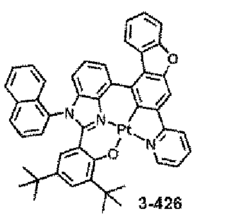
3-426

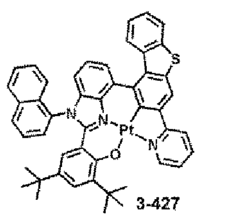
3-427

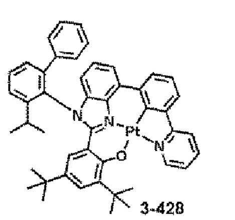
3-428

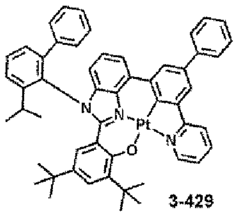
3-429

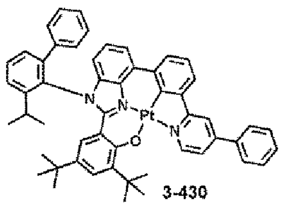
3-430

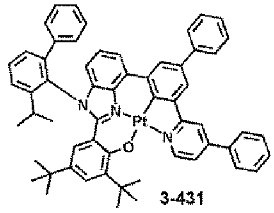
3-431

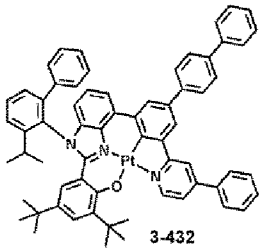
3-432

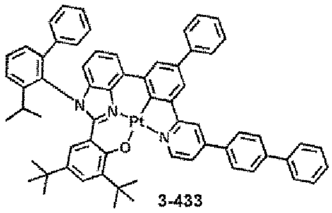
3-433

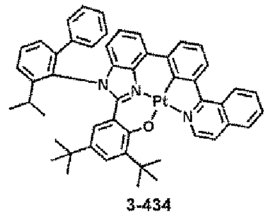
3-434

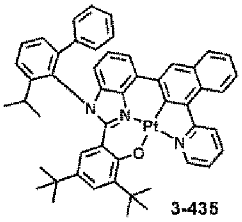
3-435

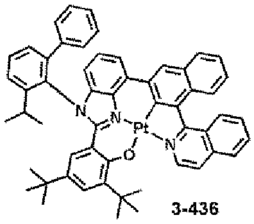
3-436

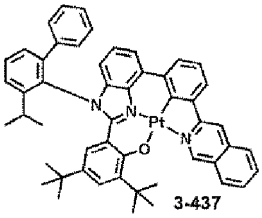
3-437

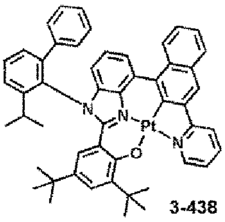
3-438

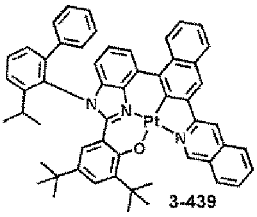
3-439

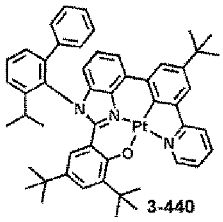
3-440

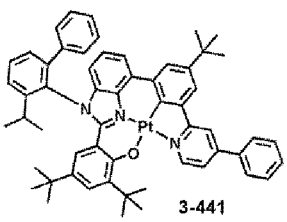
3-441

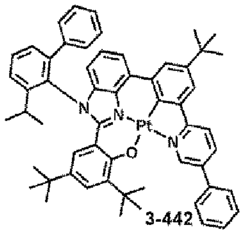
3-442

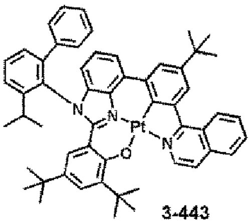
3-443

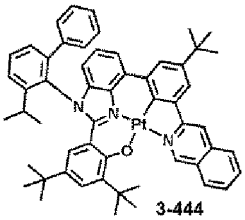
3-444

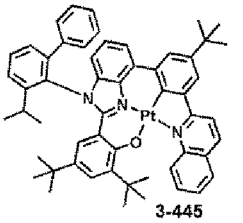
3-445

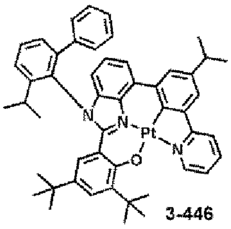
3-446

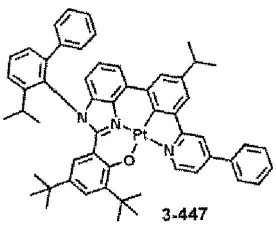
3-447

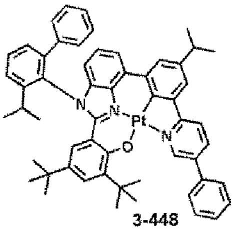
3-448

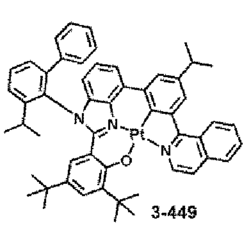
3-449

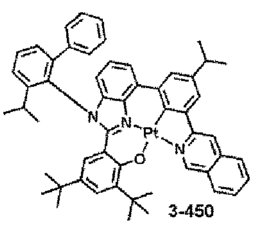
3-450

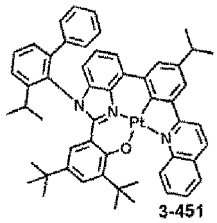
3-451

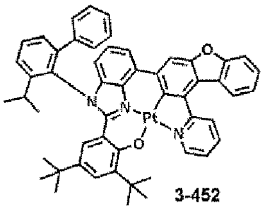
3-452

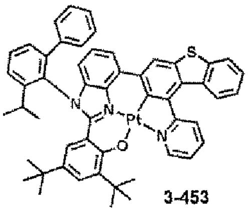
3-453

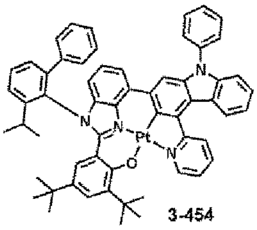
3-454

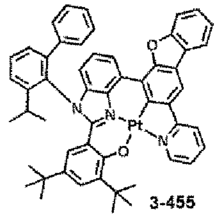
3-455

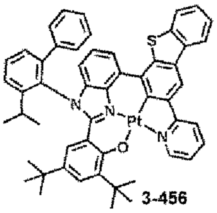
3-456

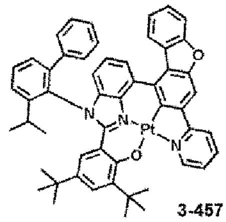
3-457

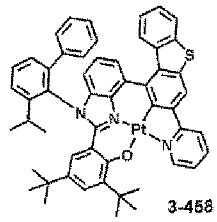
3-458

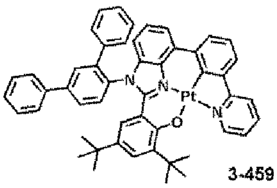
3-459

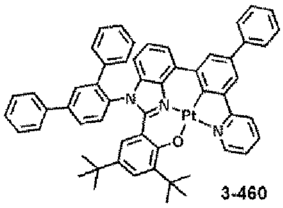
3-460

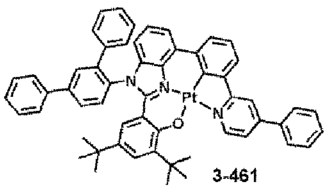
3-461

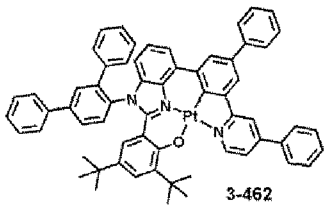
3-462

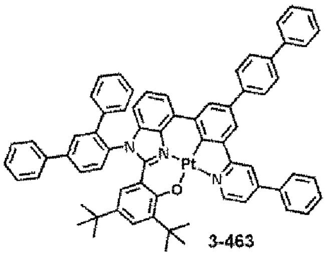
3-463

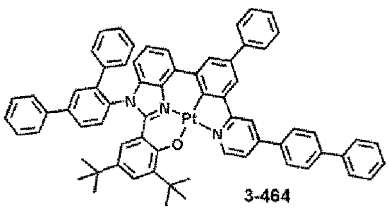
3-464

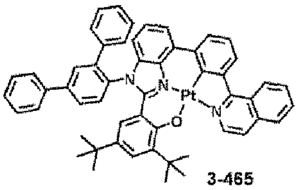
3-465

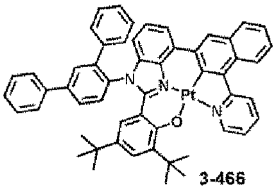
3-466

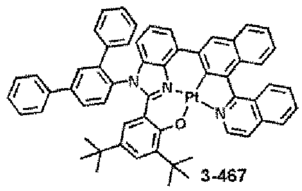
3-467

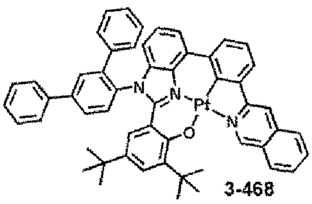
3-468

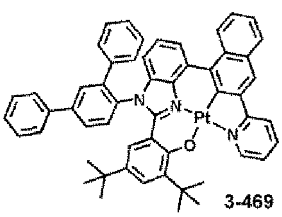
3-469

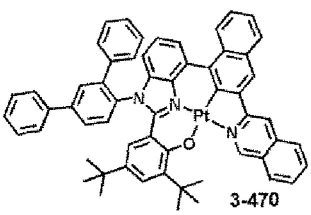
3-470

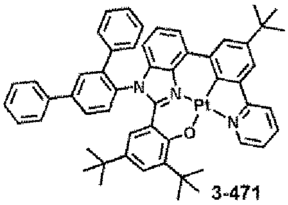
3-471

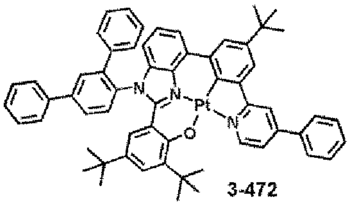
3-472

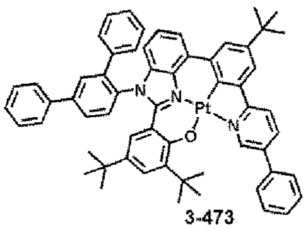
3-473

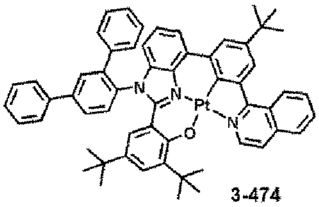
3-474

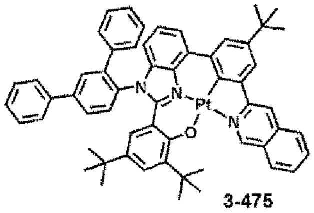
3-475

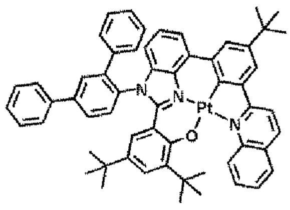
3-476

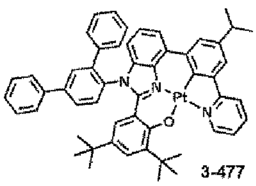
3-477

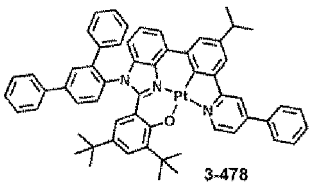
3-478

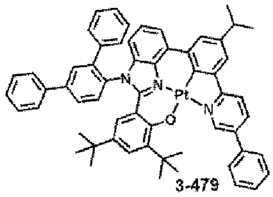
3-479

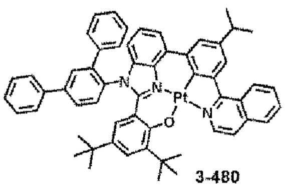
3-480

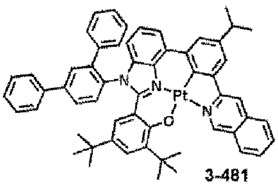
3-481

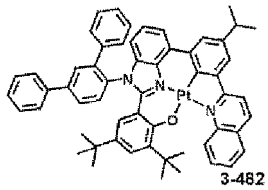
3-482

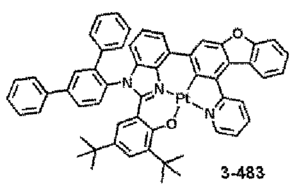
3-483

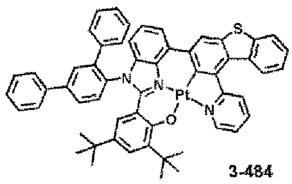
3-484

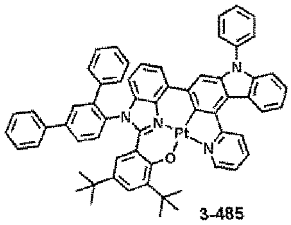
3-485

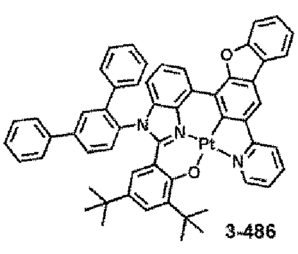
3-486

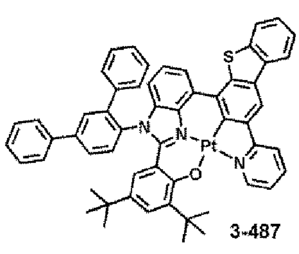
3-487

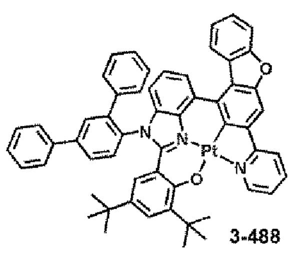
3-488

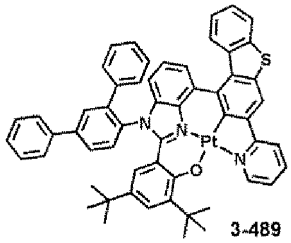
3-489

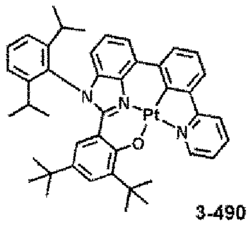
3-490

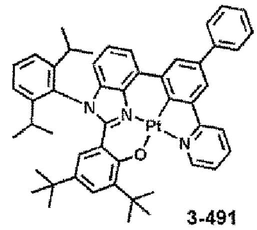
3-491

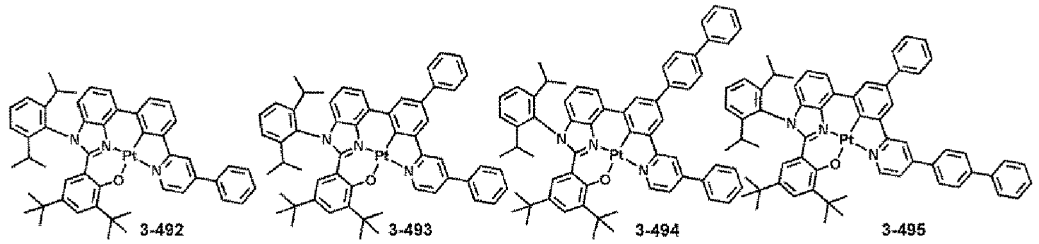
3-492 3-493 3-494 3-495

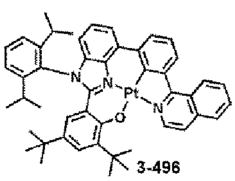
3-496

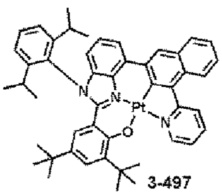
3-497

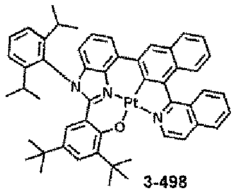
3-498

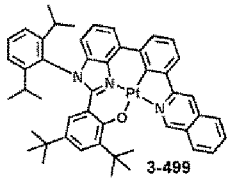
3-499

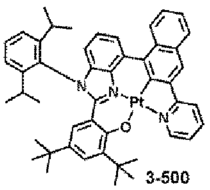
3-500

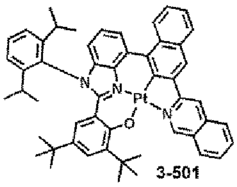
3-501

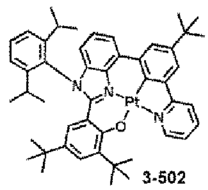
3-502

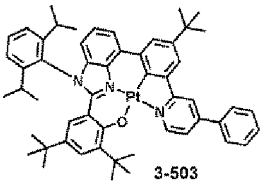
3-503

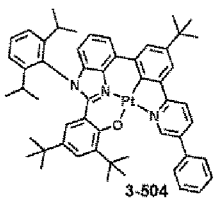
3-504

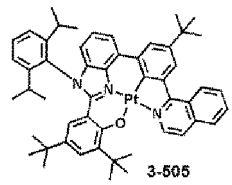
3-505

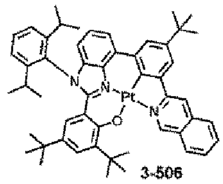
3-506

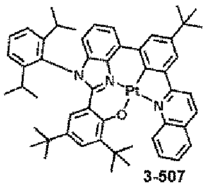
3-507

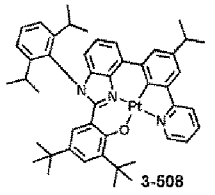
3-508

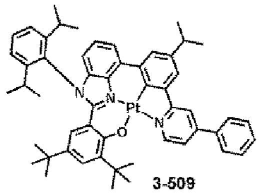
3-509

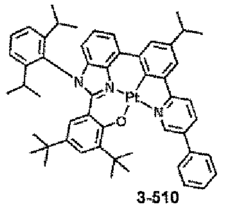
3-510

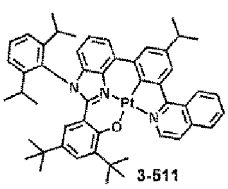
3-511

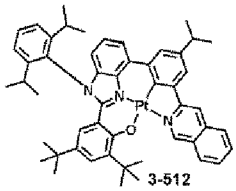
3-512

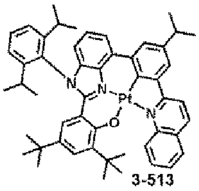
3-513

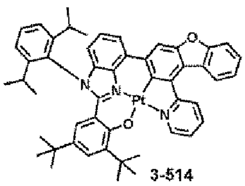
3-514

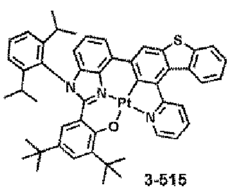
3-515

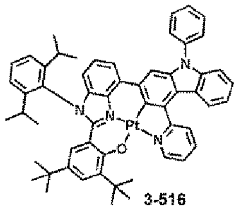
3-516

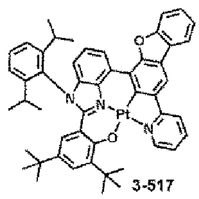
3-517

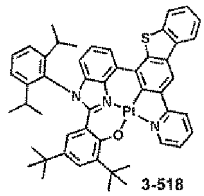
3-518

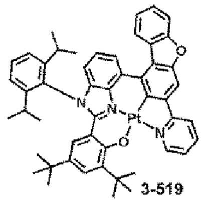
3-519

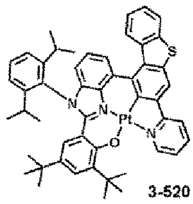
3-520

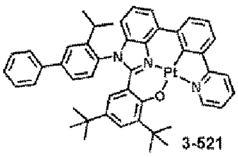
3-521

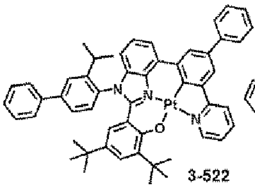
3-522

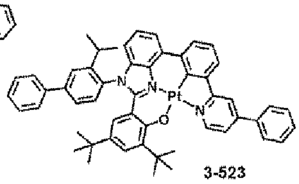
3-523

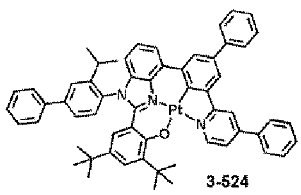
3-524

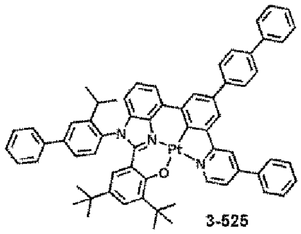
3-525

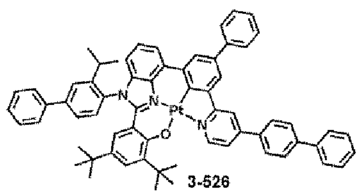
3-526

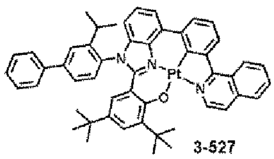
3-527

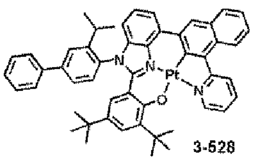
3-528

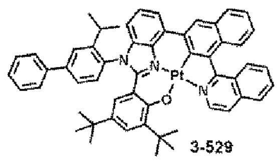
3-529

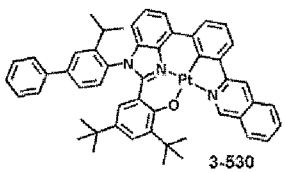
3-530

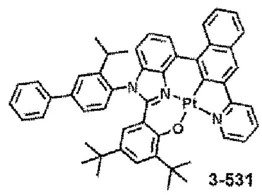
3-531

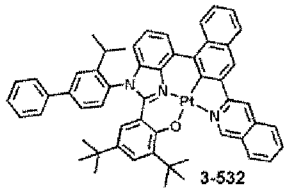
3-532

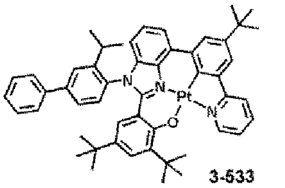
3-533

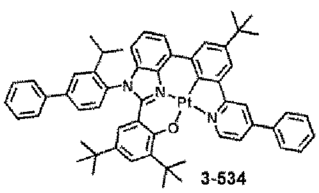
3-534

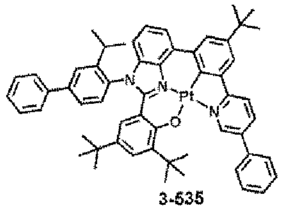
3-535

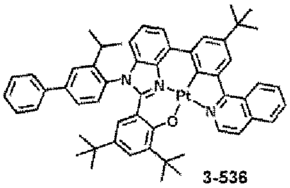
3-536

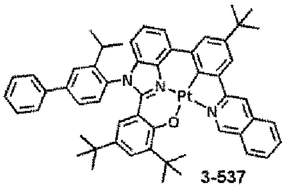
3-537

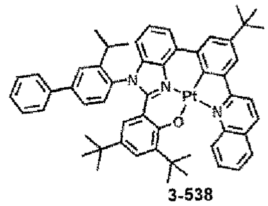
3-538

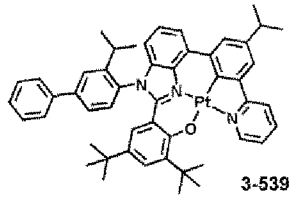
3-539

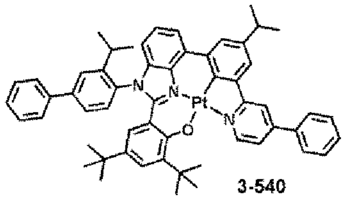
3-540

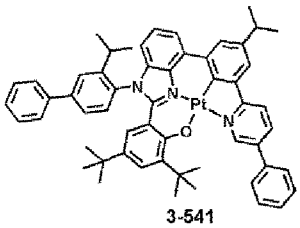
3-541

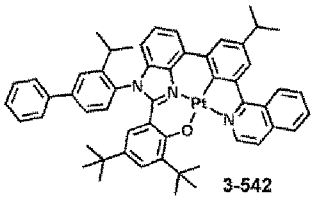
3-542

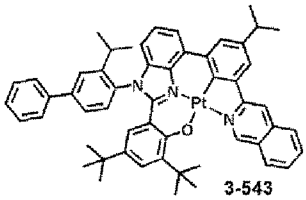
3-543

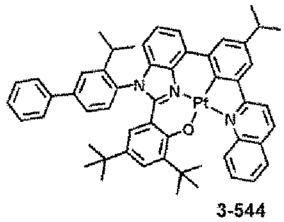
3-544

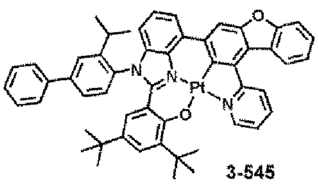
3-545

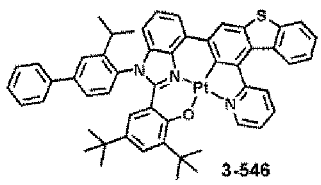
3-546

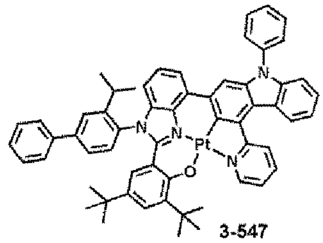
3-547

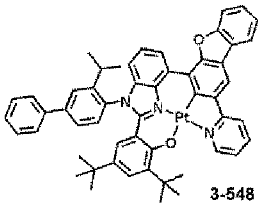
3-548

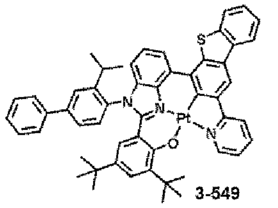
3-549

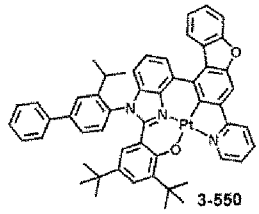
3-550

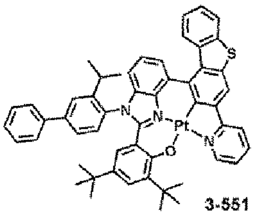
3-551

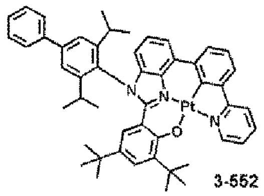
3-552

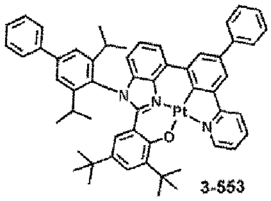
3-553

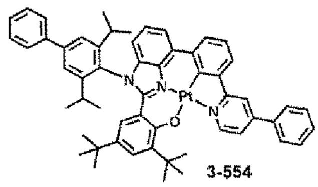
3-554

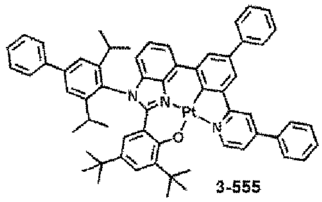
3-555

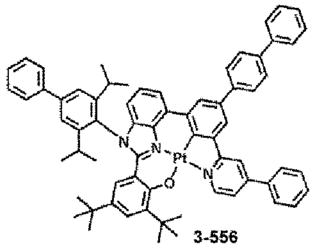
3-556

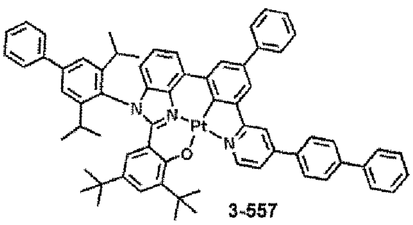
3-557

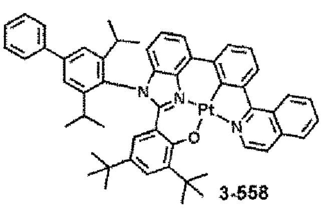
3-558

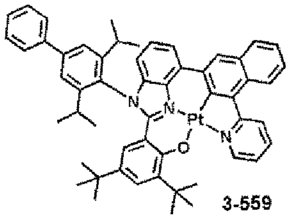
3-559

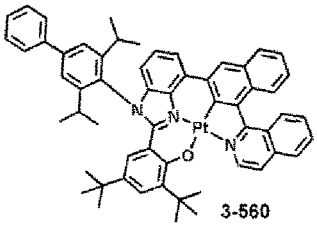
3-560

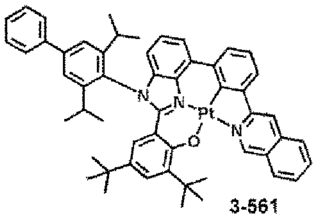
3-561

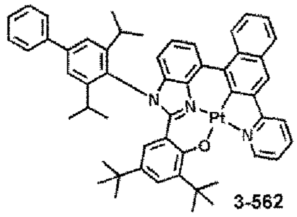
3-562

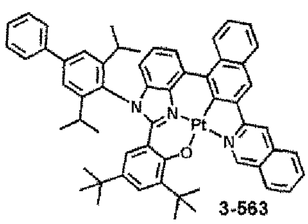
3-563

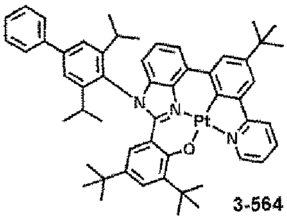
3-564

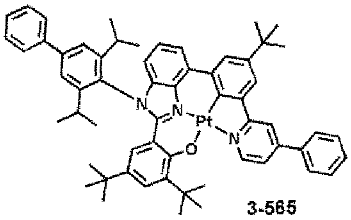
3-565

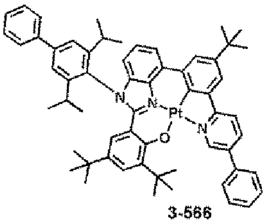
3-566

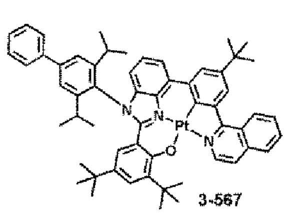
3-567

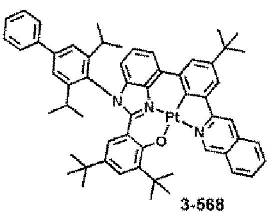
3-568

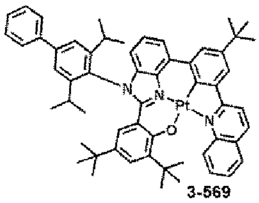
3-569

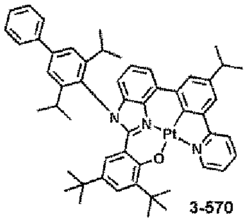
3-570

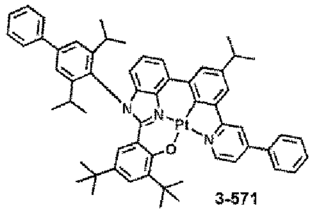
3-571

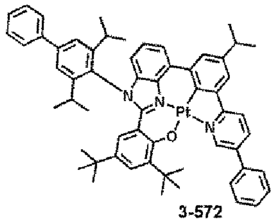
3-572

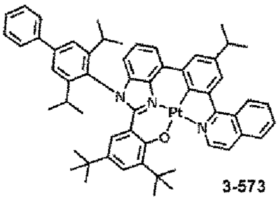
3-573

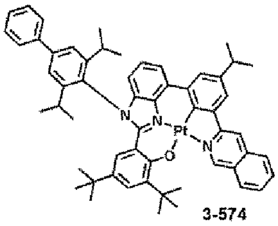
3-574

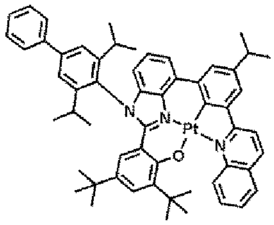
3-575

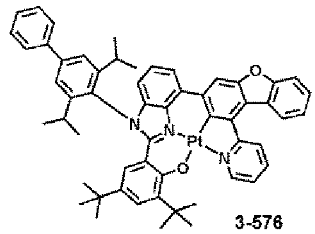
3-576

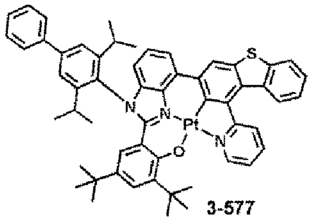
3-577

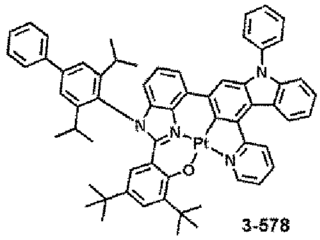
3-578

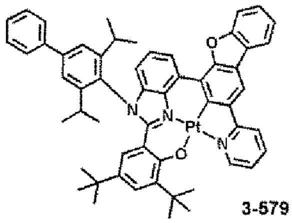
3-579

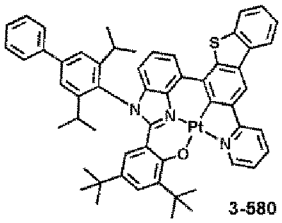
3-580

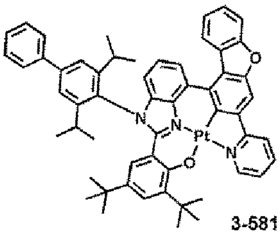
3-581

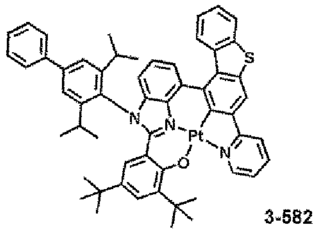
3-582

**Host in emission layer 15**

A host in the emission layer 15 may be any suitable host that satisfies the HOMO (dopant) - HOMO (host) range described herein.

A content of the host in the emission layer 15 may be greater than that of the dopant in the emission layer 15.

In an embodiment, the host may consist of one type of host. When the host consists of one type of host, the one type of host may be selected from an electron transporting host and a hole transporting host described herein.

In one or more embodiments, the host may be a mixture of two or more types of hosts. In some embodiments, the host may be a mixture of an electron transporting host and a hole transporting host, a mixture of two different types of electron transporting hosts or a mixture of two different types of hole transporting hosts. The electron transporting host and the hole transporting host may be understood by referring to the descriptions for those provided herein.

The electron transporting host may include at least one electron transporting moiety, and the hole transporting host may not include an electron transporting moiety.

The at least one electron transporting moiety may be selected from a cyano group, a π electron-depleted nitrogen-containing cyclic group, and a group represented by one of following Formulae:

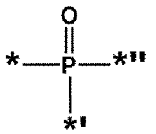
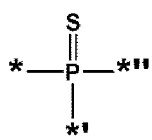
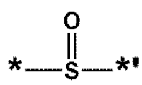
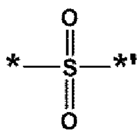

wherein, in Formulae above, *, *', and *" may each indicate a binding site to an adjacent atom.

In an embodiment, an electron transporting host in the emission layer 15 may include at least one of a cyano group and a π electron-depleted nitrogen-containing cyclic group.

In one or more embodiments, an electron transporting host in the emission layer 15 may include at least one cyano group.

In one or more embodiments, an electron transporting host in the emission layer 15 may include a cyano group and at least one π electron-depleted nitrogen-containing cyclic group.

In one or more embodiments, an electron transport host in the emission layer 15 may have a lowest anion decomposition energy of 2.5 eV or higher. When the lowest anion decomposition energy of the electron transport host

is within the range described above, the decomposition of the electron transport host due to charges and/or excitons may be substantially prevented. The lowest anion decomposition energy may be measured according to Equation 1:

Equation 1

$$E_{\text{lowest anion decomposition energy}} = E_{[A\text{-}B]^-} - [E_{A^-} + E_{B^\bullet} (\text{or } E_{A^\bullet} + E_{B^-})]$$

1. A density function theory (DFT) and/or *ab initio* method was used for quantum computation of the ground state of a neutral molecule.
2. A neutral molecular structure under an excess electron condition was used for quantum computation of the anionic state ($E_{[A\text{-}B]^-}$) of the molecule.
3. An anionic state being the most stable structure (global minimum) was used for quantum-computation of the energy of the decomposition process:

$$[A\text{-}B]^- \; A^x \text{ and } B^y \; ([E_{A^-} + E_{B^\cdot}(\text{or } E_{A^\cdot} + E_{B^-})]).$$

In this regard, the decomposition may produce i) $A^-$ + B or ii) A. + $B^-$, and from these two decomposition modes i and ii, the decomposition mode having a smaller decomposition energy value was selected for the computation.

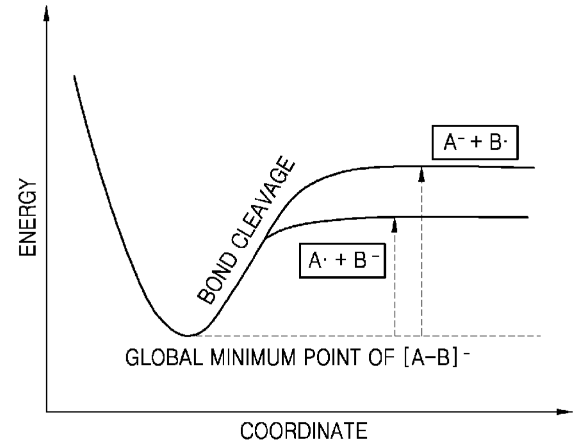


In one or more embodiments, the electron transporting host may include at least one π electron-depleted nitrogen-free cyclic group and at least one electron transporting moiety, and the hole transporting host may include at least one π electron-depleted nitrogen-free cyclic group and may not include an electron transporting moiety. Here, the at least one electron transporting moiety may be a cyano group or a π electron-depleted nitrogen-containing cyclic group.

The term "π electron-depleted nitrogen-containing cyclic group" as used herein refers to a group including a cyclic group having at least one *-N=*' moiety, .e.g., an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, or a condensed ring group in which at least one of the foregoing groups is condensed with at least one cyclic group (e.g., a condensed ring group in which a triazole group is condensed with a naphthalene group).

The π electron-depleted nitrogen-free cyclic group may be a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, an isoindole group, an indole group, a furan group, a thiophene

group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a benzosilolocarbazole group, or a triindolobenzene group, but embodiments are not limited thereto.

In some embodiments, the electron transporting host may be selected from Compounds represented by Formula E-1, and
the hole transporting host may be selected from Compounds represented by Formula H-1, but embodiments are not limited thereto:

Formula E-1 $[Ar_{301}]_{xb11}\text{-}[(L_{301})_{xb1}\text{-}R_{301}]_{xb21}$

wherein, in Formula E-1,

$Ar_{301}$ may be selected from a substituted or unsubstituted $C_5$-$C_{60}$ carbocyclic group and a substituted or unsubstituted $C_1$-$C_{60}$ heterocyclic group,
xb11 may be 1, 2, or 3,
$L_{301}$ may each independently be selected from a single bond, groups represented by one of following Formulae, a substituted or unsubstituted $C_5$-$C_{60}$ carbocyclic group, and a substituted or unsubstituted $C_1$-$C_{60}$ heterocyclic group, wherein in the following Formulae, *, *', and *" may each indicate a binding site to an adjacent atom:

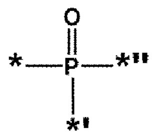 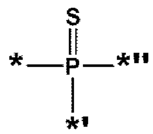 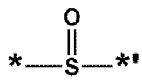 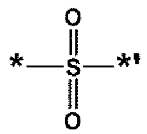

wherein, in Formulae above, xb1 may be an integer from 1 to 5,
$R_{301}$ may be selected from hydrogen, deuterium, -F, -Cl, -Br, -I, a hydroxyl group, a cyano group, a nitro group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-Si(Q_{301})(Q_{302})(Q_{303})$, $-N(Q_{301})(Q_{302})$,$-B(Q_{301})(Q_{302})$, $-C(=O)(Q_{301})$, $-S(=O)_2(Q_{301})$, $-S(=O)(Q_{301})$, $-P(=O)(Q_{301})(Q_{302})$, and $-P(=S)(Q_{301})(Q_{302})$,
xb21 may be an integer from 1 to 5,
wherein $Q_{301}$ to $Q_{303}$ may each independently be selected from a $C_1$-$C_{10}$ alkyl group, a $C_1$-$C_{10}$ alkoxy group, a phenyl group, a biphenyl group, a terphenyl group, and a naphthyl group, and
at least one of Conditions 1 to 3 may be satisfied:

Condition 1
At least one selected from $Ar_{301}$, $L_{301}$, and $R_{301}$ in Formula E-1 may each independently include a $\pi$ electron-depleted nitrogen-containing cyclic group
Condition 2
At least one selected from $L_{301}$ in Formula E-1 may be a group represented by one of following Formulae:

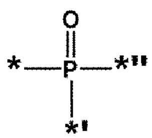 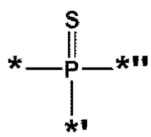 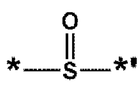 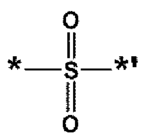

Condition 3
At least one selected from $R_{301}$ in Formula E-1 may be selected from a cyano group, $-S(=O)_2(Q_{301})$, $-S(=O)(Q_{301})$, $-P(=O)(Q_{301})(Q_{302})$, and $-P(=S)(Q_{301})(Q_{302})$

Formula H-1 $Ar_{401}-(L_{401})_{xd1}-(Ar_{402})_{xd11}$

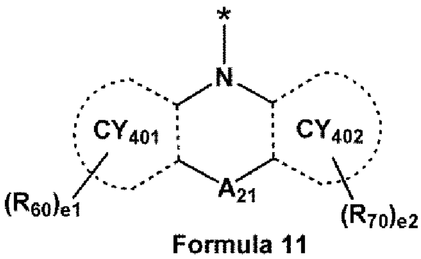

Formula 11

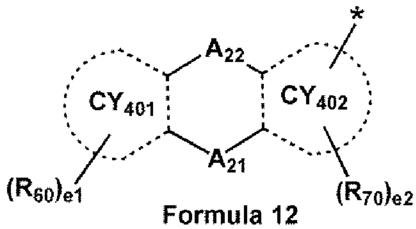

Formula 12 .

In Formulae H-1, 11, and 12,

$L_{401}$ may be selected from
a single bond; and
a π electron-depleted nitrogen-free cyclic group (e.g., a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, and a triindolobenzene group) unsubstituted or substituted with at least one selected from deuterium, a $C_1$-$C_{10}$ alkyl group, a $C_1$-$C_{10}$ alkoxy group, a phenyl group, a naphthyl group, a fluorenyl group, a carbazolyl group, a dibenzofuranyl group, a dibenzothiophenyl group, a triphenylenyl group, a biphenyl group, a terphenyl group, a tetraphenyl group, and - $Si(Q_{401})(Q_{402})(Q_{403})$,
xd1 may be an integer from 1 to 10; and when xd1 is 2 or greater, at least two $L_{401}$ groups may be identical to or different from each other,
$Ar_{401}$ may be selected from groups represented by Formulae 11 and 12,
$Ar_{402}$ may be selected from
groups represented by Formulae 11 and 12 and a π electron-depleted nitrogen-free cyclic group (e.g., a phenyl group, a naphthyl group, a fluorenyl group, a carbazolyl group, a dibenzofuranyl group, a dibenzothiophenyl group, a biphenyl group, a terphenyl group, and a triphenylenyl group); and
a π electron-depleted nitrogen-free cyclic group (e.g., a phenyl group, a naphthyl group, a fluorenyl group, a carbazolyl group, a dibenzofuranyl group, a dibenzothiophenyl group, a biphenyl group, a terphenyl group, and a triphenylenyl group) substituted with at least one selected from deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a carbazolyl group, a dibenzofuranyl group, a dibenzothiophenyl group, a biphenyl group, a terphenyl group, and a triphenylenyl group,
$CY_{401}$ and $CY_{402}$ may each independently be selected from a π electron-depleted nitrogen-free cyclic group (e.g., a benzene group, a naphthalene group, a fluorene group, a carbazole group, a benzocarbazole group, an indolocarbazole group, a dibenzofuran group, a dibenzothiophene group, a dibenzosilole group, a benzonaphthofuran group, a benzonapthothiophene group, and a benzonaphthosilole group),
$A_{21}$ may be selected from a single bond, O, S, $N(R_{51})$, $C(R_{51})(R_{52})$, and $Si(R_{51})(R_{52})$,
$A_{22}$ may be selected from a single bond, O, S, $N(R_{53})$, $C(R_{53})(R_{54})$, and $Si(R_{53})(R_{54})$,
at least one selected from $A_{21}$ and $A_{22}$ in Formula 12 may not be a single bond,
$R_{51}$ to $R_{54}$, $R_{60}$, and $R_{70}$ may each independently be selected from
hydrogen, deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, and a $C_1$-$C_{20}$ alkoxy group;
a $C_1$-$C_{20}$ alkyl group and a $C_1$-$C_{20}$ alkoxy group, each substituted with at least one selected from deuterium,

a hydroxyl group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a fluorenyl group, a carbazolyl group, a dibenzofuranyl group, and a dibenzothiophenyl group;

a $\pi$ electron-depleted nitrogen-free cyclic group (e.g., a phenyl group, a naphthyl group, a fluorenyl group, a carbazolyl group, a dibenzofuranyl group, a dibenzothiophenyl group, a biphenyl group, a terphenyl group, and a triphenylenyl group);

a $\pi$ electron-depleted nitrogen-free cyclic group (e.g., a phenyl group, a naphthyl group, a fluorenyl group, a carbazolyl group, a dibenzofuranyl group, a dibenzothiophenyl group, a biphenyl group, a terphenyl group, and a triphenylenyl group) substituted with at least one selected from deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, a fluorenyl group, a carbazolyl group, a dibenzofuranyl group, a dibenzothiophenyl group, and a biphenyl group,

$$-Si(Q_{404})(Q_{405})(Q_{406}),$$

e1 and e2 may each independently be an integer from 0 to 10,

wherein $Q_{401}$ to $Q_{406}$ may each independently be selected from hydrogen, deuterium, a hydroxyl group, an amino group, an amidino group, a hydrazine group, a hydrazone group, a carboxylic acid group or a salt thereof, a sulfonic acid group or a salt thereof, a phosphoric acid group or a salt thereof, a phenyl group, a naphthyl group, a fluorenyl group, a carbazolyl group, a dibenzofuranyl group, a dibenzothiophenyl group, a biphenyl group, a terphenyl group, and a triphenylenyl group, and

* indicates a binding site to an adjacent atom.

In an embodiment, in Formula E-1, $Ar_{301}$ and $L_{401}$ may each independently be selected from a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each unsubstituted or substituted with at least one selected from deuterium, -F, -Cl,-Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a cyano group-containing phenyl group, a cyano group-containing biphenyl group, a cyano group-containing terphenyl group, a cyano group-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group,$-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, and$-P(=O)(Q_{31})(Q_{32})$,

at least one selected from $L_{301}$ in the number of xb1 may be selected from an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each unsubstituted or substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a cyano group-containing phenyl group, a cyano group-containing biphenyl group, a cyano group-containing terphenyl group, a cyano group-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, $-Si(Q_{31})(Q_{32})(Q_{33})$, $-N(Q_{31})(Q_{32})$, $-B(Q_{31})(Q_{32})$, $-C(=O)(Q_{31})$, $-S(=O)_2(Q_{31})$, and $-P(=O)(Q_{31})(Q_{32})$, and

$R_{301}$ may be selected from hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a tetraphenyl group, a naphthyl group, a cyano group-containing phenyl group, a cyano group-containing biphenyl group, a cyano group-containing terphenyl group, a cyano group-containing tetraphenyl group, a cyano group-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, $-Si(Q_{31})(Q_{32})(Q_{33})$, $-N(Q_{31})(Q_{32})$, $-B(Q_{31})(Q_{32})$, $-C(=O)(Q_{31})$,$-S(=O)_2(Q_{31})$, and $-P(=O)(Q_{31})(Q_{32})$,

wherein $Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group, but embodiments are not limited thereto.

In some embodiments, $Ar_{301}$ may be selected from a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each unsubstituted or substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a cyano group-containing phenyl group, a cyano group-containing biphenyl group, a cyano group-containing terphenyl group, a cyano group-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, $-Si(Q_{31})(Q_{32})(Q_{33})$, $-N(Q_{31})(Q_{32})$,$-B(Q_{31})(Q_{32})$, $-C(=O)(Q_{31})$, $-S(=O)_2(Q_{31})$, and $-P(=O)(Q_{31})(Q_{32})$; and

groups represented by Formulae 5-1 to 5-3 and 6-1 to 6-33, and

$L_{301}$ may be selected from groups represented by Formulae 5-1 to 5-3 and 6-1 to 6-33:

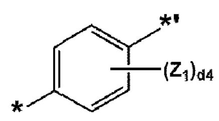

Formula 5-1

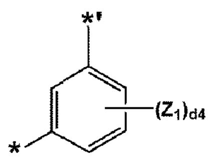

Formula 5-2

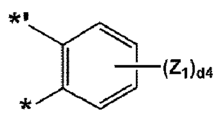

Formula 5-3

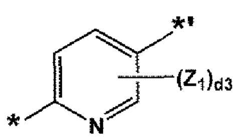

Formula 6-1

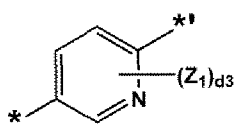

Formula 6-2

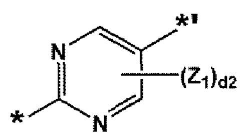

Formula 6-3

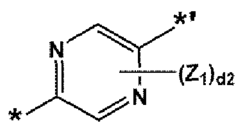

Formula 6-4

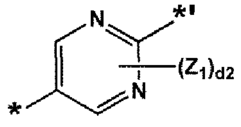
Formula 6-5

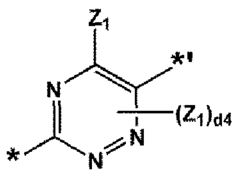
Formula 6-6

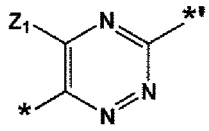
Formula 6-7

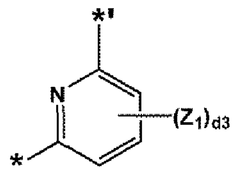
Formula 6-8

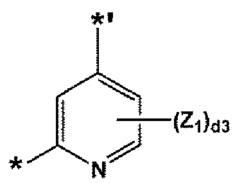
Formula 6-9

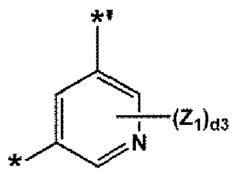
Formula 6-10

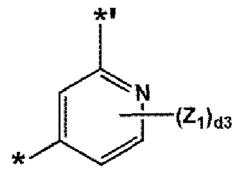
Formula 6-11

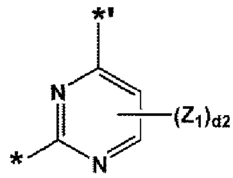
Formula 6-12

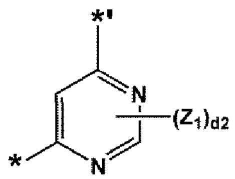
Formula 6-13

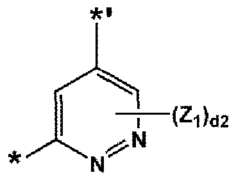
Formula 6-14

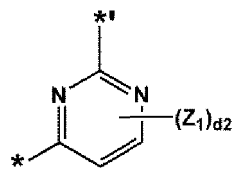
Formula 6-15

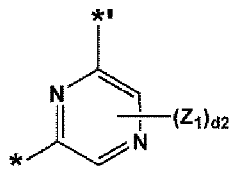
Formula 6-16

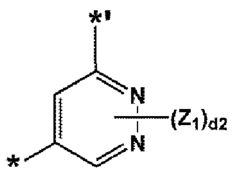
Formula 6-17

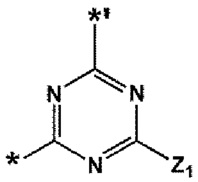
Formula 6-18

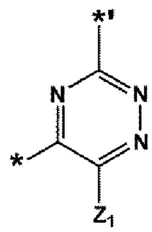
Formula 6-19

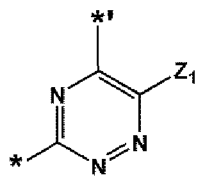
Formula 6-20

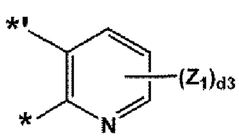
Formula 6-21

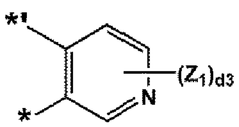
Formula 6-22

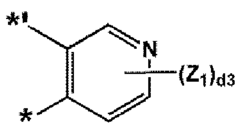
Formula 6-23

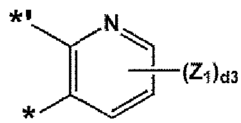
Formula 6-24

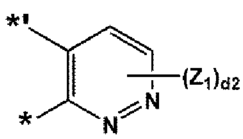
Formula 6-25

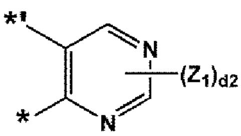
Formula 6-26

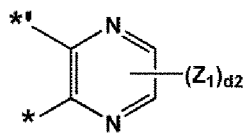
Formula 6-27

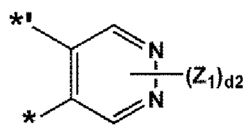
Formula 6-28

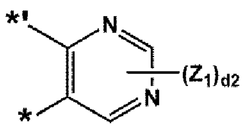
Formula 6-29

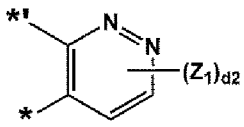
Formula 6-30

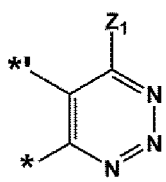
Formula 6-31

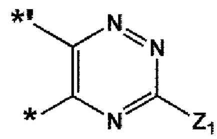
Formula 6-32

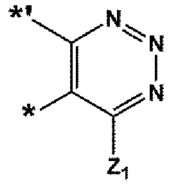

Formula 6-33

wherein, in Formulae 5-1 to 5-3 and 6-1 to 6-33,

$Z_1$ may be selected from hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a cyano group-containing phenyl group, a cyano group-containing biphenyl group, a cyano group-containing terphenyl group, a cyano group-containing naphthyl group, a pyridinyl group, a phenylpyridinyl group, a diphenylpyridinyl group, a biphenylpyridinyl group, a di(biphenyl)pyridinyl group, a pyrazinyl group, a phenylpyrazinyl group, a diphenylpyrazinyl group, a biphenylpyrazinyl group, a di(biphenyl)pyrazinyl group, a pyridazinyl group, a phenylpyridazinyl group, a diphenylpyridazinyl group, a biphenylpyridazinyl group, a di(biphenyl)pyridazinyl group, a pyrimidinyl group, a phenylpyrimidinyl group, a diphenylpyrimidinyl group, a biphenylpyrimidinyl group, a di(biphenyl)pyrimidinyl group, a triazinyl group, a phenyltriazinyl group, a diphenyltriazinyl group, a biphenyltriazinyl group, a di(biphenyl)triazinyl group, $-Si(Q_{31})(Q_{32})(Q_{33})$, $-N(Q_{31})(Q_{32})$, $-B(Q_{31})(Q_{32})$, $-C(=O)(Q_{31})$,$-S(=O)_2(Q_{31})$, and $-P(=O)(Q_{31})(Q_{32})$,
d4 may be 0, 1, 2, 3, or 4,
d3 may be 0, 1, 2, or 3,
d2 may be 0, 1, or 2, and
* and *' each indicate a binding site to an adjacent atom,
wherein $Q_{31}$ to $Q_{33}$ may be understood by referring to the descriptions for those provided herein.

In one or more embodiments, $L_{301}$ may be selected from groups represented by Formulae 5-2, 5-3, and 6-8 to 6-33.

In one or more embodiments, $R_{301}$ may be selected from a cyano group and groups represented by Formulae 7-1 to 7-18, at least one selected from $Ar_{402}$ in the number of xd11 may be selected from groups represented by Formulae 7-1 to 7-18, but embodiments are not limited thereto:

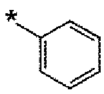
7-1

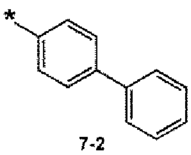
7-2

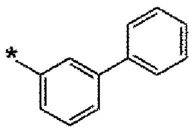
7-3

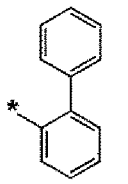
7-4

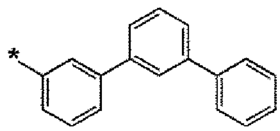
7-5

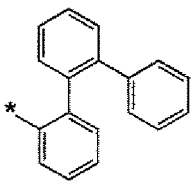
7-6

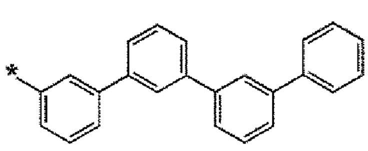
7-7

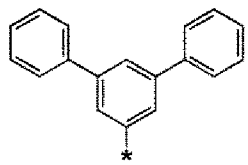
7-8

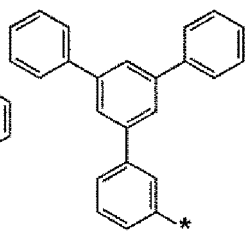
7-9

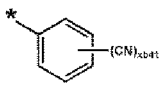
7-10

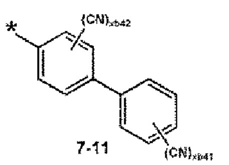
7-11

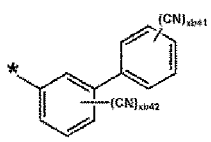
7-12

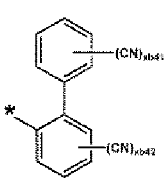
7-13

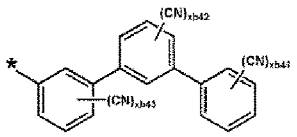
7-14

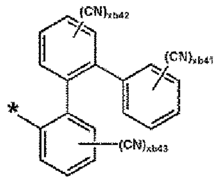
7-15

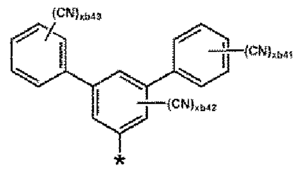
7-16

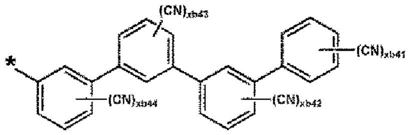
7-17

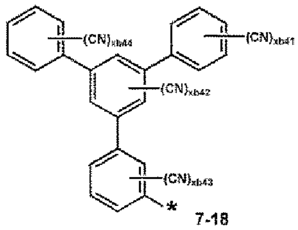
7-18

wherein, in Formulae 7-1 to 7-18,

xb41 to xb44 may each be 0, 1, or 2, provided that xb41 in Formula 7-10 may not be 0, xb41+xb42 in Formulae 7-11 to 7-13 may not be 0, xb41+xb42+xb43 in Formulae 7-14 to 7-16 may not be 0, xb41+xb42+xb43+xb44 in Formulae 7-17 and 7-18 may not be 0, and * indicates a binding site to an adjacent atom.

In Formula E-1, at least two $Ar_{301}$(s) may be identical to or different from each other, and at least two $L_{301}$(s) may be identical to or different from each other. In Formula H-1, at least two $L_{401}$(s) may be identical to or different from each other, and at least two $Ar_{402}$(s) may be identical to or different from each other.

In an embodiment, the electron transporting host may include i) at least one selected from a cyano group, a pyrimidine group, a pyrazine group, and a triazine group and ii) a triphenylene group, and the hole transporting host may include a carbazole group.

In one or more embodiments, the electron transporting host may include at least one cyano group.

In some embodiments, the electron transporting host may be selected from following compounds, but embodiments are not limited thereto:

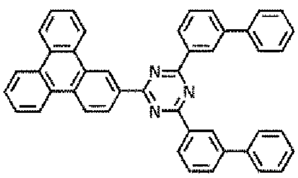
H-E1

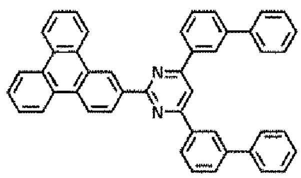
H-E2

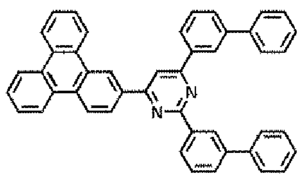
H-E3

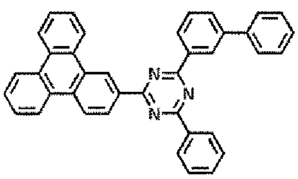
H-E4

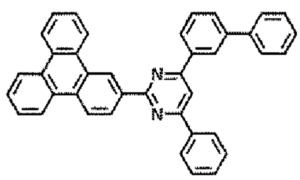
H-E5

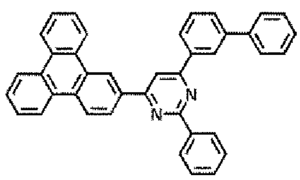
H-E6

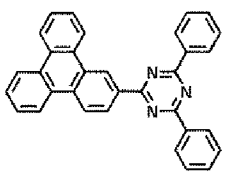
H-E7

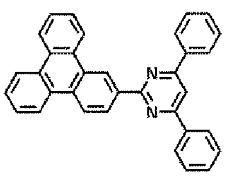
H-E8

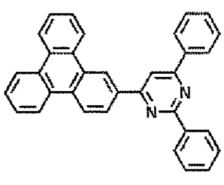
H-E9

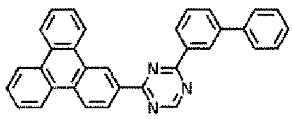

H-E10

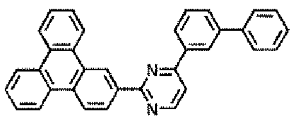

H-E11

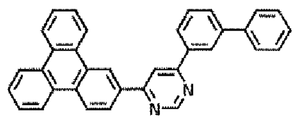

H-E12

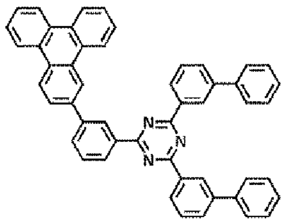

H-E13

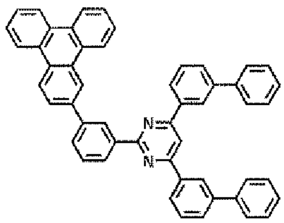

H-E14

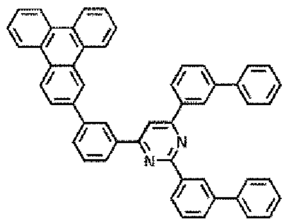

H-E15

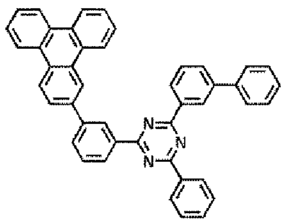

H-E16

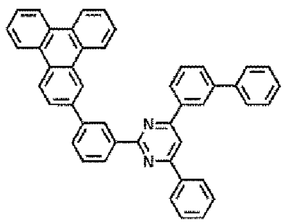

H-E17

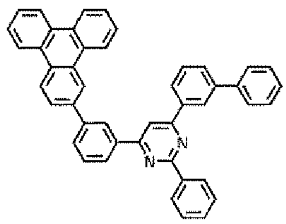

H-E18

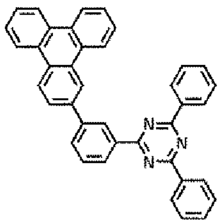

H-E19

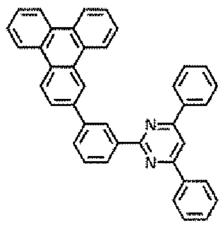

H-E20

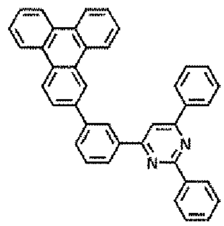

H-E21

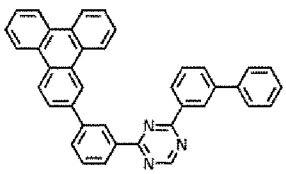

H-E22

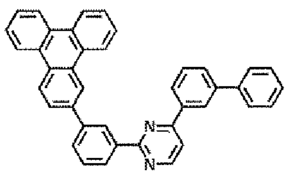

H-E23

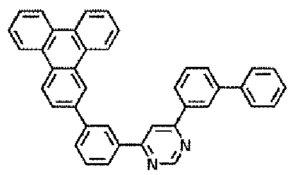

H-E24

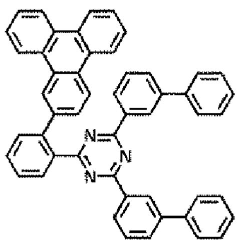

H-E25

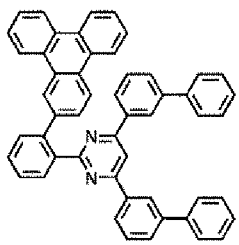

H-E26

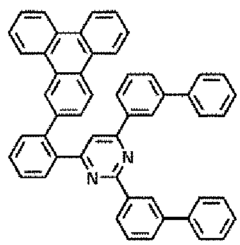

H-E27

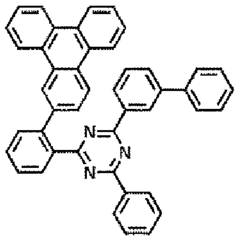

H-E28

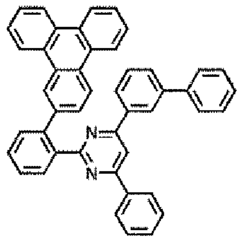

H-E29

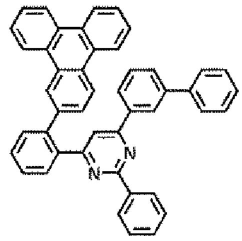

H-E30

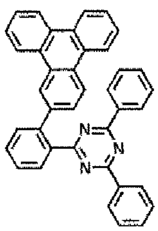

H-E31

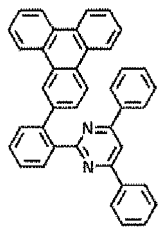

H-E32

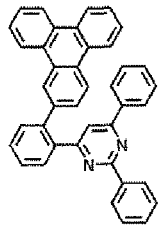

H-E33

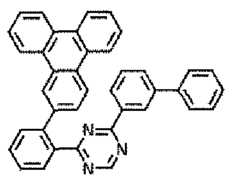

H-E34

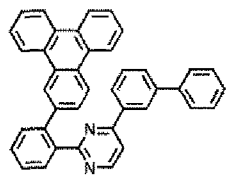

H-E35

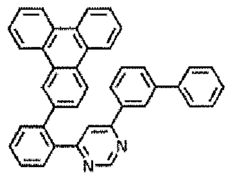

H-E36

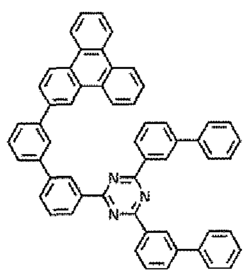

H-E37

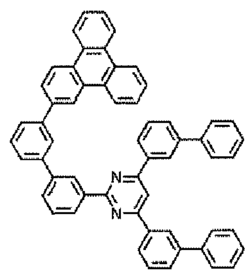

H-E38

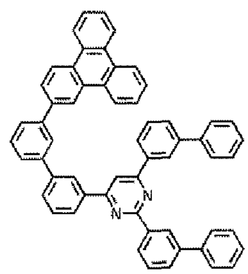

H-E39

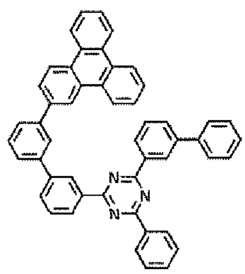

H-E40

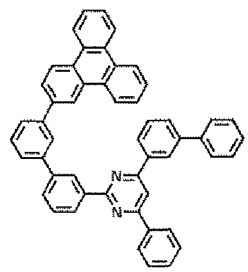

H-E41

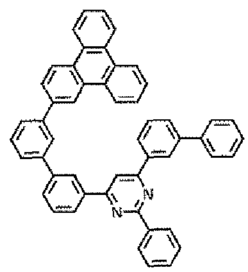

H-E42

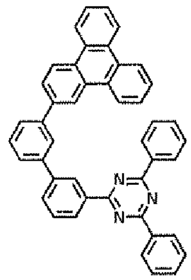

H-E43

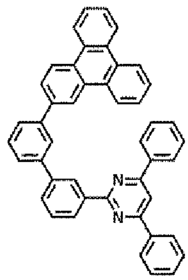

H-E44

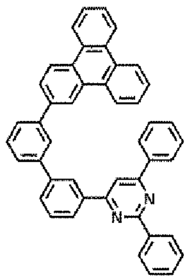

H-E45

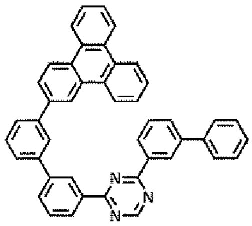

H-E46

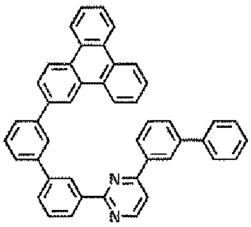

H-E47

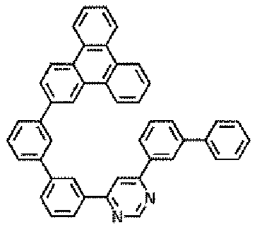

H-E48

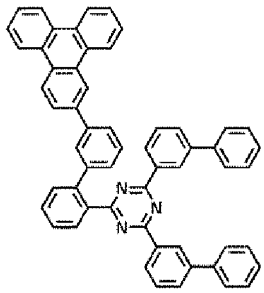

H-E49

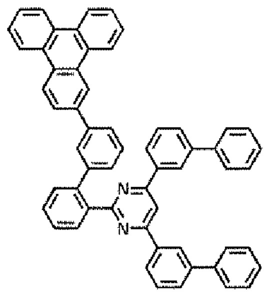

H-E50

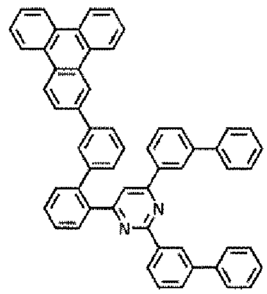

H-E51

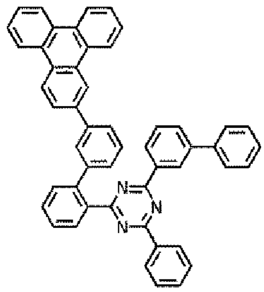

H-E52

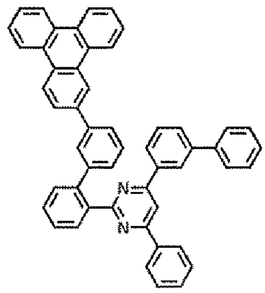

H-E53

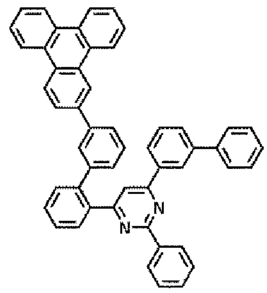

H-E54

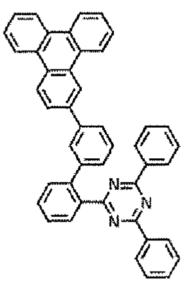

H-E55

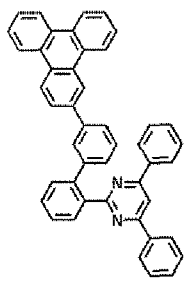

H-E56

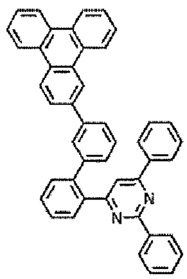

H-E57

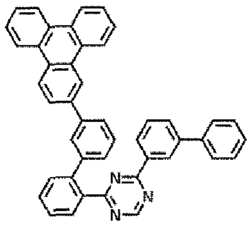

H-E58

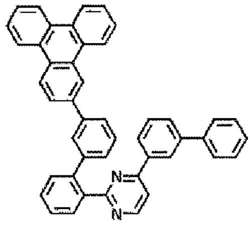

H-E59

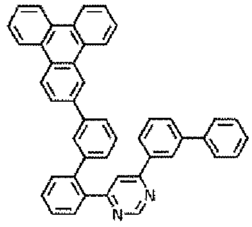

H-E60

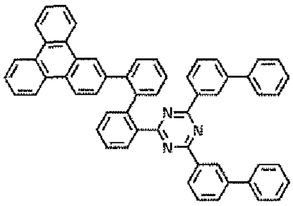

H-E61

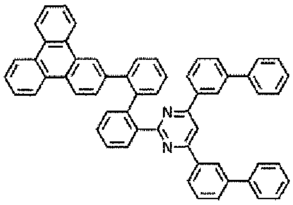

H-E62

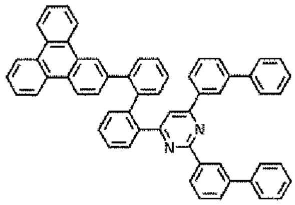

H-E63

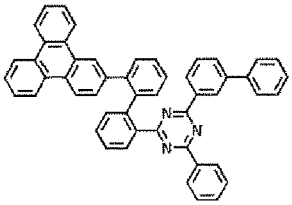

H-E64

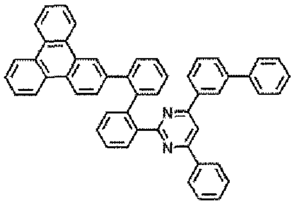

H-E65

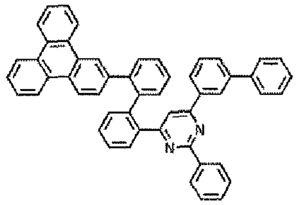

H-E66

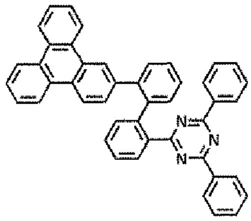

H-E67

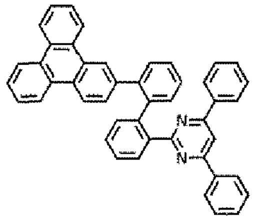

H-E68

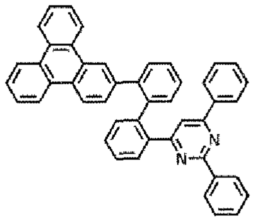

H-E69

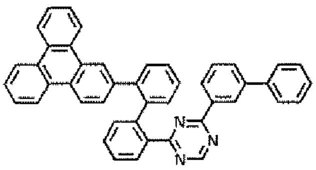

H-E70

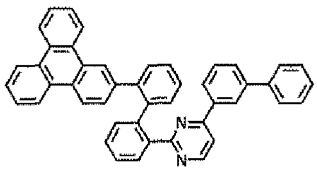

H-E71

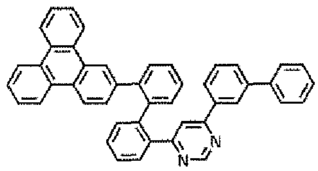

H-E72

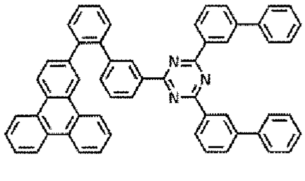

H-E73

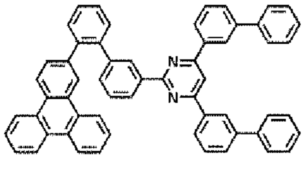

H-E74

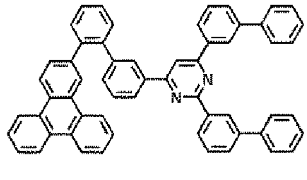

H-E75

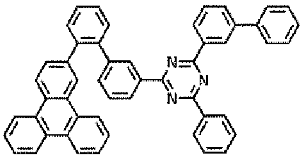
H-E76

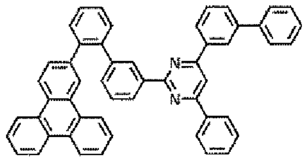
H-E77

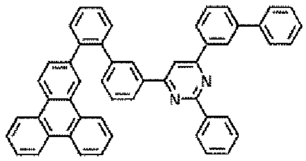
H-E78

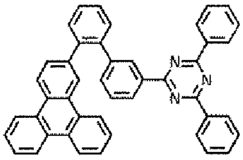
H-E79

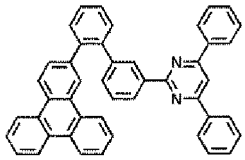
H-E80

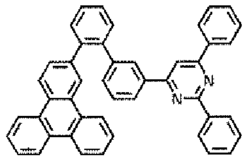
H-E81

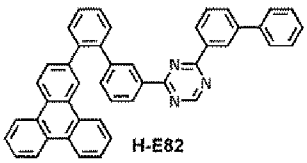
H-E82

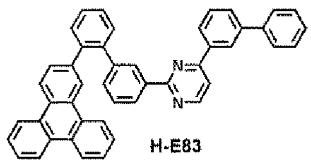
H-E83

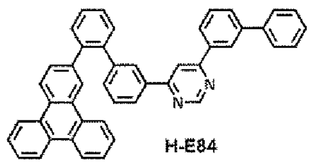
H-E84

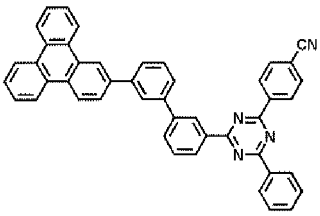
H-E(1)

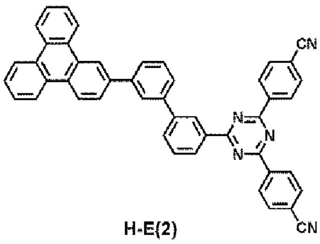
H-E(2)

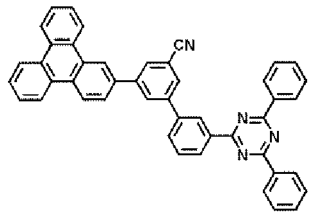
H-E(3)

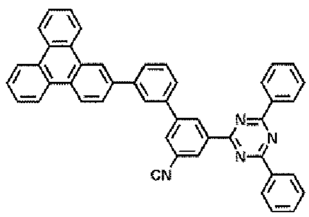
H-E(4)

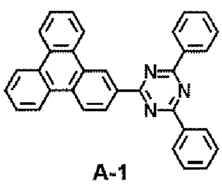
A-1

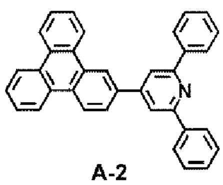
A-2

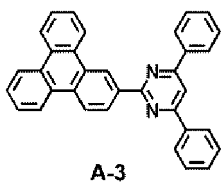
A-3

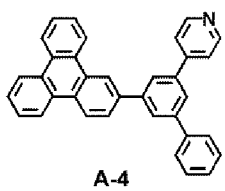
A-4

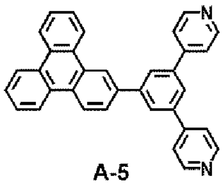
A-5

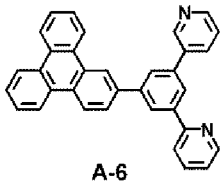
A-6

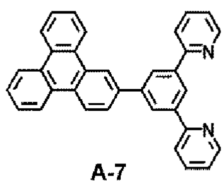
A-7

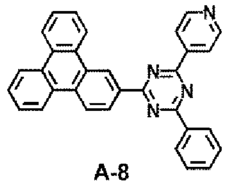
A-8

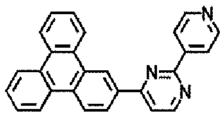

A-9

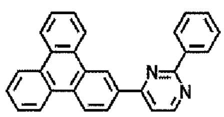

A-10

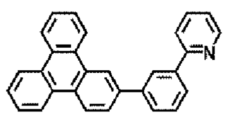

A-11

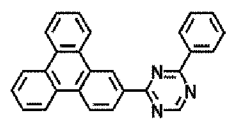

A-12

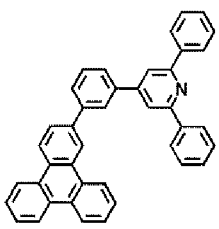

A-13

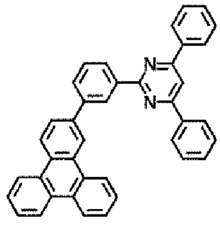

A-14

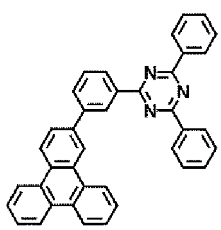

A-15

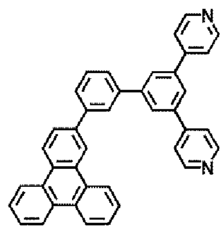

A-16

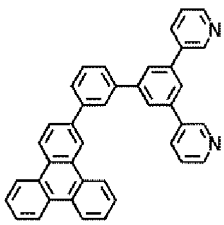

A-17

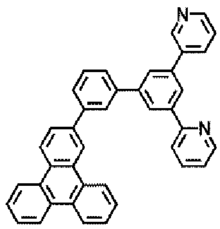

A-18

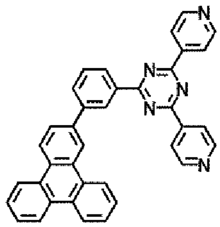

A-19

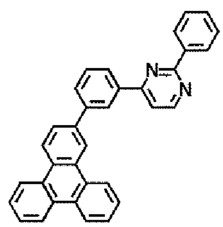

A-20

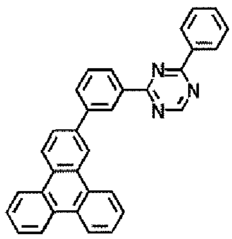

A-21

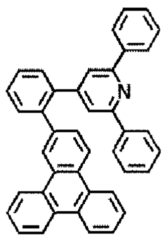

A-22

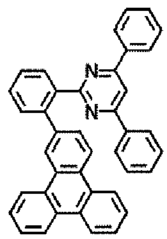

A-23

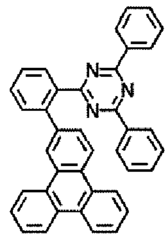

A-24

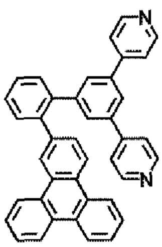

A-25

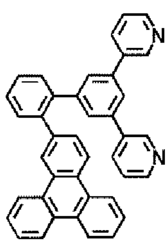

A-26

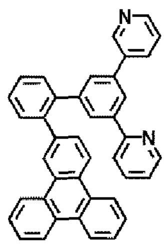

A-27

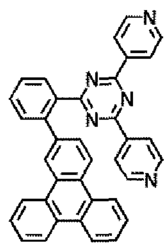

A-28

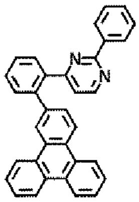

A-29

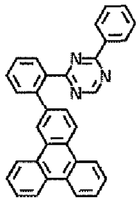

A-30

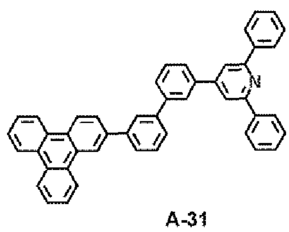

A-31

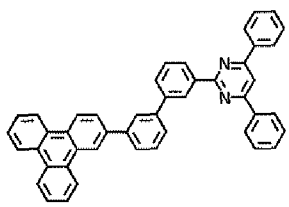

A-32

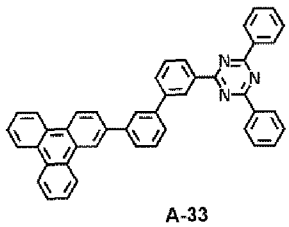
A-33

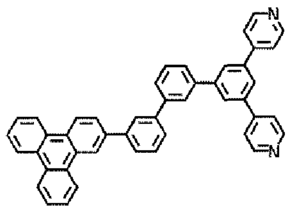
A-34

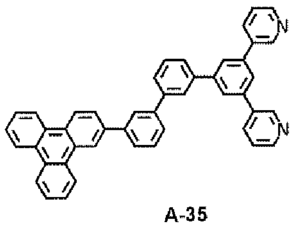
A-35

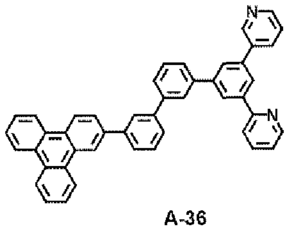
A-36

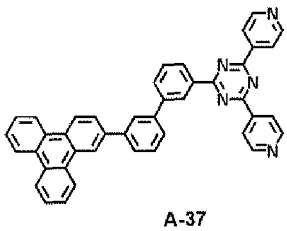
A-37

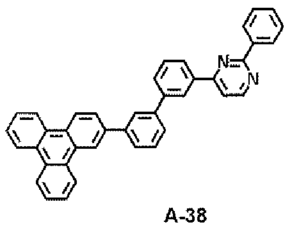
A-38

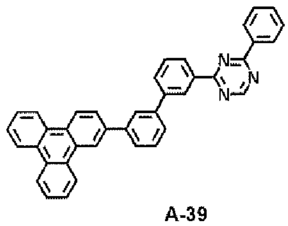
A-39

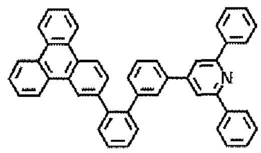
A-40

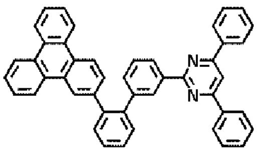
A-41

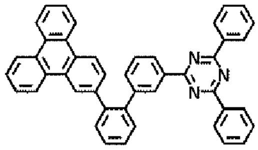
A-42

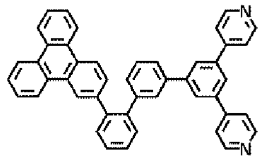
A-43

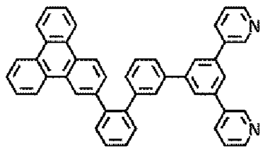
A-44

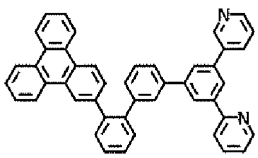
A-45

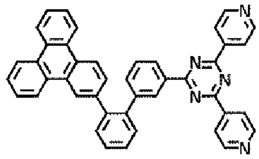
A-46

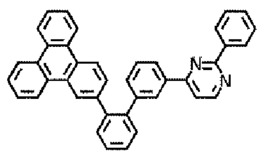
A-47

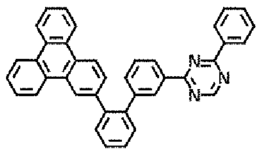
A-48

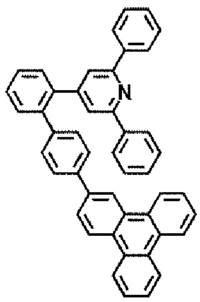
A-49

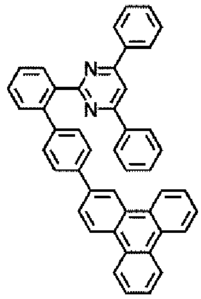
A-50

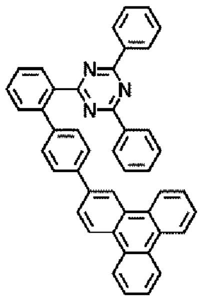
A-51

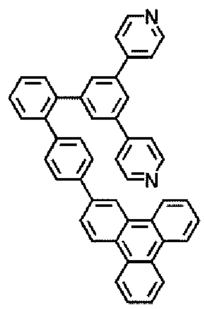
A-52

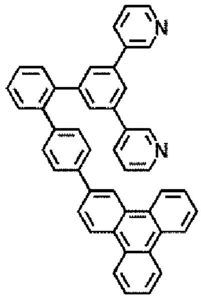
A-53

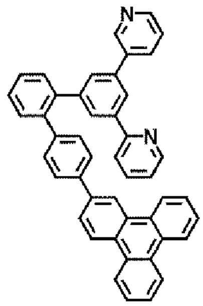
A-54

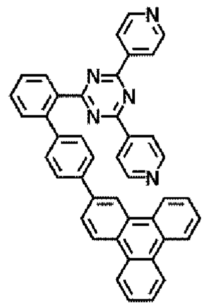
A-55

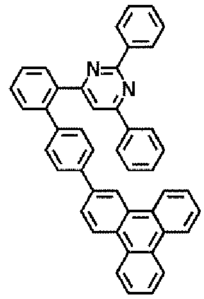
A-56

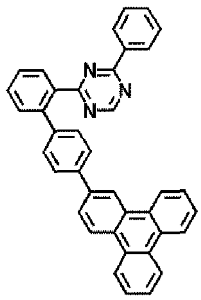
A-57

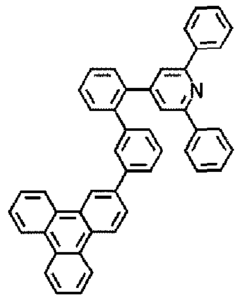
A-58

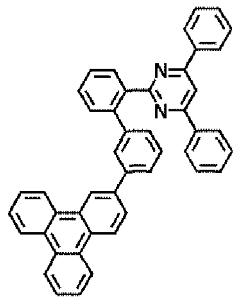
A-59

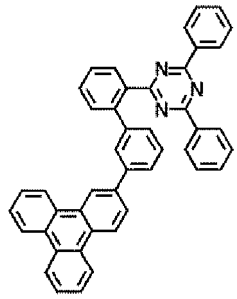
A-60

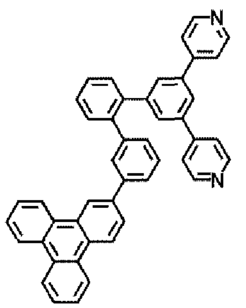
A-61

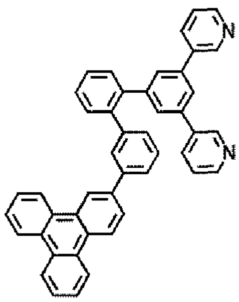
A-62

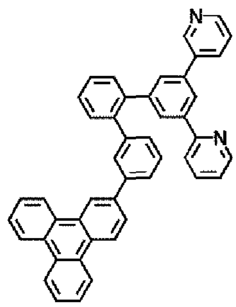
A-63

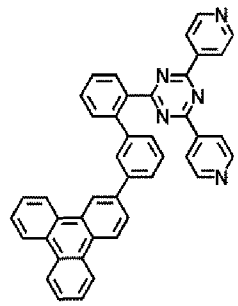
A-64

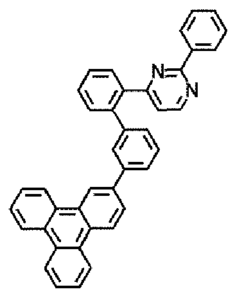
A-65

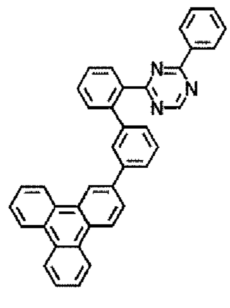
A-66

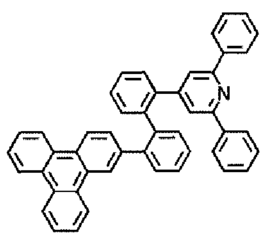
A-67

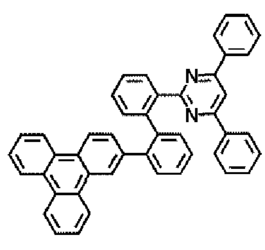
A-68

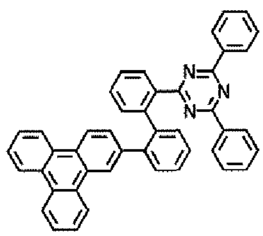
A-69

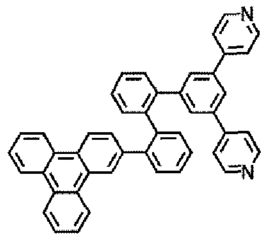
A-70

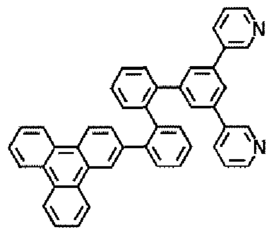
A-71

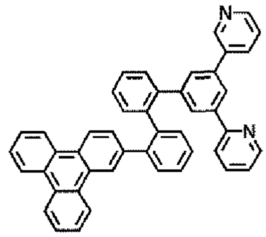
A-72

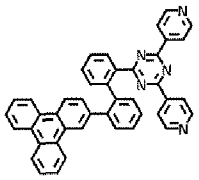
A-73

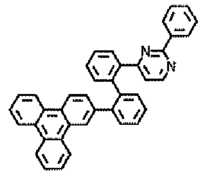
A-74

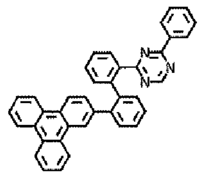
A-75

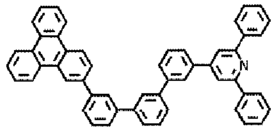
A-76

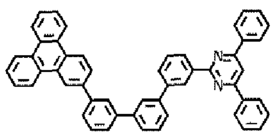
A-77

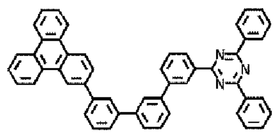
A-78

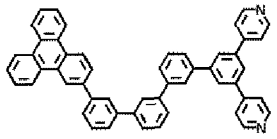
A-79

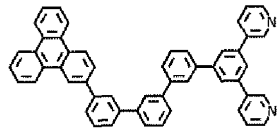
A-80

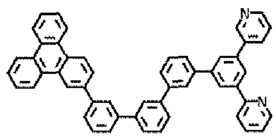
A-81

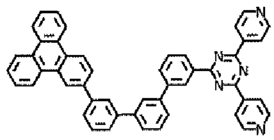
A-82

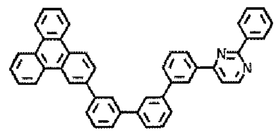
A-83

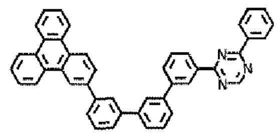
A-84

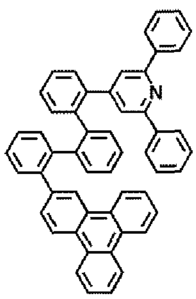
A-85

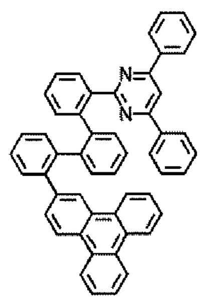
A-86

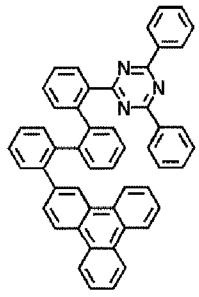
A-87

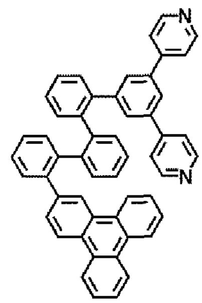
A-88

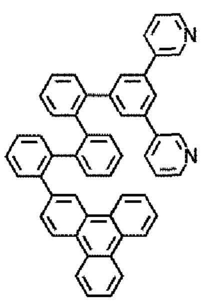
A-89

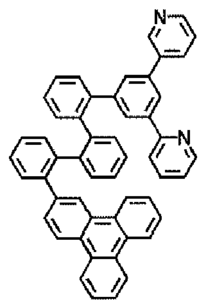
A-90

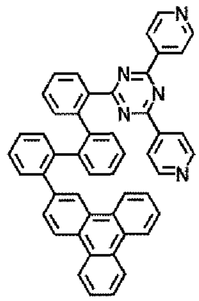
A-91

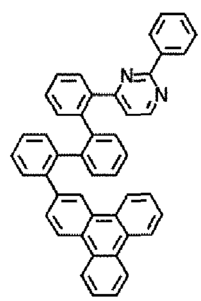
A-92

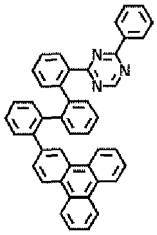
A-93
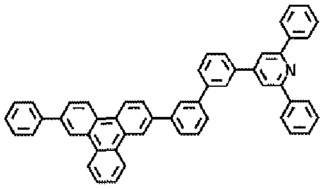
A-94
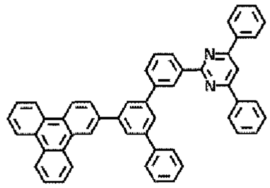
A-95
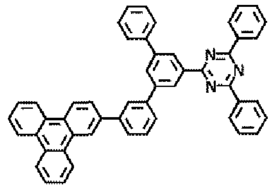
A-96

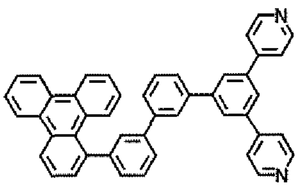
A-97
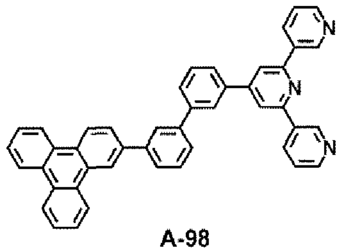
A-98
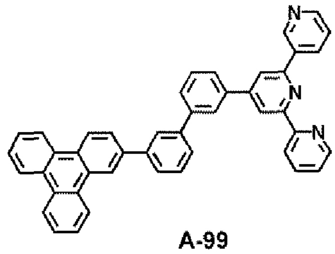
A-99

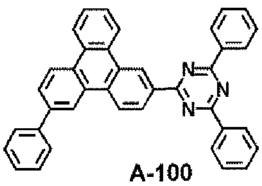
A-100
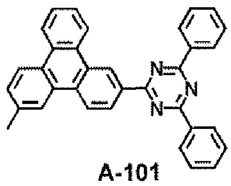
A-101
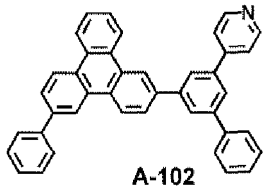
A-102

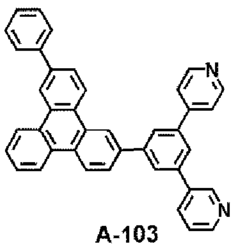
A-103
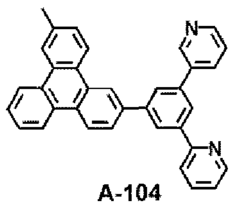
A-104
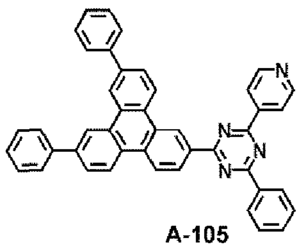
A-105

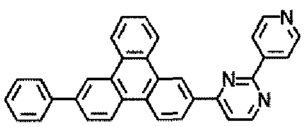
A-106
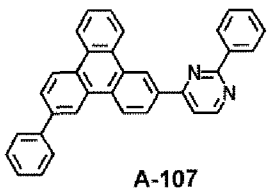
A-107
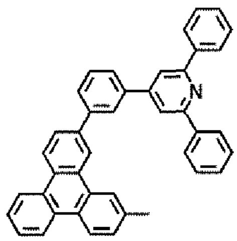
A-108

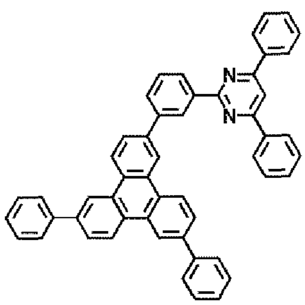

A-109

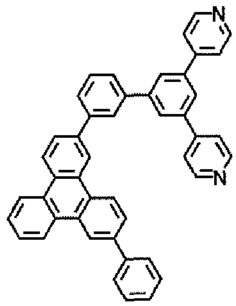

A-110

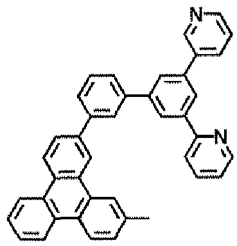

A-111

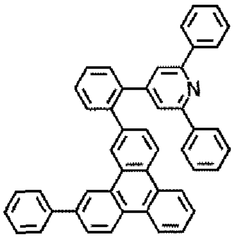

A-112

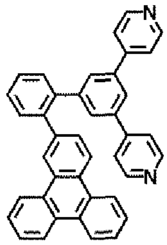

A-113

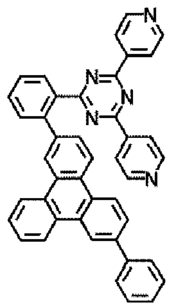

A-114

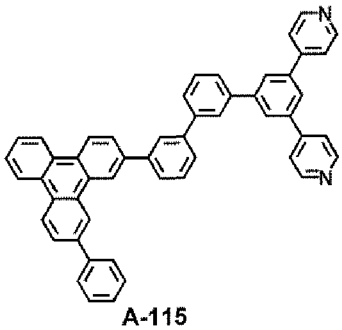

A-115

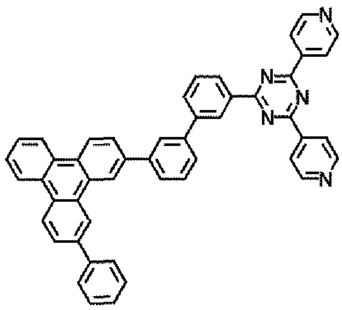

A-116

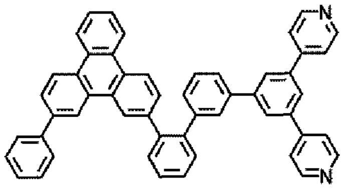

A-117

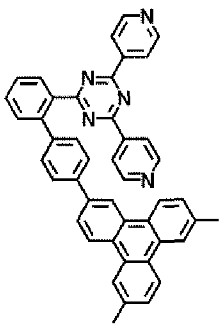

A-118

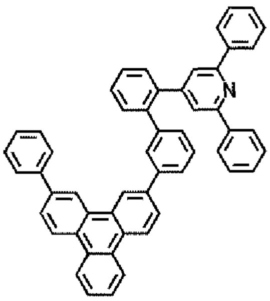

A-119

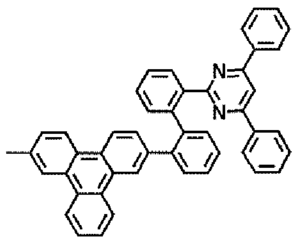

A-120

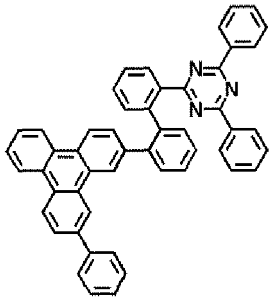

A-121

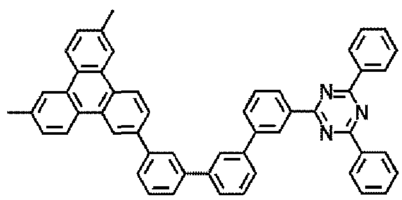

A-122

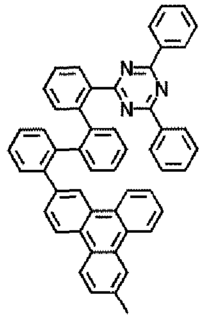

A-123

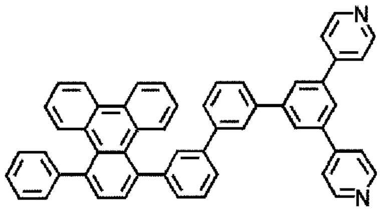

A-124

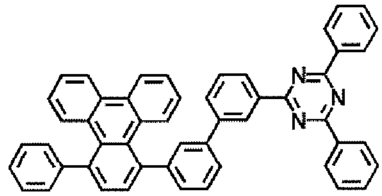

A-125

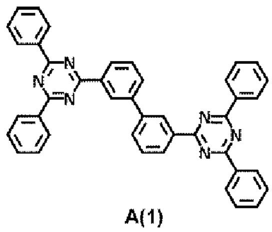

A(1)

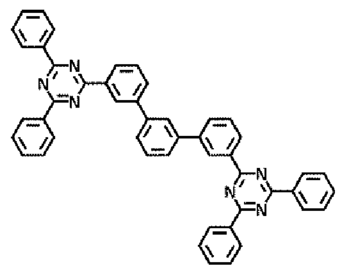

A(2)

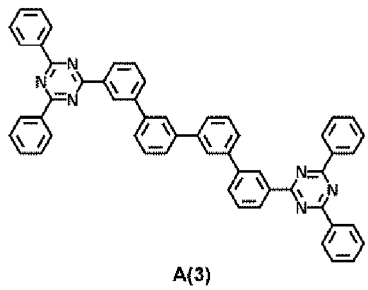

A(3)

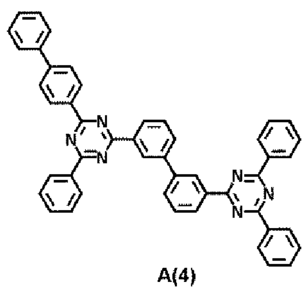

A(4)

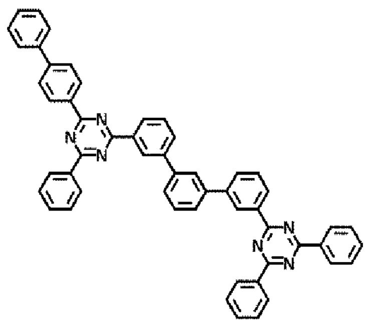

A(5)

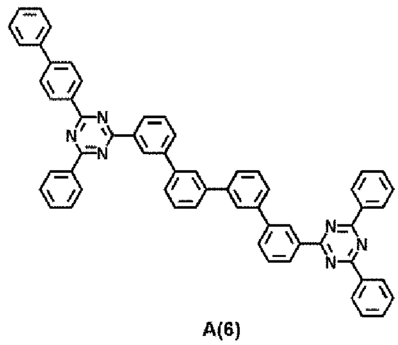

A(6)

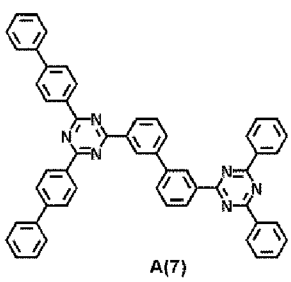

A(7)

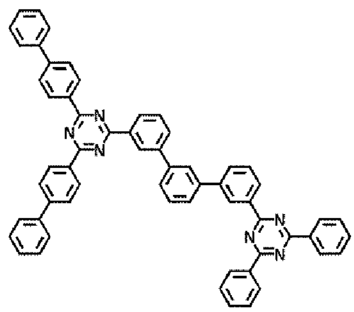

A(8)

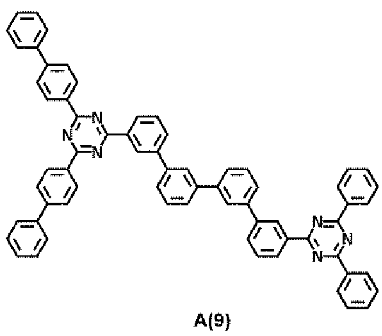

A(9)

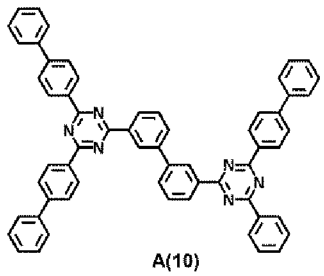

A(10)

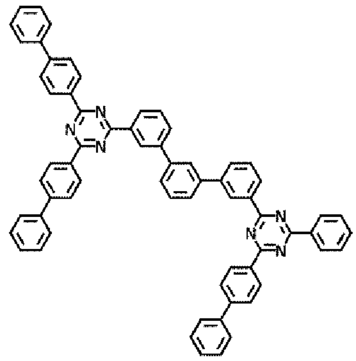

A(11)

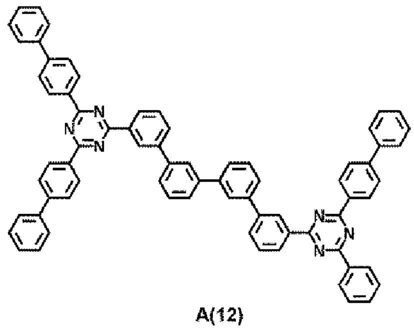

A(12)

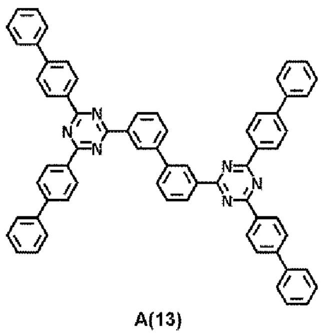

A(13)

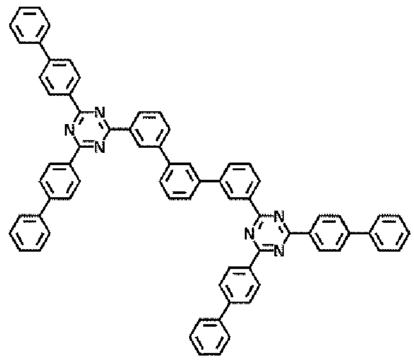

A(14)

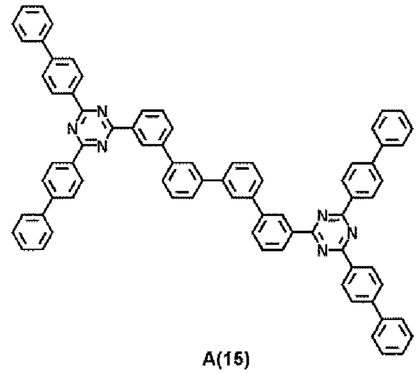

A(15)

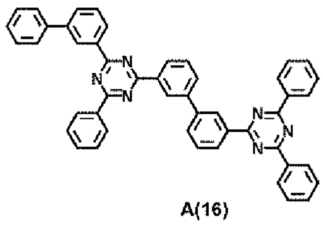

A(16)

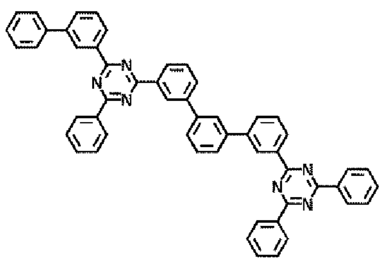

A(17)

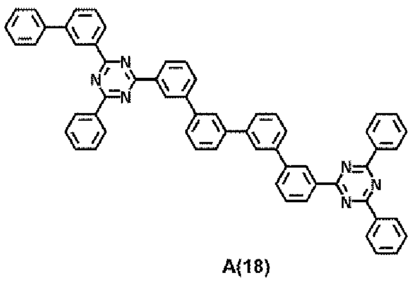

A(18)

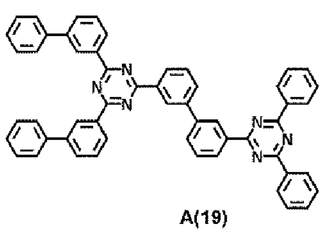

A(19)

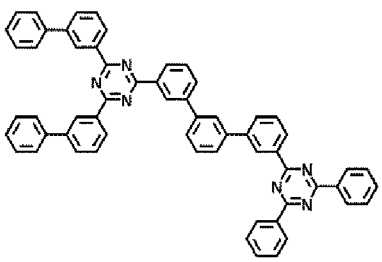

A(20)

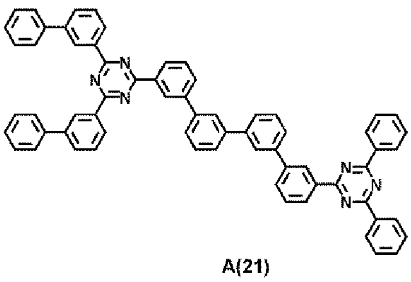

A(21)

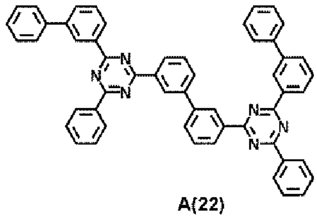
A(22)

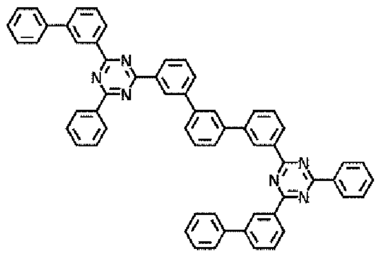
A(23)

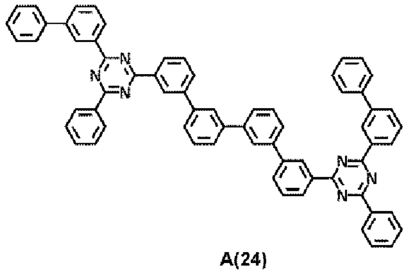
A(24)

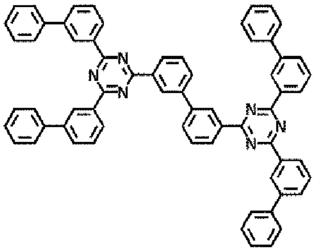
A(25)

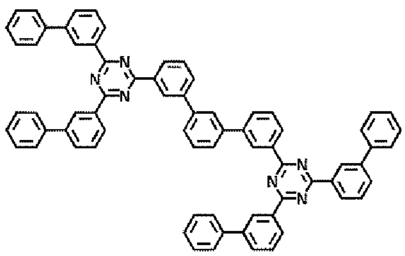
A(26)

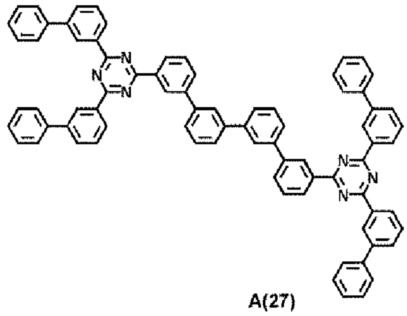
A(27)

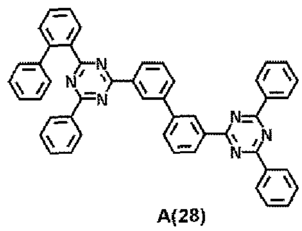
A(28)

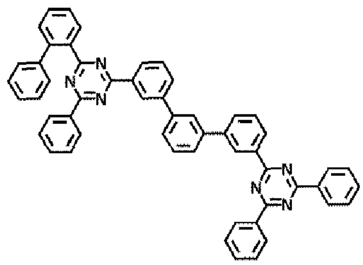
A(29)

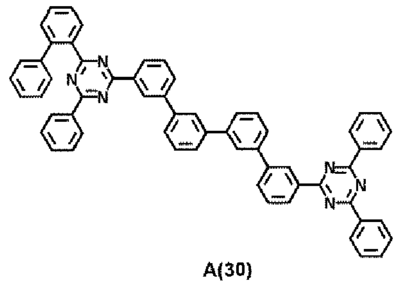
A(30)

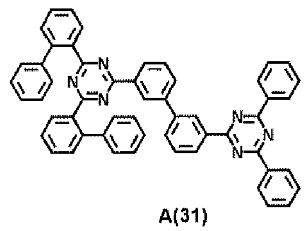
A(31)

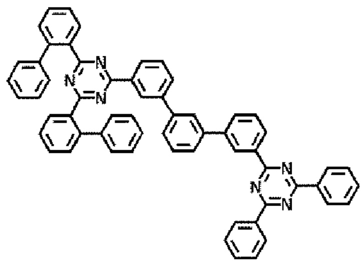
A(32)

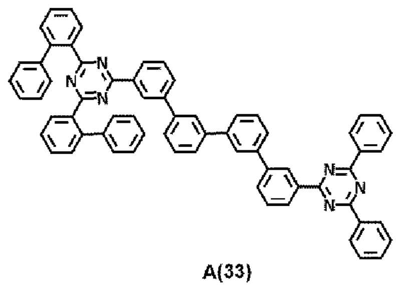
A(33)

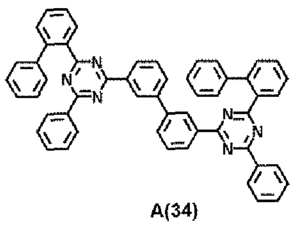
A(34)

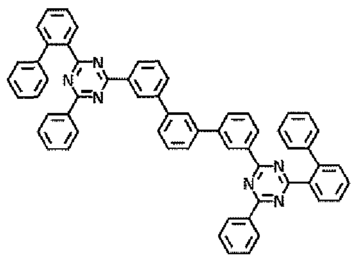
A(35)

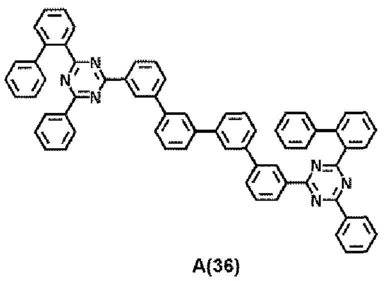
A(36)

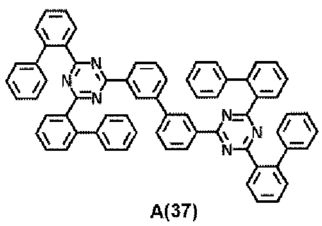

A(37)

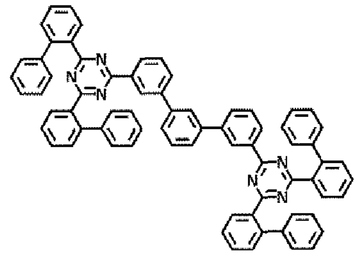

A(38)

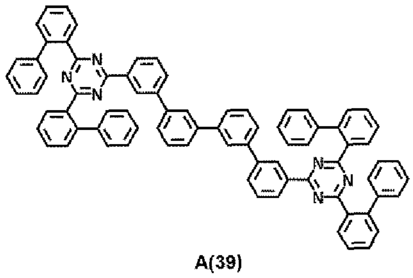

A(39)

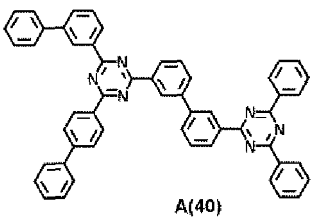

A(40)

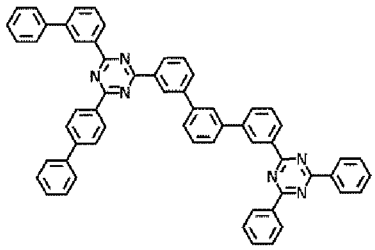

A(41)

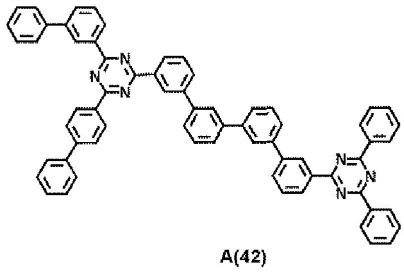

A(42)

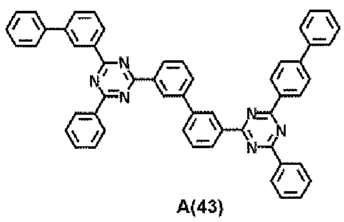

A(43)

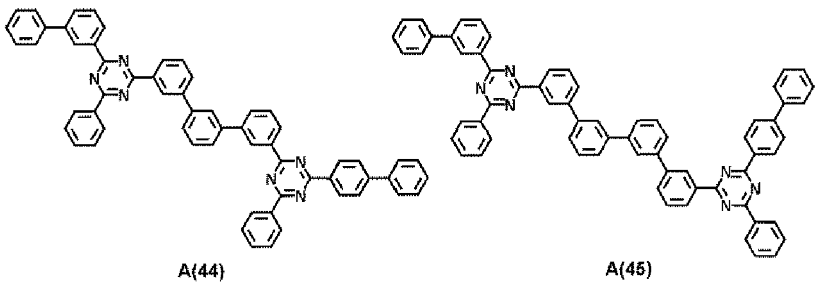

A(44)

A(45)

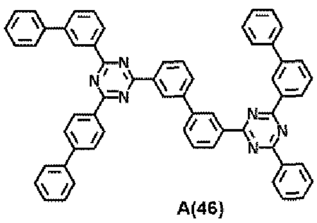

A(46)

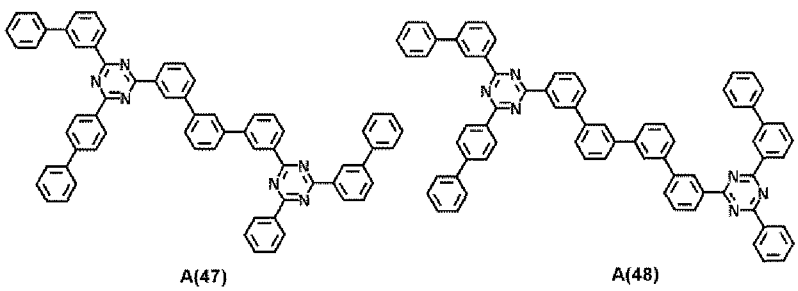

A(47)

A(48)

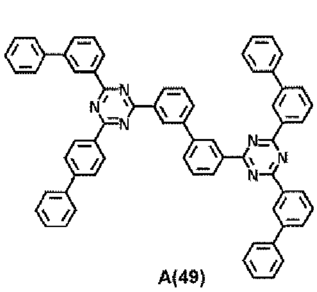

A(49)

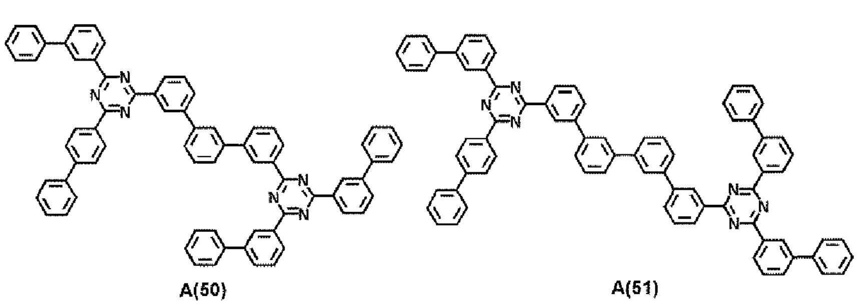

A(50)

A(51)

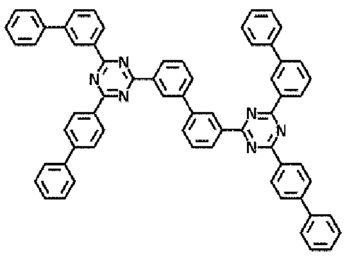

A(52)

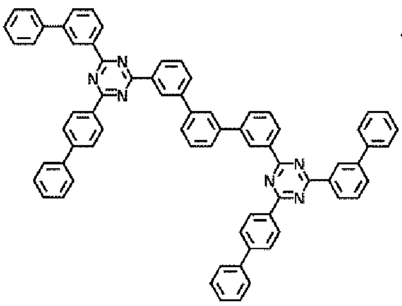

A(53)

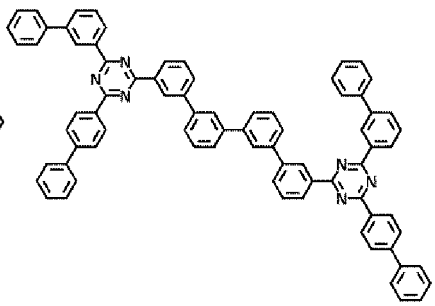

A(54)

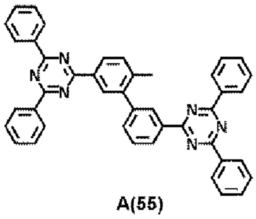

A(55)

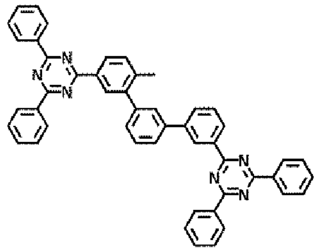

A(56)

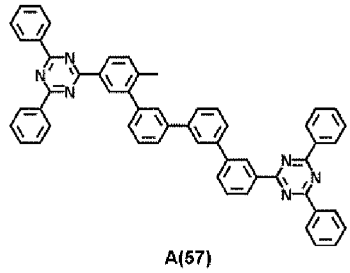

A(57)

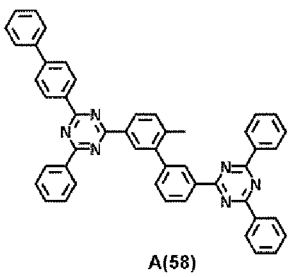

A(58)

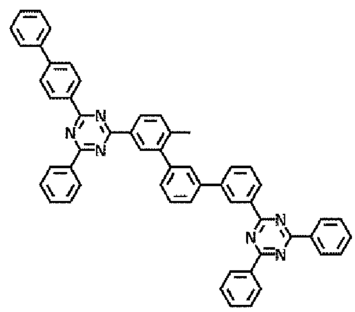

A(59)

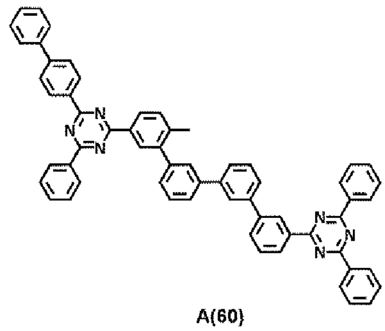

A(60)

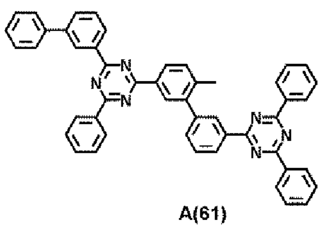

A(61)

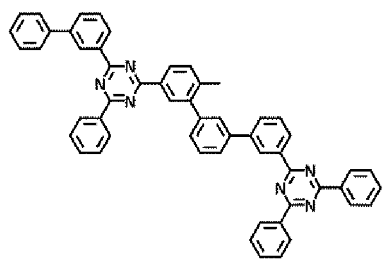

A(62)

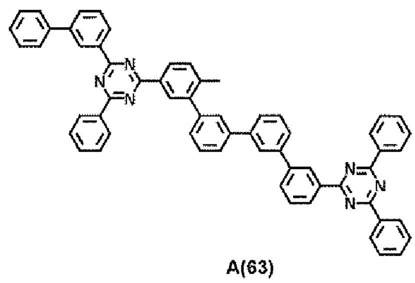

A(63)

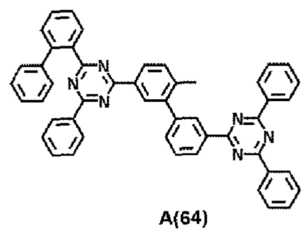

A(64)

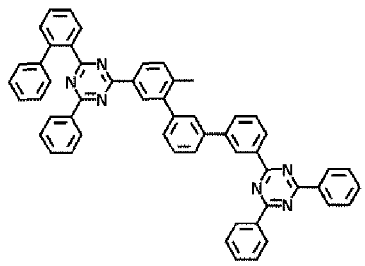

A(65)

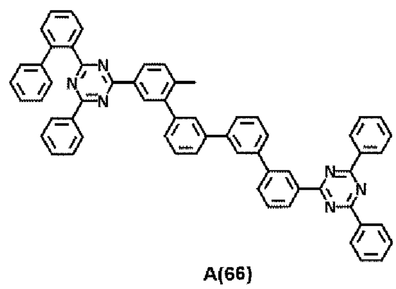

A(66)

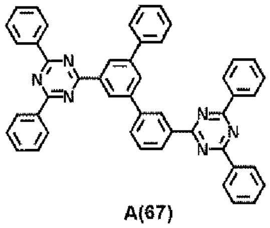
A(67)

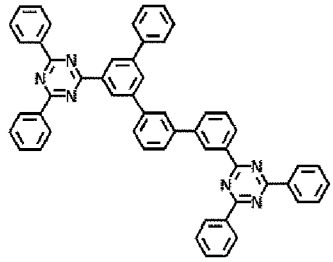
A(68)

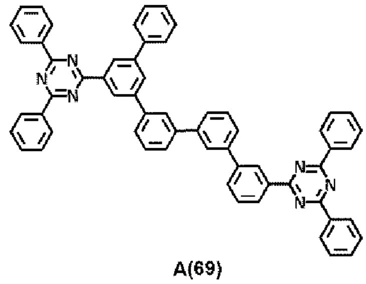
A(69)

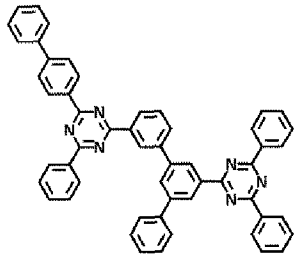
A(70)

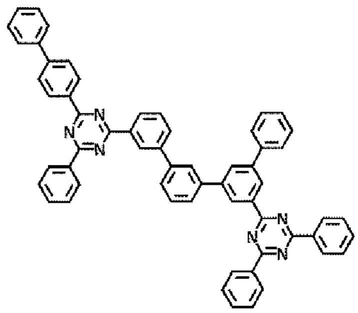
A(71)

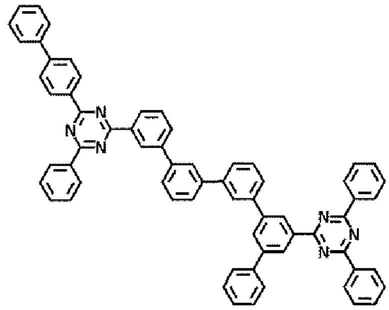
A(72)

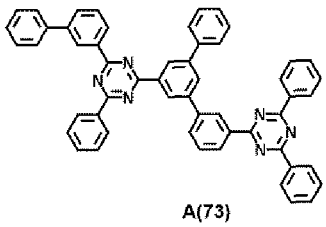
A(73)

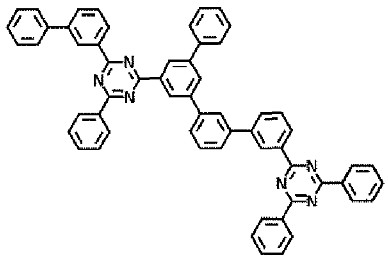
A(74)

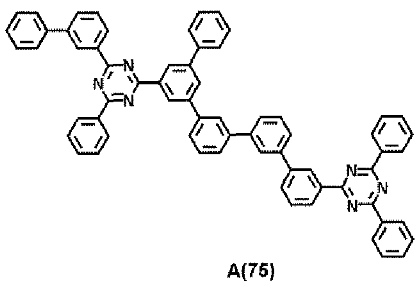
A(75)

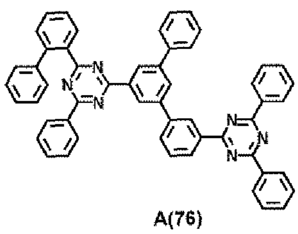
A(76)

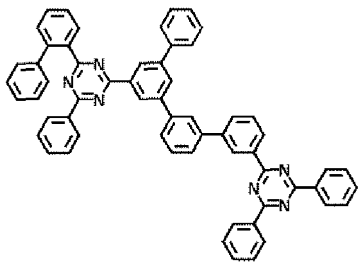
A(77)

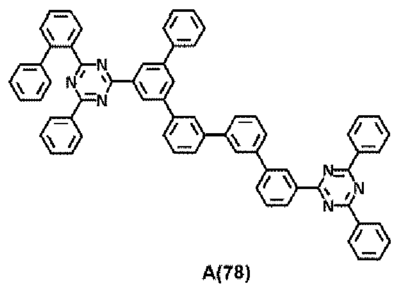
A(78)

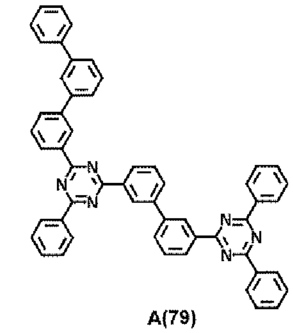

A(79)

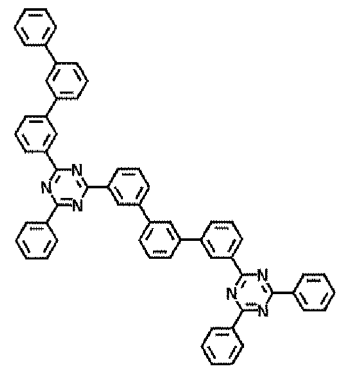

A(80)

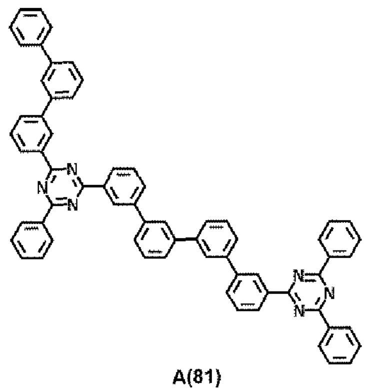

A(81)

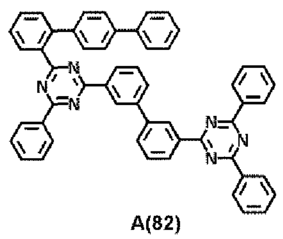

A(82)

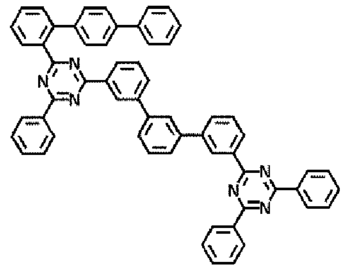

A(83)

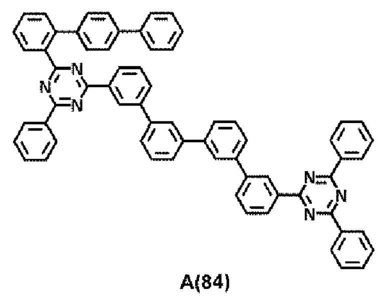

A(84)

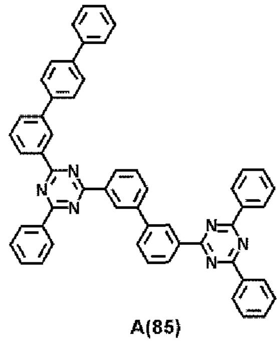

A(85)

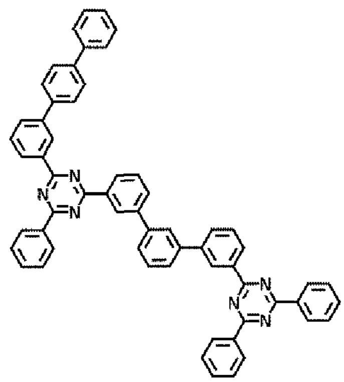

A(86)

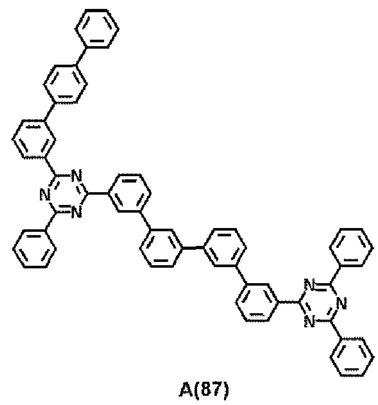

A(87)

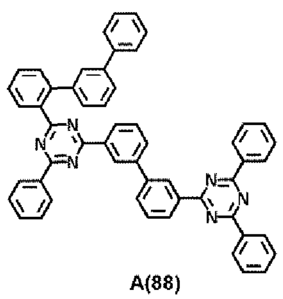

A(88)

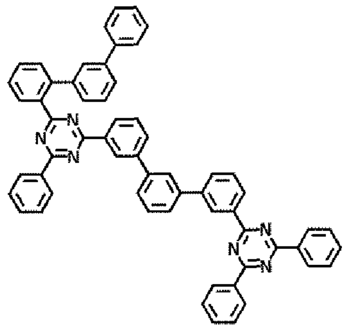

A(89)

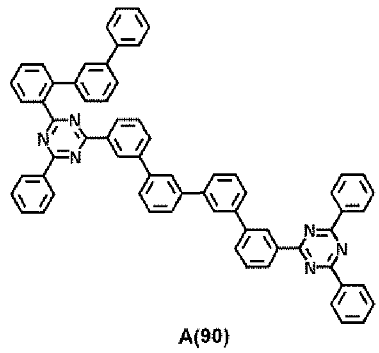

A(90)

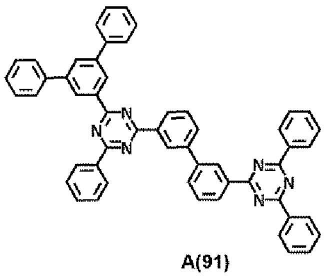

A(91)

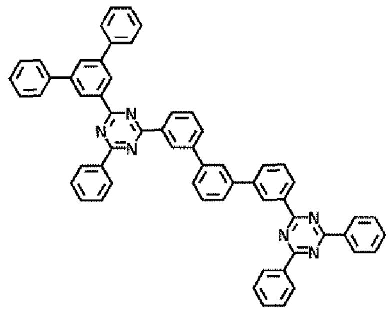

A(92)

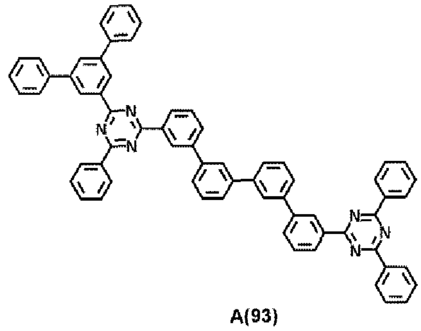

A(93)

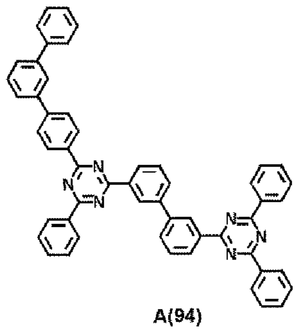

A(94)

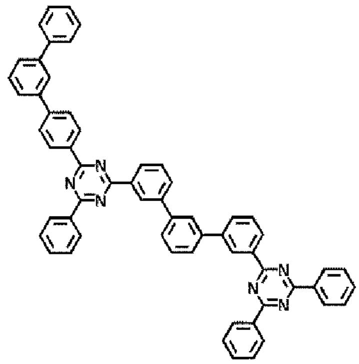

A(95)

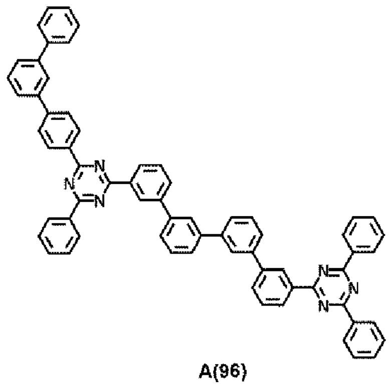

A(96)

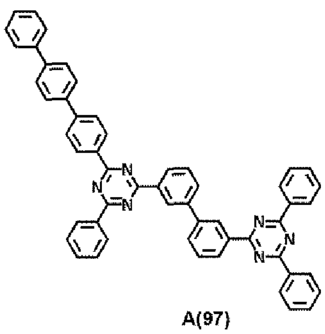

A(97)

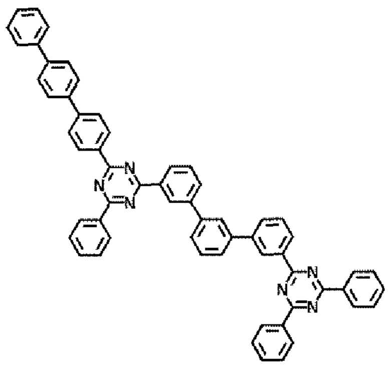

A(98)

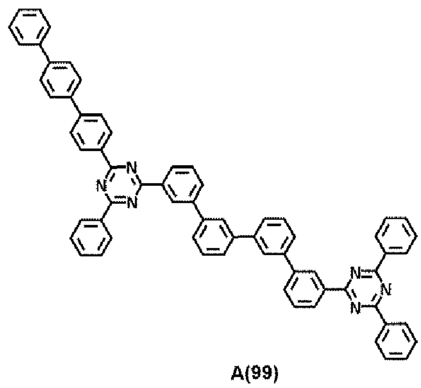

A(99)

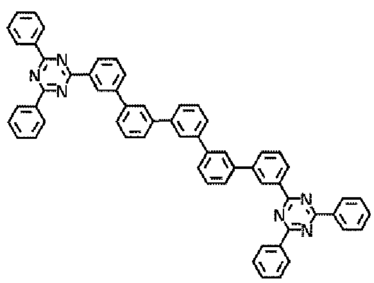

A(100)

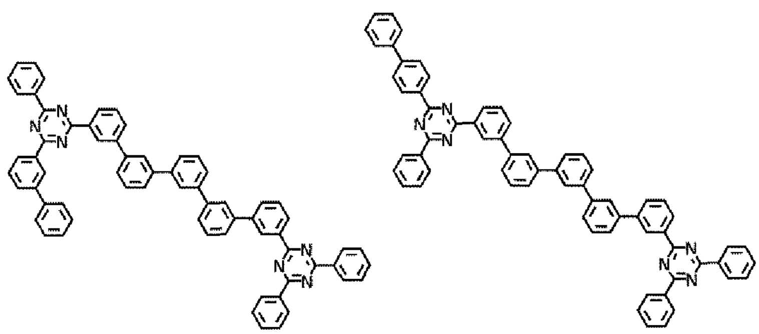

A(101)

A(102)

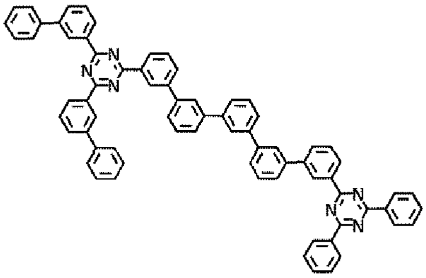

A(103)

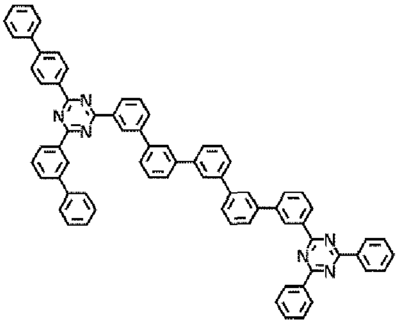

A(104)

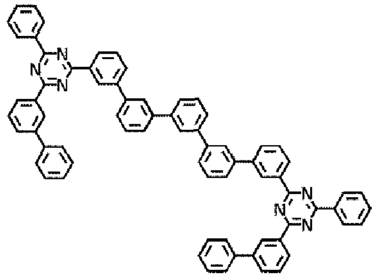

A(105)

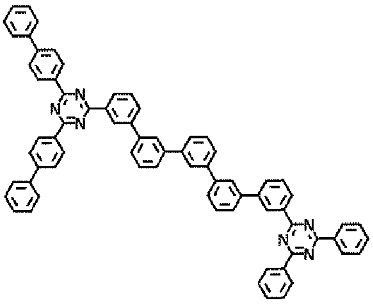

A(106)

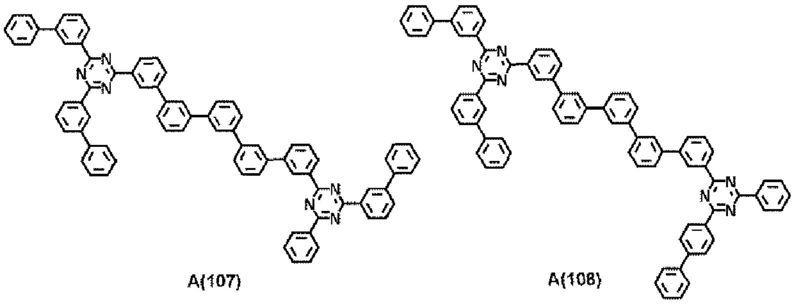

A(107)

A(108)

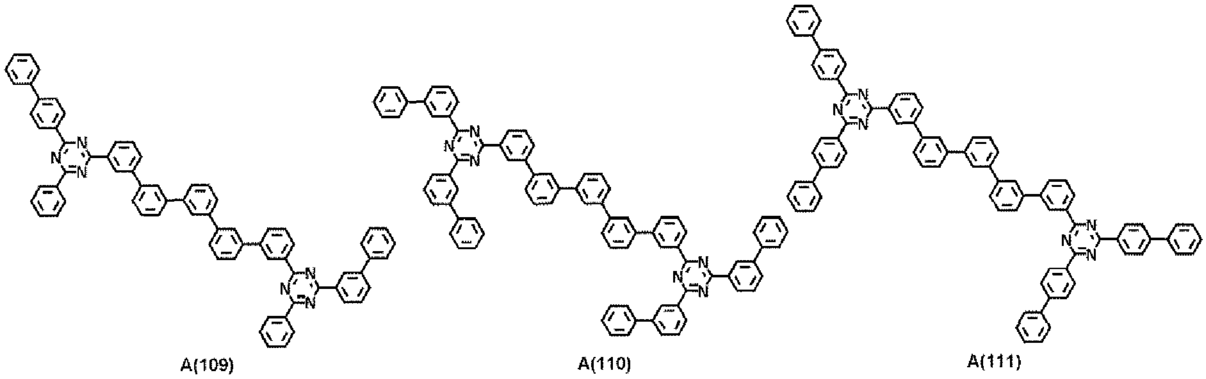

A(109)

A(110)

A(111)

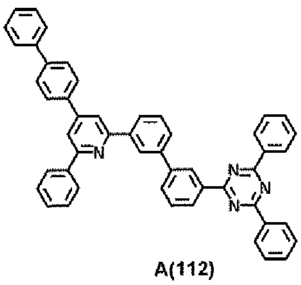

A(112)

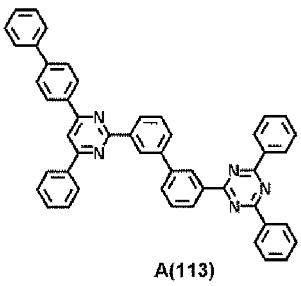

A(113)

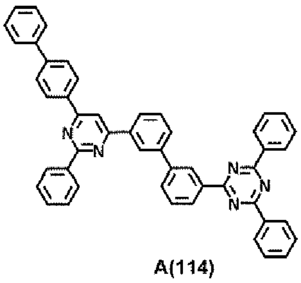

A(114)

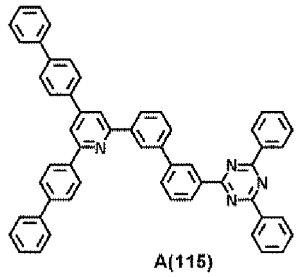

A(115)

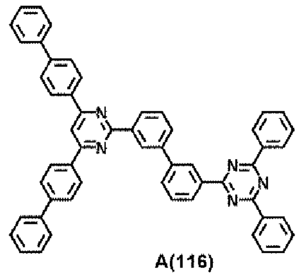

A(116)

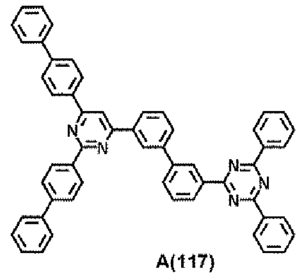

A(117)

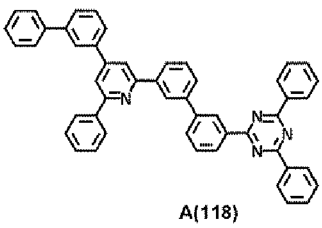

A(118)

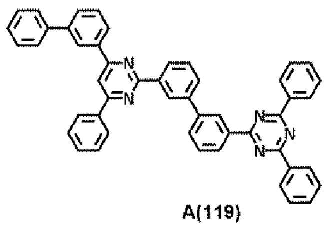

A(119)

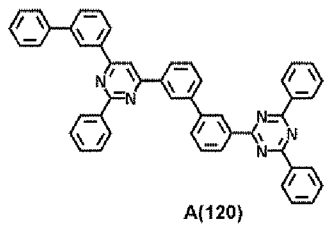

A(120)

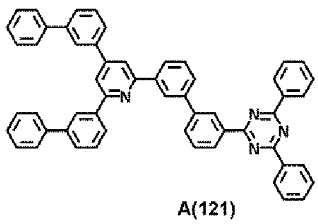

A(121)

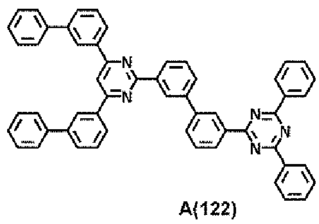

A(122)

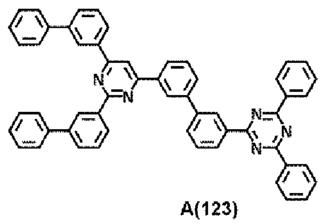

A(123)

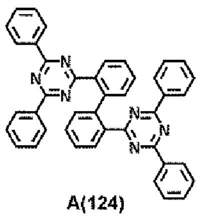

A(124)

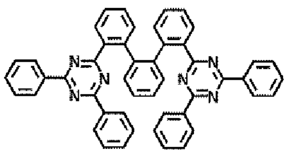

A(125)

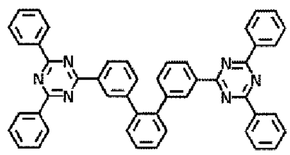

A(126)

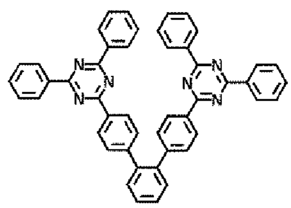

A(127)

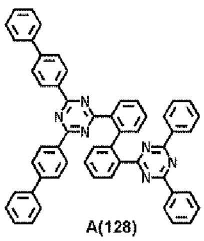

A(128)

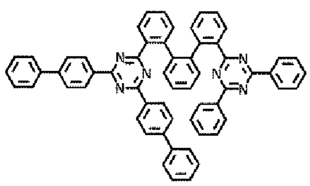

A(129)

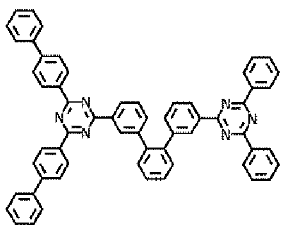

A(130)

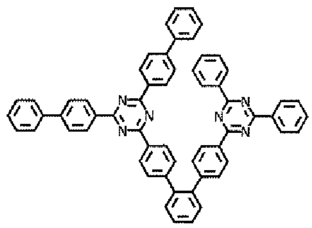

A(131)

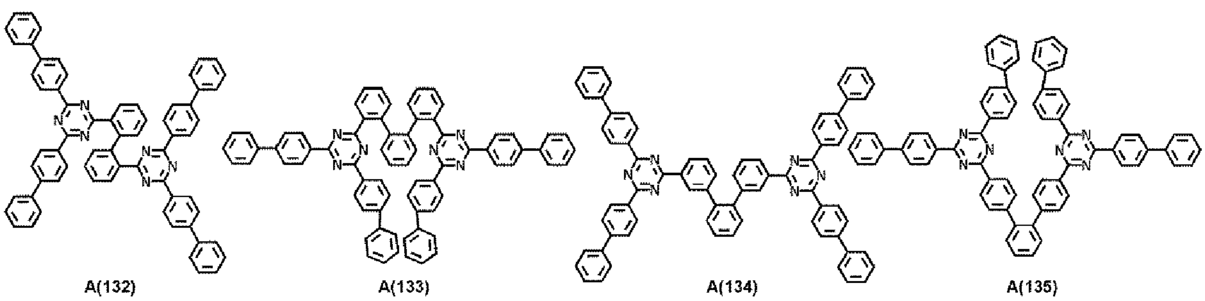

A(132) A(133) A(134) A(135)

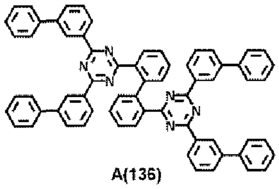
A(136)

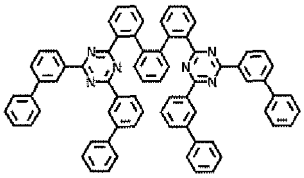
A(137)

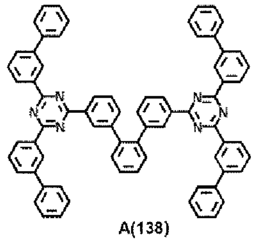
A(138)

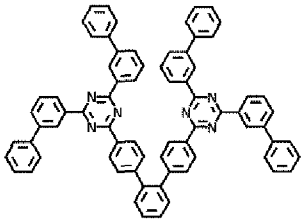
A(139)

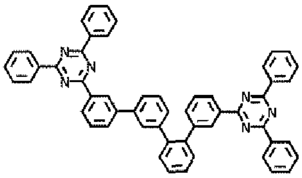
A(140)

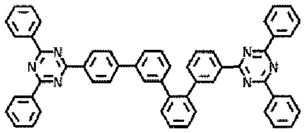
A(141)

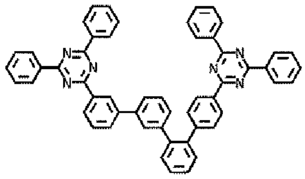
A(142)

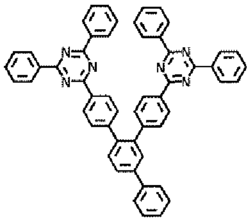
A(143)

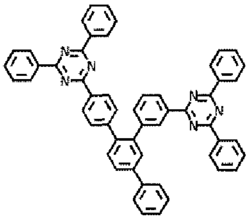
A(144)

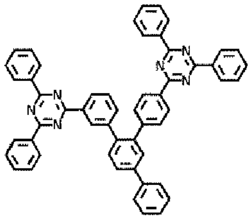
A(145)

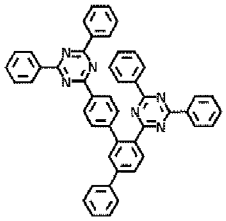
A(146)

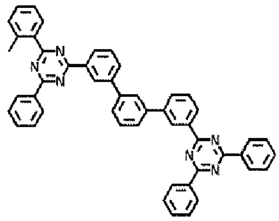
A(147)

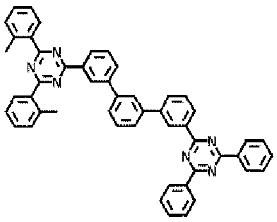
A(148)

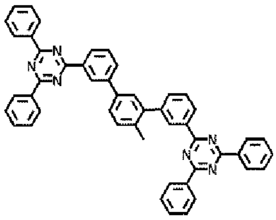
A(149)

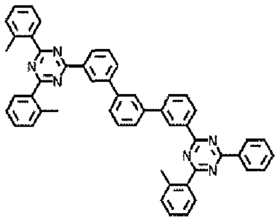
A(150)

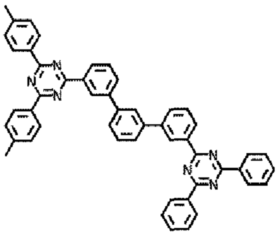
A(151)

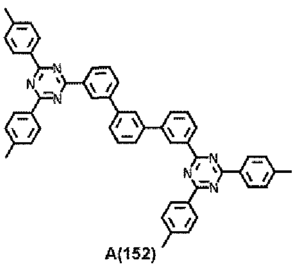
A(152)

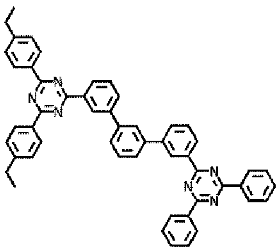
A(153)

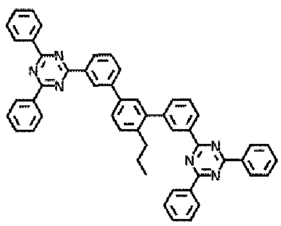
A(154)

.

In some embodiments, the hole transporting host may be selected from Compounds H-H1 to H-H103, but embodiments are not limited thereto:

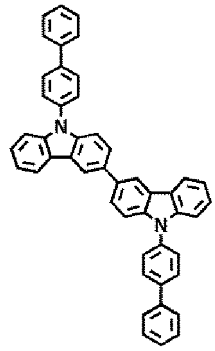
H-H1

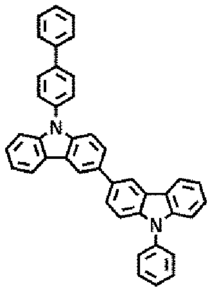
H-H2

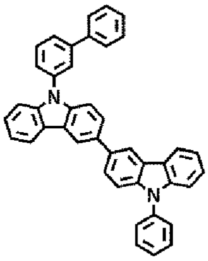
H-H3

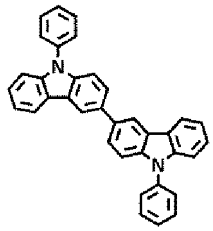
H-H4

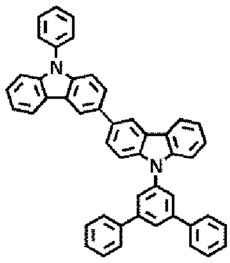
H-H5

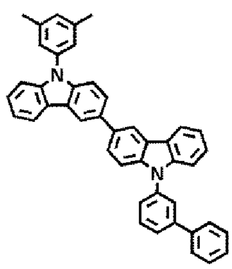
H-H6

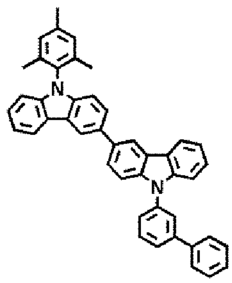
H-H7

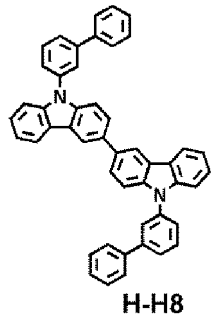
H-H8

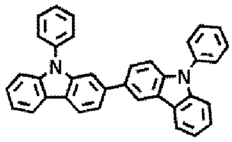
H-H9

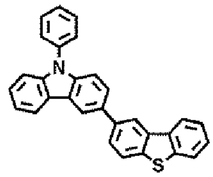
H-H10

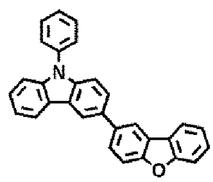
H-H11

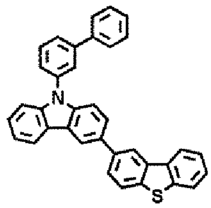
H-H12

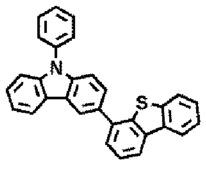
H-H13

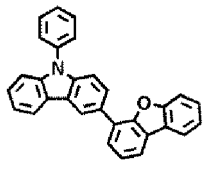
H-H14

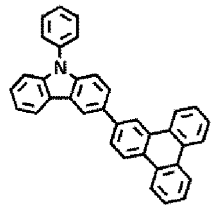
H-H15

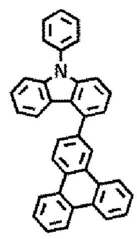
H-H16

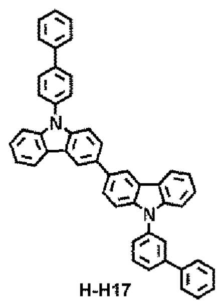
H-H17

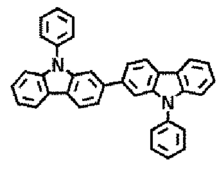
H-H18

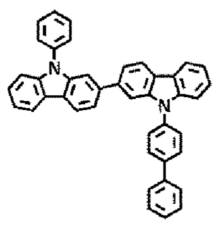
H-H19

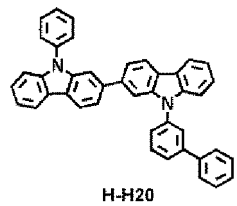
H-H20

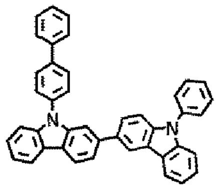
H-H21

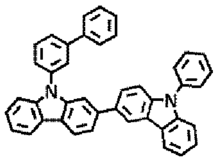
H-H22

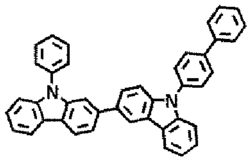
H-H23

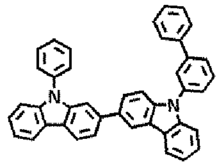
H-H24

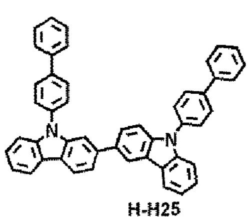
H-H25

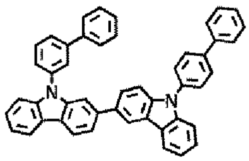
H-H26

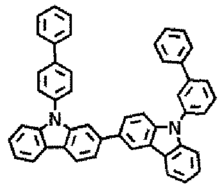
H-H27

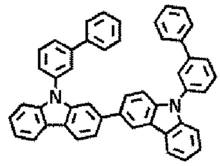
H-H28

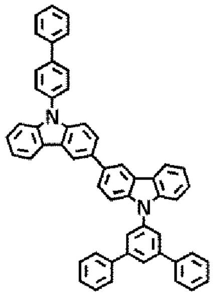
H-H29

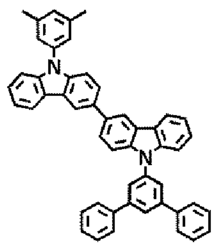
H-H30

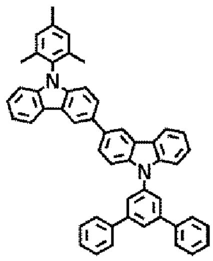
H-H31

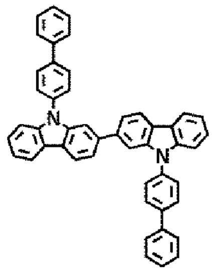
H-H32

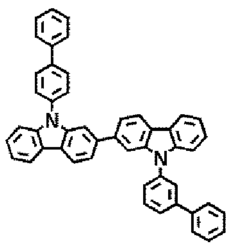
H-H33

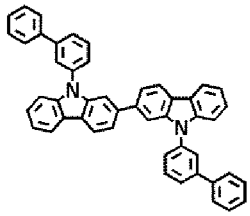
H-H34

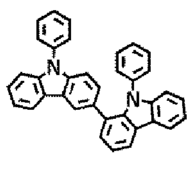
H-H35

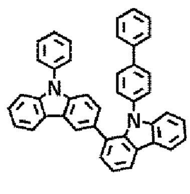
H-H36

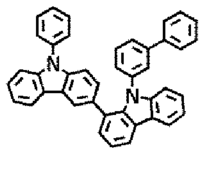
H-H37

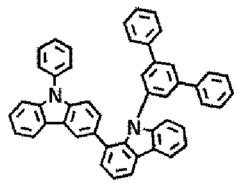
H-H38

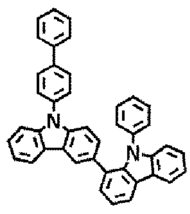
H-H39

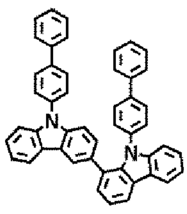
H-H40

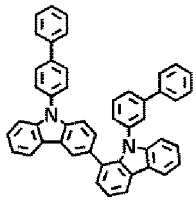
H-H41

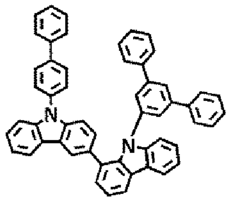
H-H42

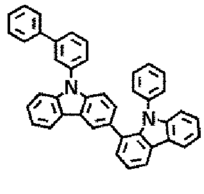
H-H43

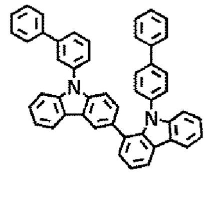
H-H44

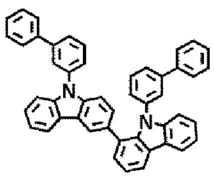
H-H45

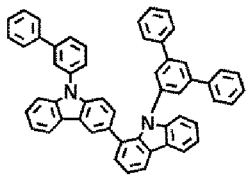
H-H46

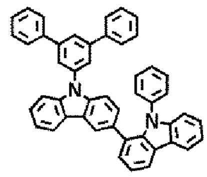
H-H47

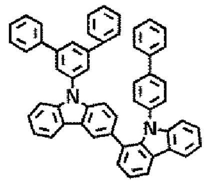
H-H48

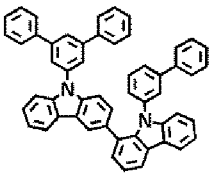
H-H49

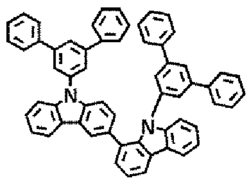
H-H50

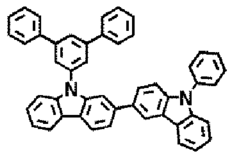
H-H51

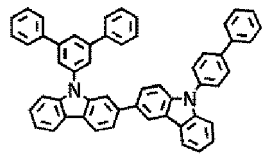
H-H52

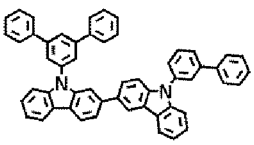
H-H53

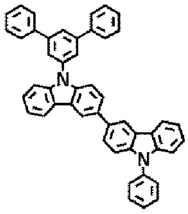
H-H54

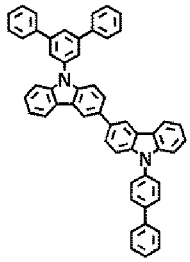
H-H55

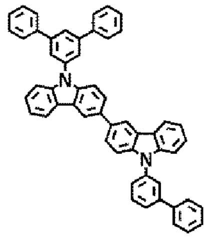
H-H56

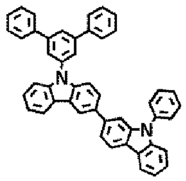
H-H57

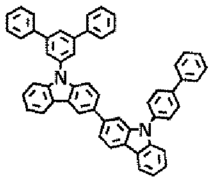
H-H58

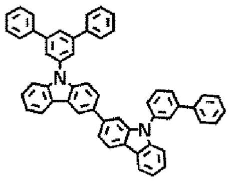
H-H59

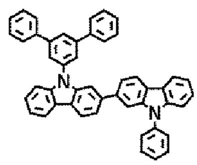
H-H60

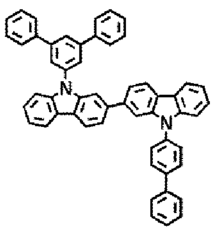
H-H61

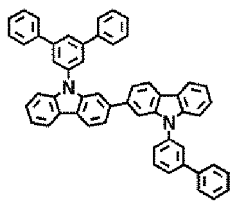
H-H62

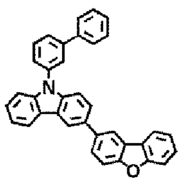
H-H63

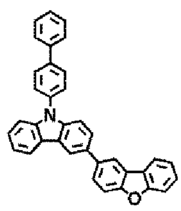
H-H64

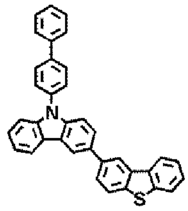
H-H65

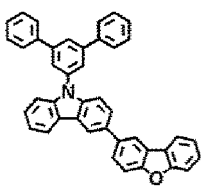
H-H66

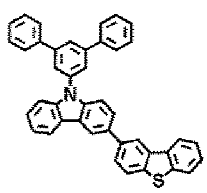
H-H67

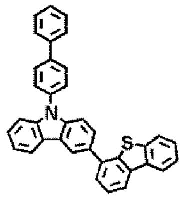
H-H68

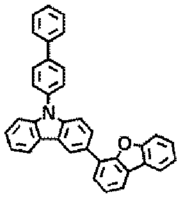
H-H69

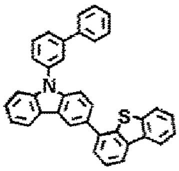
H-H70

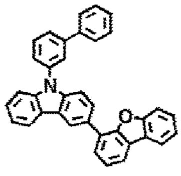
H-H71

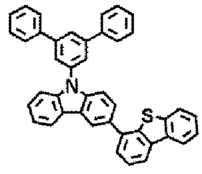
H-H72

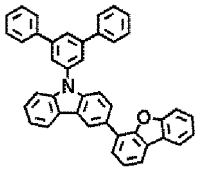
H-H73

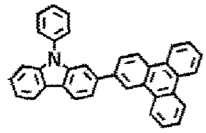
H-H74

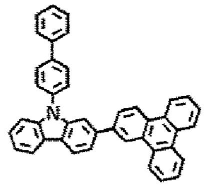
H-H75

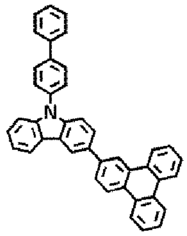
H-H76

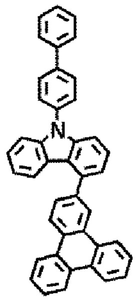
H-H77

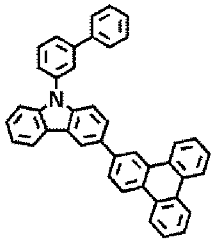
H-H78

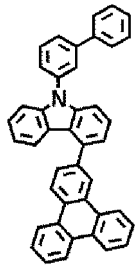
H-H79

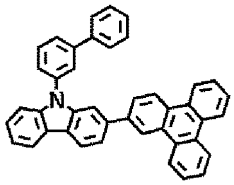
H-H80

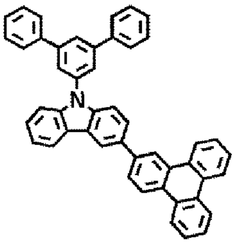
H-H81

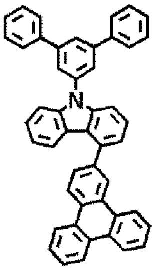
H-H82

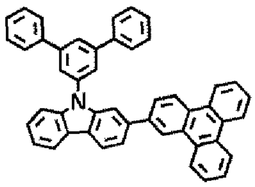
H-H83

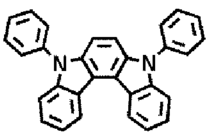
H-H84

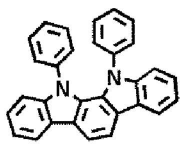
H-H85

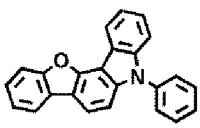
H-H86

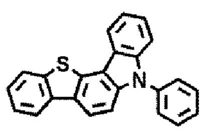
H-H87

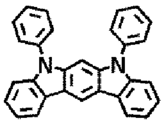
H-H88

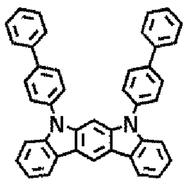
H-H89

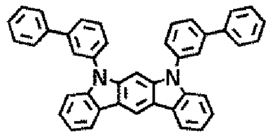
H-H90

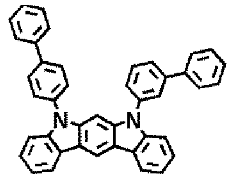
H-H91

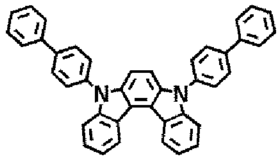
H-H92

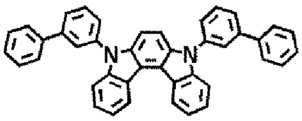
H-H93

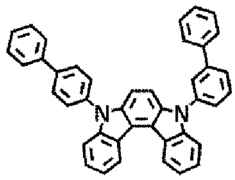
H-H94

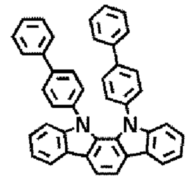
H-H95

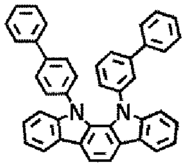
H-H96

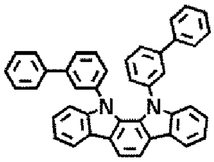
H-H97

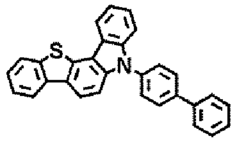
H-H98

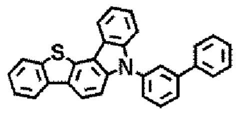
H-H99

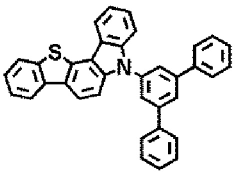
H-H100

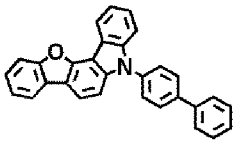
H-H101

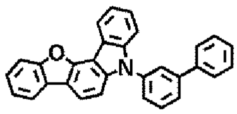
H-H102

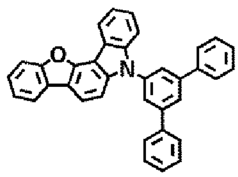
H-H103.

When the host is a mixture of an electron transporting host and a hole transporting host, a weight ratio of the electron transporting host to the hole transporting host may be in a range of about 1:9 to about 9:1, for example, about 2:8 to about 8:2, or for example, about 4:6 to about 6:4. When a weight ratio of the electron transporting host to the hole transporting host is within any of these ranges, holes and electrons transport balance into the emission layer 15 may be achieved.

In an embodiment, the electron transporting host may not be BCP, Bphene, B3PYMPM, 3P-T2T, BmPyPb, TPBi, 3TPYMB, and BSFM:

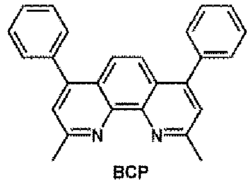
BCP

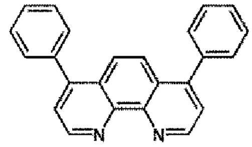
Bphen

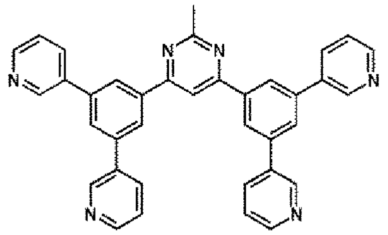
B3PYMPM

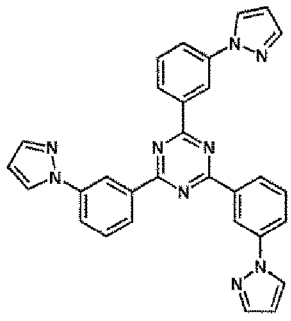

3P-T2T

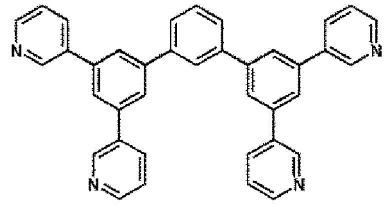

BmPyPb

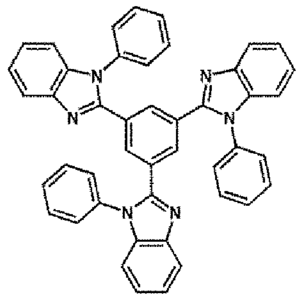

TPBi

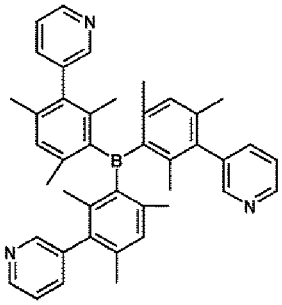

3TPYMB

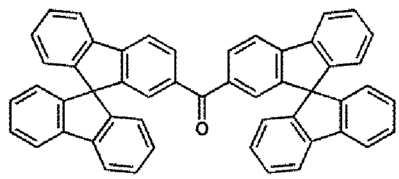

BSFM

.

In one or more embodiments, the hole transporting host may not be mCP, CBP and an amine-containing compound:

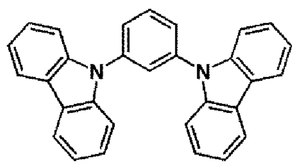

mCP

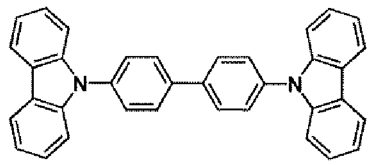

CBP

.

**Hole transport region 12**

In the organic light-emitting device 10, the hole transport region 12 may be between the first electrode 11 and the emission layer 15.

The hole transport region 12 may have a single-layered structure or a multi-layered structure.

For example, the hole transport region 12 may have a structure of hole injection layer, a structure of hole transport layer, a structure of hole injection layer/hole transport layer, a structure of hole injection layer/first hole transport layer/second hole transport layer, a structure of hole transport layer/intermediate layer, a structure of hole injection layer/hole transport layer/intermediate layer, a structure of hole transport layer/electron blocking layer, or a structure of hole injection layer/hole transport layer/electron blocking layer, but embodiments are not limited thereto.

The hole transport region 12 may include a compound having hole transport characteristics.

For example, the hole transport region 12 may include an amine-based compound.

In an embodiment, the hole transport region 12 may include at least one compound selected from compounds represented by Formulae 201 to 205, but embodiments are not limited thereto:

Formula 201

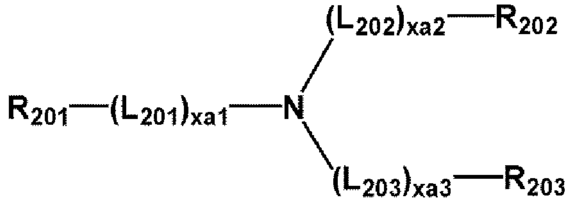

Formula 202

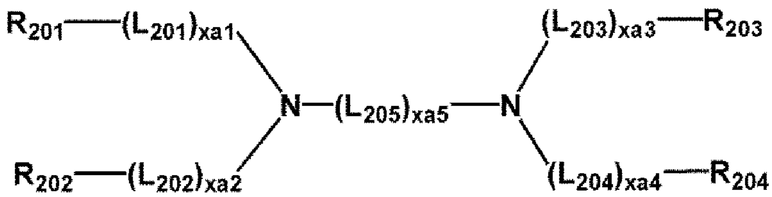

Formula 203

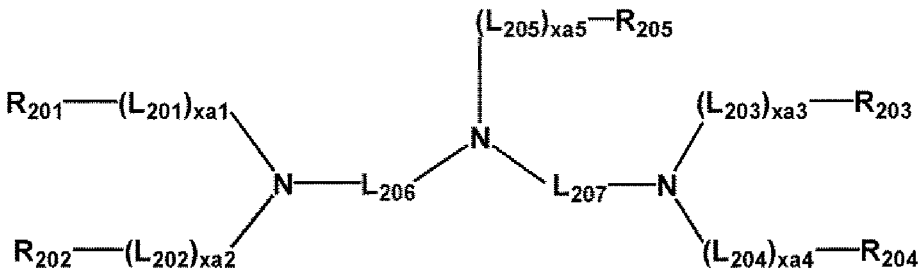

Formula 204

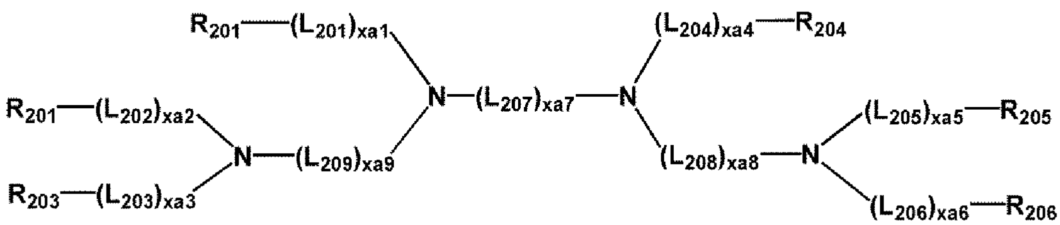

Formula 205

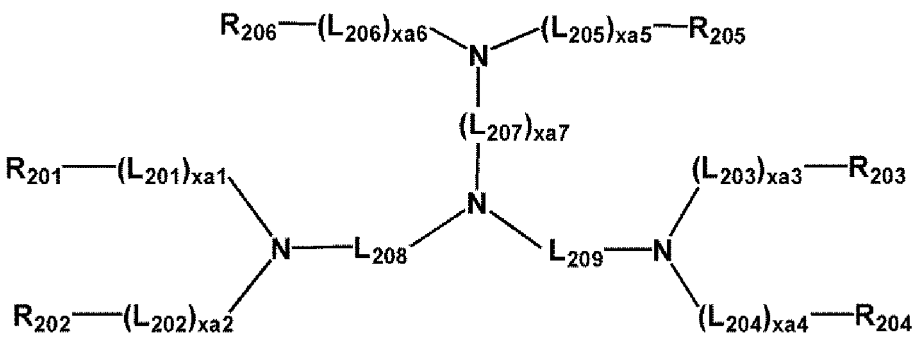

wherein in Formulae 201 to 205,

$L_{201}$ to $L_{209}$ may each independently be selected from *-O-*', *-S-*', a substituted or unsubstituted $C_5$-$C_{60}$ carbocyclic group and a substituted or unsubstituted $C_1$-$C_{60}$ heterocyclic group,
xa1 to xa9 may each independently be an integer from 0 to 5,
$R_{201}$ to $R_{206}$ may each independently be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, and a substituted or unsubstituted monovalent non-aromatic condensed heteropolycyclic group, and two adjacent groups selected from $R_{201}$ to $R_{206}$ may optionally be bound via a single bond, a dimethyl-methylene group, or a diphenyl-methylene group.

In some embodiments, $L_{201}$ to $L_{209}$ may be selected from a benzene group, a heptalene group, an indene group, a naphthalene group, an azulene group, a an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, and a triindolobenzene group, each unsubstituted or substituted with at least one selected from deuterium, a $C_1$-$C_{10}$ alkyl group, a $C_1$-$C_{10}$ alkoxy group, a phenyl group, a naphthyl group, a fluorenyl group, a carbazolyl group, a dibenzofuranyl group, a dibenzothiophenyl group, a triphenylenyl group, a biphenyl group, a terphenyl group, a tetraphenyl group, and -Si($Q_{11}$)($Q_{12}$)($Q_{13}$),
xa1 to xa9 may be each independently selected from 0, 1, and 2, and
$R_{201}$ to $R_{206}$ may each independently be selected from a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an indenocarbazolyl group, an indolocarbazolyl group, a benzofurocarbazolyl group, and a benzothienocarbazolyl group, each unsubstituted or substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a $C_1$-$C_{10}$ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si($Q_{31}$)($Q_{32}$)($Q_{33}$), and -N($Q_{31}$)($Q_{32}$),
wherein $Q_{11}$ to $Q_{13}$ and $Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group.

According to an embodiment, the hole transport region 12 may include a carbazole-containing amine-based compound.

In one or more embodiments, the hole transport region 12 may include a carbazole-containing amine-based compound and a carbazole-free amine-based compound.

The carbazole-containing amine-based compound may be, for example, selected from compounds represented by Formula 201 including a carbazole group and further including at least one selected from a dibenzofuran group, a dibenzothiophene group, a fluorene group, a spiro-bifluorene group, an indenocarbazole group, an indolocarbazole group, a benzofurocarbazole group, and a benzothienocarbazole group.

The carbazole-free amine-based compound may be, for example, selected from compounds represented by

Formula 201 not including a carbazole group and including at least one selected from a dibenzofuran group, a dibenzothiophene group, a fluorene group, and a spiro-bifluorene group.

In one or more embodiments, the hole transport region 12 may include at least one of Compounds represented by Formula 201 or 202.

In an embodiment, the hole transport region 12 may include at least one selected from Compounds represented by Formulae 201-1, 202-1 and 201-2, but embodiments are not limited thereto:

Formula 201-1

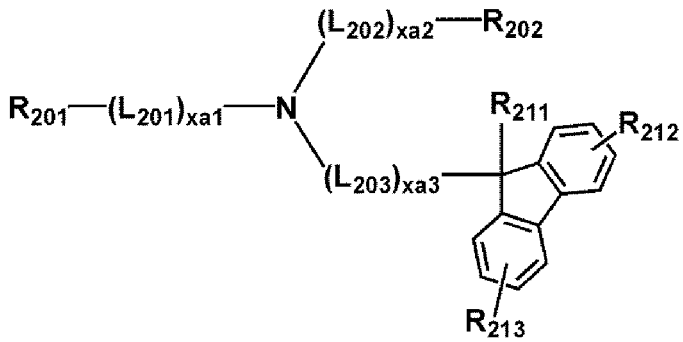

Formula 202-1

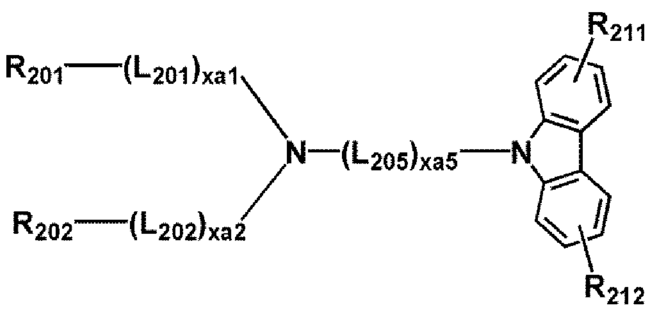

Formula 201-2

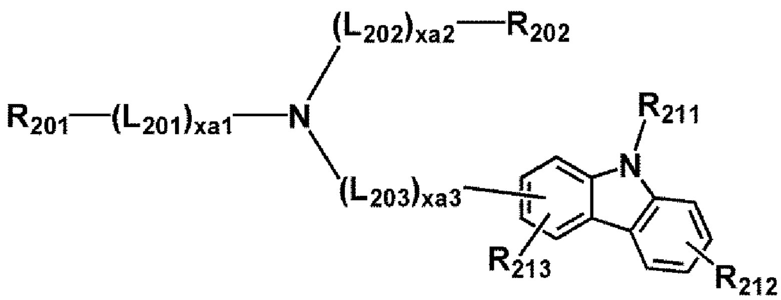

wherein in Formulae 201-1, 202-1, and 201-2, $L_{201}$ to $L_{203}$, $L_{205}$, xa1 to xa3, xa5, $R_{201}$, and $R_{202}$ may each be understood by referring to the descriptions for those provided herein, and $R_{211}$ to $R_{213}$ may each independently be selected from hydrogen, deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a phenyl group substituted with a $C_1$-$C_{10}$ alkyl group, a phenyl group substituted with -F, a naphthyl group, a fluorenyl group, a spiro-bifluorenyl group, a dimethylfluorenyl group, a diphenylfluorenyl group, a triphenylenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In some embodiments, the hole transport region 12 may include at least one selected from Compounds HT1 to HT39, but embodiments are not limited thereto:

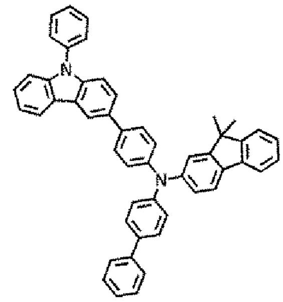
HT1

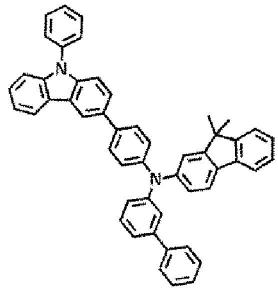
HT2

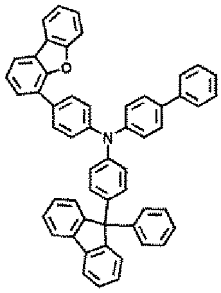
HT3

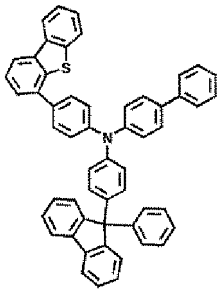
HT4

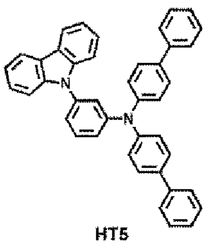
HT5

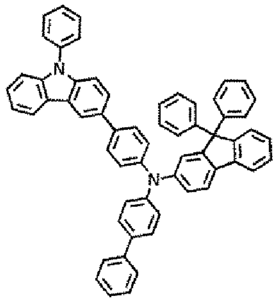
HT6

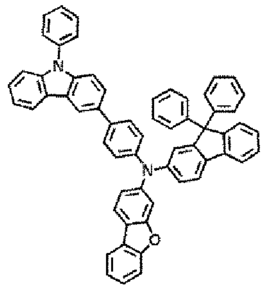
HT7

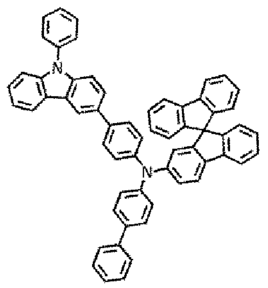
HT8

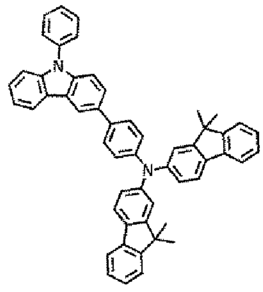
HT9

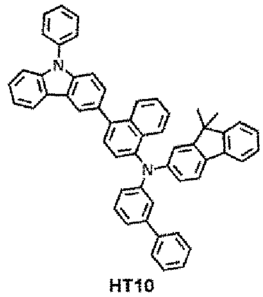
HT10

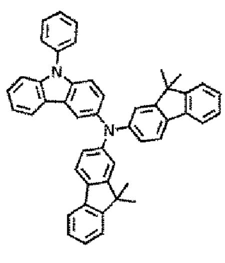
HT11

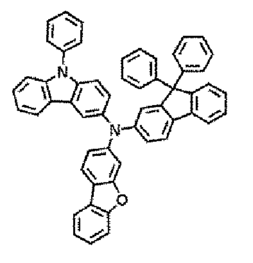
HT12

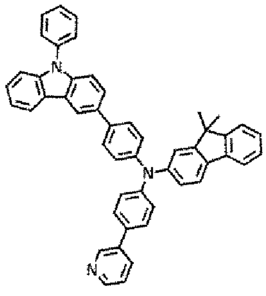
HT13

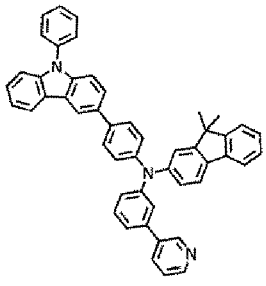
HT14

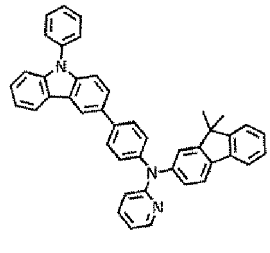
HT15

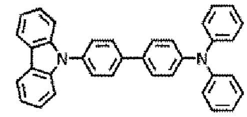

HT16

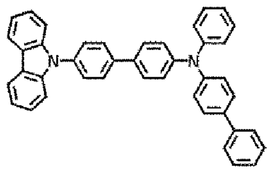

HT17

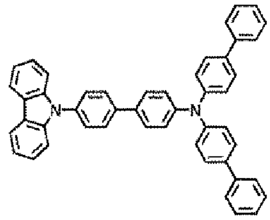

HT18

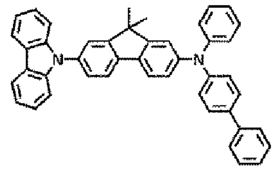

HT19

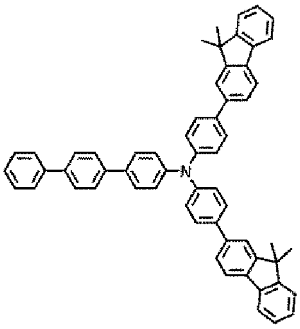

HT20

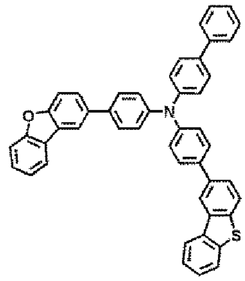

HT21

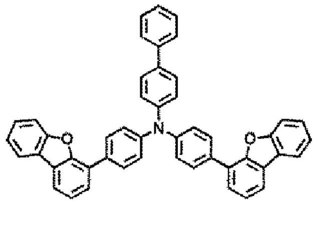

HT22

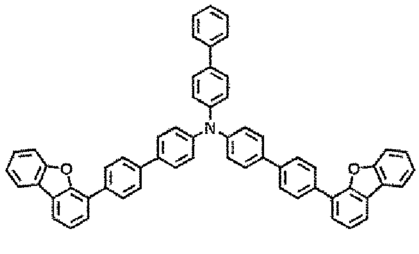

HT23

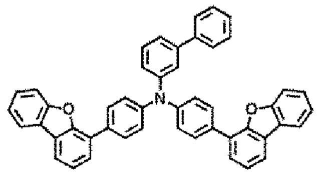

HT24

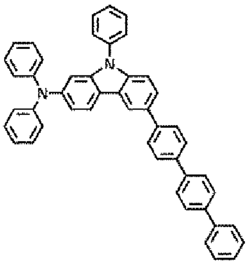

HT25

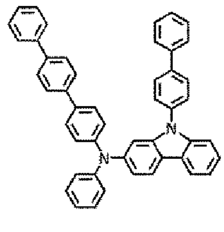

HT26

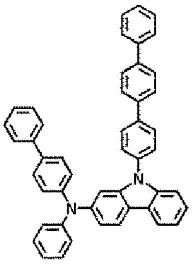

HT27

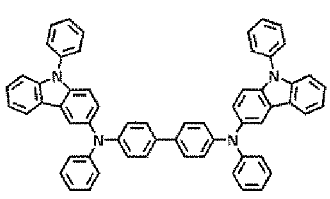

HT28

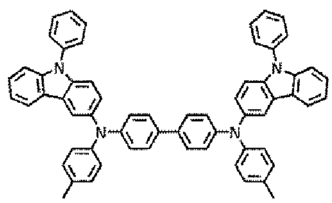

HT29

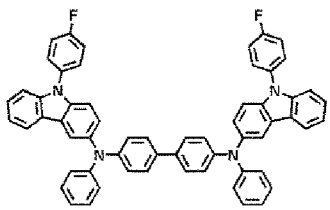

HT30

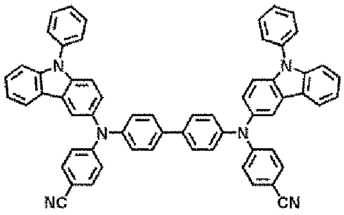

HT31

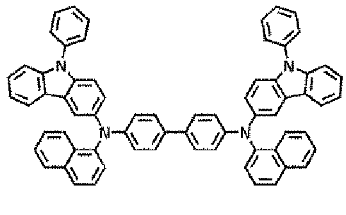

HT32

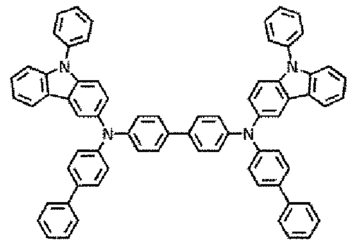

HT33

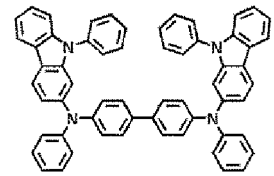

HT34

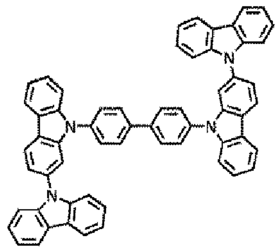

HT35

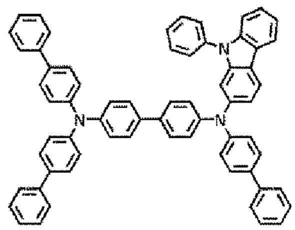

HT36

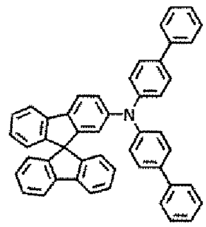

HT37

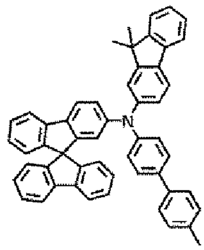

HT38

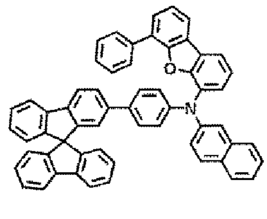

HT39

.

The hole transport region 12 of the organic light-emitting device10 may further include a p-dopant. When the hole transport region 12 further includes a p-dopant, the hole transport region 12 may have a structure including a matrix (for example, at least one compound represented by Formulae 201 to 205) and a p-dopant included in the matrix. The p-dopant may be homogeneously or non-homogeneously doped in the hole transport region 12.

In some embodiments, a LUMO energy level of the p-dopant may be -3.5 eV or less.

The p-dopant may include at least one selected from a quinone derivative, a metal oxide, and a cyano group-containing compound, but embodiments are not limited thereto.

In some embodiments, the p-dopant may include at least one selected from

a quinone derivative such as tetracyanoquinodimethane (TCNQ), 2,3,5,6-tetrafluoro-7,7,8,8-tetracyanoquinodimethane (F4-TCNQ), and F6-TCNNQ;

a metal oxide, such as tungsten oxide or molybdenum oxide;

1,4,5,8,9,12-hexaazatriphenylene-hexacarbonitrile (HAT-CN); and

a compound represented by Formula 221,but embodiments are not limited thereto:

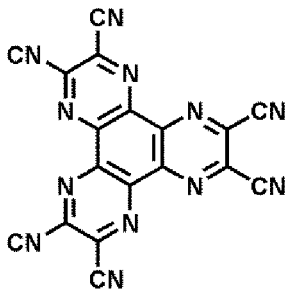

HAT-CN

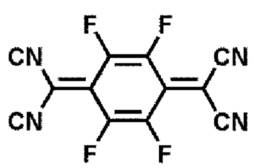

F4-TCNQ

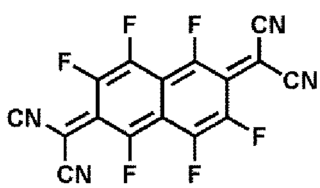

F6-TCNNQ

Formula 221

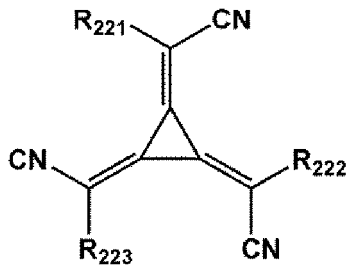

wherein, in Formula 221,

$R_{221}$ to $R_{223}$ may each independently be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_1$-$C_{60}$ heteroaryl group, a substituted or unsubstituted monovalent non-aromatic condensed polycyclic group, and a substituted or unsubstituted monovalent non-aromatic condensed heteropolycyclic group, provided that at least one selected from $R_{221}$ to $R_{223}$ may include at least one substituent selected from a cyano group, -F, -Cl, -Br, -I, a $C_1$-$C_{20}$ alkyl group substituted with -F, a $C_1$-$C_{20}$ alkyl group substituted with -Cl, a $C_1$-$C_{20}$ alkyl group substituted with -Br, and a $C_1$-$C_{20}$ alkyl group substituted with -I.

A thickness of the hole transport region 12 may be in a range of about 100 Angstroms (Å) to about 10,000 Å, for example, about 400 Å to about 2,000 Å, and a thickness of the emission layer 15 may be in a range of about 100 Å to about 3,000 Å, for example, about 300 Å to about 1,000 Å. When the thicknesses of the hole transport region 12 and the emission layer 15 are within any of these ranges, satisfactory hole transporting characteristics and/or luminescence characteristics may be obtained without a substantial increase in driving voltage.

**Electron transport region 17**

In the organic light-emitting device 10, the electron transport region 17 may be between the emission layer 15 and the second electrode 19.

The electron transport region 17 may have a single-layered structure or a multi-layered structure.

For example, the electron transport region 17 may have a structure of electron transport layer, a structure of electron transport layer/electron injection layer, a structure of buffer layer/electron transport layer, a structure of hole blocking layer/electron transport layer, a structure of buffer layer/electron transport layer/electron injection layer, or a structure of hole blocking layer/electron transport layer/electron injection layer, but embodiments are not limited thereto. The electron transport region 17 may also include an electron control layer.

The electron transport region 17 may include a known electron transport material.

The electron transport region 17 (for example, the buffer layer, the hole blocking layer, the electron control layer, or the electron transport layer in the electron transport region 17) may include a metal-free compound including at least one $\pi$ electron-depleted nitrogen-containing cyclic group. The $\pi$ electron-depleted nitrogen-containing cyclic group may be understood by referring to the description for those provided herein. The electron transport region 17 may also include an electron control layer.

In some embodiments, the electron transport region may include a compound represented by Formula 601:

Formula 601 $[Ar_{601}]_{xe11}$-$[(L_{601})_{xe1}$-$R_{601}]_{xe21}$

wherein, in Formula 601,

$Ar_{601}$ and $L_{601}$ may each independently be a substituted or unsubstituted $C_5$-$C_{60}$ carbocyclic group or a substituted or unsubstituted $C_1$-$C_{60}$ heterocyclic group,
xe11 may be 1, 2, or 3,
xe1 may be an integer from 0 to 5,
$R_{601}$ may be selected from a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a

substituted or unsubstituted monovalent non-aromatic condensed heteropolycyclic group, $-Si(Q_{601})(Q_{602})(Q_{603})$, $-C(=O)(Q_{601})$, $-S(=O)_2(Q_{601})$, and $-P(=O)(Q_{601})(Q_{602})$,
wherein $Q_{601}$ to $Q_{603}$ may each independently be a $C_1$-$C_{10}$ alkyl group, a $C_1$-$C_{10}$ alkoxy group, a phenyl group, a biphenyl group, a terphenyl group, or a naphthyl group, and
xe21 may be an integer from 1 to 5.

In one embodiment, at least one selected from $Ar_{601}$(s) in the number of xe11 and $R_{601}$(s) in the number of xe21 may include the $\pi$ electron-depleted nitrogen-containing cyclic group.

In an embodiment, ring $Ar_{601}$ and $L_{601}$ in Formula 601 may be selected from a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each unsubstituted or substituted with at least one selected from deuterium, -F, -Cl,-Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, $-Si(Q_{31})(Q_{32})(Q_{33})$,$-S(=O)_2(Q_{31})$, and $-P(=O)(Q_{31})(Q_{32})$,
wherein $Q_{31}$ to $Q_{33}$ may each independently be selected from a $C_1$-$C_{10}$ alkyl group, a $C_1$-$C_{10}$ alkoxy group, a phenyl group, a biphenyl group, a terphenyl group, and a naphthyl group.

When xe11 in Formula 601 is 2 or greater, at least two $Ar_{601}$(s) may be linked via a single bond.

In one or more embodiments, $Ar_{601}$ in Formula 601 may be an anthracene group.

In some embodiments, the compound represented by Formula 601 may be represented by Formula 601-1:

Formula 601-1

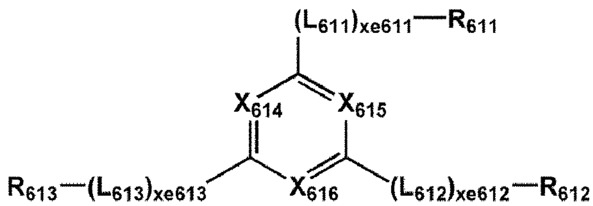

wherein, in Formula 601-1,

$X_{614}$ may be N or $C(R_{614})$, $X_{615}$ may be N or $C(R_{615})$, $X_{616}$ may be N or $C(R_{616})$, and at least one selected from $X_{614}$ to $X_{616}$ may be N,
$L_{611}$ to $L_{613}$ may each be understood by referring to the descriptions for $L_{601}$ provided herein,
xe611 to xe613 may each be understood by referring to the descriptions for xe1 provided herein,
$R_{611}$ to $R_{613}$ may each be understood by referring to the descriptions for $R_{601}$ provided herein, and
$R_{614}$ to $R_{616}$ may each independently be selected from hydrogen, deuterium,-F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, and a naphthyl group.

In one or more embodiments, in Formulae 601 and 601-1, xe1 and xe611 to xe613, may each independently be 0, 1, or 2.

In one or more embodiments, in Formulae 601 and 601-1, $R_{601}$ and $R_{611}$ to $R_{613}$ may each independently be selected from a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl

group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each unsubstituted or substituted with at least one selected from deuterium, -F, -Cl, -Br, -I, a hydroxyl group, a cyano group, a nitro group, an amidino group, a hydrazino group, a hydrazono group, a $C_1$-$C_{20}$ alkyl group, a $C_1$-$C_{20}$ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and

$$-S(=O)_2(Q_{601})$$

and

$$-P(=O)(Q_{601})(Q_{602}),$$

wherein $Q_{601}$ and $Q_{602}$ may each be understood by referring to the descriptions for those provided herein.

The electron transport region may include at least one compound selected from Compounds ET1 to ET36, but embodiments are not limited thereto:

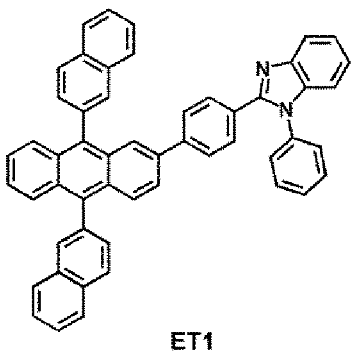

ET1

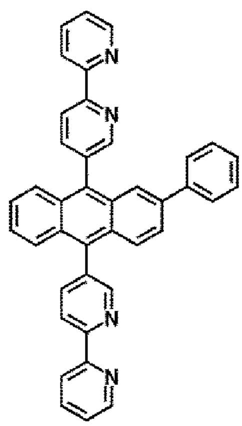

ET2

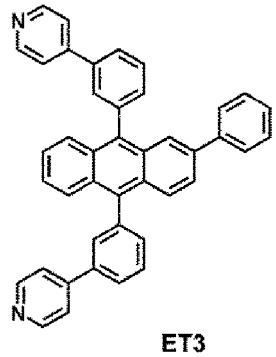

ET3

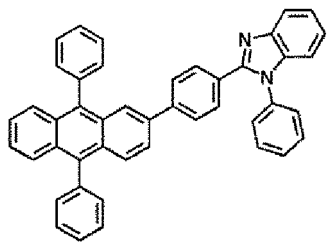

ET4

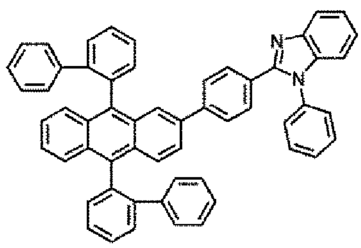

ET5

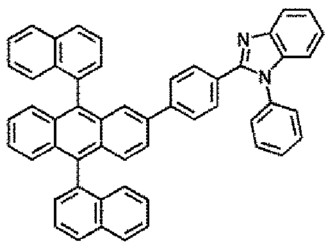

ET6

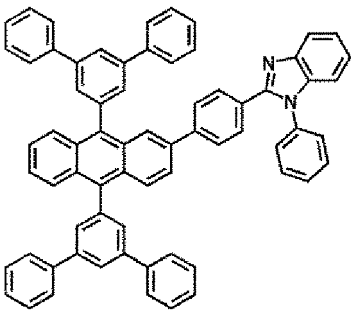

ET7

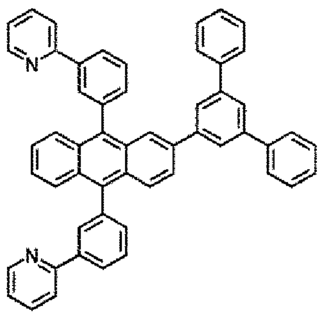

ET8

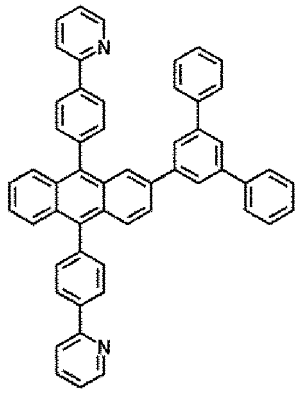

ET9

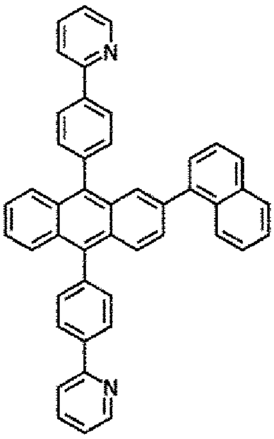

ET10

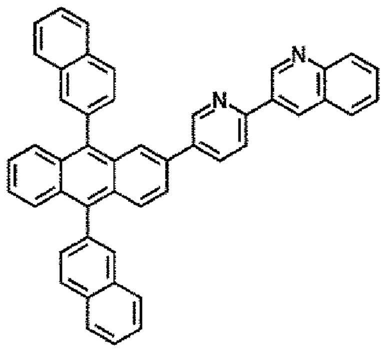

ET11

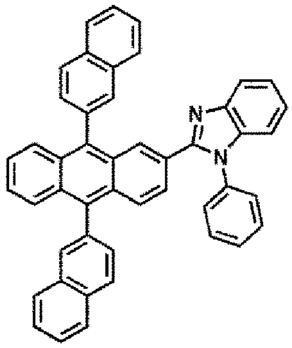

ET12

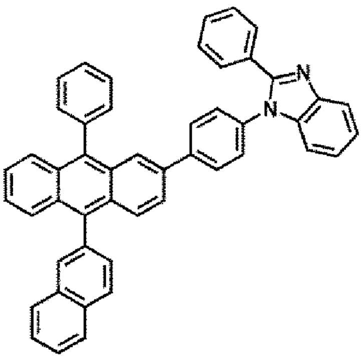

ET13

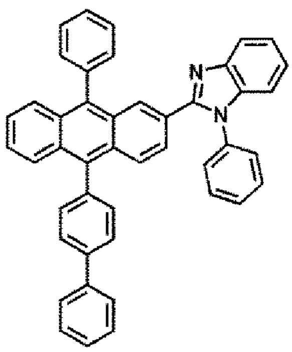

ET14

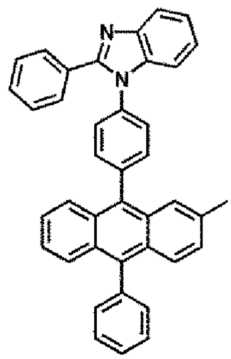

ET15

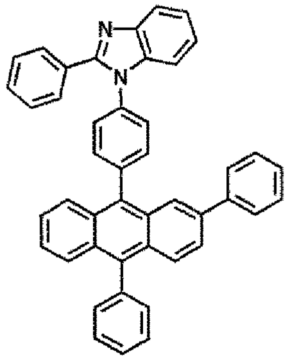

ET16

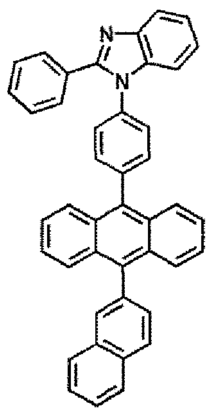

ET17

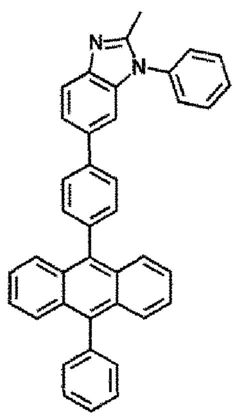

ET18

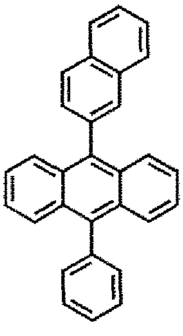

ET19

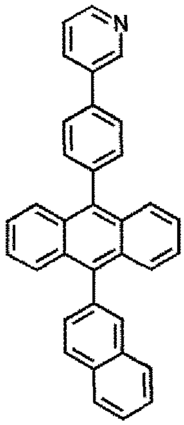

ET20

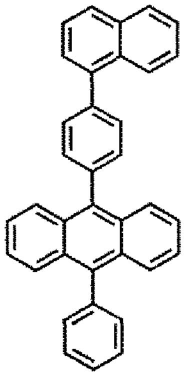

ET21

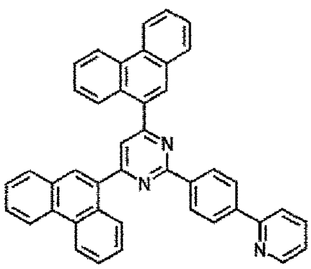

ET22

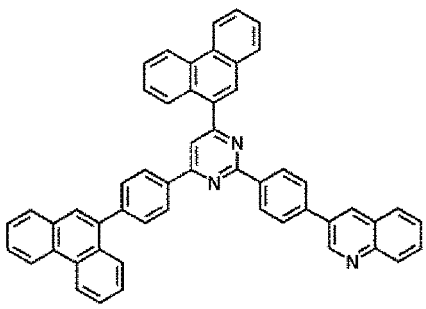

ET23

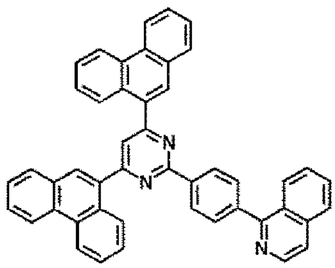

ET24

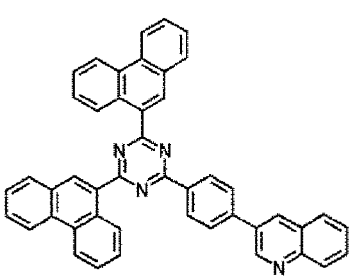

ET25

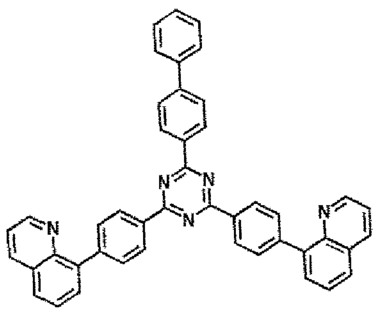

ET26

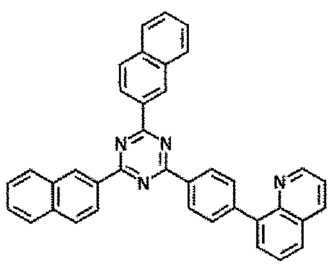

ET27

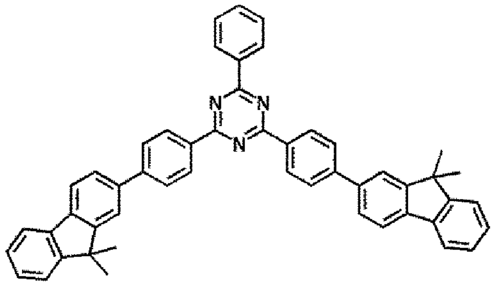
ET28

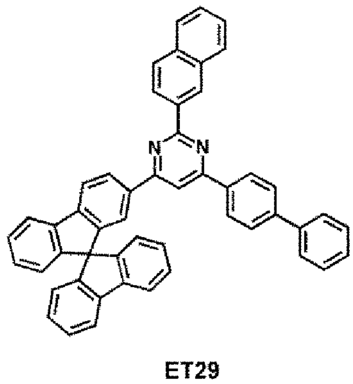
ET29

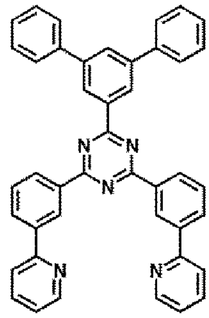
ET30

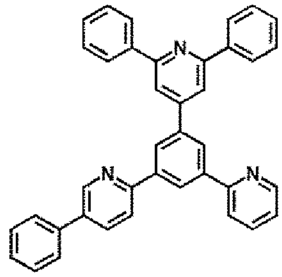
ET31

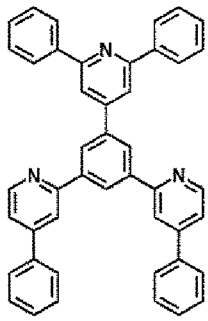
ET32

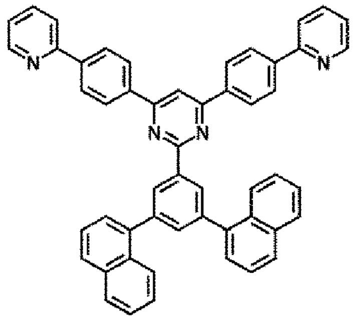
ET33

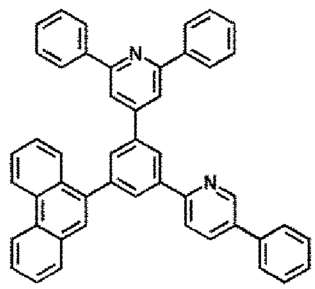
ET34

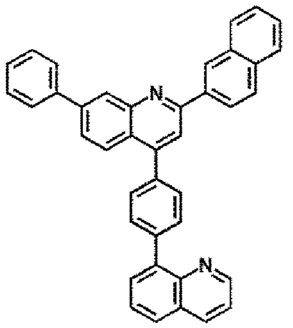
ET35

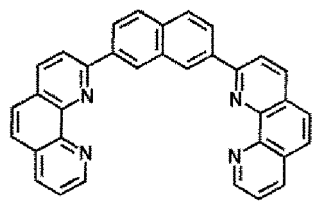
ET36

.

In one or more embodiments, the electron transport region may include at least one selected from 2,9-dimethyl-4,7-diphenyl-1,10-phenanthroline (BCP), 4,7-dphenyl-1,10-phenanthroline (Bphen), $Alq_3$, BAlq, 3-(biphenyl-4-yl)-5-(4-tert-butylphenyl)-4-phenyl-4H-1,2,4-triazole (TAZ), and NTAZ:

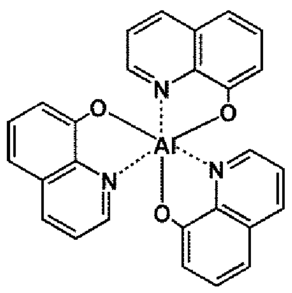
$Alq_3$

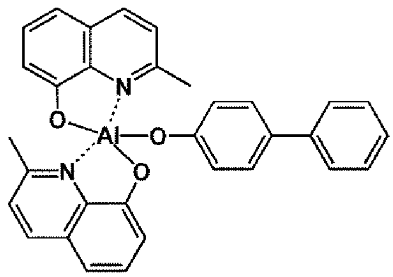
BAlq

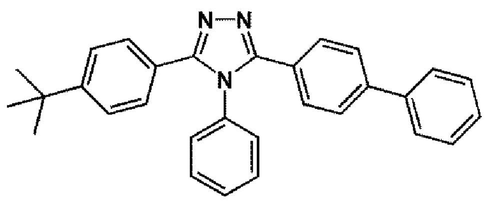
TAZ

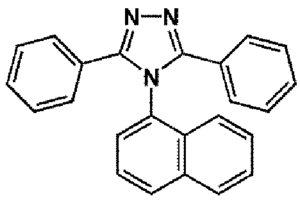

NTAZ

.

The thicknesses of the buffer layer, the hole blocking layer, or the electron control layer may each independently be in a range of about 20 Å to about 1,000 Å, and in some embodiments, about 30 Å to about 300 Å. When the thicknesses of the buffer layer, the hole blocking layer or the electron control layer are within any of these ranges, excellent hole blocking characteristics or excellent electron controlling characteristics may be obtained without a substantial increase in driving voltage.

The thickness of the electron transport layer may be in a range of about 100 Å to about 1,000 Å, and in some embodiments, about 150 Å to about 500 Å. When the thickness of the electron transport layer is within any of these ranges, excellent electron transport characteristics may be obtained without a substantial increase in driving voltage.

The electron transport region 17 (e.g., the electron transport layer in the electron transport region 17) may further include, in addition to the materials described above, a material including metal.

The material including metal may include at least one selected from an alkali metal complex and an alkaline earth metal complex. The alkali metal complex may include a metal ion selected from a lithium (Li) ion, a sodium (Na) ion, a potassium (K) ion, a rubidium (Rb) ion, and a cesium (Cs) ion. The alkaline earth metal complex may include a metal ion selected from a beryllium (Be) ion, a magnesium (Mg) ion, a calcium (Ca) ion, an strontium (Sr) ion, and a barium (Ba) ion. Each ligand coordinated with the metal ion of the alkali metal complex and the alkaline earth metal complex may independently be selected from a hydroxyquinoline, a hydroxyisoquinoline, a hydroxybenzoquinoline, a hydroxyacridine, a hydroxyphenanthridine, a hydroxyphenyloxazole, a hydroxyphenylthiazole, a hydroxydiphenyl oxadiazole, a hydroxydiphenyl thiadiazole, a hydroxyphenyl pyridine, a hydroxyphenyl benzimidazole, a hydroxyphenyl benzothiazole, a bipyridine, a phenanthroline, and a cyclopentadiene, but embodiments are not limited thereto.

For example, the material including metal may include a Li complex. The Li complex may include, e.g., Compound ET-D1 (lithium 8-hydroxyquinolate, LiQ) or Compound ET-D2:

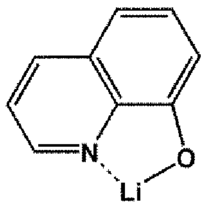

ET-D1

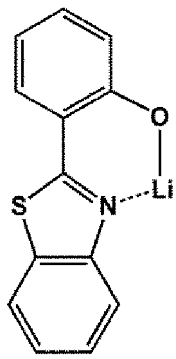

ET-D2 .

The electron transport region 17 may include an electron injection layer that facilitates injection of electrons from the second electrode 19. The electron injection layer may be in direct contact with the second electrode 19.

The electron injection layer may have i) a single-layered structure including a single layer including a single material, ii) a single-layered structure including a single layer including a plurality of different materials, or iii) a multi-layered structure having a plurality of layers, each including a plurality of different materials.

The electron injection layer may include an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof.

The alkali metal may be selected from Li, Na, K, Rb, and Cs. In an embodiment, the alkali metal may be Li, Na, or Cs. In one or more embodiments, the alkali metal may be Li or Cs, but embodiments are not limited thereto.

The alkaline earth metal may be selected from Mg, Ca, Sr, and Ba.

The rare earth metal may be selected from Sc, Y, Ce, Tb, Yb, and Gd.

The alkali metal compound, the alkaline earth metal compound, and the rare earth metal compound may each independently be selected from oxides and halides (e.g., fluorides, chlorides, bromides, or iodines) of the alkali metal, the alkaline earth metal, and the rare earth metal, respectively.

The alkali metal compound may be selected from alkali metal oxides, such as $Li_2O$, $Cs_2O$, or $K_2O$, and alkali metal halides, such as LiF, NaF, CsF, KF, LiI, NaI, CsI, KI, or RbI. In an embodiment, the alkali metal compound may be selected from LiF, $Li_2O$, NaF, LiI, NaI, CsI, and KI, but embodiments are not limited thereto.

The alkaline earth metal compound may be selected from alkaline earth metal compounds such as BaO, SrO, CaO, $Ba_xSr_{1-x}O$ (where $0<x<1$), and $Ba_xCa_{1-x}O$ (where $0<x<1$). In an embodiment, the alkaline earth metal compound may be selected from BaO, SrO, and CaO, but embodiments are not limited thereto.

The rare earth metal compound may be selected from $YbF_3$, $ScF_3$, $ScO_3$, $Y_2O_3$, $Ce_2O_3$, $GdF_3$, and $TbF_3$. In an embodiment, the rare earth metal compound may be selected from $YbF_3$, $ScF_3$, $TbF_3$, $YbI_3$, $ScI_3$, and $TbI_3$, but embodiments are not limited thereto.

The alkali metal complex, the alkaline earth metal complex, and the rare earth metal complex may each include ions of the above-described alkali metal, alkaline earth metal, and rare earth metal. Each ligand coordinated with the metal ion of the alkali metal complex, the alkaline earth metal complex, and the rare earth metal complex may independently be selected from a hydroxyquinoline, a hydroxyisoquinoline, a hydroxybenzoquinoline, a hydroxyacridine, a hydroxyphenanthridine, a hydroxyphenyl oxazole, a hydroxyphenyl thiazole, a hydroxydiphenyl oxadiazole, a hydroxydiphenyl thiadiazole, a hydroxyphenyl pyridine, a hydroxyphenyl benzimidazole, a hydroxyphenyl benzothiazole, a bipyridine, a phenanthroline, and a cyclopentadiene, but embodiments are not limited thereto.

The electron injection layer may consist of an alkali metal, an alkaline earth metal, a rare earth metal, an alkali metal compound, an alkaline earth metal compound, a rare earth metal compound, an alkali metal complex, an alkaline earth metal complex, a rare earth metal complex, or a combination thereof, as described above. In some embodiments, the electron injection layer may further include an organic material. When the electron injection layer further includes an organic material, the alkali metal, the alkaline earth metal, the rare earth metal, the alkali metal compound, the alkaline earth metal compound, the rare earth metal compound, the alkali metal complex, the alkaline earth metal complex, the rare earth metal complex, or a combination thereof may be homogeneously or non-homogeneously dispersed in a matrix including the organic material.

The thickness of the electron injection layer may be in a range of about 1 Å to about 100 Å, and in some embodiments, about 3 Å to about 90 Å. When the thickness of the electron injection layer is within any of these ranges, excellent electron injection characteristics may be obtained without a substantial increase in driving voltage.

**Second electrode 19**

The second electrode 19 may be on the organic layer 10A. In an embodiment, the second electrode 19 may be a cathode that is an electron injection electrode. In this embodiment, a material for forming the second electrode 19 may be a material having a low work function, for example, a metal, an alloy, an electrically conductive compound, or a combination thereof.

The second electrode 19 may include at least one selected from lithium (Li), silver (Ag), magnesium (Mg), aluminum (Al), aluminum-lithium (Al-Li), calcium (Ca), magnesium-indium (Mg-In), magnesium-silver (Mg-Ag), ITO, and IZO, but embodiments are not limited thereto. The second electrode 19 may be a transmissive electrode, a semi-transmissive electrode, or a reflective electrode.

The second electrode 19 may have a single-layered structure, or a multi-layered structure including two or more layers.

**Description of FIG. 3**

FIG. 3 is a schematic view of an organic light-emitting device 100 according to an embodiment.

The organic light-emitting device 100 in FIG. 3 includes a first electrode 110, a second electrode 190 facing the first electrode 110, and a first light-emitting unit 151 and a second light-emitting unit 152 between the first electrode 100 and the second electrode 190. A charge generating layer 141 may be between the first light-emitting unit 151 and the second light-emitting unit 152, and the charge generating layer 141 may include an n-type charge generating layer 141-N and a p-type charge generating layer 141-P. The charge generating layer 141 is a layer serving to generate charges and supply the generated charges to the adjacent light-emitting unit, and may include a known material.

The first light-emitting unit 151 may include a first emission layer 151-EM, and the second light-emitting unit 152 may include a second emission layer 152-EM. A maximum emission wavelength of light emitted by the first light-emitting unit 151 may be different from a maximum emission wavelength of light emitted by the second light-emitting unit 152. For example, mixed light of the light emitted by the first light-emitting unit 151 and the light emitted by the second light-emitting unit 152 may be white light, but embodiments are not limited thereto.

A hole transport region 120 may be between the first light-emitting unit 151 and the first electrode 110, and the second light-emitting unit 152 may include a first hole transport region 121 toward the first electrode 110.

An electron transport region 170 may be between the second light-emitting unit 152 and the second electrode 190, and the first light-emitting unit 151 may include a first electron transport region 171 between the charge generating layer 141 and the first emission layer 151-EM.

The first emission layer 151-EM may include a host and a dopant, the first emission layer 151-EM may emit a phosphorescent light, and the dopant may be an organometallic compound. In this regard, a PLQY of the dopant included in the first emission layer 151-EM may be about 0.8 or greater and about 1.0 or less; a decay time of the dopant included in the first emission layer 151-EM may be about 0.1 $\mu$s or greater and about 2.9 $\mu$s or less; and the host and the dopant included in the first emission layer 151-EM may satisfy 0.1 eV $\leq$ HOMO (dopant) - HOMO (host) $\leq$ 0.4 eV, provided that the HOMO (dopant) represents a HOMO energy level (expressed in electron volts) of the dopant, and the HOMO (host) represents, in a case where the host included in the first emission layer 151-EM includes one type of host (for example, the host included in the first emission layer 151-EM consists of one type of host), a HOMO energy level (expressed in electron volts) of the one type of host; or in a case where the host included in the first emission layer 151-EM is a mixture of two or more different types of host, a highest HOMO energy level from among HOMO energy levels (expressed in electron volts) of the two or more different types of host. Evaluation methods of a PLQY of the dopant, a decay time of the dopant, HOMO (dopant), and HOMO (host) may be understood by referring to the descriptions for those provided herein. For example, an emission energy of a maximum emission wavelength of an emission spectrum of the dopant included in the first emission layer 151-EM may be about 2.31 eV or greater and about 2.48 eV or less and an evaluation method of an emission energy of a maximum emission wavelength of an emission spectrum of the dopant may be understood by referring to the descriptions for those provided herein.

The second emission layer 152-EM may include a host and a dopant, the second emission layer 152-EM may emit a phosphorescent light, and the dopant may be an organometallic compound. In this regard, a PLQY of the dopant included in the second emission layer 152-EM may be about 0.8 or greater and about 1.0 or less; a decay time of the dopant included in the second emission layer 152-EM may be about 0.1 $\mu$s or greater and about 2.9 $\mu$s or less; and the host and the dopant included in the second emission layer 152-EM may satisfy 0.1 eV $\leq$ HOMO (dopant) - HOMO (host) $\leq$ 0.4 eV, provided that the HOMO (dopant) represents a HOMO energy level (expressed in electron volts) of the dopant, and the HOMO (host) represents, in a case where the host included in the second emission layer 152-EM includes one type of host (for example, the host included in the second emission layer 152-EM consists of one type of host), a HOMO energy level (expressed in electron volts) of the one type of host; or in a case where the host included in the second emission layer 152-EM is a mixture of two or more different types of host, a highest HOMO energy level from among HOMO energy levels (expressed in electron volts) of the two or more different types of host. Evaluation methods of a PLQY of the dopant, a decay time of the dopant, HOMO (dopant), and HOMO (host) may be understood by referring to the descriptions for those provided herein. For example, an emission energy of a maximum emission wavelength of an emission spectrum of the dopant included in the second emission layer 152-EM may be about 2.31 eV or greater and about 2.48 eV or less and an evaluation method of an emission energy of a maximum emission wavelength of an emission spectrum of the dopant may be understood by referring to the descriptions for those provided herein.

As described above, each of the first emission layer 151-EM and the second emission layer 152-EM of the organic light-emitting device 100 may satisfy "all" of the PLQY range of the dopant, the decay time range of the dopant, and the HOMO (dopant) - HOMO (host) range, described herein, "at the same time". Thus, relatively low current driving conditions may be selected to achieve a high luminance of the organic light-emitting device 100, a diffusion length of excitons in the first emission layer 151-EM and the second emission layer 152-EM may be decreased, and a density of excitons in the first emission layer 151-EM and the second emission layer 152-EM may be decreased. Therefore, the organic light-emitting device 100 may have significantly long lifespan characteristics. Additionally, each of the first emission layer 151-EM and the second emission layer 152-EM of the organic light-emitting device 100 may additionally satisfy the emission energy range of a maximum emission wavelength of an emission spectrum of the dopant. Thus, possibility of decomposition of the host and/or the dopant included in the first emission layer 151-EM and the second emission layer 152-EM may be reduced. Therefore, the organic light-emitting device 100 may have significantly longer lifespan characteristics.

In FIG. 3, the first electrode 110 and the second electrode 190 may each be understood by referring to the descriptions for the first electrode 11 and the second electrode 19 in FIG. 1, respectively.

In FIG. 3, the first emission layer 151-EM and the second emission layer 152-EM may each be understood by referring to the descriptions for the emission layer 15 in FIG. 1.

In FIG. 3, the hole transport region 120 and the first hole transport region 121 may each be understood by referring to the descriptions for the hole transport region 12 in FIG. 1.

In FIG. 3, the electron transport region 170 and the first electron transport region 171 may each be understood by referring to the descriptions for the electron transport region 17 in FIG. 1.

Hereinbefore, by referring to FIG. 3, the organic light-emitting device 100 has been described in which the first

light-emitting unit 151 and the second light-emitting unit 152 both satisfy the PLQY range of the dopant, the decay time range of the dopant, and the HOMO (dopant) - HOMO (host) range, described herein. However, the organic light-emitting device 100 in FIG. 3 may be subjected to various modifications, for example, at least one of the first light-emitting unit 151 and the second light-emitting unit 152 of the organic light-emitting device 100 in FIG. 3 may be replaced by any suitable known light-emitting unit, or three or more light-emitting units may be included.

## Description of FIG. 4

FIG. 4 is a schematic view of an organic light-emitting device 200 according to an embodiment.

The organic light-emitting device 100 in FIG. 4 includes a first electrode 210, a second electrode 290 facing the first electrode 210, and a first emission layer 251 and a second emission layer 252 between the first electrode 210 and the second electrode 290.

A maximum emission wavelength of light emitted by the first emission layer 251 may be different from a maximum emission wavelength of light emitted by the second emission layer 252. For example, mixed light of the light emitted by the first emission layer 251 and the light emitted by the second emission layer 252 may be white light, but embodiments are not limited thereto.

A hole transport region 220 may be between the first emission layer 251 and the first electrode 210, and an electron transport region 270 may be between the second emission layer 252 and the second electrode 290.

The first emission layer 251 may include a host and a dopant, the first emission layer 251 may emit a phosphorescent light, and the dopant may be an organometallic compound. In this regard, a PLQY of the dopant included in the first emission layer 251 may be about 0.8 or greater and about 1.0 or less; a decay time of the dopant included in the first emission layer 251 may be about 0.1 $\mu$s or greater and about 2.9 $\mu$s or less; and the host and the dopant included in the first emission layer 251 may satisfy 0.1 eV $\leq$ HOMO (dopant) - HOMO (host) $\leq$ 0.4 eV, provided that the HOMO (dopant) represents a HOMO energy level (expressed in electron volts) of the dopant, and the HOMO (host) represents, in a case where the host included in the first emission layer 251 includes one type of host (for example, the host included in the first emission layer 251 consists of one type of host), a HOMO energy level (expressed in electron volts) of the one type of host; or in a case where the host included in the first emission layer 251 is a mixture of two or more different types of host, a highest HOMO energy level from among HOMO energy levels (expressed in electron volts) of the two or more different types of host. Evaluation methods of a PLQY of the dopant, a decay time of the dopant, HOMO (dopant), and HOMO (host) may be understood by referring to the descriptions for those provided herein. For example, an emission energy of a maximum emission wavelength of an emission spectrum of the dopant included in the first emission layer 251 may be about 2.31 eV or greater and about 2.48 eV or less and an evaluation method of an emission energy of a maximum emission wavelength of an emission spectrum of the dopant may be understood by referring to the descriptions for those provided herein.

The second emission layer 252 may include a host and a dopant, the second emission layer 252 may emit a phosphorescent light, and the dopant may be an organometallic compound. In this regard, a PLQY of the dopant included in the second emission layer 252 may be about 0.8 or greater and about 1.0 or less; a decay time of the dopant included in the second emission layer 252 may be about 0.1 $\mu$s or greater and about 2.9 $\mu$s or less; and the host and the dopant included in the second emission layer 252 may satisfy 0.1 eV $\leq$ HOMO (dopant) - HOMO (host) $\leq$ 0.4 eV, provided that the HOMO (dopant) represents a HOMO energy level (expressed in electron volts) of the dopant, and the HOMO (host) represents, in a case where the host included in the second emission layer 252 includes one type of host (for example, the host included in the second emission layer 252 consists of one type of host), a HOMO energy level (expressed in electron volts) of the one type of host; or in a case where the host included in the second emission layer 252 is a mixture of two or more different types of host, a highest HOMO energy level from among HOMO energy levels (expressed in electron volts) of the two or more different types of host. Evaluation methods of a PLQY of the dopant, a decay time of the dopant, HOMO (dopant), and HOMO (host) may be understood by referring to the descriptions for those provided herein. For example, an emission energy of a maximum emission wavelength of an emission spectrum of the dopant included in the second emission layer 252 may be about 2.31 eV or greater and about 2.48 eV or less and an evaluation methods of an emission energy of a maximum emission wavelength of an emission spectrum of the dopant may be understood by referring to the descriptions for those provided herein.

As described above, each of the first emission layer 251 and the second emission layer 252 of the organic light-emitting device 200 may satisfy "all" of the PLQY range of the dopant, the decay time range of the dopant, and the HOMO (dopant) - HOMO (host) range, described herein, "at the same time". Thus, relatively low current driving conditions may be selected to achieve a high luminance of the organic light-emitting device 200, a diffusion length of excitons in the first emission layer 251 and the second emission layer 252 may be decreased, and a density of excitons in the first emission layer 251 and the second emission layer 252 may be decreased. Therefore, the organic light-emitting device 200 may have significantly improved lifespan characteristics. Additionally, each of the first emission layer 251 and the second emission layer 252 of the organic light-emitting device 200 may additionally satisfy the emission energy range

of a maximum emission wavelength of an emission spectrum of the dopant. Thus, possibility of decomposition of the host and/or the dopant included in the first emission layer 251 and the second emission layer 252 may be reduced. Therefore, the organic light-emitting device 200 may have significantly improved lifespan characteristics.

In FIG. 4, the first electrode 210, the hole transport region 220, and the second electrode 290 may each be understood by referring to the descriptions for the first electrode 11, the hole transport region 12, and the second electrode 19 in FIG. 1, respectively.

In FIG. 4, the first emission layer 251 and the second emission layer 252 may each be understood by referring to the descriptions for the emission layer 15 in FIG. 1.

In FIG. 4, the electron transport region 170 may be understood by referring to the descriptions for the electron transport region 17 in FIG. 1.

Hereinbefore, by referring to FIG. 4, the organic light-emitting device 200 has been described in which the first emission layer 251 and the second emission layer 252 both satisfy the PLQY range of the dopant, the decay time range of the dopant, and the HOMO (dopant) - HOMO (host) range, described herein. However, the organic light-emitting device in FIG. 4 may be subjected to various modifications, for example, one of the first emission layer 251 and the second emission layer 252 may be replaced by a known layer, three or more emission layers may be included, or an intermediate layer may be further located between neighboring emission layers.

## Description of terms

The term "$C_1$-$C_{60}$ alkyl group" as used herein refers to a linear or branched saturated aliphatic hydrocarbon monovalent group having 1 to 60 carbon atoms. Examples thereof include a methyl group, an ethyl group, a propyl group, an isobutyl group, a sec-butyl group, a tert-butyl group, a pentyl group, an iso-amyl group, and a hexyl group. The term "$C_1$-$C_{60}$ alkylene group" as used herein refers to a divalent group having substantially the same structure as the $C_1$-$C_{60}$ alkyl group.

The term "$C_1$-$C_{60}$ alkoxy group" as used herein refers to a monovalent group represented by $-OA_{101}$ (wherein $A_{101}$ is a $C_1$-$C_{60}$ alkyl group). Examples thereof include a methoxy group, an ethoxy group, and an isopropyloxy group.

The term "$C_2$-$C_{60}$ alkenyl group" as used herein refers to a group formed by including at least one carbon-carbon double bond in the middle or at the terminus of the $C_2$-$C_{60}$ alkyl group. Examples thereof include an ethenyl group, a propenyl group, and a butenyl group. The term "$C_2$-$C_{60}$ alkenylene group" as used herein refers to a divalent group having substantially the same structure as the $C_2$-$C_{60}$ alkenyl group.

The term "$C_2$-$C_{60}$ alkynyl group" as used herein refers to a group formed by including at least one carbon-carbon triple bond in the middle or at the terminus of the $C_2$-$C_{60}$ alkyl group. Examples thereof include an ethynyl group and a propynyl group. The term "$C_2$-$C_{60}$ alkynylene group" as used herein refers to a divalent group having substantially the same structure as the $C_2$-$C_{60}$ alkynyl group.

The term "$C_3$-$C_{10}$ cycloalkyl group" as used herein refers to a monovalent saturated monocyclic saturated hydrocarbon group including 3 to 10 carbon atoms. Examples thereof include a cyclopropyl group, a cyclobutyl group, a cyclopentyl group, a cyclohexyl group, and a cycloheptyl group. The term "$C_3$-$C_{10}$ cycloalkylene group" as used herein refers to a divalent group having substantially the same structure as the $C_3$-$C_{10}$ cycloalkyl group.

The term "$C_1$-$C_{10}$ heterocycloalkyl group" as used herein refers to a monovalent monocyclic group including at least one heteroatom selected from N, O, P, Si, and S as a ring-forming atom and 1 to 10 carbon atoms. Examples thereof include a tetrahydrofuranyl group and a tetrahydrothiophenyl group. The term "$C_1$-$C_{10}$ heterocycloalkylene group" as used herein refers to a divalent group having substantially the same structure as the $C_1$-$C_{10}$ heterocycloalkyl group.

The term "$C_3$-$C_{10}$ cycloalkenyl group" as used herein refers to a monovalent monocyclic group including 3 to 10 carbon atoms and at least one carbon-carbon double bond in its ring, wherein the molecular structure as a whole is non-aromatic. Examples thereof include a cyclopentenyl group, a cyclohexenyl group, and a cycloheptenyl group. The term "$C_3$-$C_{10}$ cycloalkenylene group" as used herein refers to a divalent group having substantially the same structure as the $C_3$-$C_{10}$ cycloalkenyl group.

The term "$C_1$-$C_{10}$ heterocycloalkenyl group" as used herein refers to a monovalent monocyclic group including at least one heteroatom selected from N, O, P, Si, and S as a ring-forming atom, 1 to 10 carbon atoms, and at least one double bond in its ring. Examples of the $C_1$-$C_{10}$ heterocycloalkenyl group include a 2,3-dihydrofuranyl group and a 2,3-dihydrothiophenyl group. The term "$C_1$-$C_{10}$ heterocycloalkylene group" as used herein refers to a divalent group having substantially the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms. The term "$C_6$-$C_{60}$ arylene group" as used herein refers to a divalent group having a carbocyclic aromatic system having 6 to 60 carbon atoms. Examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and a $C_6$-$C_{60}$ arylene group each include at least two rings, the at least two rings may be fused.

The term "$C_1$-$C_{60}$ heteroaryl group" as used herein refers to a monovalent group having a heterocyclic aromatic

system having at least one heteroatom selected from N, O, P, Si, and S as a ring-forming atom and 1 to 60 carbon atoms. The term "$C_1$-$C_{60}$ heteroarylene group" as used herein refers to a divalent group having a heterocyclic aromatic system having at least one heteroatom selected from N, O, P, Si, and S as a ring-forming atom and 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_1$-$C_{60}$ heteroaryl group and the $C_1$-$C_{60}$ heteroarylene group each include at least two rings, the at least two rings may be fused.

The term "$C_6$-$C_{60}$ aryloxy group" as used herein indicates -$OA_{102}$ (wherein $A_{102}$ is a $C_6$-$C_{60}$ aryl group). The term "$C_6$-$C_{60}$ arylthio group" as used herein indicates-$SA_{103}$ (wherein $A_{103}$ is a $C_6$-$C_{60}$ aryl group).

The term "monovalent non-aromatic condensed polycyclic group" as used herein refers to a monovalent group that has two or more condensed rings and only carbon atoms (e.g., the number of carbon atoms may be in a range of 8 to 60) as ring-forming atoms, wherein the molecular structure as a whole is non-aromatic. Examples of the monovalent non-aromatic condensed polycyclic group include a fluorenyl group. The term "divalent non-aromatic condensed polycyclic group" as used herein refers to a divalent group having substantially the same structure as the monovalent non-aromatic condensed polycyclic group.

The term "monovalent non-aromatic condensed heteropolycyclic group" as used herein refers to a monovalent group that has two or more condensed rings and a heteroatom selected from N, O, P, Si, and S and carbon atoms (e.g., the number of carbon atoms may be in a range of 1 to 60) as ring-forming atoms, wherein the molecular structure as a whole is non-aromatic. Examples of the monovalent non-aromatic condensed heteropolycyclic group include a carbazolyl group. The term "divalent non-aromatic condensed heteropolycyclic group" as used herein refers to a divalent group having substantially the same structure as the monovalent non-aromatic condensed heteropolycyclic group.

The term "$C_5$-$C_{30}$ carbocyclic group" as used herein refers to a saturated or unsaturated cyclic group including 5 to 30 carbon atoms only as ring-forming atoms. The $C_5$-$C_{30}$ carbocyclic group may be a monocyclic group or a polycyclic group.

The term "$C_1$-$C_{30}$ heterocyclic group" as used herein refers to saturated or unsaturated cyclic group including 1 to 30 carbon atoms and at least one heteroatom selected from N, O, P, Si, and S as ring-forming atoms. The $C_1$-$C_{30}$ heterocyclic group may be a monocyclic group or a polycyclic group.

In the present specification, at least one substituent of the substituted $C_5$-$C_{30}$ carbocyclic group, the substituted $C_2$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_6$-$C_{60}$ aryloxy group, the substituted $C_6$-$C_{60}$ arylthio group, the substituted $C_1$-$C_{60}$ heteroaryl group, the substituted monovalent non-aromatic condensed polycyclic group, and the substituted monovalent non-aromatic condensed heteropolycyclic group may be selected from:

deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, and a $C_1$-$C_{60}$ alkoxy group;

a $C_1$-$C_{60}$ alkyl group, a $C_2$-$C_{60}$ alkenyl group, a $C_2$-$C_{60}$ alkynyl group, and a $C_1$-$C_{60}$ alkoxy group, each substituted with at least one selected from deuterium, -F, -Cl, -Br, -I, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, -$N(Q_{11}Q_{12})$,-$Si(Q_{13})(Q_{14})(Q_{15})$, -$B(Q_{16})(Q_{17})$, and -$P(=O)(Q_{13})(Q_{19})$;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group, each substituted with at least one selected from deuterium, - F, -Cl, -Br, -I, -$CD_3$, -$CD_2H$, -$CDH_2$, -$CF_3$, -$CF_2H$, -$CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group,-N($Q_{21}$)($Q_{22}$), -Si($Q_{23}$)($Q_{24}$)($Q_{25}$), -B($Q_{26}$)($Q_{27}$), and -P(=O)($Q_{23}$)($Q_{29}$); and
-N($Q_{31}$)($Q_{32}$), -Si($Q_{33}$)($Q_{34}$)($Q_{35}$), -B($Q_{36}$)($Q_{37}$), and -P(=O)($Q_{33}$)($Q_{39}$),
wherein $Q_1$ to $Q_9$, $Q_{11}$ to $Q_{19}$, $Q_{21}$ to $Q_{29}$, and $Q_{31}$ to $Q_{39}$ may each independently be selected from hydrogen, deuterium, -F, -Cl, -Br, -I, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_1$-$C_{60}$ alkyl group substituted with at least one selected from deuterium; a $C_1$-$C_{60}$ alkyl group; and a $C_6$-$C_{60}$ aryl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_6$-$C_{60}$ aryl group substituted with at least one selected from deuterium; a $C_1$-$C_{60}$ alkyl group; and a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, and a monovalent non-aromatic condensed heteropolycyclic group.

The terms "a biphenyl group, a terphenyl group, and a tetraphenyl group" as used herein each refer to a monovalent group having two, three, and four phenyl groups linked via a single bond, respectively.

The terms "a cyano group-containing phenyl group, a cyano group-containing biphenyl group, a cyano group-containing terphenyl group, and a cyano group-containing tetraphenyl group" as used herein each refer to a phenyl group, a biphenyl group, a terphenyl group, and a tetraphenyl group, each substituted with at least one cyano group. In "the cyano group-containing phenyl group, the cyano group-containing biphenyl group, the cyano group-containing terphenyl group, and the cyano group-containing tetraphenyl group", a cyano group may be substituted at any position, and "the cyano group-containing phenyl group, the cyano group-containing biphenyl group, the cyano group-containing terphenyl group, and the cyano group-containing tetraphenyl group" may further include a substituent in addition to a cyano group. For example, 'a phenyl group substituted with a cyano group' and 'a phenyl group substituted with a methyl group' all belong to "a cyano group-containing phenyl group".

Hereinafter, a compound and an organic light-emitting device according to an embodiment will be described in detail with reference to Synthesis Examples and Examples, however, the present disclosure is not limited thereto. The wording "B was used instead of A" used in describing Synthesis Examples means that an amount of B used was identical to an amount of A used in terms of molar equivalents.

Examples

**Synthesis Example 1: Synthesis of Compound 1-8**

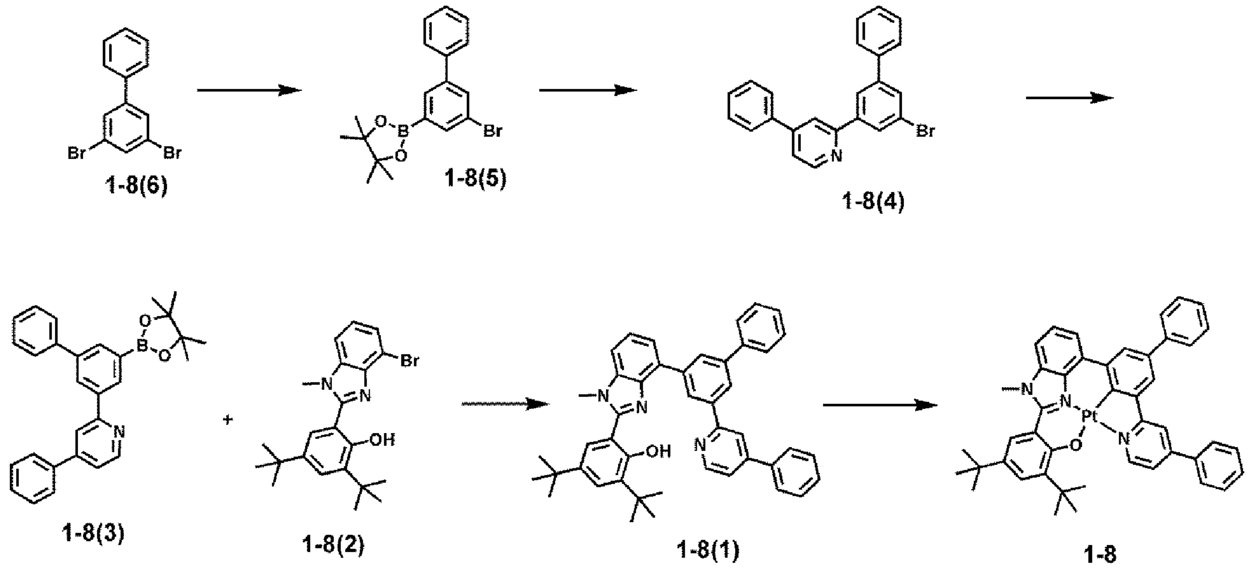

1-8(6) 1-8(5) 1-8(4)

1-8(3) + 1-8(2) 1-8(1) 1-8

Synthesis of Intermediate 1-8(5)

0.024 moles (mol) of Starting Material 1-8(6) and 9.0 grams (g, 0.036 mol, 1.5 equivalents, equiv.) of bispinacolato diboron were added into a flask. 4.6 g (0.048 mol, 2 equiv.) of potassium acetate and 0.96 g (0.05 equiv.) of $PdCl_2$(dppf) were added thereto followed by addition of 100 milliliters (mL) of toluene and reflux at a temperature of 100 °C over night. The resulting product was cooled to room temperature, and a precipitate was filtered to obtain a filtrate. The obtained filtrate was washed with ethyl acetate (EA) and $H_2O$, and a column chromatography was performed thereon to obtain Intermediate 1-8(5).

Synthesis of Intermediate 1-8(4)

0.014 mol (1.2 equiv.) of Intermediate 1-8(5) and 0.012 mol (1 equiv.) of 2-bromo-4-phenylpyridine, 0.61 g (0.001 mol, 0.07equiv.) of tetrakis(triphenylphosphine)palladium(0), and 3.1 g (0.036mol, 3 equiv.) of potassium carbonate were dissolved in a solvent (25 mL, 0.8 molar (M)) in which tetrahydrofuran (THF) was mixed with distilled water ($H_2O$) at a ratio of 3:1, followed by reflux for 12 hours. The resulting product was cooled to room temperature, and a precipitate was filtered to obtain a filtrate. The obtained filtrate was washed with ethyl acetate (EA) and $H_2O$, and a column chromatography (while increasing a rate of methylene chloride (MC)/hexane to between 25% and 50%) was performed to obtain Intermediate 1-8(4).

Synthesis of Intermediate 1-8(3)

0.009 mol of Intermediate 1-8(4) and 3.6 g (0.014 mol, 1.5 equiv.) of bispinacolato diboron were added to a flask, followed by addition of 1.9 g (0.019 mol, 2 equiv.) of potassium acetate, 0.39 g (0.05 equiv.) of $PdCl_2$(dppf), and 32 mL of toluene and reflux at a temperature of 100 °C over night. The resulting product was cooled to room temperature, and a precipitate was filtered to obtain a filtrate. The obtained filtrate was washed with ethyl acetate (EA) and $H_2O$, and a column chromatography was performed thereon to obtain Intermediate 1-8(3).

Synthesis of Intermediate 1-8(1)

0.005mol (1.2 equiv.) of Intermediate 1-8(3) and 0.004 mol (1 equiv.) of Intermediate 1-8(2), 0.35 g (0.001 mol, 0.07 equiv.) of tetrakis(triphenylphosphine)palladium(0), and 1.8 g (0.013 mol, 3 equiv.) of potassium carbonate were dissolved in a solvent in which THF was mixed with distilled water ($H_2O$) at a ratio of 3:1, followed by reflux for 12 hours. The resulting product was cooled to room temperature, and a precipitate was filtered to obtain a filtrate. The obtained filtrate was washed with EA and $H_2O$, and a column chromatography (while increasing a rate of EA/hexane to between 20% and 35%) was performed to obtain Intermediate 1-8(1).

Synthesis of Compound 1-8

2.5 mmol of Intermediate 1-8(1) and 1.23 g (3 mmol, 1.2 equiv.) of $K_2PtCl_4$ were dissolved in 25 mL of a solvent in which 20 mL of AcOH was mixed with 5 mL of $H_2O$, followed by reflux for 16 hours. The resulting product was cooled to room temperature, and a precipitate was filtered to obtain a filtrate. The obtained filtrate was dissolved in MC and washed with $H_2O$, and a column chromatography was performed thereon to obtain Compound 1-8.

**Synthesis Example 2: Synthesis of Compound 1-12**

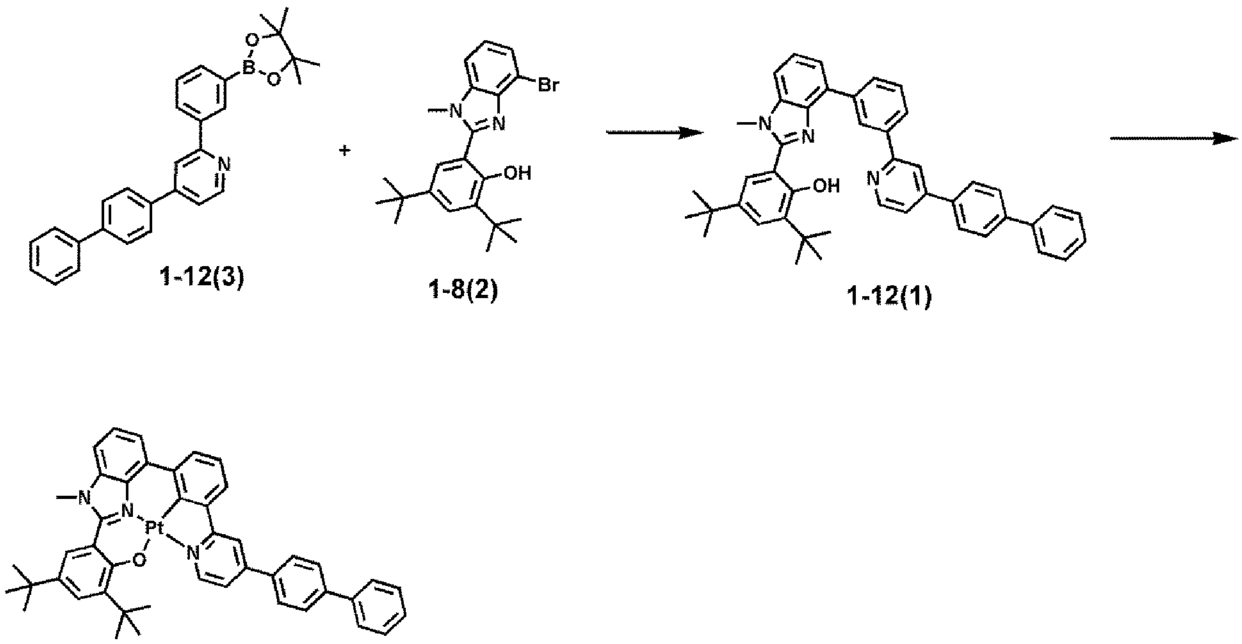

1-12(3) 1-8(2) 1-12(1)

1-12

Synthesis of Intermediate 1-12(1)

Intermediate 1-12(1) was obtained in substantially the same manner as in Synthesis of Intermediate 1-8(1) in Synthesis Example 1, except that Intermediate 1-12(3) was used instead of Intermediate 1-8(3).

Synthesis of Compound 1-12

Compound 1-12 was obtained in substantially the same manner as in Synthesis of Compound 1-8 in Synthesis Example 1, except that Intermediate 1-12(1) was used instead of Intermediate 1-8(1).

**Synthesis Example 3: Synthesis of Compound 1-89**

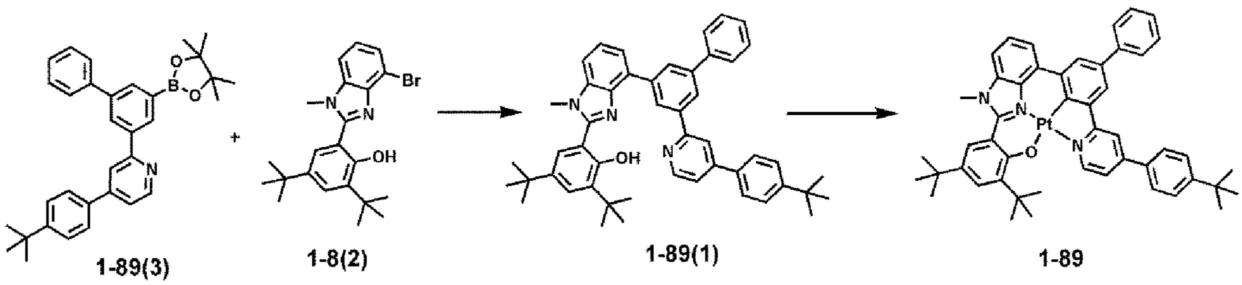

1-89(3) 1-8(2) 1-89(1) 1-89

Synthesis of Intermediate 1-89(1)

Intermediate 1-89(1) was obtained in substantially the same manner as in Synthesis of Intermediate 1-8(1) in Synthesis Example 1, except that Intermediate 1-89(3) was used instead of Intermediate 1-8(3).

Synthesis of Compound 1-89

Compound 1-89 was obtained in substantially the same manner as in Synthesis of Compound 1-8 in Synthesis Example 1, except that Intermediate 1-89(1) was used instead of Intermediate 1-8(1).

**Synthesis Example 4: Synthesis of Compound 3-225**

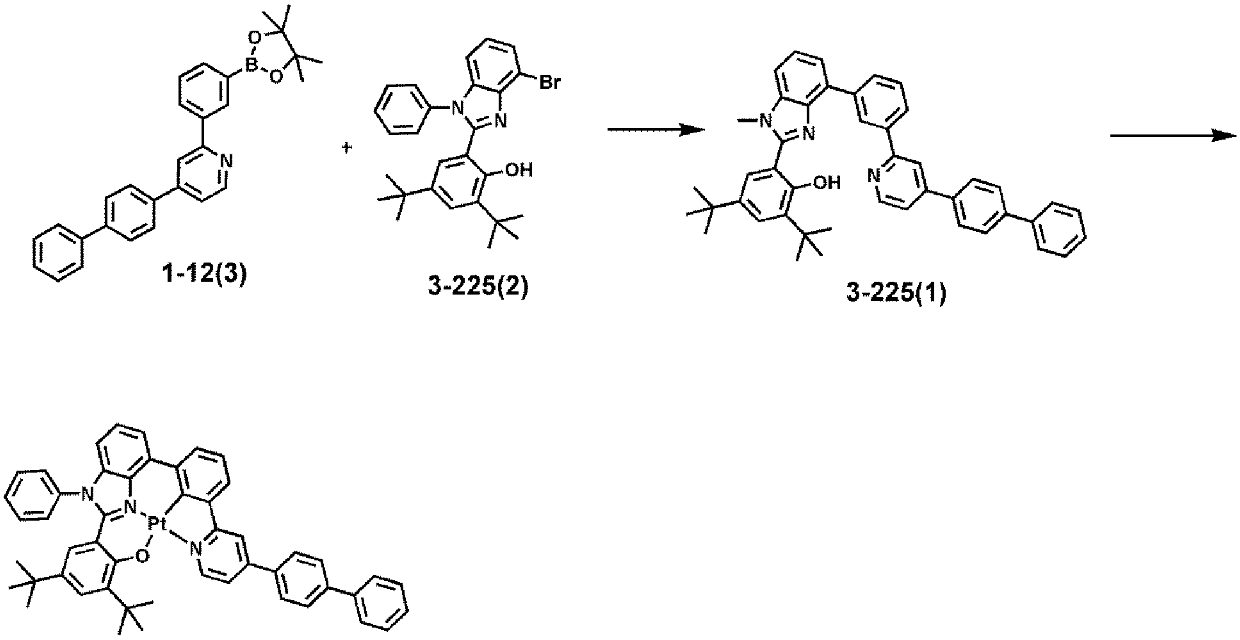

1-12(3) 3-225(2) 3-225(1)

3-225

Synthesis of Intermediate 3-225(1)

Intermediate 3-225(1) was obtained in substantially the same manner as in Synthesis of Intermediate 1-8(1) in Synthesis Example 1, except that Intermediate 1-12(3) and Intermediate 3-225(2) were used instead of Intermediate 1-8(3) and Intermediate 1-8(2), respectively.

Synthesis of Compound 3-225

Compound 1-225 was obtained in substantially the same manner as in Synthesis of Compound 1-8 in Synthesis Example 1, except that Intermediate 3-225(1) was used instead of Intermediate 1-8(1).

**Synthesis Example 5: Synthesis of Compound 1-90**

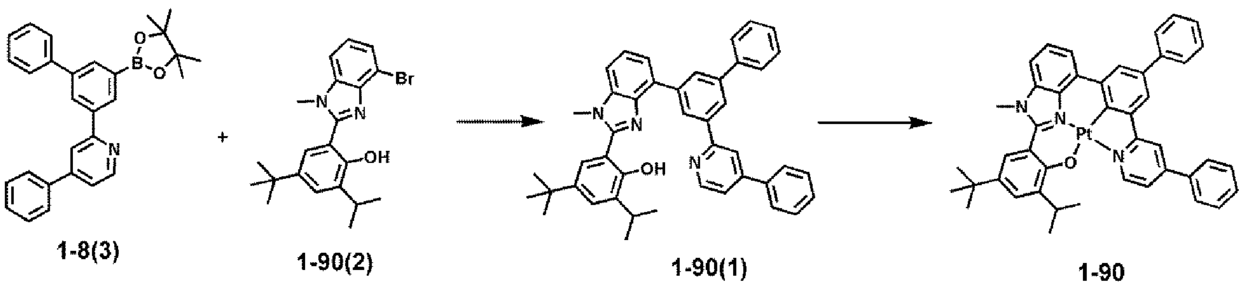

1-8(3) 1-90(2) 1-90(1) 1-90

Synthesis of Intermediate 1-90(1)

Intermediate 1-90(1) was obtained in substantially the same manner as in Synthesis of Intermediate 1-8(1) in Synthesis Example 1, except that Intermediate 1-90(2) was used instead of Intermediate 1-8(2).

Synthesis of Compound 1-90

Compound 1-90 was obtained in substantially the same manner as in Synthesis of Compound 1-8 in Synthesis Example 1, except that Intermediate 1-90(1) was used instead of Intermediate 1-8(1).

**Synthesis Example 6: Synthesis of Compound 1-91**

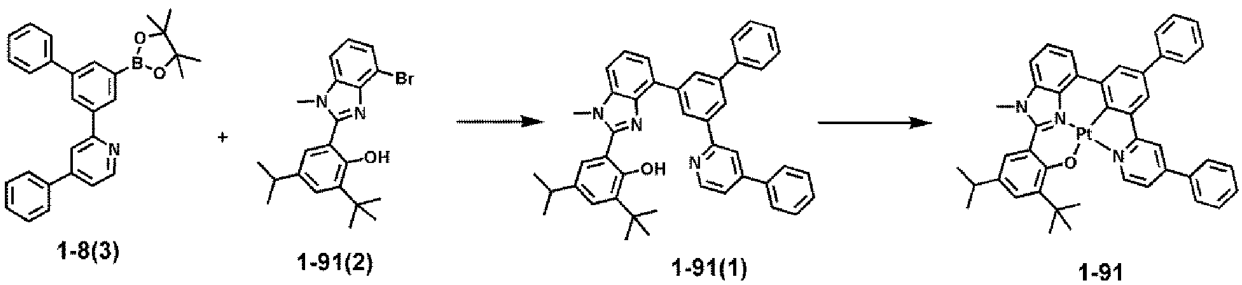

1-8(3) 1-91(2) 1-91(1) 1-91

Synthesis of Intermediate 1-91(1)

Intermediate 1-91(1) was obtained in substantially the same manner as in Synthesis of Intermediate 1-8(1) in Synthesis Example 1, except that Intermediate 1-91(2) was used instead of Intermediate 1-8(2).

Synthesis of Compound 1-91

Compound 1-91 was obtained in substantially the same manner as in Synthesis of Compound 1-8 in Synthesis Example 1, except that Intermediate 1-91(1) was used instead of Intermediate 1-8(1).

**Synthesis Example 7: Synthesis of Compound 1-36**

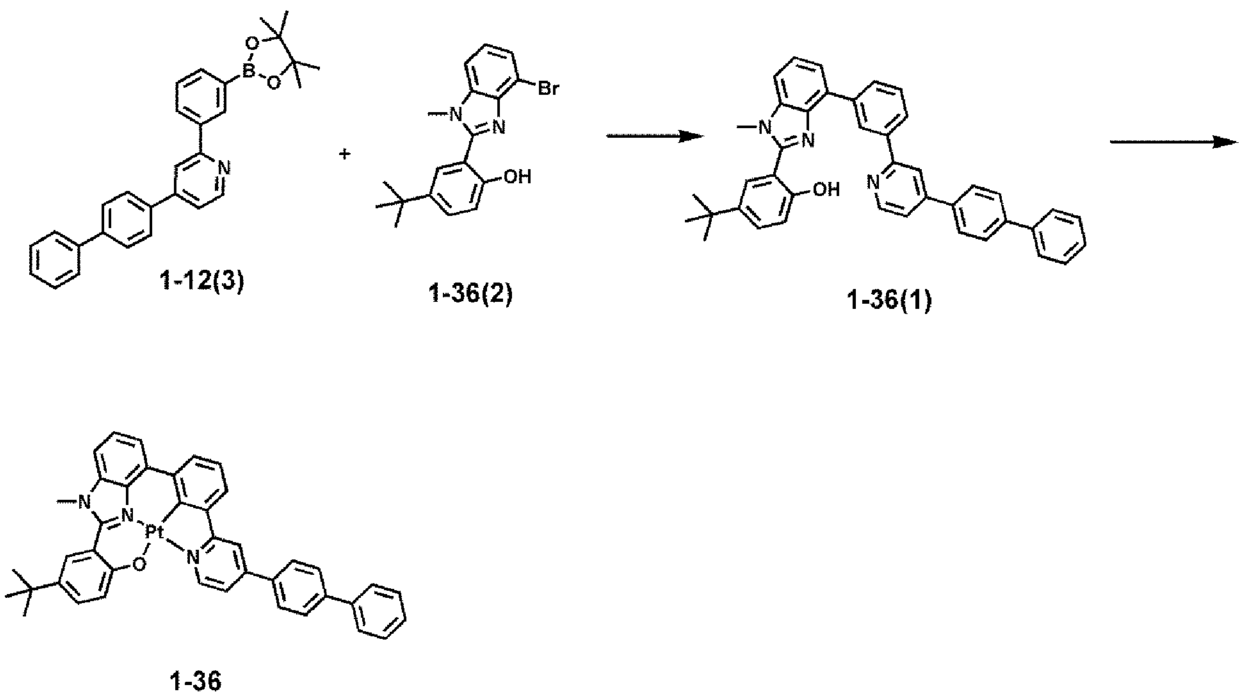

1-12(3) 1-36(2) 1-36(1)

1-36

Synthesis of Intermediate 1-36(1)

Intermediate 1-36(1) was obtained in substantially the same manner as in Synthesis of Intermediate 1-8(1) in Synthesis Example 1, except that Intermediate 1-12(3) and Intermediate 1-36(2) were used instead of Intermediate 1-8(3) and Intermediate 1-8(2), respectively.

Synthesis of Compound 1-36

Compound 1-36 was obtained in substantially the same manner as in Synthesis of Compound 1-8 in Synthesis Example 1, except that Intermediate 1-36(1) was used instead of Intermediate 1-8(1).

**Evaluation Example 1 : Measurement of emission energy of maximum emission wavelength and PLQY**

Each Compound shown in Table 1 was vacuum-co-deposited on a quartz substrate in a weight ratio shown in Table 1 at a vacuum degree of $10^{-7}$ torr to form Films A(1), B(1), C(1), D(1), E(1), F(1), G(1), 1-8(1), 1-12(1), 1-89(1), 3-225(1), 1-90(1), 1-91(1), and 1-36(1), each having a thickness of 40 nm and each Compound shown in Table 2 was vacuum-co-deposited on a quartz substrate in a weight ratio shown in Table 2 at a vacuum degree of $10^{-7}$ torr to form Films A(3), B(3), C(3), D(3), E(3), F(3), G(3), 1-8(3), 1-12(3), 1-89(3), 3-225(3), 1-90(3), 1-91(3), 1-36(3), and 1-8(4), each having a thickness of 40 nanometers (nm).

The emission spectrum of each of Films A(1), B(1), C(1), D(1), E(1), F(1), G(1), 1-8(1), 1-12(1), 1-89(1), 3-225(1), 1-90(1), 1-91(1), 1-36(1), A(3), B(3), C(3), D(3), E(3), F(3), G(3), 1-8(3), 1-12(3), 1-89(3), 3-225(3), 1-90(3), 1-91(3), 1-36(3), and 1-8(4) was measured by using a Hamamatsu Quantaurus-QY absolute PL quantum yield measurement system equipped with a xenon light source, a monochromator, a photonic multichannel analyzer, and an integrating sphere, and utilizing PLQY measurement software (Hamamatsu Photonics, Ltd., Shizuoka, Japan). For the measurements, an excitation wavelength was scanned and measured at every 10 nm interval from 320 nm to 380 nm, and from these measurements, a spectrum measured at the excitation wavelength of 340 nm was taken. Then, an emission energy of the maximum emission wavelength of the dopant included in each Film was measured and shown in Tables 1 and 2.

Subsequently, the PLQY of each of Films A(1), B(1), C(1), D(1), E(1), F(1), G(1), 1-8(1), 1-12(1), 1-89(1), 3-225(1), 1-90(1), 1-91(1), 1-36(1), A(3), B(3), C(3), D(3), E(3), F(3), G(3), 1-8(3), 1-12(3), 1-89(3), 3-225(3), 1-90(3), 1-91(3), 1-36(3), and 1-8(4) was scanned and measured at an excitation wavelength of every 10 nm interval from 320 nm to 380 nm by using a Hamamatsu Quantaurus-QY absolute PL quantum yield measurement system. The PLQY of the dopant included in each Film measured is shown in Tables 1 and 2.

Table 1

| Film No. | Film composition (weight ratio) | Emission energy of maximum emission wavelength of dopant (eV) | PLQY of dopant |
|---|---|---|---|
| A(1) | H-H1 : H-E1 : A (45: 45: 10) | 2.39 | 0.939 |
| B(1) | H-H1 : H-E1 : B (45 : 45 : 10) | 2.35 | 0.919 |
| C(1) | H-H1 : H-E1 : C (45 : 45 : 10) | 2.37 | 0.888 |
| D(1) | H-H1 : H-E1 : D (45 : 45 : 10) | 2.43 | 0.828 |
| E(1) | H-H1 : H-E1 : E (45 : 45 : 10) | 2.44 | 0.921 |
| F(1) | H-H1 : H-E1 : F (45 : 45 : 10) | 2.38 | 0.986 |
| G(1) | H-H1 : H-E1 : G (45 : 45 : 10) | 2.39 | 0.943 |
| 1-8(1) | H-H1 : H-E1 : 1-8 (45 : 45 : 10) | 2.34 | 0.980 |

(continued)

| Film No. | Film composition (weight ratio) | Emission energy of maximum emission wavelength of dopant (eV) | PLQY of dopant |
|---|---|---|---|
| 1-12(1) | H-H1 : H-E1 : 1-12 (45 : 45 : 10) | 2.35 | 0.980 |
| 1-89(1) | H-H1 : H-E1 : 1-89 (45 : 45: 10) | 2.33 | 0.979 |
| 3-225(1) | H-H1 : H-E1 : 3-225 (45 : 45 : 10) | 2.33 | 0.979 |
| 1-90(1) | H-H1 : H-E1 : 1-90 (45 : 45: 10) | 2.33 | 0.978 |
| 1-91(1) | H-H1 : H-E1 : 1-91 (45 : 45 : 10) | 2.35 | 0.980 |
| 1-36(1) | H-H1 : H-E1 : 1-36 (45 : 45 : 10) | 2.35 | 0.978 |

Table 2

| Film No. | Film composition (weight ratio) | Emission energy of maximum emission wavelength of dopant (eV) | PLQY of dopant |
|---|---|---|---|
| A(3) | H-H2 : H-E43 : A (45 : 45 : 10) | 2.39 | 0.925 |
| B(3) | H-H2 : H-E43 : B (45 : 45 : 10) | 2.35 | 0.867 |
| C(3) | H-H2 : H-E43 : C (45 : 45 : 10) | 2.37 | 0.879 |
| D(3) | H-H2 : H-E43 : D (45 : 45 : 10) | 2.43 | 0.805 |
| E(3) | H-H2 : H-E43 : E (45 : 45 : 10) | 2.44 | 0.869 |
| F(3) | H-H2 : H-E43 : F (45 : 45 : 10) | 2.38 | 0.927 |
| G(3) | H-H2 : H-E43 : G (45 : 45 : 10) | 2.39 | 0.889 |
| 1-8(3) | H-H2 : H-E43 : 1-8 (45 : 45 : 10) | 2.34 | 0.942 |
| 1-12(3) | H-H2 : H-E43 : 1-12 (45 : 45 : 10) | 2.35 | 0.951 |
| 1-89(3) | H-H2 : H-E43 : 1-89 (45 : 45 : 10) | 2.33 | 0.935 |
| 3-225(3) | H-H2 : H-E43 : 3-225 (45 : 45 : 10) | 2.33 | 0.967 |
| 1-90(3) | H-H2 : H-E43 : 1-90 (45 : 45 : 10) | 2.33 | 0.970 |
| 1-91(3) | H-H2 : H-E43 : 1-91 (45 : 45 : 10) | 2.35 | 0.924 |

(continued)

| Film No. | Film composition (weight ratio) | Emission energy of maximum emission wavelength of dopant (eV) | PLQY of dopant |
|---|---|---|---|
| 1-36(3) | H-H2 : H-E43 : 1-36 (45 : 45 : 10) | 2.35 | 0.955 |
| 1-8(4) | H-H17 : H-E43 : 1-8 (45 : 45 : 10) | 2.34 | 0.985 |

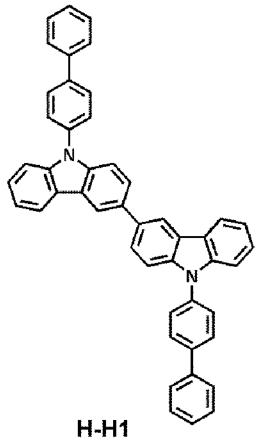
H-H1

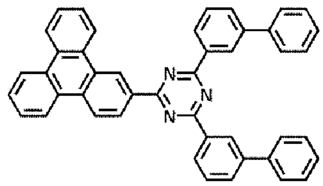
H-E1

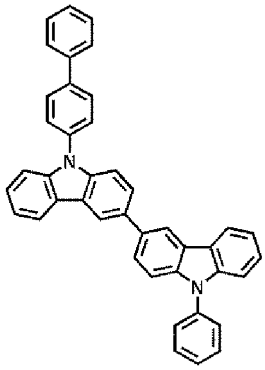
H-H2

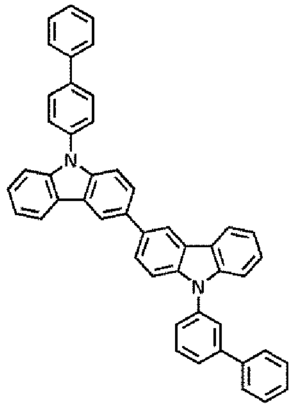
H-H17

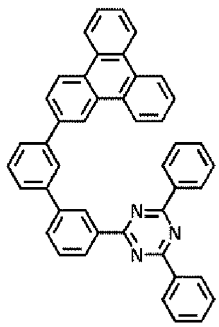
H-E43

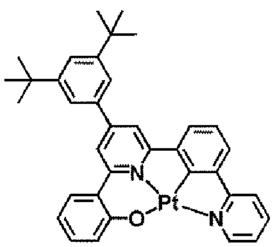
A

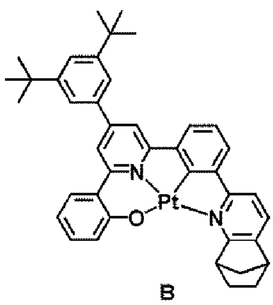
B

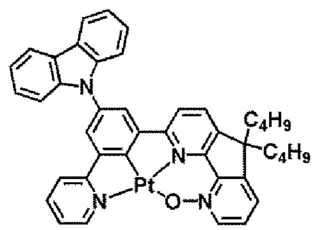
C

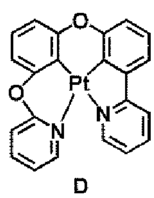
D

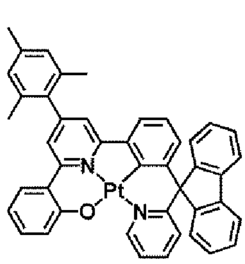
E

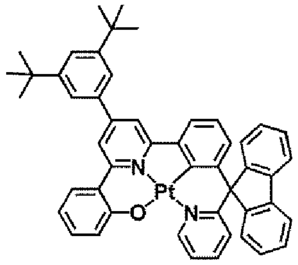
F

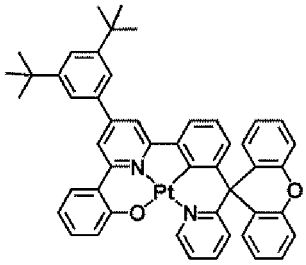
G

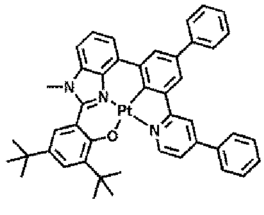
1-8

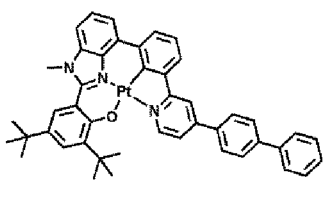
1-12

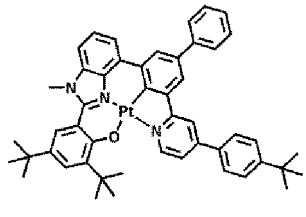
1-89

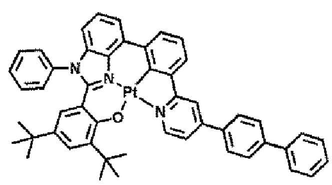
3-225

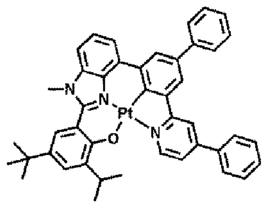
1-90

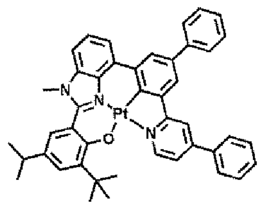
1-91

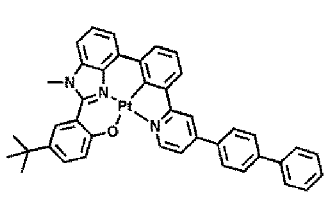
1-36

## Evaluation Example 2: Measurement of decay time

Each of photoluminescence (PL) spectra of Films A(1), B(1), C(1), D(1), E(1), F(1), G(1), 1-8(1), 1-12(1), 1-89(1), 3-225(1), 1-90(1), 1-91(1), 1-36(1), A(3), B(3), C(3), D(3), E(3), F(3), G(3), 1-8(3), 1-12(3), 1-89(3), 3-225(3), 1-90(3), 1-91(3), 1-36(3) and 1-8(4) was evaluated at room temperature by using a time-resolved photoluminescence (TRPL) measurement system, FluoTime 300 (available from PicoQuant), and a pumping source, PLS340 (available from PicoQuant, excitation wavelength=340 nm, spectral width=20 nm). Then, a wavelength of the main peak in each PL spectrum was determined, and upon photon pulses (pulse width=500 picoseconds, ps) applied to the film by PLS340, the number of photons emitted at the wavelength of the main peak for each film was repeatedly measured over time by time-correlated single photon counting (TCSPC), thereby obtaining TRPL curves available for the sufficient fitting. Based on the results obtained therefrom, one or more exponential decay functions were set forth for the fitting, thereby obtaining a decay time $T_{decay}$ (Ex) for each of Films A(1), B(1), C(1), D(1), E(1), F(1), G(1), 1-8(1), 1-12(1), 1-89(1), 3-225(1), 1-90(1), 1-91(1), 1-36(1), A(3), B(3), C(3), D(3), E(3), F(3), G(3), 1-8(3), 1-12(3), 1-89(3), 3-225(3), 1-90(3), 1-91(3), 1-36(3) and 1-8(4). The results thereof are shown in Tables 3 and 4. The functions used for the fitting are as described in Equation 20, and an average of each decay time $T_{decay}$ for each of the exponential decay functions used for the fitting was taken as $T_{decay}$(Ex), i.e., a decay time. Here, during the same measurement time as the measurement time for obtaining TRPL curves, the same measurement was repeated once more in a dark state (i.e., a state where a pumping signal incident on each of the films was blocked), thereby obtaining a baseline or a background signal curve available as a baseline for the fitting:

Equation 20

$$f(t) = \sum_{i=1}^{n} A_i \, exp\left(-t/T_{decay,i}\right)$$

Table 3

| Film No. | Film composition (weight ratio) | Decay time of dopant (μs) |
|---|---|---|
| A(1) | H-H1 : H-E1 : A (45: 45: 10) | 3.1 |
| B(1) | H-H1 : H-E1 : B (45 : 45 : 10) | 3.7 |
| C(1) | H-H1 : H-E1 : C (45 : 45 : 10) | 10.9 |
| D(1) | H-H1 : H-E1 : D (45 : 45 : 10) | 4.3 |
| E(1) | H-H1 : H-E1 : E (45 : 45 : 10) | 6.5 |
| F(1) | H-H1 : H-E1 : F (45 : 45 : 10) | 4.5 |
| G(1) | H-H1 : H-E1 : G (45 : 45 : 10) | 4.4 |
| 1-8(1) | H-H1 : H-E1 : 1-8 (45 : 45 : 10) | 2.4 |
| 1-12(1) | H-H1 : H-E1 : 1-12 (45 : 45 : 10) | 2.4 |
| 1-89(1) | H-H1 : H-E1 : 1-89 (45: 45: 10) | 2.4 |
| 3-225(1) | H-H1 : H-E1 : 3-225 (45 : 45 : 10) | 2.3 |
| 1-90(1) | H-H1 : H-E1 : 1-90 (45: 45: 10) | 2.0 |
| 1-91(1) | H-H1 : H-E1 : 1-91 (45 : 45 : 10) | 2.5 |
| 1-36(1) | H-H1 : H-E1 : 1-36 (45 : 45 : 10) | 2.4 |

Table 4

| Film No. | Film composition (weight ratio) | Decay time of dopant (μs) |
|---|---|---|
| A(3) | H-H2 : H-E43 : A (45 : 45 : 10) | 3.1 |
| B(3) | H-H2 : H-E43 : B (45 : 45 : 10) | 3.6 |
| C(3) | H-H2 : H-E43 : C (45 : 45 : 10) | 11.1 |
| D(3) | H-H2 : H-E43 : D (45 : 45 : 10) | 4.3 |
| E(3) | H-H2 : H-E43 : E (45 : 45 : 10) | 6.3 |
| F(3) | H-H2 : H-E43 : F (45 : 45 : 10) | 4.4 |
| G(3) | H-H2 : H-E43 : G (45 : 45 : 10) | 4.2 |
| 1-8(3) | H-H2 : H-E43 : 1-8 (45 : 45 : 10) | 2.5 |
| 1-12(3) | H-H2 : H-E43 : 1-12 (45 : 45 : 10) | 2.5 |
| 1-89(3) | H-H2 : H-E43 : 1-89 (45 : 45 : 10) | 2.3 |
| 3-225(3) | H-H2 : H-E43 : 3-225 (45 : 45 : 10) | 2.4 |
| 1-90(3) | H-H2 : H-E43 : 1-90 (45 : 45 : 10) | 2.0 |
| 1-91(3) | H-H2 : H-E43 : 1-91 (45 : 45 : 10) | 2.4 |
| 1-36(3) | H-H2 : H-E43 : 1-36 (45 : 45 : 10) | 2.4 |
| 1-8(4) | H-H17 : H-E43 : 1-8 (45 : 45 : 10) | 2.3 |

**Evaluation Example 3 : Measurement of HOMO energy level**

Each Compound shown in Table 5 was vacuum-(co)-deposited on an ITO substrate in a weight ratio shown in Table 5 at a vacuum degree of $10^{-7}$ torr to form Films A(2), B(2), C(2), D(2), E(2), F(2), G(2), 1-8(2), 1-12(2), 1-89(2), 3-225(2), 1-90(2), 1-91(2), 1-36(2), H-H1, H-E1, H-H2, H-H17 and H-E43 each having a thickness of 40 nm. The photoelectron emission of each Film was measured by using a photoelectron spectrometer AC3 (available from Riken Keiki

Co., Ltd.) in an ambient atmosphere. During the measurement, the intensity of UV light source of AC-3 was fixed at 10 nanowatts (nW), and the photoelectron emission was measured at every 0.05 eV interval from -4.5 eV to -7.0 eV. The time for measuring each point was 10 seconds. In order to obtain the HOMO energy level, a photoelectron efficiency spectrum was obtained by applying a cube root to the measured photoelectron emission intensity value. Then, a tangent line was drawn for a first slope to obtain a point of contact between a baseline and the tangent line. The results thereof are shown in Table 3. Here, the baseline was modified using a light source modification function of AC3.

Table 5

| Film No. | Film composition (weight ratio) | HOMO energy level (eV) |
|---|---|---|
| A(2) | 1,4-Bis(triphenylsilyl)benzene : A (85 : 15) | -5.34 |
| B(2) | 1,4-Bis(triphenylsilyl)benzene : B (85 : 15) | -5.48 |
| C(2) | 1,4-Bis(triphenylsilyl)benzene : C (85 : 15) | -5.68 |
| D(2) | 1,4-Bis(triphenylsilyl)benzene : D (85 : 15) | -5.38 |
| E(2) | 1,4-Bis(triphenylsilyl)benzene : E (85 : 15) | -5.62 |
| F(2) | 1,4-Bis(triphenylsilyl)benzene : F (85 : 15) | -5.55 |
| G(2) | 1,4-Bis(triphenylsilyl)benzene : G (85 : 15) | -5.58 |
| 1-8(2) | 1,4-Bis(triphenylsilyl)benzene : 1-8(85 : 15) | -5.38 |
| 1-12(2) | 1,4-Bis(triphenylsilyl)benzene : 1-12 (85 : 15) | -5.39 |
| 1-89(2) | 1,4-Bis(triphenylsilyl)benzene : 1-89 (85 : 15) | -5.35 |
| 3-225(2) | 1,4-Bis(triphenylsilyl)benzene : 3-225 (85 : 15) | -5.34 |
| 1-90(2) | 1,4-Bis(triphenylsilyl)benzene : 1-90 (85 : 15) | -5.36 |
| 1-91(2) | 1,4-Bis(triphenylsilyl)benzene : 1-91 (85 : 15) | -5.37 |
| 1-36(2) | 1,4-Bis(triphenylsilyl)benzene : 1-36 (85 : 15) | -5.36 |
| H-H1 | H-H1(100wt%) | -5.57 |
| H-E1 | H-E1 (100wt%) | -6.07 |
| H-H2 | H-H2 (100wt%) | -5.59 |
| H-H17 | H-H17 (100wt%) | -5.55 |
| H-E43 | H-E43 (100wt%) | -6.08 |

## Comparative Example A

An ITO glass substrate was cut to a size of 50 millimeters (mm) x 50 mm x 0.5 mm. Then the glass substrate was sonicated in acetone isopropyl alcohol and pure water for about 15 minutes each, and cleaned by exposure to ultraviolet rays and ozone for 30 minutes.

F6-TCNNQ was deposited on the ITO electrode (anode) on the glass substrate to form a hole injection layer having a thickness of 100 Å, and then HT1 was deposited on the hole injection layer to form a hole transport layer having a thickness of 1,260 Å, thereby forming a hole transport region.

Then, a hole transporting host H-H1 and an electron transporting host H-E1 (where a weight ratio of the hole transporting host to the electron transporting host was 5:5) as a host and Compound A as a dopant were co-deposited on the hole transport region (where a weight ratio of the host to the dopant was 90:10), thereby forming an emission layer having a thickness of 400 Å.

Subsequently, Compound ET1 and Liq were co-deposited on a weight ratio of 5:5 on the emission layer to form an electron transport layer having a thickness of 360 Å. Then, LiF was deposited on the electron transport layer to form an electron injection layer having a thickness of 5 Å. Then, Al was vacuum-deposited on the electron injection layer to form a second electrode (cathode) having a thickness of 800 Å, thereby completing the manufacture of an organic light-emitting device having a structure of ITO/F6-TCNNQ (100 Å)/HT1 (1,260 Å)/(H-H+HE1):Compound A (10 wt%) (400 Å)/ET1:Liq (50 wt%) (360 Å)/LiF (5 A)/Al (800 Å).

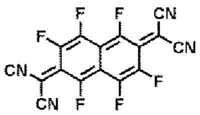

F6-TCNNQ

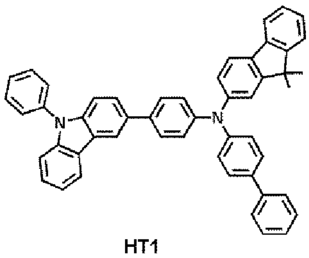

HT1

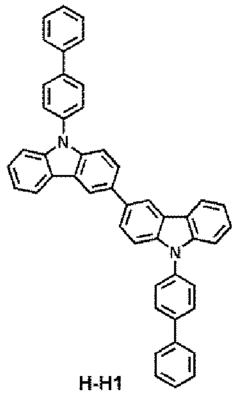

H-H1

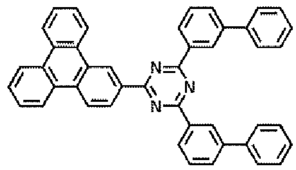

H-E1

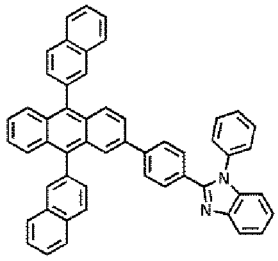

ET1

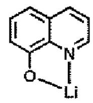

Liq

**Comparative Examples B to G and Examples 1 to 7**

Organic light-emitting devices were manufactured in substantially the same manner as in Comparative Example A, except that compounds shown in Table 6 as a hole transporting host, an electron transporting host and a dopant were used in the formation of the emission layer.

Comparative Examples 1A to 1G and Examples 11 to 18

Organic light-emitting devices were manufactured in substantially the same manner as in Comparative Example A, except that compounds shown in Table 7 as a hole transporting host, an electron transporting host and a dopant were used in the formation of the emission layer.

**Evaluation Example** 4 : **Measurement of OLED lifespan**

The lifespan ($T_{95}$) of each of the organic light-emitting devices manufactured in Comparative Examples A to G, Examples 1 to 7, Comparative Examples 1A to 1G and Examples 11 to 18 (at 6,000 candelas per square meter ($cd/m^2$)) was measured. The results thereof are shown in Tables 6 and 7. A luminance meter (Minolta Cs-1000A) was used in evaluation, and the lifespan ($T_{95}$) refers to time required for the initial luminance of 6,000 nit of the organic light-emitting device to reduce by 95%. The lifespan ($T_{95}$) was shown in values (%) relative to that of the organic light-emitting device of Example 1 (in other words, the lifespan ($T_{95}$) of the organic light-emitting device of Example 1 is 100 %)

Table 6

| | A hole transporting host | An electron transporting host | dopant | Emission energy of maximum emission wavelength of dopant (eV) | PLQY of dopant | Decay time of dopant (μs) | HOMO (dopant)-HOMO(host) (eV) | Lifespan ($T_{95}$) (%) |
|---|---|---|---|---|---|---|---|---|
| Comparative Example A | H-H1 | H-E1 | A | 2.39 | 0.939 | 3.1 | 0.23 | 8.2 |
| Comparative Example B | H-H1 | H-E1 | B | 2.35 | 0.919 | 3.7 | 0.09 | 20 |
| Comparative Example C | H-H1 | H-E1 | C | 2.37 | 0.888 | 10.9 | -0.11 | 1.3 |
| Comparative Example D | H-H1 | H-E1 | D | 2.43 | 0.828 | 4.3 | 0.19 | 4.0 |
| Comparative Example E | H-H1 | H-E1 | E | 2.44 | 0.921 | 6.5 | -0.05 | 0.4 |
| Comparative Example F | H-H1 | H-E1 | F | 2.38 | 0.986 | 4.5 | 0.02 | 2.5 |
| Comparative Example G | H-H1 | H-E1 | G | 2.39 | 0.943 | 4.4 | -0.01 | 1.6 |
| Example 1 | H-H1 | H-E1 | 1-8 | 2.34 | 0.980 | 2.4 | 0.19 | 100 |
| Example 2 | H-H1 | H-E1 | 1-12 | 2.35 | 0.980 | 2.4 | 0.18 | 70 |
| Example 3 | H-H1 | H-E1 | 1-89 | 2.33 | 0.979 | 2.4 | 0.22 | 84 |
| Example 4 | H-H1 | H-E1 | 3-225 | 2.33 | 0.979 | 2.3 | 0.23 | 72 |
| Example 5 | H-H1 | H-E1 | 1-90 | 2.33 | 0.978 | 2.0 | 0.21 | 86 |
| Example 6 | H-H1 | H-E1 | 1-91 | 2.35 | 0.980 | 2.5 | 0.20 | 76 |
| Example 7 | H-H1 | H-E1 | 1-36 | 2.35 | 0.978 | 2.4 | 0.21 | 70 |

Table 7

| | A hole transporting host | An electron transporting host | dopant | Emission energy of maximum emission wavelength of dopant (eV | PLQY of dopant | Decay time of dopant (μs) | HOMO (dopant)-HOMO(host) (eV) | Lifespan ($T_{95}$) (%) |
|---|---|---|---|---|---|---|---|---|
| Comparative Example 1A | H-H2 | H-E43 | A | 2.39 | 0.925 | 3.1 | 0.25 | 4.3 |
| Comparative Example 1B | H-H2 | H-E43 | B | 2.35 | 0.867 | 3.6 | 0.11 | 12 |
| Comparative Example 1C | H-H2 | H-E43 | C | 2.37 | 0.879 | 11.1 | -0.09 | 0.8 |
| Comparative Example 1D | H-H2 | H-E43 | D | 2.43 | 0.805 | 4.3 | 0.21 | 2.8 |
| Comparative Example 1E | H-H2 | H-E43 | E | 2.44 | 0.869 | 6.3 | -0.03 | 0.2 |
| Comparative Example 1F | H-H2 | H-E43 | F | 2.38 | 0.927 | 4.4 | 0.04 | 1.5 |
| Comparative Example 1G | H-H2 | H-E43 | G | 2.39 | 0.889 | 4.2 | 0.01 | 0.8 |
| Example 11 | H-H2 | H-E43 | 1-8 | 2.34 | 0.942 | 2.5 | 0.21 | 78 |
| Example 12 | H-H2 | H-E43 | 1-12 | 2.35 | 0.951 | 2.5 | 0.20 | 72 |
| Example 13 | H-H2 | H-E43 | 1-89 | 2.33 | 0.935 | 2.3 | 0.24 | 60 |
| Example 14 | H-H2 | H-E43 | 3-225 | 2.33 | 0.967 | 2.4 | 0.25 | 50 |
| Example 15 | H-H2 | H-E43 | 1-90 | 2.33 | 0.970 | 2.0 | 0.23 | 82 |
| Example 16 | H-H2 | H-E43 | 1-91 | 2.35 | 0.924 | 2.4 | 0.22 | 41 |
| Example 17 | H-H2 | H-E43 | 1-36 | 2.35 | 0.955 | 2.4 | 0.23 | 34 |
| Example 18 | H-H17 | H-E43 | 1-8 | 2.34 | 0.985 | 2.3 | 0.17 | 120 |

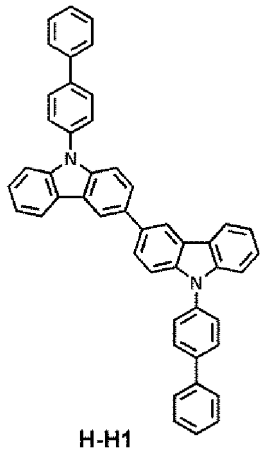

**H-H1**

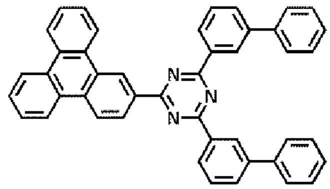

**H-E1**

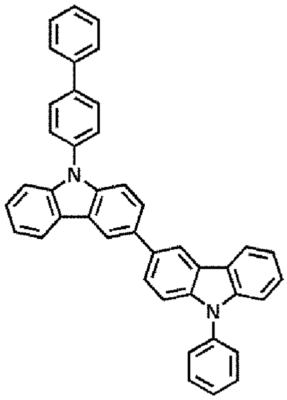

**H-H2**

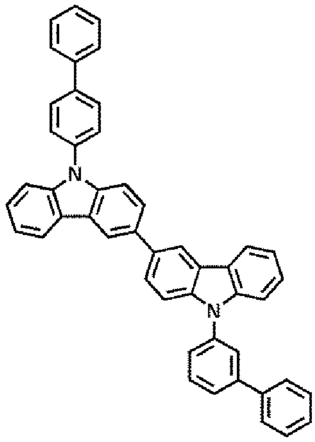

**H-H17**

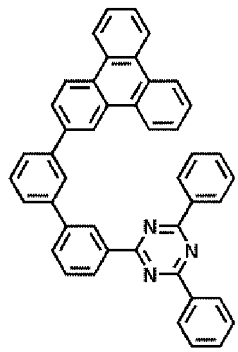

**H-E43**

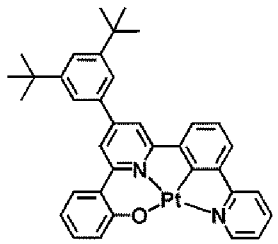

A

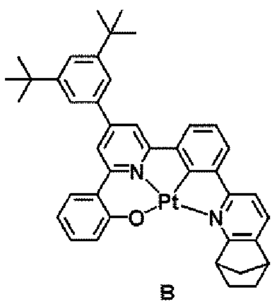

B

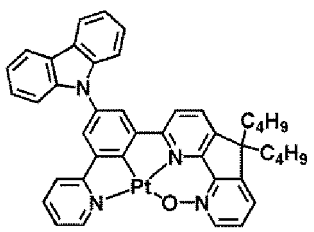

C

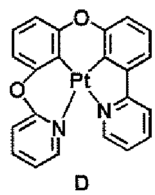

D

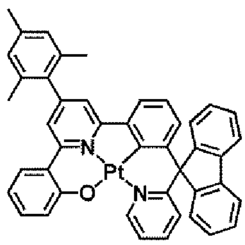

E

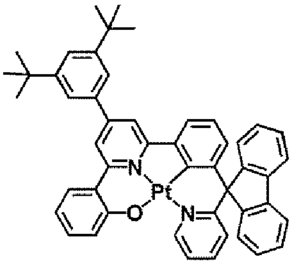

F

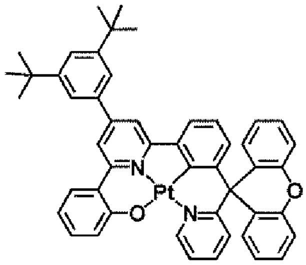

G

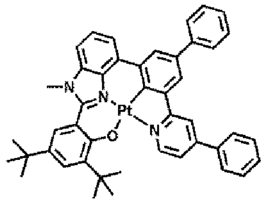

1-8

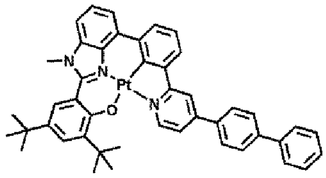

1-12

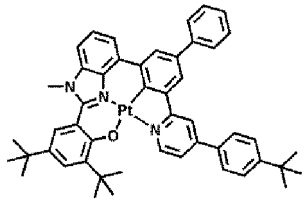

1-89

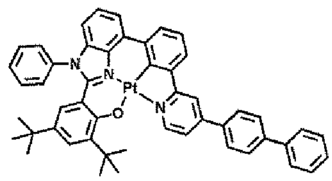

3-225

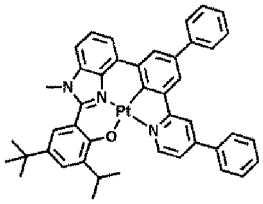

1-90

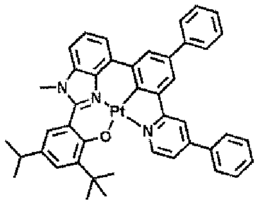

1-91

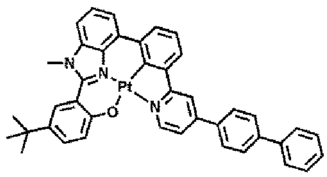

1-36

Referring to Table 6, it was found that the organic light-emitting devices of Examples 1 to 7 have improved lifespan characteristics, as compared with the organic light-emitting devices of Comparative Examples A to G and referring to Table 7, it was found that the organic light-emitting devices of Examples 11 to 18 have improved lifespan characteristics, as compared with the organic light-emitting devices of Comparative Examples 1A to 1G.

As apparent from the foregoing description, an organic light-emitting device satisfying certain parameters may have long lifespan.

## Claims

**1.** An organic light-emitting device comprising:

a first electrode;
a second electrode facing the first electrode; and
an emission layer disposed between the first electrode and the second electrode,
wherein the emission layer comprises a host and a dopant,
the emission layer emits a phosphorescent light,
the dopant is an organometallic compound,
a photoluminescence quantum yield (PLQY) of the dopant is 0.8 or greater and 1.0 or less,
a decay time of the dopant is 0.1 microseconds (μs) or greater and 2.9 μs or less,
0.1 eV ≤ HOMO (dopant) - HOMO (host) ≤ 0.4 eV, wherein the HOMO (dopant) represents a highest occupied molecular orbital (HOMO) energy level (expressed in electron volts) of the dopant, and the HOMO (host) represents, in a case where the host comprised in the emission layer comprises one type of host, a HOMO energy level (expressed in electron volts) of the one type of host; or in a case where the host comprised in the emission layer is a mixture of two or more different types of host, a highest HOMO energy level from among HOMO energy levels (expressed in electron volts) of the two or more different types of host,
the PLQY of the dopant is a PLQY of Film 1,
the decay time of the dopant is calculated from a time-resolved photoluminescence (TRPL) spectrum with respect to Film 1,
Film 1 has a thickness of 40 nanometers (nm) obtained by vacuum-deposition of the host and the dopant comprised in the emission layer in a weight ratio of 90:10 on a quartz substrate at a vacuum degree of $10^{-7}$ torr,
the HOMO (dopant) is a negative value measured by using a photoelectron spectrometer in an ambient atmosphere with respect to a film having a thickness of 40 nm obtained by vacuum-deposition of 1,4-bis(triphenylsilyl)benzene and the dopant comprised in the emission layer in a weight ratio of 85:15 on an ITO substrate at a vacuum degree of $10^{-7}$ torr, and
the HOMO (host) is, i) in a case where the host comprises one type of host, a negative value measured by using a photoelectron spectrometer in an ambient atmosphere with respect to a film having a thickness of 40 nm obtained by vacuum-deposition of the one type of host on an ITO substrate at a vacuum degree of $10^{-7}$ torr; or ii) in a case where the host is a mixture of two or more different types of host, a largest negative value from

among negative values measured by using a photoelectron spectrometer in an ambient atmosphere with respect to films having a thickness of 40 nm obtained by vacuum-deposition of each of the two or more different types of host on an ITO substrate at a vacuum degree of $10^{-7}$ torr.

**2.** The organic light-emitting device of claim 1, wherein the emission energy of a maximum emission wavelength of an emission spectrum of the dopant is 2.31 eV or greater and 2.48 eV or less and the emission energy of a maximum emission wavelength of an emission spectrum of the dopant is calculated from a maximum emission wavelength of an emission spectrum with respect to Film 1; and/or
wherein the PLQY of the dopant is 0.9 or greater and 1.0 or less.

**3.** The organic light-emitting device of claims 1 or 2, wherein a decay time of the dopant is 1.0 $\mu$s or greater and 2.9 $\mu$s or less; and/or
wherein 0.1 eV $\leq$ HOMO (dopant) - HOMO (host) $\leq$ 0.25 eV.

**4.** The organic light-emitting device of any of claims 1-3, wherein
the PLQY of the dopant is 0.975 or greater and 1.0 or less,
the decay time of the dopant is 2.0 $\mu$s or greater and 2.5 $\mu$s or less, and
0.15 eV $\leq$ HOMO (dopant) - HOMO (host) $\leq$ 0.25 eV.

**5.** The organic light-emitting device of any of claims 1-4, wherein the dopant is an iridium-free organometallic compound.

**6.** The organic light-emitting device of any of claims 1-5, wherein the dopant is an organometallic compound comprising platinum (Pt), osmium (Os), titanium (Ti), zirconium (Zr), hafnium (Hf), europium (Eu), terbium (Tb), thulium (Tm), rhodium (Rh), ruthenium (Ru), rhenium (Re), beryllium (Be), magnesium (Mg), aluminum (Al), calcium (Ca), manganese (Mn), cobalt (Co), copper (Cu), zinc (Zn), gallium (Ga), germanium (Ge), palladium (Pd), silver (Ag), or gold (Au).

**7.** The organic light-emitting device of any of claims 1-6, wherein the dopant is a platinum-containing organometallic compound; and/or
wherein the dopant has a square-planar coordination structure.

**8.** The organic light-emitting device of any of claims 1-7, wherein the dopant comprises a metal M and an organic ligand, and the metal M and the organic ligand are capable of together forming one, two, or three cyclometalated rings.

**9.** The organic light-emitting device of any of claims 1-8, wherein the dopant comprises a metal M and a tetradentate organic ligand, and the metal M and the tetradentate organic ligand are capable of together forming three or four cyclometalated rings,
the metal M is platinum (Pt), osmium (Os), titanium (Ti), zirconium (Zr), hafnium (Hf), europium (Eu), terbium (Tb), thulium (Tm), rhodium (Rh), ruthenium (Ru), rhenium (Re), beryllium (Be), magnesium (Mg), aluminum (Al), calcium (Ca), manganese (Mn), cobalt (Co), copper (Cu), zinc (Zn), gallium (Ga), germanium (Ge), palladium (Pd), silver (Ag), or gold (Au), and
the tetradentate organic ligand comprises a benzimidazole group and a pyridine group.

**10.** The organic light-emitting device of any of claims 1-9, wherein
the host comprises an electron transporting host and a hole transporting host,
the electron transporting host comprises at least one electron transporting moiety,
the hole transporting host does not comprise an electron transporting moiety, and
the at least one electron transporting moiety is selected from a cyano group, a $\pi$ electron-depleted nitrogen-containing cyclic group, and a group represented by one of following Formulae:

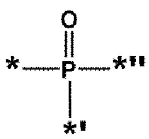 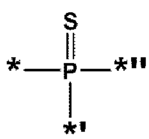 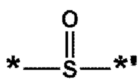 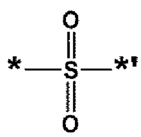

wherein, in the Formulae above, *, *', and *" each indicate a binding site to an adjacent atom.

**11.** The organic light-emitting device of claim 10, wherein
the electron transporting host comprises at least one π electron-depleted nitrogen-free cyclic group and at least one electron transporting moiety,
the hole transporting host comprises at least one π electron-depleted nitrogen-free cyclic group and does not comprise an electron transporting moiety, and
the at least one electron transporting moiety is a cyano group or a π electron-depleted nitrogen-containing cyclic group;
preferably wherein the π electron-depleted nitrogen-containing cyclic group is an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, an iso-benzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, or a condensed ring group in which at least one of the foregoing groups is condensed with at least one cyclic group, and
the π electron-depleted nitrogen-free cyclic group is a benzene group, a heptalene group, an indene group, a naphthalene group, an azulene group, an indacene group, acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a benzosilolocarbazole group, or a triindolobenzene group.

**12.** The organic light-emitting device of claims 10 or 11, wherein the electron transporting host comprises i) at least one selected from a cyano group, a pyrimidine group, a pyrazine group, and a triazine group and ii) a triphenylene group, and the hole transporting host comprises a carbazole group; or
wherein the electron transporting host comprises at least one cyano group.

**13.** The organic light-emitting device of any of claims 1-12, wherein a hole transport region is disposed between the first electrode and the emission layer, and the hole transport region comprises an amine-containing compound.

**14.** The organic light-emitting device of any of claims 1-13, wherein:

emission units in the number of m are stacked between the first electrode and the second electrode, the emission units comprising at least one of the emission layers; and
further comprising charge generating layer(s) in the number of m-1 between each two adjacent emission units from among the m emission units, the each m-1 charge generating layer(s) comprising an n-type charge generating layer and a p-type charge generating layer,
wherein m is an integer of 2 or greater, and
a maximum emission wavelength of light emitted from at least one of the emission units in the number of m differs from that of light emitted from at least one of the other emission units.

**15.** The organic light-emitting device of any of claims 1-13, wherein:

emission layers in the number of m are stacked between the first electrode and the second electrode,
wherein m is an integer of 2 or greater, and
a maximum emission wavelength of light emitted from at least one of the emission layers in the number of m differs from that of light emitted from at least one of the other emission layers.

## Patentansprüche

**1.** Organische lichtemittierende Vorrichtung, umfassend: eine erste Elektrode,
eine der ersten Elektrode zugewandte zweite Elektrode, und

eine zwischen der ersten Elektrode und der zweiten Elektrode angeordnete Emissionsschicht,
wobei die Emissionsschicht einen Wirt und einen Dotierstoff umfasst, die Emissionsschicht ein phosphoreszierendes Licht emittiert, der Dotierstoff eine metallorganische Verbindung ist,
eine Photolumineszenz-Quantenausbeute (PLQY) des Dotierstoffs 0,8 oder höher und 1,0 oder niedriger ist,
eine Zerfallszeit des Dotierstoffs 0,1 Mikrosekunden ($\mu$s) oder mehr und 2,9 $\mu$s oder wenige beträgt,
0,1 eV $\leq$ HOMO (Dotierstoff) - HOMO (Wirt) $\leq$ 0,4 eV, wobei HOMO (Dotierstoff) ein höchstes besetztes molekulares Orbital-Energieniveau (HOMO-Energieniveau) (ausgedrückt in Elektronvolt) des Dotierstoffs darstellt, und HOMO (Wirt) in einem Fall, in dem der in der Emissionsschicht enthaltene Wirt einen Wirtstyp umfasst, ein HOMO-Energieniveau (ausgedrückt in Elektronvolt) der einen Wirtstyp darstellt, oder in einem Fall, in dem der in der Emissionsschicht enthaltene Wirt eine Mischung aus zwei oder mehr verschiedenen Wirtstypen ist, ein höchstes HOMO-Energieniveau aus den HOMO-Energieniveaus (ausgedrückt in Elektronvolt) der zwei oder mehr verschiedenen Wirtstypen, das PLQY des Dotierstoffs ein PLQY des Films 1 ist,
die Zerfallszeit des Dotierstoffs aus einem zeitaufgelösten Photolumineszenzspektrum (TRPL-Spektrum) in Bezug auf Film 1 berechnet wird,
Film 1 eine Dicke von 40 Nanometern (nm) hat, erhalten durch Vakuumabscheidung des Wirtes und des in der Emissionsschicht enthaltenen Dotierstoffs in einem Gewichtsverhältnis von 90:10 auf einem Quarzsubstrat bei einem Vakuumgrad von $10^{-7}$ Torr,
der HOMO (Dotierstoff) ein negativer Wert ist, der unter Verwendung eines Photoelektronenspektrometers in einer Umgebungsatmosphäre in Bezug auf einen Film mit einer Dicke von 40 nm gemessen wird, erhalten durch Vakuumabscheidung von 1,4-Bis(triphenylsilyl)benzol, und der Dotierstoff in der Emissionsschicht in einem Gewichtsverhältnis von 85:15 auf einem ITO-Substrat bei einem Vakuumgrad von $10^{-7}$ Torr enthalten ist, und
der HOMO (Wirt) i) in einem Fall, in dem der Wirt einen Wirtstyp umfasst, ein negativer Wert ist, der unter Verwendung eines Photoelektronenspektrometers in einer Umgebungsatmosphäre in Bezug auf einen Film mit einer Dicke von 40 nm gemessen wird, erhalten durch Vakuumabscheidung des einen Wirtstyps auf einem ITO-Substrat bei einem Vakuumgrad von $10^{-7}$ Torr, oder ii) in einem Fall, in dem der Wirt ein Gemisch aus zwei oder mehr verschiedenen Wirtstypen ist, ein größter negativer Wert unter den negativen Werten ist, der unter Verwendung eines Photoelektronenspektrometers in einer Umgebungsatmosphäre in Bezug auf Filme mit einer Dicke von 40 nm gemessen wird, erhalten durch Vakuumabscheidung jedes der zwei oder mehreren verschiedenen Wirtstypen auf einem ITO-Substrat bei einem Vakuumgrad von $10^{-7}$ Torr.

**2.** Organische lichtemittierende Vorrichtung nach Anspruch 1, wobei die Emissionsenergie einer maximalen Emissionswellenlänge eines Emissionsspektrums des Dotierstoffs 2,31 eV oder mehr und 2,48 eV oder weniger beträgt und die Emissionsenergie einer maximalen Emissionswellenlänge eines Emissionsspektrums des Dotierstoffs aus einer maximalen Emissionswellenlänge eines Emissionsspektrums in Bezug auf Film 1 berechnet wird, und/oder
wobei die PLQY des Dotierstoffs 0,9 oder größer und 1,0 oder kleiner ist.

**3.** Organische lichtemittierende Vorrichtung nach Anspruch 1 oder 2, wobei eine Zerfallszeit des Dotierstoffs 1,0 $\mu$s oder mehr und 2,9 $\mu$s oder weniger beträgt, und/oder
wobei 0,1 eV $\leq$ HOMO (Dotierstoff) - HOMO (Wirt) $\leq$ 0,25 eV.

**4.** Organische lichtemittierende Vorrichtung nach einem der Ansprüche 1 bis 3, wobei
die PLQY des Dotierstoffs 0,975 oder mehr und 1,0 oder weniger beträgt,
die Zerfallszeit des Dotierstoffs 2,0 $\mu$s oder mehr und 2,5 $\mu$s oder weniger beträgt, und
0,15 eV $\leq$ HOMO (Dotierstoff) - HOMO (Wirt) $\leq$ 0,25 eV.

**5.** Organische lichtemittierende Vorrichtung nach einem der Ansprüche 1 bis 4, wobei der Dotierstoff eine iridiumfreie metallorganische Verbindung ist.

**6.** Organische lichtemittierende Vorrichtung nach einem der Ansprüche 1 bis 5, wobei der Dotierstoff eine metallorganische Verbindung ist, die Platin (Pt), Osmium (Os), Titan (Ti), Zirkonium (Zr), Hafnium (Hf), Europium (Eu), Terbium (Tb), Thulium (Tm), Rhodium (Rh), Ruthenium (Ru), Rhenium (Re), Beryllium (Be), Magnesium (Mg), Aluminium (Al), Calcium (Ca), Mangan (Mn), Kobalt (Co), Kupfer (Cu), Zink (Zn), Gallium (Ga), Germanium (Ge), Palladium (Pd), Silber (Ag) oder Gold (Au) umfasst.

**7.** Organische lichtemittierende Vorrichtung nach einem der Ansprüche 1 bis 6, wobei der Dotierstoff eine platinhaltige metallorganische Verbindung ist, und/oder
wobei der Dotierstoff eine quadratisch-planare Koordinationsstruktur aufweist.

**8.** Organische lichtemittierende Vorrichtung nach einem der Ansprüche 1 bis 7, wobei der Dotierstoff ein Metall M und einen organischen Liganden umfasst, und das Metall M und der organische Ligand in der Lage sind, zusammen einen, zwei oder drei cyclometallierte Ringe zu bilden.

**9.** Organische lichtemittierende Vorrichtung nach einem der Ansprüche 1 bis 8, wobei der Dotierstoff ein Metall M und einen dreizähnigen organischen Liganden umfasst, und das Metall M und die dreizähnigen organischen Liganden in der Lage sind, zusammen drei oder vier cyclometallierte Ringe zu bilden,
das Metall M Platin (Pt), Osmium (Os), Titan (Ti), Zirkonium (Zr), Hafnium (Hf), Europium (Eu), Terbium (Tb), Thulium (Tm), Rhodium (Rh), Ruthenium (Ru), Rhenium (Re), Beryllium (Be), Magnesium (Mg), Aluminium (Al), Calcium (Ca), Mangan (Mn), Kobalt (Co), Kupfer (Cu), Zink (Zn), Gallium (Ga), Germanium (Ge), Palladium (Pd), Silber (Ag) oder Gold (Au) ist, und
der dreizähnige organische Ligand eine Benzimidazolgruppe und eine Pyridingruppe umfasst.

**10.** Organische lichtemittierende Vorrichtung nach einem der Ansprüche 1 bis 9, wobei
der Wirt einen elektronentransportierenden Wirt und einen lochtransportierenden Wirt umfasst,
der elektronentransportierende Wirt mindestens einen elektronentransportierenden Anteil umfasst,
der lochtransportierende Wirt keine elektronentransportierende Einheit umfasst, und
der mindestens eine elektronentransportierende Anteil ausgewählt ist aus einer Cyanogruppe, einer elektronenverarmten stickstoffhaltigen cyclischen π-Gruppe und einer durch eine der folgenden Formeln dargestellten Gruppe:

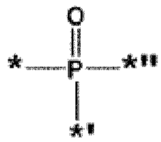 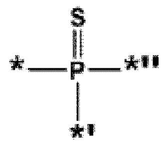 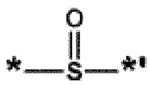 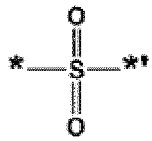

wobei in den obigen Formeln *, *' und *" jeweils eine Bindungsstelle zu einem benachbarten Atom anzeigen.

**11.** Organische lichtemittierende Vorrichtung nach Anspruch 10, wobei der elektronentransportierende Wirt mindestens eine elektronenverarmte stickstofffreie cyclische π-Gruppe und mindestens einen elektronentransportierenden Anteil umfasst,
der lochtransportierende Wirt mindestens eine elektronenverarmte stickstofffreie cyclische π-Gruppe umfasst und keinen elektronentransportierenden Anteil umfasst, und
der mindestens eine elektronentransportierende Anteil eine Cyanogruppe oder eine elektronenverarmte stickstoffhaltige cyclische π-Gruppe ist,
wobei vorzugsweise die elektronenverarmte stickstoffhaltige cyclische π-Gruppe eine Imidazolgruppe, eine Pyrazolgruppe, eine Thiazolgruppe, eine Isothiazolgruppe, eine Oxazolgruppe, eine Isoxazolgruppe, eine Pyridingruppe, eine Pyrazingruppe, eine Pyridazingruppe, eine Pyrimidingruppe, eine Indazolgruppe, eine Puringruppe, eine Chinolingruppe, eine Isochinolingruppe, eine Benzochinolingruppe, eine Benzoisochinolingruppe, eine Phthalazingruppe, eine Naphthyridingruppe, eine Chinoxalingruppe, eine Benzochinoxalingruppe, eine Chinazolingruppe, eine Cinnolingruppe, eine Phenanthridingruppe, eine Acridingruppe, eine Phenanthrolingruppe, eine Phenazingruppe, eine Benzimidazolgruppe, eine Isobenzothiazolgruppe, eine Benzoxazolgruppe, eine Isobenzoxazolgruppe, eine Triazolgruppe, eine Tetrazolgruppe, eine Oxadiazolgruppe, eine Triazingruppe, eine Thiadiazolgruppe, eine Imidazopyridingruppe, eine Imidazopyrimidingruppe, eine Azacarbazolgruppe oder eine kondensierte Ringgruppe ist, in der mindestens eine der vorstehenden Gruppen mit mindestens einer cyclischen Gruppe kondensiert ist, und
die elektronenverarmte stickstofffreie cyclische π-Gruppe eine Benzolgruppe, eine Heptalengruppe, eine Indengruppe, eine Naphthalingruppe, eine Azulengruppe, eine Indacengruppe, eine Acenaphthylengruppe, eine Fluorgruppe, eine Spirobifluorengruppe, eine Benzofluorengruppe, eine Dibenzofluorengruppe, eine Phenalengruppe, eine Phenanthrengruppe, eine Anthracengruppe, eine Fluoranthengruppe, eine Triphenylengruppe, eine Pyrengruppe, eine Chrysengruppe, eine Naphthacengruppe, eine Picengruppe, eine Perylengruppe, eine Pentacengruppe, eine Hexacengruppe, eine Pentacengruppe, eine Rubicengruppe, eine Coronengruppe, eine Ovalengruppe, eine Pyrrolgruppe, eine Isoindolgruppe, eine Indolgruppe, eine Furangruppe, eine Thiophengruppe, eine Benzofurangruppe, eine Benzothiophengruppe, eine Benzocarbazolgruppe, eine Dibenzocarbazolgruppe, eine Dibenzofurangruppe, eine Dibenzothiophengruppe, eine Dibenzothiophensulfongruppe, eine Carbazolgruppe, eine Dibenzosilolgruppe, eine Indenocarbazolgruppe, eine Indolocarbazolgruppe, eine Benzofurocarbazolgruppe, eine Benzothienocarbazolgruppe, eine Benzosilolocarbazolgruppe oder eine Triindolobenzolgruppe ist.

**12.** Organische lichtemittierende Vorrichtung nach Anspruch 10 oder 11, wobei der elektronentransportierende Wirt i)

mindestens eine, ausgewählt aus einer Cyanogruppe, einer Pyrimidingruppe, einer Pyrazingruppe und einer Triazingruppe und ii) eine Triphenylengruppe umfasst und der lochtransportierende Wirt eine Carbazolgruppe umfasst, oder
wobei der elektronentransportierende Wirt mindestens eine Cyanogruppe umfasst.

**13.** Organische lichtemittierende Vorrichtung nach einem der Ansprüche 1 bis 12, wobei ein Lochtransportbereich zwischen der ersten Elektrode und der Emissionsschicht angeordnet ist und der Lochtransportbereich eine aminhaltige Verbindung umfasst.

**14.** Organische lichtemittierende Vorrichtung nach einem der Ansprüche 1 bis 13, wobei:

Emissionseinheiten in der Anzahl m zwischen der ersten Elektrode und der zweiten Elektrode gestapelt sind, wobei die Emissionseinheiten mindestens eine der Emissionsschichten umfassen, und
ferner umfassend Ladungserzeugungsschicht(en) in der Anzahl von m-1 zwischen jeweils zwei benachbarten Emissionseinheiten aus den m-Emissionseinheiten, wobei die einzelnen m-1-Ladungserzeugungsschichten eine Ladungserzeugungsschicht des n-Typs und eine Ladungserzeugungsschicht des p-Typs umfassen, wobei m eine ganze Zahl von 2 oder mehr ist, und
eine maximale Emissionswellenlänge des von mindestens einer der Emissionseinheiten in der Anzahl m emittierten Lichts sich von derjenigen des von mindestens einer der anderen Emissionseinheiten emittierten Lichts unterscheidet.

**15.** Organische lichtemittierende Vorrichtung nach einem der Ansprüche 1 bis 13, wobei: Emissionsschichten in der Anzahl m zwischen der ersten Elektrode und der zweiten Elektrode gestapelt sind,
wobei m eine ganze Zahl von 2 oder mehr ist, und
eine maximale Emissionswellenlänge des von mindestens einer der Emissionsschichten in der Anzahl m emittierten Lichts sich von derjenigen des von mindestens einer der anderen Emissionsschichten emittierten Lichts unterscheidet.

## Revendications

**1.** Dispositif organique électroluminescent comprenant :

une première électrode ;
une seconde électrode se faisant face à la première électrode ; et
une couche d'émission disposée entre la première électrode et la seconde électrode,
dans lequel la couche d'émission comprend un hôte et un dopant, la couche d'émission émet une lumière phosphorescente, le dopant est un composé organométallique,
un rendement quantique de photoluminescence (PLQY) du dopant est de 0,8 ou plus et de 1,0 ou moins,
un temps de décroissance du dopant est de 0,1 microsecondes ($\mu$s) ou plus et de 2,9 $\mu$s ou moins,
0,1 eV $\leq$ HOMO (dopant) - HOMO (hôte) $\leq$ 0,4 eV, dans lequel l'HOMO (dopant) représente un niveau d'énergie d'orbitale moléculaire occupée la plus élevée (HOMO) (exprimé en électron volts) du dopant, et l'HOMO (hôte) représente, dans le cas où l'hôte compris dans la couche d'émission comprend un type d'hôte, un niveau d'énergie HOMO (exprimé en électron volts) du type d'hôte ; ou dans le cas où l'hôte compris dans la couche d'émission est un mélange d'au moins deux types d'hôte différents, le niveau d'énergie HOMO le plus élevé entre les niveaux d'énergie HOMO (exprimé en électron volts) des au moins deux types d'hôte différents, le PLQY du dopant est un PLQY de Film 1,
le temps de décroissance du dopant est calculé à partir d'un spectre de photoluminescence à résolution temporelle ce (TRPL) par rapport au Film 1,
le Film 1 a une épaisseur de 40 nanomètres (nm) obtenu par dépôt sous vide de l'hôte et du dopant compris dans la couche d'émission dans un rapport massique de 90:10 sur un substrat de quartz à un degré de vide de $10^{-7}$ torr,
l'HOMO (dopant) est une valeur négative mesurée en utilisant un spectromètre photo-électronique sous une atmosphère ambiante par rapport à un film ayant une épaisseur de 40 nm obtenu par dépôt sous vide de 1,4-bis(triphénylsilyl)benzène et du dopant compris dans la couche d'émission dans un rapport massique de 85:15 sur un substrat ITO à un degré de vide de $10^{-7}$ torr, et
l'HOMO (hôte) est, i) dans le cas où l'hôte comprend un type d'hôte, une valeur négative mesurée en utilisant un spectromètre photo-électronique sous une atmosphère ambiante par rapport à un film ayant une épaisseur

de 40 nm obtenu par dépôt sous vide d'un type d'hôte sur un substrat ITO à un degré de vide de $10^{-7}$ torr ; ou ii) dans le cas où l'hôte est un mélange d'au moins deux types d'hôte différents, une valeur négative la plus élevée entre des valeurs négatives mesurées en utilisant un spectromètre photo-électronique sous une atmosphère ambiante par rapport à un film ayant une épaisseur de 40 nm obtenu par dépôt sous vide de chacun des au moins deux types d'hôte différents sur un substrat ITO à un degré de vide de $10^{-7}$ torr.

**2.** Dispositif organique électroluminescent selon la revendication 1, dans lequel l'énergie d'émission d'une longueur d'onde d'émission maximale d'un spectre d'émission du dopant est de 2,31 eV ou plus et de 2,48 eV ou moins et l'énergie d'émission d'une longueur d'onde d'émission maximale d'un spectre d'émission du dopant est calculée à partir d'une longueur d'onde d'émission maximale d'un spectre d'émission par rapport au Film 1 ; et/ou
dans lequel le PLQY du dopant est de 0,9 ou plus et de 1,0 ou moins.

**3.** Dispositif organique électroluminescent selon la revendication 1 ou la revendication 2, dans lequel un temps de décroissance du dopant est de 1,0 $\mu$s ou plus et de 2,9 $\mu$s ou moins ; et/ou
dans lequel 0,1 eV $\leq$ HOMO (dopant) - HOMO (hôte) $\leq$ 0,25 eV.

**4.** Dispositif organique électroluminescent selon l'une quelconque des revendications 1 à 3, dans lequel
le PLQY du dopant est de 0,975 ou plus et de 1,0 ou moins,
le temps de décroissance du dopant est de 2,0 $\mu$s ou plus et de 2,5 $\mu$s ou moins, et
0,15 eV $\leq$ HOMO (dopant) - HOMO (hôte) $\leq$ 0,25 eV.

**5.** Dispositif organique électroluminescent selon l'une quelconque des revendications 1 à 4, dans lequel le dopant est un composé organométallique exempt d'iridium.

**6.** Dispositif organique électroluminescent selon l'une quelconque des revendications 1 à 5, dans lequel le dopant est un composé organométallique comprenant le platine (Pt), l'osmium (Os), le titane (Ti), le zirconium (Zr), le hafnium (Hf), l'europium (Eu), le terbium (Tb), le thulium (Tm), le rhodium (Rh), le ruthénium (Ru), le rhénium (Re), le béryllium (Be), le magnésium (Mg), l'aluminium (A1), le calcium (Ca), le manganèse (Mn), le cobalt (Co), le cuivre (Cu), le zinc (Zn), le gallium (Ga), le germanium (Ge), le palladium (Pd), l'argent (Ag), ou l'or (Au).

**7.** Dispositif organique électroluminescent selon l'une quelconque des revendications 1 à 6, dans lequel le dopant est un composé organométallique contenant du platine ; et/ou
dans lequel le dopant a une structure de coordination plane carrée.

**8.** Dispositif organique électroluminescent selon l'une quelconque des revendications 1 à 7, dans lequel le dopant comprend un métal M et un ligand organique, et le métal M et le ligand organique sont capables de former ensemble un, deux, ou trois cycles cyclométallisés.

**9.** Dispositif organique électroluminescent selon l'une quelconque des revendications 1 à 8, dans lequel le dopant comprend un métal M et un ligand organique tétradentate, et le métal M et le ligand organique tétradentate sont capables de former ensemble trois ou quatre cycles cyclométallisés,
le métal M est le platine (Pt), l'osmium (Os), le titane (Ti), le zirconium (Zr), le hafnium (Hf), l'europium (Eu), le terbium (Tb), le thulium (Tm), le rhodium (Rh), le ruthénium (Ru), le rhénium (Re), le béryllium (Be), le magnésium (Mg), l'aluminium (A1), le calcium (Ca), le manganèse (Mn), le cobalt (Co), le cuivre (Cu), le zinc (Zn), le gallium (Ga), le germanium (Ge), le palladium (Pd), l'argent (Ag), ou l'or (Au), et
le ligand organique tétradentate comprend un groupe benzimidazole et un groupe pyridine.

**10.** Dispositif organique électroluminescent selon l'une quelconque des revendications 1 à 9, dans lequel
l'hôte comprend un hôte de transport d'électrons et un hôte de transport de trous,
l'hôte de transport d'électrons comprend au moins une fraction de transport d'électrons,
l'hôte de transport de trous ne comprend pas une fraction de transport d'électrons, et
l'au moins une fraction de transport d'électrons est choisie parmi un groupe cyano, un groupe cyclique contenant de l'azote appauvri en électron $\pi$, et a groupe représenté par l'une des formules suivantes :

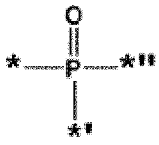 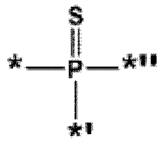 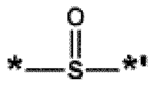 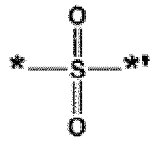

dans lequel, dans les formules ci-dessus, *, *', et *" indiquent chacun un site de liaison à un atome adjacent.

**11.** Dispositif organique électroluminescent selon la revendication 10, dans lequel l'hôte de transport d'électrons comprend au moins un groupe cyclique exempt d'azote appauvri en électron π et au moins une fraction de transport d'électrons,
l'hôte de transport de trous comprend au moins un groupe cyclique exempt d'azote appauvri en électron π et ne comprend pas une fraction de transport d'électrons, et
l'au moins une fraction de transport d'électrons est un groupe cyano ou un groupe cyclique contenant de l'azote appauvri en électron π ;
de préférence dans lequel le groupe cyclique contenant de l'azote appauvri en électron π est an imidazole, un groupe pyrazole, un groupe thiazole, un groupe isothiazole, un groupe oxazole, un groupe isoxazole, un groupe pyridine, un groupe pyrazine, un groupe pyridazine, un groupe pyrimidine, un groupe indazole, un groupe purine, un groupe quinoline, un groupe isoquinoline, un groupe benzoquinoline, un groupe benzoisoquinoline, un groupe phtalazine, un groupe naphtyridine, un groupe quinoxaline, un groupe benzoquinoxaline, un groupe quinazoline, un groupe cinnoline, un groupe phénanthridine, un groupe acridine, un groupe phénanthroline, un groupe phénazine, un groupe benzimidazole, un groupe iso-benzothiazole, un groupe benzoxazole, un groupe isobenzoxazole, un groupe triazole, un groupe tétrazole, un groupe oxadiazole, un groupe triazine, un groupe thiadiazole, un groupe imidazopyridine, un groupe imidazopyrimidine, un groupe azacarbazole, ou un groupe cyclique condensé dans lequel au moins un des groupes précédents est condensé avec au moins un groupe cyclique, et
le groupe cyclique exempt d'azote appauvri en électron π est un groupe benzène, un groupe heptalène, un groupe indène, un groupe naphtalène, un groupe azulène, un groupe indacène, acénaphtylène, un groupe fluorène, un groupe spiro-bifluorène, un groupe benzofluorène, un groupe dibenzofluorène, un groupe phénalène, un groupe phénanthrène, un groupe anthracène, un groupe fluoranthène, un groupe triphénylène, un groupe pyrène, un groupe chrysène, un groupe naphtacène, un groupe picène, un groupe pérylène, un groupe pentacène, un groupe hexacène, un groupe pentacène, un groupe rubicène, un groupe coronène, un groupe ovalène, un groupe pyrrole, un groupe isoindole, un groupe indole, un groupe furane, un groupe thiophène, un groupe benzofurane, un groupe benzothiophène, un groupe benzocarbazole, un groupe dibenzocarbazole, un groupe dibenzofurane, un groupe dibenzothiophène, un groupe dibenzothiophène sulfone, un groupe carbazole, un groupe dibenzosilole, un groupe indénocarbazole, un groupe indolocarbazole, un groupe benzofurocarbazole, un groupe benzothiénocarbazole, un groupe benzosilolocarbazole, ou un groupe triindolobenzène.

**12.** Dispositif organique électroluminescent selon la revendication 10 ou la revendication 11, dans lequel l'hôte de transport d'électrons comprend i) au moins un groupe choisi parmi un groupe cyano, un groupe pyrimidine, un groupe pyrazine, et un groupe triazine et ii) un groupe triphénylène, et l'hôte de transport de trous comprend un groupe carbazole ; ou
dans lequel l'hôte de transport d'électrons comprend au moins un groupe cyano.

**13.** Dispositif organique électroluminescent selon l'une quelconque des revendications 1 à 12, dans lequel une région de transport de trous est disposée entre la première électrode et la couche d'émission, et la région de transport de trous comprend un composé contenant une amine.

**14.** Dispositif organique électroluminescent selon l'une quelconque des revendications 1 à 13, dans lequel :

des unités d'émission dans le nombre de m sont empilées entre la première électrode et
la seconde électrode, les unités d'émission comprenant au moins une des couches d'émission ; et
comprenant en outre au moins une couche de génération de charge dans le nombre de m-1 entre chacune des deux unités d'émission adjacente entre les m unité d'émission, chacune des m-1 couches de génération de charge comprenant une couche de génération de charge de type n et une couche de génération de charge de type p,
dans lequel m est un nombre entier valant 2 ou plus, et
une longueur d'onde d'émission maximale de lumière émise à partir d'au moins une des unités d'émission dans le nombre de m est différent de celui de la lumière émise à partir d'au moins une des autres unités d'émission.

**15.** Dispositif organique électroluminescent selon l'une quelconque des revendications 1 à 13, dans lequel :

les couches d'émission dans le nombre de m sont empilées entre la première électrode et la seconde électrode, dans lequel m est un nombre entier valant 2 ou plus, et
une longueur d'onde d'émission maximale de lumière émise à partir d'au moins une des couches d'émission dans le nombre de m des lumière émise à partir d'au moins une des autres couches d'émission.

FIG. 1

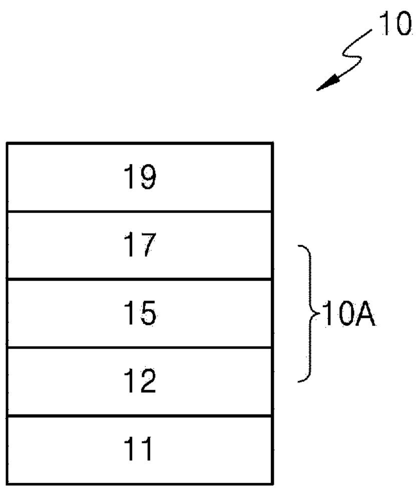

FIG. 2

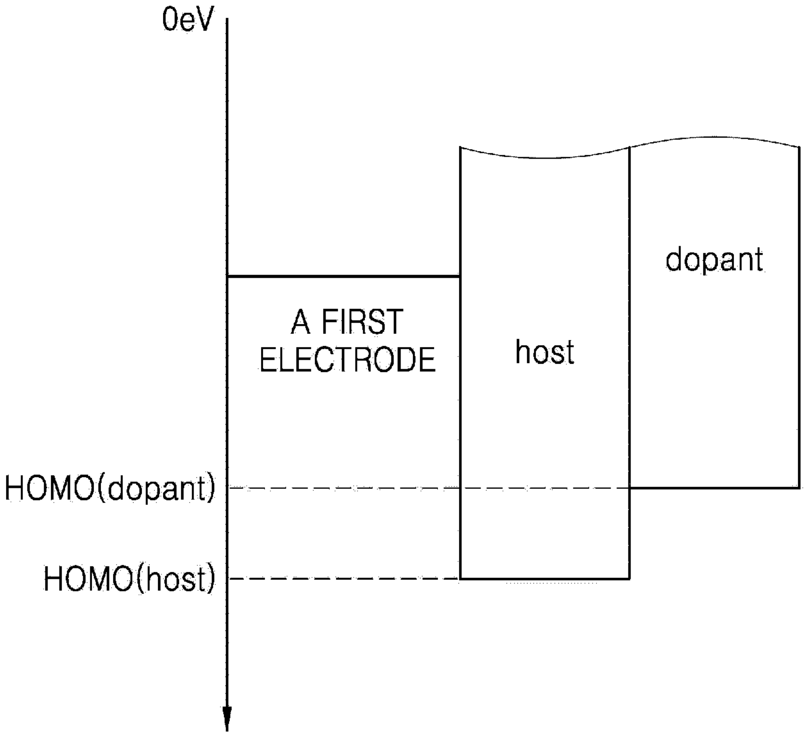

FIG. 3

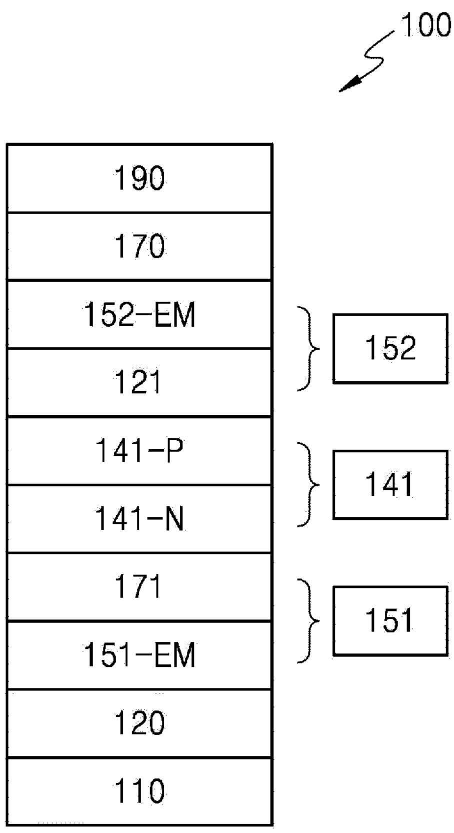

FIG. 4

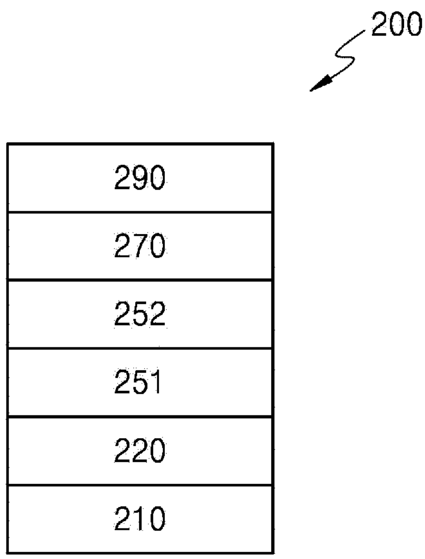

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- *J. Mater. Chem. C,* 2015, vol. 3, 8212-8218
- *Adv. Funct. Mater.,* 2013, vol. 23, 5168-5176